# EUROPEAN PATENT SPECIFICATION

(11) **EP 3 026 056 B1**
(45) Date of publication and mention of the grant of the patent: **08.11.2017**
(21) Application number: 15196295.8
(22) Date of filing: 25.11.2015
(51) Int. Cl.: C07F 15/00, C09K 11/06, H01L 51/00

(54) **ORGANOMETALLIC COMPOUND AND ORGANIC LIGHT-EMITTING DEVICE INCLUDING THE SAME**
ORGANOMETALLISCHE VERBINDUNG UND ORGANISCHE LICHTEMITTIERENDE VORRICHTUNG DAMIT
COMPOSÉ ORGANOMÉTALLIQUE ET DISPOSITIF ÉLECTROLUMINESCENT ORGANIQUE L'INCLUANT

(30) Priority: 28.11.2014 KR 20140169183; 14.09.2015 KR 20150129776
(43) Date of publication of application: 01.06.2016
(73) Proprietor: Samsung Electronics Co., Ltd., Gyeonggi-do 16677 (KR)
(72) Inventor: HWANG, Kyuyoung, 16678 Gyeonggi-do (KR); CHOI, Hyeonho, 16678 Gyeonggi-do (KR); KWAK, Yoonhyun, 16678 Gyeonggi-do (KR); KOO, Hyun, 16678 Gyeonggi-do (KR); LEE, Kumhee, 16678 Gyeonggi-do (KR); CHOI, Whail, 16678 Gyeonggi-do (KR); HONG, Seokhwan, 16678 Gyeonggi-do (KR); KWON, Ohyun, 16678 Gyeonggi-do (KR)
(74) Representative: Scheuermann, Erik

(56) References cited:
- WO-A1-2014/065498

## Description

### FIELD OF THE INVENTION

One or more embodiments relate to an organometallic compound and an organic light-emitting device including the same.

### BACKGROUND OF THE INVENTION

Organic light emitting devices (OLEDs) are self-emission devices that have wide viewing angles, high contrast ratios, and short response times. In addition, OLEDs exhibit excellent brightness, driving voltage, and response speed characteristics, and produce full-color images.

In an example, an organic light-emitting device includes an anode, a cathode, and an organic layer that is disposed between the anode and the cathode and includes an emission layer. A hole transport region may be disposed between the anode and the emission layer, and an electron transport region may be disposed between the emission layer and the cathode. Holes provided from the anode may move toward the emission layer through the hole transport region, and electrons provided from the cathode may move toward the emission layer through the electron transport region. The holes and the electrons are recombined in the emission layer to produce excitons. These excitons change from an excited state to a ground state, thereby generating light. WO 2014/065498 describes organometallic compounds for use in LEDs. Various types of organic light emitting devices are known. However, there still remains a need in OLEDs having low driving voltage, high efficiency, high brightness, and long lifespan.

### SUMMARY OF THE INVENTION

One or more embodiments relate to a novel organometallic compound and an organic light-emitting device including the same.

Additional aspects will be set forth in part in the description which follows and, in part, will be apparent from the description, or may be learned by practice of the presented embodiments.

An aspect provides an organometallic compound represented by Formula 1:

Formula 1 M(L₁)ₙ₁(L₂)ₙ₂

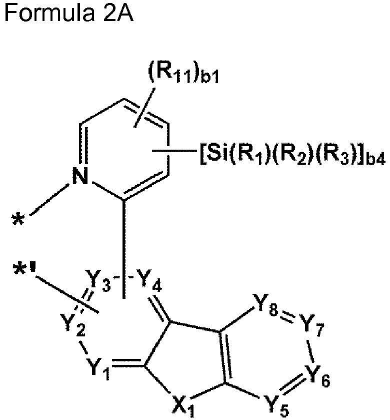

wherein M in Formula 1 is selected from Ir, Pt, Os, Ti, Zr, Hf, Eu, Tb, Tm, and Rh,
in Formula 1, L₁ is a ligand represented by Formula 2A, n1 is 1, 2, or 3, and when n1 is 2 or more, 2 or more L₁ may be identical or different,
in Formula 1, L₂ is selected from a monovalent organic ligand, a divalent organic ligand, a trivalent organic ligand, and a tetravalent organic ligand, n2 is 0, 1, 2, 3, or 4, when n2 is 2 or more, 2 or more L₂ may be identical or different,
L₁ and L₂ in Formula 1 may be different from each other,
R₁ to R₃ in Formula 2A may be each independently selected from a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, and -Si(Q₅₁)(Q₅₂)(Q₅₃),
X₁ in Formula 2A may be selected from O, S, S(=O)₂, N(R₂₁), and Si(R₂₂)(R₂₃),
in Formula 2A, Y₁ may be N, C(R₄₁) or a carbon atom connected to a pyridine ring, Y₂ may be N, C(R₄₂) or a carbon atom connected to a pyridine ring, Y₃ may be N, C(R₄₃) or a carbon atom connected to a pyridine ring, Y₄ may be N, C(R₄₄) or a carbon atom connected to a pyridine ring, Y₅ may be N or C(R₄₅), Y₆ may be N or C(R₄₆), Y₇ may be N or C(R₄₇), Y₈ may be N or C(R₄₈), and one of Y₁ to Y₄ may be a carbon atom connected to a pyridine ring,
R₁₁, R₂₁ to R₂₃ and R₄₁ to R₄₈ in Formula 2A may be each independently selected from a hydrogen, a deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅),--B(Q₆)(Q₇), and -P(=O)(Q₈)(Q₉), and 2 or more R₁₁ may optionally be linked to each other form a saturated or unsaturated C₄-C₆₀ ring, and two or more of R₄₁ to R₄₄ may be linked to each other to form a saturated or unsaturated C₄-C₆₀ ring, and two or more of R₄₅ to R₄₈ may be optionally linked to each other to form a saturated or unsaturated C₄-C₆₀
in Formula 2A, b1 is an integer selected from 0 to 3, and b4 is an integer selected from 1 to 4,
* and *' in Formula 2A are binding sites to M in Formula 1,
at least one of substituents of the substituted C₁-C₆₀ alkyl group, substituted C₂-C₆₀ alkenyl group, substituted C₂-C₆₀ alkynyl group, substituted C₁-C₆₀ alkoxy group, substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₆-C₆₀ aryloxy group, substituted C₆-C₆₀ arylthio group, substituted C₁-C₆₀ heteroaryl group, substituted monovalent non-aromatic condensed polycyclic group, and substituted monovalent non-aromatic condensed heteropolycyclic group is selected from
a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -B(Q₁₆)(Q₁₇), and -P(=O)(Q₁₈)(Q₁₉) ;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -B(Q₂₆)(Q₂₇), and -P(=O)(Q₂₈)(Q₂₉); and

   -N(Q₃₁)(Q₃₂), -Si(Q₃₃)(Q₃₄)(Q₃₅), -B(Q₃₆)(Q₃₇), and -P(=O)(Q₃₈)(Q₃₉);
wherein Q₁ to Q₉, Q₁₁ to Q₁₉, Q₂₁ to Q₂₉, Q₃₁ to Q₃₉ and Q₅₁ to Q₅₃ may be each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group.

Another aspect provides an organic light-emitting device including:
a first electrode;
a second electrode; and
an organic layer disposed between the first electrode and the second electrode, wherein the organic layer includes an emission layer and at least one organometallic compound represented by Formula 1.

The emission layer may include the organometallic compound.

The organometallic compound included in the emission layer may act as a dopant, and the emission layer may further include a host.

### BRIEF DESCRIPTION OF THE DRAWINGS

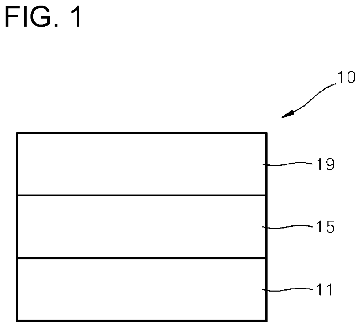

These and/or other aspects will become apparent and more readily appreciated from the following description of the embodiments, taken in conjunction with FIG. 1 which is a schematic view of an organic light-emitting device according to an embodiment.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present inventive concept. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly in contact with the other element or intervening elements may present therebetween. In contrast, when an element is referred to as being "directly on" another element, there are no intervening elements present.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

The terminology used herein is for the purpose of describing particular embodiments only and is not intended to be limiting. As used herein, the singular forms "a," "an," and "the" are intended to include the plural forms as well, unless the context clearly indicates otherwise.

It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Spatially relative terms, such as "beneath," "below," "lower," "above," "upper" and like, may be used herein for ease of description to describe one element or feature's relationship to another element(s) or feature(s) as illustrated in the figures. It will be understood that the spatially relative terms are intended to encompass different of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein. Examplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated the figures are schematic in nature and their shapes are not intended to illustrate the shape of a region and are not intended to limit the scope of the present claims.

An organometallic compound according to an embodiment is represented by Formula 1 below:

Formula 1 M(L₁)ₙ₁(L₂)ₙ₂

M in Formula 1 may be selected from iridium (Ir), platinum (Pt), osmium (Os), titanium (Ti), zirconium (Zr), hafnium (Hf), europium (Eu), terbium (Tb), thulium (Tm), and rhodium (Rh).

For example, M in Formula 1 may be selected from iridium (Ir), platinum (Pt), osmium (Os), and rhodium (Rh).

In some embodiments, M in Formula 1 may be selected from iridium (Ir) and platinum (Pt), but is not limited thereto.

In Formula 1, L₁ is a ligand represented by Formula 2A, n1 is 1, 2, or 3, and when n1 is 2 or more, 2 or more L₁ may be identical or different. 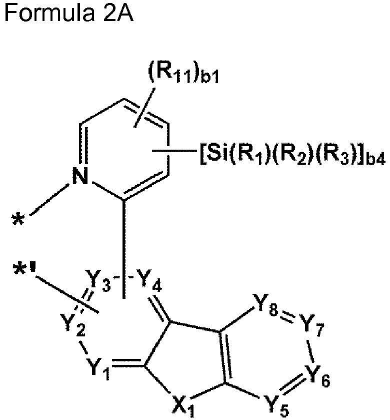
wherein in Formula 1, L₂ is selected from a monovalent organic ligand, a divalent organic ligand, a trivalent organic ligand, and a tetravalent organic ligand, n2 is 0, 1, 2, 3, or 4, when n2 is 2 or more, 2 or more L₂ may be identical or different.
L₁ and L₂ in Formula 1 may be different from each other.

For example, n1 in Formula 1 may be 1.

In some embodiments, the organometallic compound represented by Formula 1 may not include an ionic group. For example, the organometallic compound may not be a salt consisting of an ionic pair.

In some embodiments, in Formula 1, M is Ir and the sum of n1 and n2 is 3; or M is Pt and the sum of n1 and n2 is 2, and the organometallic compound represented by Formula 1 may not include an ionic group.

R₁ to R₃ in Formula 2A may be each independently selected from a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, and -Si(Q₅₁)(Q₅₂)(Q₅₃).

For example, R₁ to R₃ in Formula 2A may be each independently selected from
a C₁-C₂₀ alkyl group, a C₁-C₂₀ alkoxy group, and -Si(Q₅₁)(Q₅₂)(Q₅₃);
a C₁-C₂₀ alkyl group and a C₁-C₂₀ alkoxy group, each substituted with at least one selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group; and
a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl a pyridazinyl group, an isoindolyl group, an indolyl group, an indazolyl group, a purinyl a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, benzothiophenyl group, an isobenzothiazolyl group, a benzoxazolyl group, an isobenzoxazolyl group, a triazolyl group, a tetrazolyl group, an oxadiazolyl group, a group, a dibenzofuranyl group, a dibenzothiophenyl group, a benzocarbazolyl group, a dibenzocarbazolyl group, an imidazopyridinyl group, and an imidazopyrimidinyl group; and
Q₅₁ to Q₅₃ may be each independently selected from
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group, but embodiments are not limited thereto.

In other examples, R₁ to R₃ in Formula 2A may be each independently selected from -CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, and -Si(Q₅ᵢ)(Q₅₂)(Q₅₃); and
an n-propyl group, an isopropyl group, an n-butyl group, an isobutyl group, a sec-sec-butyl group, a tert-butyl group, an n-pentyl group, an isopentyl group, a sec-pentyl a tert-pentyl group, a phenyl group, and a naphthyl group, each substituted with at least selected from a deuterium, a C₁-C₁₀ alkyl group, and a phenyl group;
Q₅₁ to Q₅₃ may be each independently selected from
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group.

In some embodiments, Q₅₁ to Q₅₃ may be each independently a methyl group or an ethyl group.

In some embodiments, in Formula 2A,
R₁ to R₃ may all be identical;
R₁ and R₃ may be identical and R₂ and R₁ may be different; or
R₁ to R₃ may all be different from each other.
X₁ in Formula 2A may be selected from O, S, S(=O)₂, N(R₂₁), and Si(R₂₂)(R₂₃).

For example, X₁ in Formula 2A may be selected from O, S, and N(R₂₁).

According to an embodiment, X₁ in Formula 2A may be O, but is not limited thereto.

R₁₁, R₂₁ to R₂₃ and R₄₁ to R₄₈ in Formula 2A may be each independently selected from a hydrogen, a deuterium, -F, -Cl, -Br, -I, -SF₅, a hydroxyl group, a cyano group, a group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅),--B(Q₆)(Q₇), and -P(=O)(Q₈)(Q₉).

For example, R₁₁, R₂₁ to R₂₃ and R₄₁ to R₄₈ in Formula 2A may be each independently selected from
a hydrogen, a deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, and a C₁-C₂₀ alkoxy group;
a C₁-C₂₀ alkyl group and a C₁-C₂₀ alkoxy group, each substituted with at least one selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic group or a salt thereof, a phosphoric acid group or a salt thereof, a C₁-C₁₀ alkyl group, a C₁-C₁₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₁₄ aryl group, a C₁-C₁₄ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₁₄ aryl group, a C₁-C₁₄ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₁₄ aryl group, a C₁-C₁₄ heteroaryl group, a monovalent non-aromatic condensed polycyclic group, and a monovalent non-aromatic condensed heteropolycyclic group, each substituted with at least one selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₁₄ aryl group, a C₁-C₁₄ heteroaryl group, a monovalent non-aromatic condensed polycyclic group, and a monovalent non-aromatic condensed heteropolycyclic group; and
-N(Q₁)(Q₂), -Si(Q₃)(Q₄)(Q₅), -B(Q₆)(Q₇), and -P(=O)(Q₈)(Q₉);
Q₁ to Q₉ may be each independently selected from a substituted or unsubstituted C₁-C₂₀ alkyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or C₆-C₁₄ aryl group, a substituted or unsubstituted C₁-C₁₄ heteroaryl group, a substituted or unsubstituted monovalent non-aromatic condensed polycyclic group, and a substituted or unsubstituted monovalent non-aromatic condensed heteropolycyclic group.

In some embodiments, R₁₁, R₂₁ to R₂₃ and R₄₁ to R₄₈ in Formula 2A may be each independently selected from
a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, and a C₁-C₂₀ alkoxy group;
a C₁-C₂₀ alkyl group and a C₁-C₂₀ alkoxy group, each substituted with at least one selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl a pyridazinyl group, an isoindolyl group, an indolyl group, an indazolyl group, a purinyl a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl a pyridazinyl group, an isoindolyl group, an indolyl group, an indazolyl group, a purinyl a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, benzothiophenyl group, an isobenzothiazolyl group, a benzoxazolyl group, an isobenzoxazolyl group, a triazolyl group, a tetrazolyl group, an oxadiazolyl group, a group, a dibenzofuranyl group, a dibenzothiophenyl group, a benzocarbazolyl group, a dibenzocarbazolyl group, an imidazopyridinyl group, and an imidazopyrimidinyl group; and

-B(Q₆)(Q₇) and -P(=O)(Q₈)(Q₉),

Q₆ to Q₉ may be each independently selected from
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-sec-butyl group, a tert-butyl group, an n-pentyl group, an isopentyl group, a sec-pentyl a tert-pentyl group, a phenyl group, and a naphthyl group, each substituted with at least selected from a deuterium, a C₁-C₁₀ alkyl group, and a phenyl group, but embodiments are not limited thereto.

In some embodiments, R₁₁, R₂₁ to R₂₃ and R₄₁ to R₄₈ in Formula 2A may be each independently selected from
a hydrogen, a deuterium, -F, a cyano group, a nitro group, -SF₅, a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl, norbornanyl group, a norbornenyl, a cyclopentenyl group, a cyclohexenyl group, a cycloheptenyl group, a phenyl group, a naphthyl group, a pyridinyl group, and a pyrimidinyl group;
a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an isohexyl a sec-hexyl group, a tert-hexyl group, an n-heptyl group, an isoheptyl group, a sec-heptyl group, a tert-heptyl group, an n-octyl group, an isooctyl group, a sec-octyl group, a tert-group, an n-nonyl group, an isononyl group, a sec-nonyl group, a tert-nonyl group, an n-n-decyl group, an isodecyl group, a sec-decyl group, a tert-decyl group, a methoxy group, ethoxy group, a propoxy group, a butoxy group, a pentoxy group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a pyridinyl group, and a pyrimidinyl group, each substituted with at least one selected from a deuterium, -F, -CD₃, -CD₂H,--CF₃, -CF₂H, -CFH₂, a cyano group, a nitro group, a C₁-C₁₀ alkyl group, a C₁-C₁₀ alkoxy group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a pyridinyl group, and a pyrimidinyl group; and

-B(Q₆)(Q₇) and -P(=O)(Q₈)(Q₉),

Q₆ to Q₉ may be each independently selected from
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group.
In some embodiments, R₁₁, R₂₁ to R₂₃ and R₄₁ to R₄₈ in Formula 2A may be each independently selected from a hydrogen, a deuterium, -F, a cyano group, a nitro group, - SF₅, -CH₃, -CD₃, -CD₂H, -CDH₂, -CF₃, -CF₂H, -CFH₂, groups represented by Formulae 9-1 to 9-17, and groups represented by Formulae 10-1 to 10-30, but they are not limited thereto:

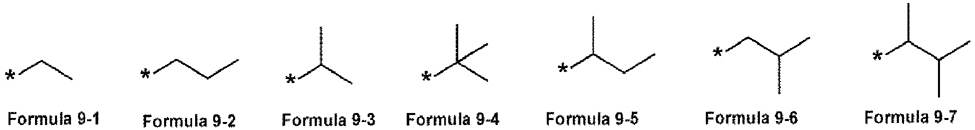

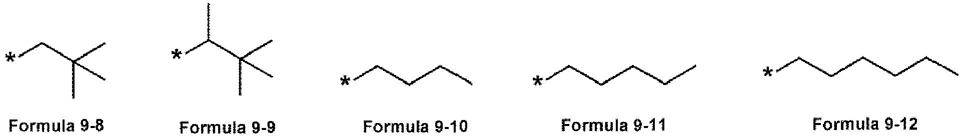

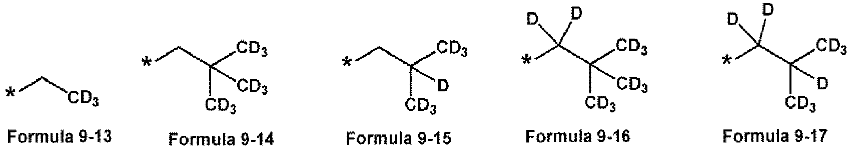

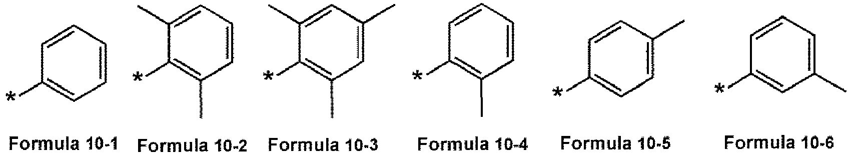

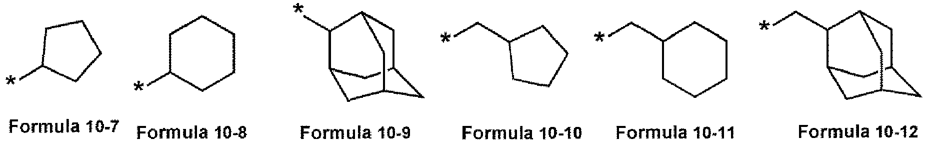

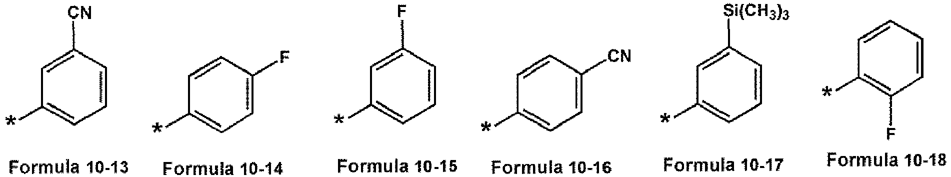

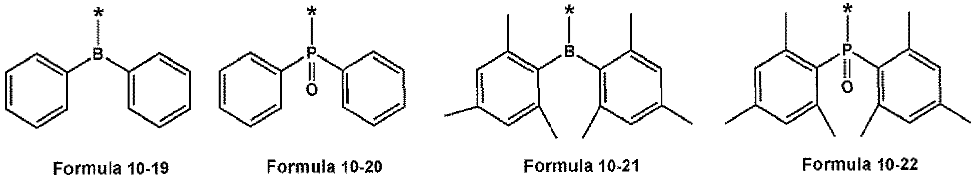

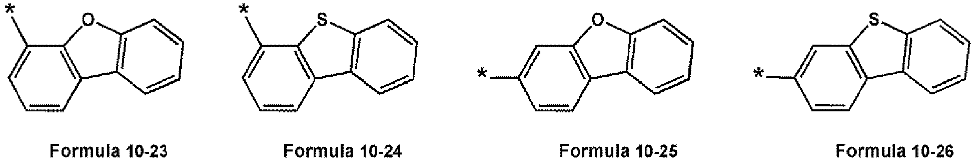

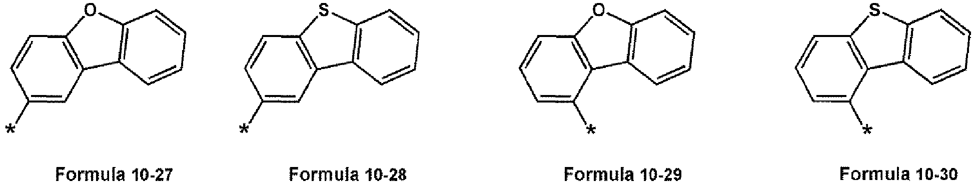

In Formulae 9-1 to 9-17 and 10-1 to 10-30, * is a binding site to a neighboring atom.

In Formula 2A, b1 is an integer selected from 0 to 3, and b4 is an integer selected from 1 to 4.

In some embodiments, R₂₁ to R₂₃ in X₁ of Formula 2A are each independently selected from
a C₁-C₂₀ alkyl group, a C₁-C₂₀ alkoxy group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyridinyl group, a pyrimidinyl group, and a triazinyl group;
a C₁-C₂₀ alkyl group and a C₁-C₂₀ alkoxy group, each substituted with at least one selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;
a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyridinyl group, a pyrimidinyl group, and a triazinyl group, each substituted with at least one selected from a deuterium, -F, -Cl, -Br, -I, -CD₃, -CD₂H, -CDH₂, -CF₃, -CF₂H, -CFH₂, a hydroxyl group, a cyano group, a nitro group, amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, and a naphthyl group.

In Formula 2A, b1 indicates the number of R₁₁, when b1 is 2 or more, 2 or more R₁₁ are identical or different, and b4 indicates the number of -Si(R₁)(R₂)(R₃), when b4 is 2 or more, 2 or more -Si(R₁)(R₂)(R₃) are identical or different.

In some embodiments, in Formula 2A, b1 may be 0, 1 or 2, and b4 may be 1 or 2, but they are not limited thereto.

In some embodiments, in Formula 2A, b1 may be 0 or 1, and b4 may be 1, but they are not limited thereto.

Regarding Formula 2A, two or more R₁₁s may be optionally linked to each other to form a saturated or unsaturated C₄-C₆₀ ring (for example, a cyclopentane, a cyclohexane, an adamantane, a norbornane, a benzene, a pyridine, a pyrimidine, a naphthalene, a pyrene, or a chrysene), two or more of R₄₁ to R₄₄ may be optionally linked to each other to form a saturated or unsaturated C₄-C₆₀ ring (for example, a cyclopentane, a cyclohexane, an adamantane, a norbornane, a benzene, a pyridine, a pyrimidine, a naphthalene, a pyrene, or a chrysene), and two or more of R₄₅ to R₄₈ may be optionally linked to each to form a saturated or unsaturated C₄-C₆₀ ring (for example, a cyclopentane, a an adamantane, a norbornane, a benzene, a pyridine, a pyrimidine, a naphthalene, a pyrene, or a chrysene).

For example, two R₁₁s in Formula 2A may bind to each other to form a substituted or unsubstituted a cyclohexane or a substituted or unsubstituted a benzene, but embodiments are not limited thereto.

In some embodiments, none of Y₁ to Y₈ in Formula 2A may be N.

In some embodiments, Y₁ or Y₃ in Formula 2A may be N.

In some embodiments, Y₅ or Y₆ in Formula 2A may be N.

In some embodiments, one or two of Y₁, Y₃, Y₅, and Y₆ in Formula 2A may be N

In some embodiments, L₁ in Formula 1 may be selected from ligands represented by Formula 2A-1 to 2A-16 below:

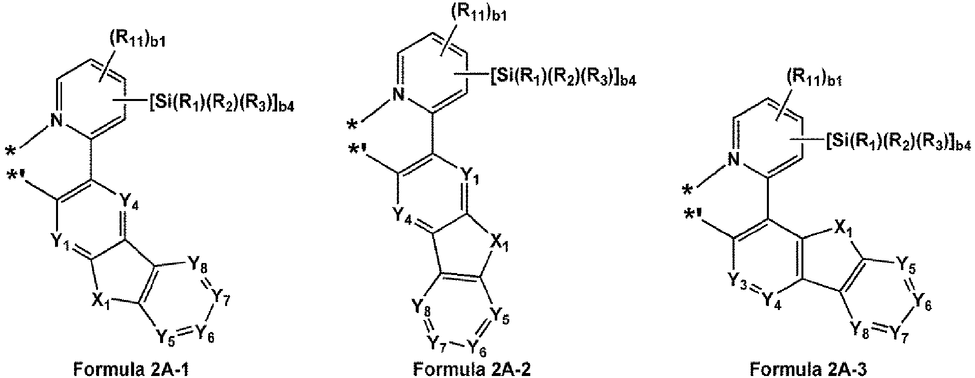

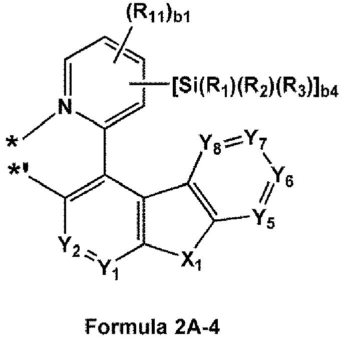

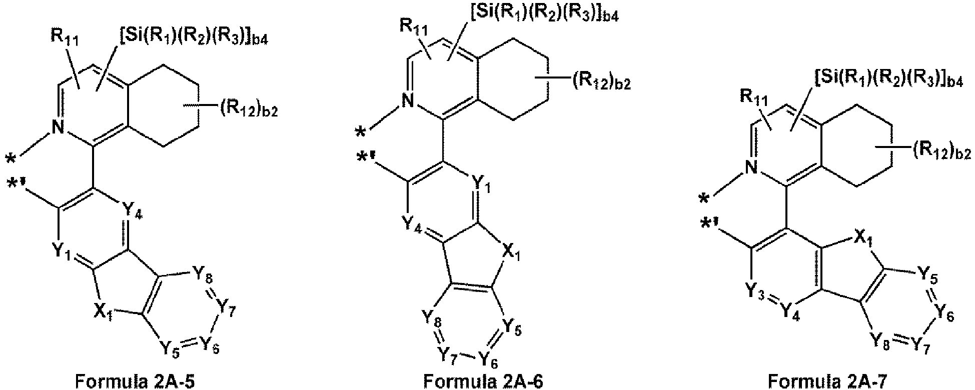

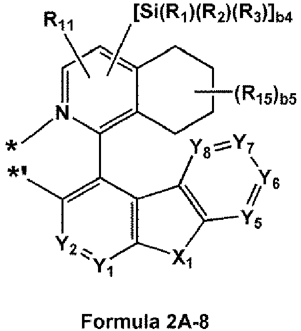

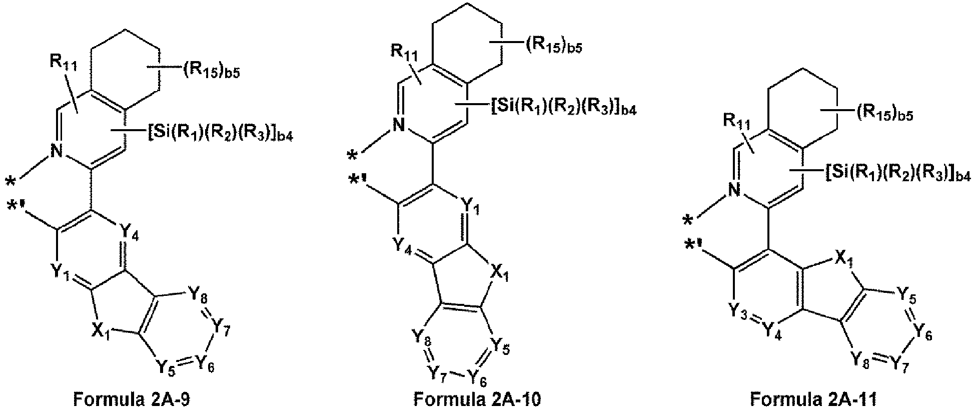

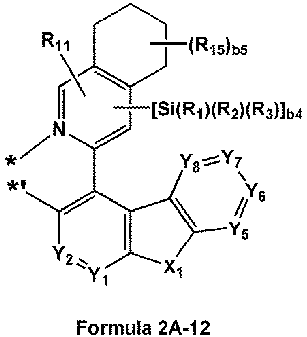

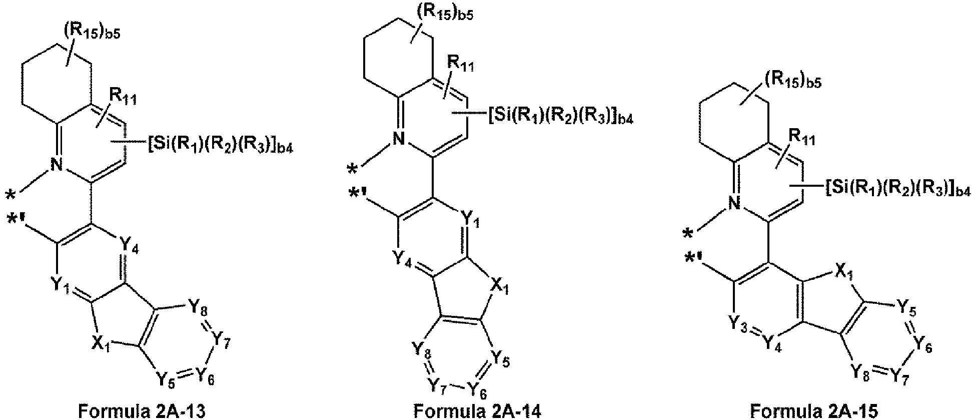

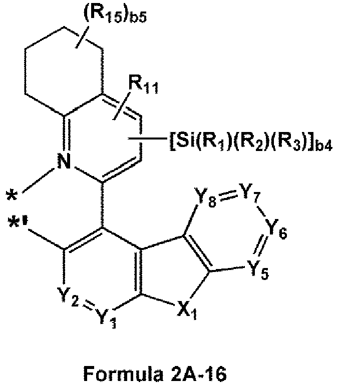

Regarding Formulae 2A-1 to 2A-16, descriptions of R₁ to R₃, X₁, Y₁ to Y₈, R₁₁, b1 and b4 are the same as described above, descriptions of R₁₅ are the same as described in connection with R₁₁, b5 is an integer selected from 0 to 8, and * and *' are binding sites to M in Formula 1.

In some embodiments,
in Formulae 2A-1 to 2A-16, Y₁ may be C(R₄₁), Y₂ may be C(R₄₂), Y₃ may be C(R₄₃), Y₄ may be C(R₄₄), Y₅ may be C(R₄₅), Y₆ may be C(R₄₆), Y₇ may be C(R₄₇), and Y₈ may be C(R₄₈);
in Formulae 2A-1, 2A-2, 2A-4, 2A-5, 2A-6, 2A-8, 2A-9, 2A-10, 2A-12, 2A-13, 2A-14, and 2A-16, Y₁ may be N, Y₄ may be C(R₄₄), Y₅ may be C(R₄₅), Y₆ may be C(R₄₆), Y₇ may be C(R₄₇), and Y₈ may be C(R₄₈);
in Formulae 2A-1, 2A-2, 2A-4, 2A-5, 2A-6, 2A-8, 2A-9, 2A-10, 2A-12, 2A-13, 2A-14, and 2A-16, Y₁ may be C(R₄₁), Y₄ may be C(R₄₄), Y₅ may be N, Y₆ may be C(R₄₆), Y₇ may be C(R₄₇), and Y₈ may be C(R₄₈);
in Formulae 2A-1, 2A-2, 2A-4, 2A-5, 2A-6, 2A-8, 2A-9, 2A-10, 2A-12, 2A-13, 2A-14, and 2A-16, Y₁ may be C(R₄₁), Y₄ may be C(R₄₄), Y₅ may be C(R₄₅), Y₆ may be N, Y₇ may be C(R₄₇), and Y₈ may be C(R₄₈);
in Formulae 2A-1, 2A-2, 2A-4, 2A-5, 2A-6, 2A-8, 2A-9, 2A-10, 2A-12, 2A-13, 2A-14, and 2A-16, Y₁ may be N, Y₄ may be C(R₄₄), Y₅ may be N, Y₆ may be C(R₄₆), Y₇ may be C(R₄₇), and Y₈ may be C(R₄₈);
in Formulae 2A-1, 2A-2, 2A-4, 2A-5, 2A-6, 2A-8, 2A-9, 2A-10, 2A-12, 2A-13, 2A-14, and 2A-16, Y₁ may be N, Y₄ may be C(R₄₄), Y₅ may be C(R₄₅), Y₆ may be N, Y₇ may be C(R₄₇), and Y₈ may be C(R₄₈);
in Formulae 2A-3, 2A-7, 2A-11, and 2A-15, Y₃ may be N, Y₄ may be C(R₄₄), Y₅ may be C(R₄₅), Y₆ may be C(R₄₆), Y₇ may be C(R₄₇), and Y₈ may be C(R₄₈);
in Formulae 2A-3, 2A-7, 2A-11, and 2A-15, Y₃ may be C(R₄₃), Y₄ may be C(R₄₄), Y₅ may be N, Y₆ may be C(R₄₆), Y₇ may be C(R₄₇), and Y₈ may be C(R₄₈);
in Formulae 2A-3, 2A-7, 2A-11, and 2A-15, Y₃ may be C(R₄₃), Y₄ may be C(R₄₄), Y₅ may be C(R₄₅), Y₆ may be N, Y₇ may be C(R₄₇), and Y₈ may be C(R₄₈);
in Formulae 2A-3, 2A-7, 2A-11, and 2A-15, Y₃ may be N, Y₄ may be C(R₄₄), Y₅ may be N, Y₆ may be C(R₄₆), Y₇ may be C(R₄₇), and Y₈ may be C(R₄₈);
in Formulae 2A-3, 2A-7, 2A-11, and 2A-15, Y₃ may be N, Y₄ may be C(R₄₄), Y₅ may be C(R₄₅), Y₆ may be N, Y₇ may be C(R₄₇), and Y₈ may be C(R₄₈), but they are not limited thereto.

In this regard, a maximum luminance wavelength decreases in this following order: i) an organometallic compound using the ligand represented by Formula 2A-4, 2A-8, 2A-12 or 2A-16 ii) an organometallic compound using the ligand represented by Formula 2A-2, 2A-6, 2A-10 or 2A-14 iii) an organometallic compound using the ligand represented by Formula 2A-3, 2A-7, 2A-11 or 2A-15 and iv) an organometallic compound using the ligand represented by Formula 2A-1, 2A-5, 2A-9 or 2A-13. That is, a maximum luminance wavelength of the organometallic compound using the ligand represented by Formula 2A-1, 2A-5, 2A-9 or 2A-13 among Formulae 2A-1 to 2A-16 is the smallest.

In some embodiments, L₁ in Formula 1 may be selected from ligands represented by Formulae 2AA-1, 2AA-2, 2AA-3, 2AA-4 and 2AB below. When L₁ in Formula 1 is selected from ligands represented by Formulae 2AA-1 and 2AB, an organic light-emitting device using the organometallic compound represented by Formula 1 may have high efficiency and a long life span.

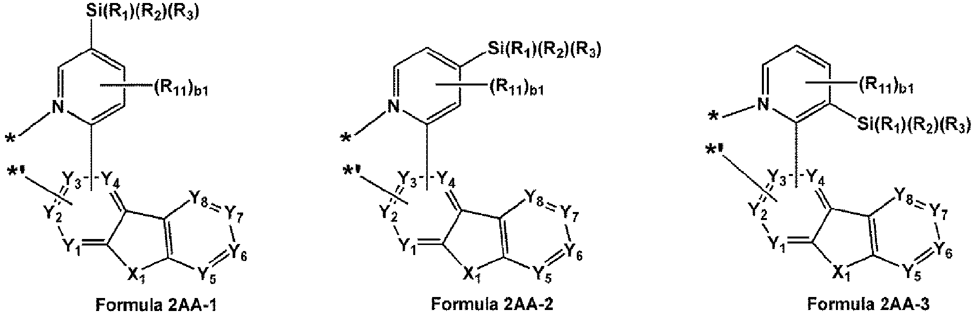

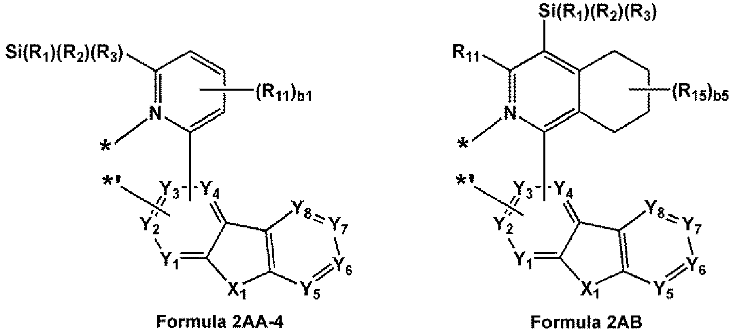

Regarding Formulae 2AA-1, 2AA-2, 2AA-3, 2AA-4, and 2AB, R₁ to R₃, X₁, Y₁ to Y₈, R₁₁, and b1 are already described above, R₁₅ may be understood by referring to the description of R₁₁, b5 is an integer selected from 0 to 8, and each of * and *' indicates a binding site to M in Formula 1.

For example, in Formulae 2A-1 to 2A-16, 2AA-1, 2AA-2, 2AA-3, 2AA-4, and 2AB,
R₁ to R₃ may be each independently selected from
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, and -Si(Q₅₁)(Q₅₂)(Q₅₃); and
an n-propyl group, an isopropyl group, an n-butyl group, an isobutyl group, a sec-sec-butyl group, a tert-butyl group, an n-pentyl group, an isopentyl group, a sec-pentyl a tert-pentyl group, a phenyl group, and a naphthyl group, each substituted with at least selected from a deuterium, a C₁-C₁₀ alkyl group, and a phenyl group;
Q₅₁ to Q₅₃ may be each independently selected from
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group,
X₁ may be selected from O, S, S(=O)₂, N(R₂₁), and Si(R₂₂)(R₂₃),
Y₁ to Y₈ are aleady described above,
R₁₁, R₁₅, R₂₁ to R₂₃ and R₄₁ to R₄₈ may be each independently selected from
a hydrogen, a deuterium, -F, a cyano group, a nitro group, -SF₅, a methyl group, an ethyl group, an n-propyl group, an isopropyl group, an n-butyl group, an isobutyl group, a sec-butyl group, a tert-butyl group, an n-pentyl group, an isopentyl group, a sec-pentyl a tert-pentyl group, an n-hexyl group, an isohexyl group, a sec-hexyl group, a tert-hexyl group, an n-heptyl group, an isoheptyl group, a sec-heptyl group, a tert-heptyl group, an n-n-octyl group, an isooctyl group, a sec-octyl group, a tert-octyl group, an n-nonyl group, an isononyl group, a sec-nonyl group, a tert-nonyl group, an n-decyl group, an isodecyl group, sec-decyl group, a tert-decyl group, a methoxy group, an ethoxy group, a propoxy group, a butoxy group, a pentoxy group, a cyclopentyl group, a cyclohexyl group, a cycloheptyl a cyclooctyl group, an adamantanyl, norbornanyl group, a norbornenyl, a cyclopentenyl group, a cyclohexenyl group, a cycloheptenyl group, a phenyl group, a naphthyl group, a pyridinyl group, and a pyrimidinyl group;
a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a pyridinyl group, and a pyrimidinyl group, each substituted with at least one selected from a deuterium, -F, -CD₃, -CD₂H, -CDH₂, -CF₃, -CF₂H, -CFH₂, a cyano group, a nitro group, a C₁-C₁₀ alkyl group, a C₁-C₁₀ alkoxy group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a pyridinyl group, and a pyrimidinyl group; and

-B(Q₆)(Q₇) and -P(=O)(Q₈)(Q₉),

Q₆ to Q₉ may be each independently selected from
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, and a phenyl group, and a naphthyl group, each substituted with at least one selected from a deuterium and a C₁-C₁₀ alkyl group,
b1 may be an integer selected from 0 to 3,
b4 may be 1 or 2,
b5 may be an integer selected from 0 to 8, but they are not limited thereto.

In some embodiments, L₁ in Formula 1 may be selected from ligands represented by Formulae 2A(1) to 2A(40) below: 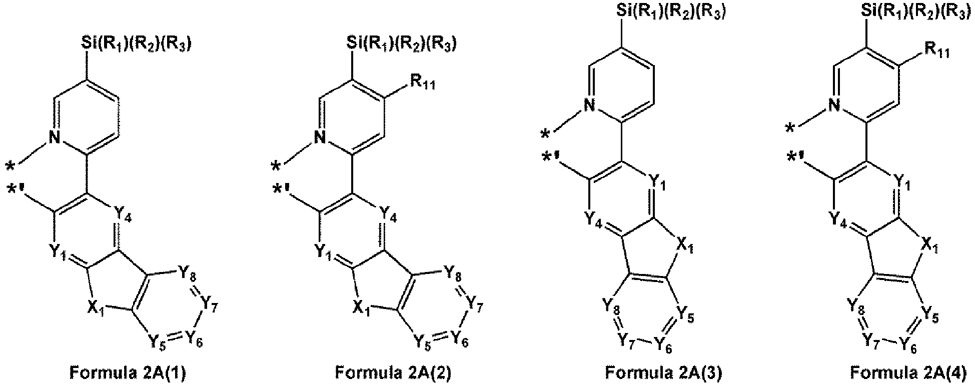 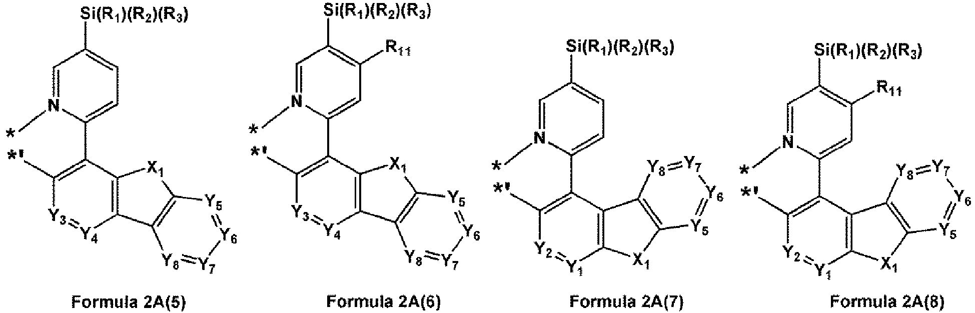 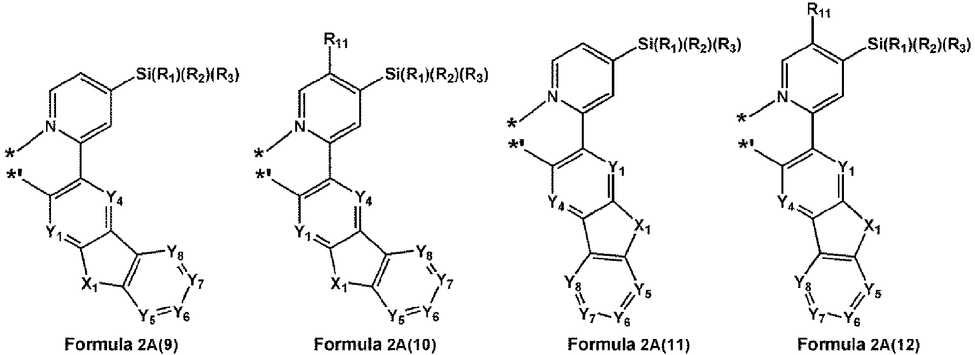 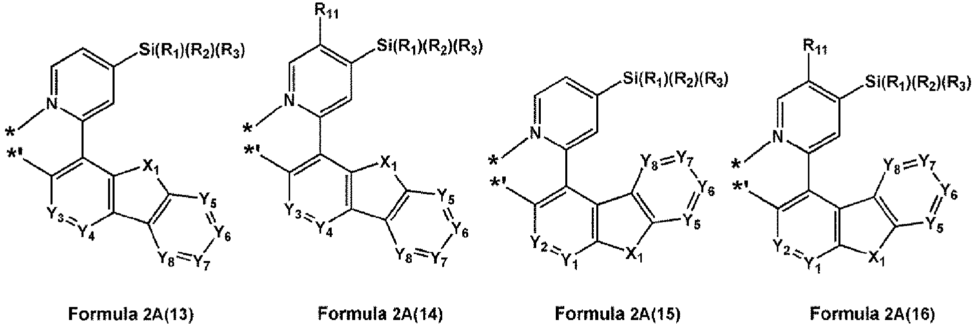 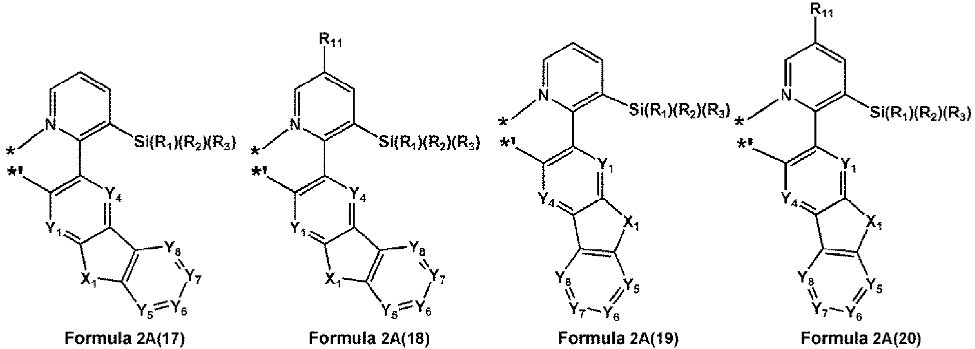 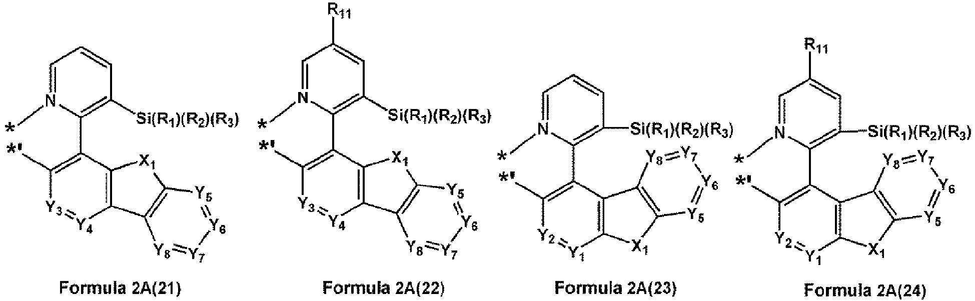 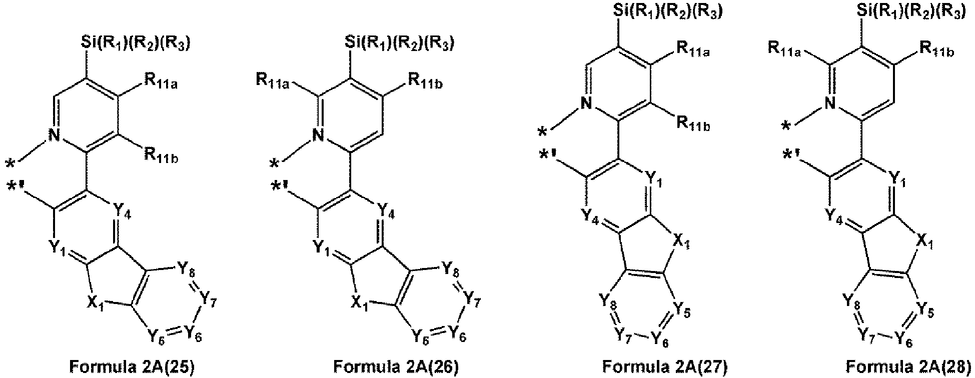 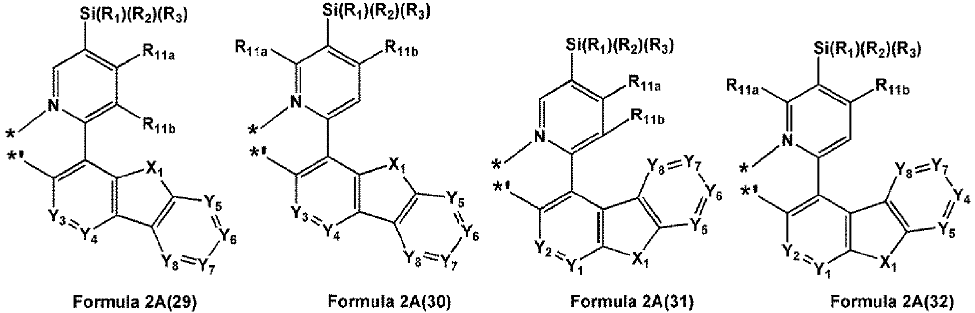 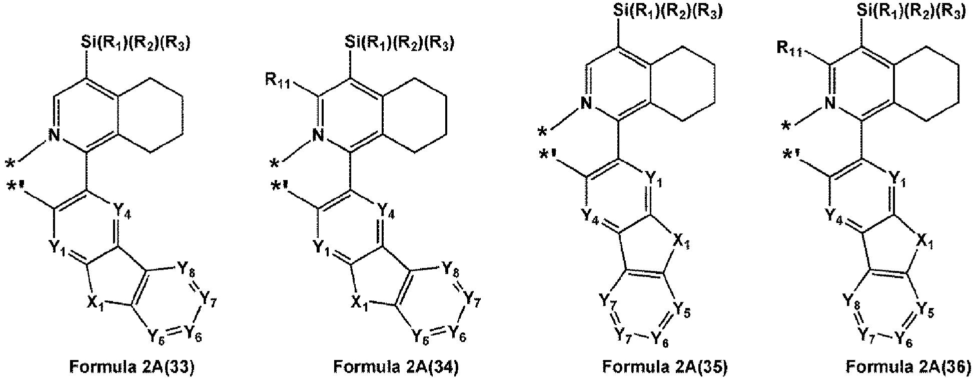 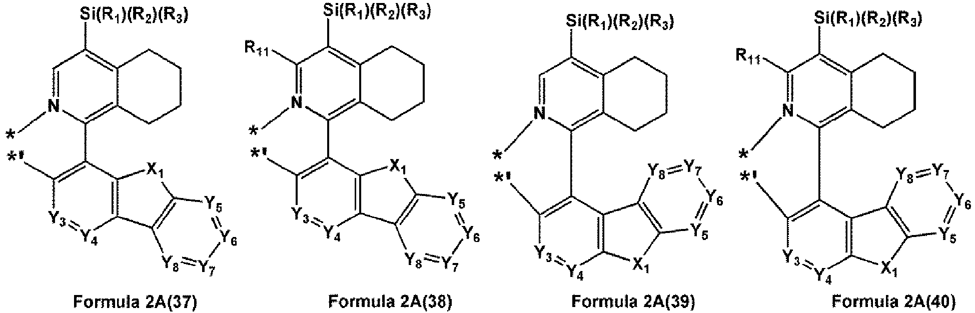 Regarding Formulae 2A(1) to 2A(40), R₁ to R₃, X₁, Y₁ to Y₈, and R₁₁ are already described above, R₁₁ₐ and R_{11b} may be understood by referring to the description of R₁₁, and each of * and *' indicates a binding site to M in Formula 1, provided that R₁₁, R₁₁ₐ, and R_{11b} are not hydrogen.

In some embodiments,
in Formulae 2A(1) to 2A(40), Y₁ may be C(R₄₁), Y₂ may be C(R₄₂), Y₃ may be C(R₄₃), Y₄ may be C(R₄₄), Y₅ may be C(R₄₅), Y₆ may be C(R₄₆), Y₇ may be C(R₄₇), and Y₈ may be C(R₄₈);
in Formulae 2A(1) to 2(4), 2A(7) to 2A(12), 2A(15) to 2A(20), 2A(23) to 2A(28), and 2A(31) to 2A(36), Y₁ may be N, Y₄ may be C(R₄₄), Y₅ may be C(R₄₅), Y₆ may be C(R₄₆), Y₇ may be C(R₄₇), and Y₈ may be C(R₄₈);
in Formulae 2A(1) to 2(4), 2A(7) to 2A(12), 2A(15) to 2A(20), 2A(23) to 2A(28), and 2A(31) to 2A(36), Y₁ may be C(R₄₁), Y₄ may be C(R₄₄), Y₅ may be N, Y₆ may be C(R₄₆), Y₇ may be C(R₄₇), and Y₈ may be C(R₄₈);
in Formulae 2A(1) to 2(4), 2A(7) to 2A(12), 2A(15) to 2A(20), 2A(23) to 2A(28), and 2A(31) to 2A(36), Y₁ may be C(R₄₁), Y₄ may be C(R₄₄), Y₅ may be C(R₄₅), Y₆ may be N, Y₇ may be C(R₄₇), and Y₈ may be C(R₄₈);
in Formulae 2A(1) to 2(4), 2A(7) to 2A(12), 2A(15) to 2A(20), 2A(23) to 2A(28), and 2A(31) to 2A(36), Y₁ may be N, Y₄ may be C(R₄₄), Y₅ may be N, Y₆ may be C(R₄₆), Y₇ may be C(R₄₇), and Y₈ may be C(R₄₈);
in Formulae 2A(1) to 2(4), 2A(7) to 2A(12), 2A(15) to 2A(20), 2A(23) to 2A(28), and 2A(31) to 2A(36), Y₁ may be N, Y₄ may be C(R₄₄), Y₅ may be C(R₄₅), Y₆ may be N, Y₇ may be C(R₄₇), and Y₈ may be C(R₄₈);
in Formulae 2A(5), 2A(6), 2A(13), 2A(14), 2A(21), 2A(22), 2A(29), 2A(30), 2A(37), and 2A(38), Y₃ may be N, Y₄ may be C(R₄₄), Y₅ may be C(R₄₅), Y₆ may be C(R₄₆), Y₇ may be C(R₄₇), and Y₈ may be C(R₄₈);
in Formula 2A(5), 2A(6), 2A(13), 2A(14), 2A(21), 2A(22), 2A(29), 2A(30), 2A(37), and 2A(38), Y₃ may be C(R₄₃), Y₄ may be C(R₄₄), Y₅ may be N, Y₆ may be C(R₄₆), Y₇ may be C(R₄₇), and Y₈ may be C(R₄₈);
in Formulae 2A(5), 2A(6), 2A(13), 2A(14), 2A(21), 2A(22), 2A(29), 2A(30), 2A(37), 2A(38), Y₃ may be C(R₄₃), Y₄ may be C(R₄₄), Y₅ may be C(R₄₅), Y₆ may be N, Y₇ may be C(R₄₇), and Y₈ may be C(R₄₈);
in Formulae 2A(5), 2A(6), 2A(13), 2A(14), 2A(21), 2A(22), 2A(29), 2A(30), 2A(37), and 2A(38), Y₃ may be N, Y₄ may be C(R₄₄), Y₅ may be N, Y₆ may be C(R₄₆), Y₇ may be C(R₄₇), and Y₈ may be C(R₄₈); or
in Formulae 2A(5), 2A(6), 2A(13), 2A(14), 2A(21), 2A(22), 2A(29), 2A(30), 2A(37), and 2A(38), Y₃ may be N, Y₄ may be C(R₄₄), Y₅ may be C(R₄₅), Y₆ may be N, Y₇ may be C(R₄₇), and Y₈ may be C(R₄₈), but they are not limited thereto.

For example, in Formulae 2A(1) to 2A(40),
R₁ to R₃ may be each independently selected from
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, and -Si(Q₅₁)(Q₅₂)(Q₅₃); and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group;
Q₅₁ to Q₅₃ may be each independently selected from
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group,
X₁ may be selected from O, S, S(=O)₂, N(R₂₁), and Si(R₂₂)(R₂₃),
Y₁ to Y₈ are already described above,
R₁₁, R₁₁ₐ, R_{11b}, R₂₁ to R₂₃ and R₄₁ to R₄₈ are each independently selected from
a hydrogen, a deuterium, -F, a cyano group, a nitro group, -SF₅, a methyl group, an ethyl group, an n-propyl group, an isopropyl group, an n-butyl group, an isobutyl group, a sec-butyl group, a tert-butyl group, an n-pentyl group, an isopentyl group, a sec-pentyl a tert-pentyl group, an n-hexyl group, an isohexyl group, a sec-hexyl group, a tert-hexyl group, an n-heptyl group, an isoheptyl group, a sec-heptyl group, a tert-heptyl group, an n-n-octyl group, an isooctyl group, a sec-octyl group, a tert-octyl group, an n-nonyl group, an isononyl group, a sec-nonyl group, a tert-nonyl group, an n-decyl group, an isodecyl group, sec-decyl group, a tert-decyl group, a methoxy group, an ethoxy group, a propoxy group, a butoxy group, a pentoxy group, a cyclopentyl group, a cyclohexyl group, a cycloheptyl a cyclooctyl group, an adamantanyl, norbornanyl group, a norbornenyl, a cyclopentenyl group, a cyclohexenyl group, a cycloheptenyl group, a phenyl group, a naphthyl group, a pyridinyl group, and a pyrimidinyl group;
a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a pyridinyl group, and a pyrimidinyl group, each substituted with at least one selected from a deuterium, -F, -CD₃, -CD₂H, -CDH₂, -CF₃, -CF₂H, -CFH₂, a cyano group, a nitro group, a C₁-C₁₀ alkyl group, a C₁-C₁₀ alkoxy group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a pyridinyl group, and a pyrimidinyl group; and
-B(Q₆)(Q₇), and -P(=O)(Q₈)(Q₉) (provided that, R₁₁, R₁₁ₐ, and R_{11b} in Formulae 2A(1) to 2A(40) is not a hydrogen),
Q₆ to Q₉ may be each independently selected from
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium and a C₁-C₁₀ alkyl group, but embodiments are not limited thereto.

In some embodiments, regarding Formulae 2A(1) to 2A(40),
R₁ to R₃ may be each independently selected from
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, and -Si(Q₅₁)(Q₅₂)(Q₅₃); and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group;
Q₅₁ to Q₅₃ may be each independently selected from
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group,
X₁ may be selected from O, S, S(=O)₂, N(R₂₁), and Si(R₂₂)(R₂₃),
Y₁ to Y₈ are already described above,
R₁₁, R₁₁ₐ, R_{11b} and R₄₁ to R₄₈ may be selected from a deuterium, -F, a cyano group, a nitro group, -SF₅, -CH₃, -CD₃, -CD₂H, -CDH₂, -CF₃, -CF₂H, -CFH₂, groups represented by Formulae 9-1 to 9-17, and groups represented by Formulae 10-1 to 10-30,
R₂₁ to R₂₃ are each independently selected from
a C₁-C₂₀ alkyl group, a C₁-C₂₀ alkoxy group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyridinyl group, a pyrimidinyl group, and a triazinyl group;
a C₁-C₂₀ alkyl group and a C₁-C₂₀ alkoxy group, each substituted with at least one selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic group or a salt thereof, and a phosphoric acid group or a salt thereof; and
a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyridinyl group, a pyrimidinyl group, and a triazinyl group, each substituted with at least one selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, and a naphthyl group,
but are not limited thereto.

L₂ in Formula 1 may be selected from ligands represented by Formulae 3A to 3G: 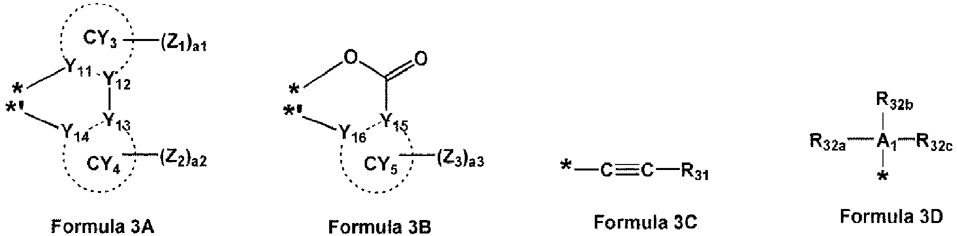 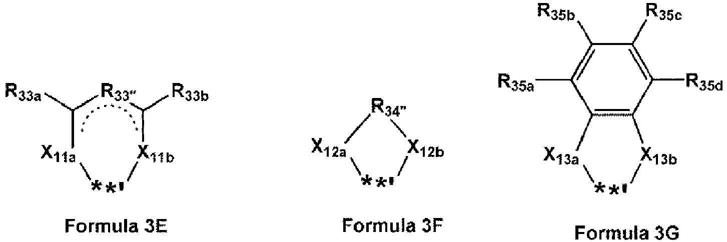
wherein in Formulae 3A to 3G,
Y₁₁ to Y₁₆ are each independently carbon (C) or nitrogen (N), Y₁₁ and Y₁₂ are linked to each other by a single bond or a double bond, Y₁₃ and Y₁₄ are linked to each other by a single bond or a double bond, and Y₁₅ and Y₁₆ are linked to each other by a single bond or a double bond,
CY₃ to CY₅ are each independently selected from a C₅-C₆₀ carbocyclic group and a C₂-C₆₀ heterocyclic group ("a monocyclic group" or "polycyclic group", respectively).
a1 to a3 are each independently an integer selected from 1 to 5 and CY₃ and CY₄ may be optionally additionally linked to each other via an organic linking group,
A₁ is P or As;
X₁₁ₐ, X_{11b}, X₁₂ₐ, X_{12b}, X₁₃ₐ, and X_{13b} may be each independently selected from N, O, N(R₃₄), P(R₃₅)(R₃₆), and As(R₃₇)(R₃₈) (provided that none of X₁₂ₐ, X_{12b}, X₁₃ₐ, and X_{13b} are N or O);
R_{33"} and R_{34"} are each independently selected from a single bond, a double bond, a substituted or unsubstituted C₁-C₅ alkylene group, a substituted or unsubstituted C₂-C₅ alkenylene group, and a substituted or unsubstituted C₆-C₁₀ arylene group;
Z₁ to Z₃, R₃₁, R₃₂ₐ, R_{32b}, R_{32c}, R₃₃ₐ, R_{33b}, R₃₄ to R₃₈, R₃₅ₐ, R_{35b}, R_{35c}, and R_{35d} are independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - -N(Q₁)(Q₂), -Si(Q₃)(Q₄)(Q₅), -B(Q₆)(Q₇), and -P(=O)(Q₈)(Q₉),
* and *' each indicate binding sites to M in Formula 1;
at least one of substituents of the substituted C₁-C₅ alkylene group, substituted C₂-C₅ alkenylene group, substituted C₆-C₁₀ arylene group, substituted C₁-C₆₀ alkyl group, substituted C₂-C₆₀ alkenyl group, substituted C₂-C₆₀ alkynyl group, substituted C₁-C₆₀ alkoxy group, substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₆-C₆₀ aryloxy group, substituted C₆-C₆₀ arylthio group, substituted C₁-C₆₀ heteroaryl group, substituted monovalent non-aromatic condensed polycyclic group and substituted monovalent non-aromatic condensed heteropolycyclic group is selected from
a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from a deuterium, -F, -Cl, -Br, -I, - -CD₃, -CD₂H, -CDH₂, -CF₃, -CF₂H, -CFH₂, a hydroxyl group, a cyano group, a nitro group, amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -B(Q₁₆)(Q₁₇), and -P(=O)(Q₁₈)(Q₁₉) ;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -B(Q₂₆)(Q₂₇), and -P(=O)(Q₂₈)(Q₂₉); and

   -N(Q₃₁)(Q₃₂), -Si(Q₃₃)(Q₃₄)(Q₃₅), -B(Q₃₆)(Q₃₇), and -P(=O)(Q₃₈)(Q₃₉);
wherein Q₁ to Q₉, Q₁₁ to Q₁₉, Q₂₁ to Q₂₉, and Q₃₁ to Q₃₉ may be each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group.

According to an embodiment, CY₃ to CY₅ in Formulae 3A and 3B may be each independently selected from a benzene, a naphthalene, a fluorene, a spiro-fluorene, an indene, a pyrrole, a thiophene, a furan, an imidazole, a pyrazole, a thiazole, an isothiazole, an oxazole, an isoxazole, a pyridine, a pyrazine, a pyrimidine, a pyridazine, a quinoline, an isoquinoline, a benzoquinoline, a quinoxaline, a quinazoline, a carbazole, a benzoimidazole, a benzofuran, a benzothiophene, an isobenzothiophene, a benzoxazole, an isobenzoxazole, a triazole, a tetrazole, an oxadiazole, a triazine, a dibenzofuran, a dibenzothiophene, and 5,6,7,8-tetrahydroisoquinoline, but they are not limited thereto. In some embodiments, L₂ in Formula 1 may be selected from ligands represented by Formulae 3-1 to 3-111, but are not limited thereto: 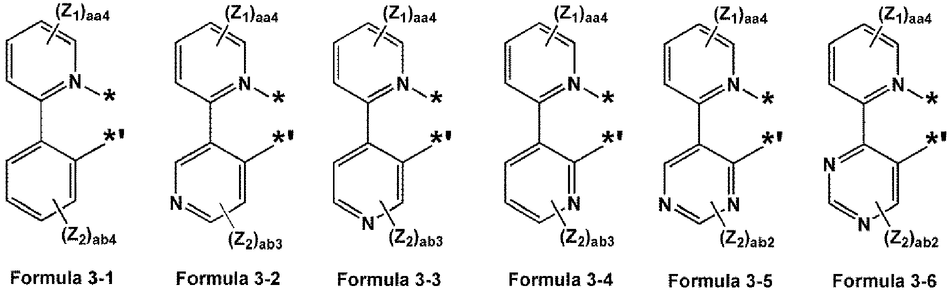 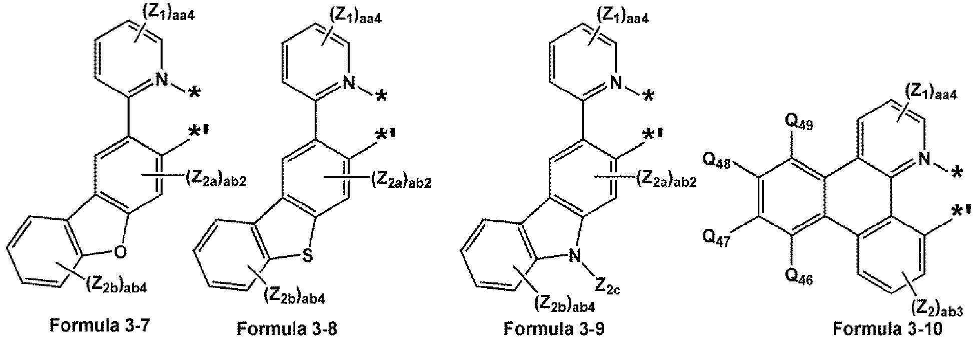 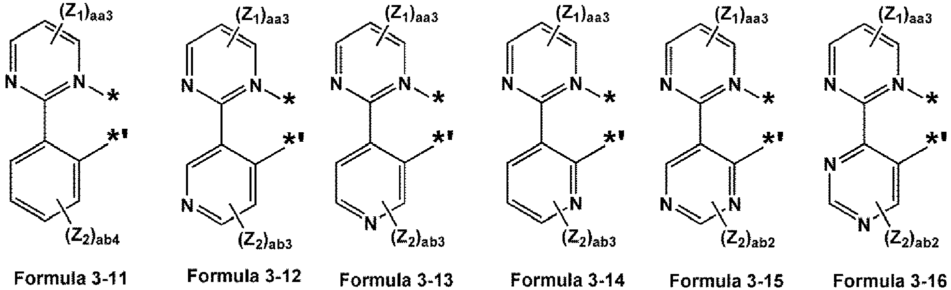 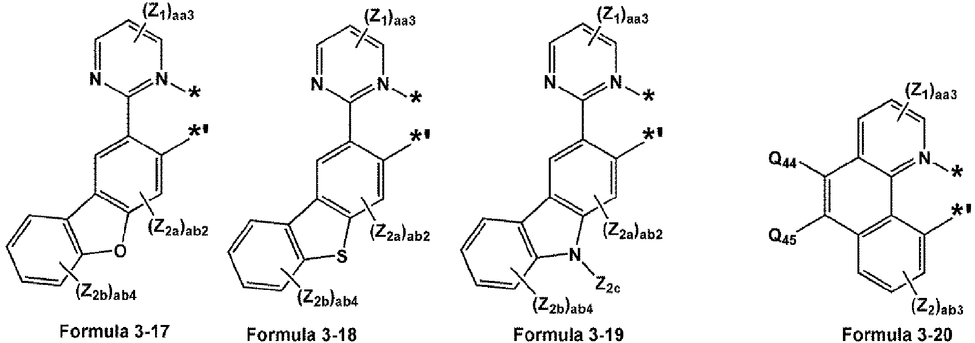 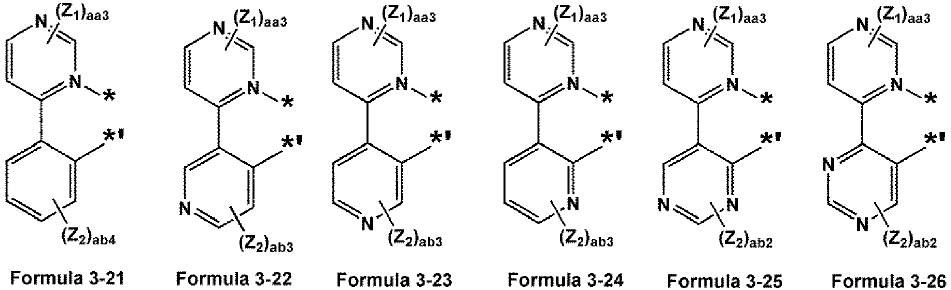 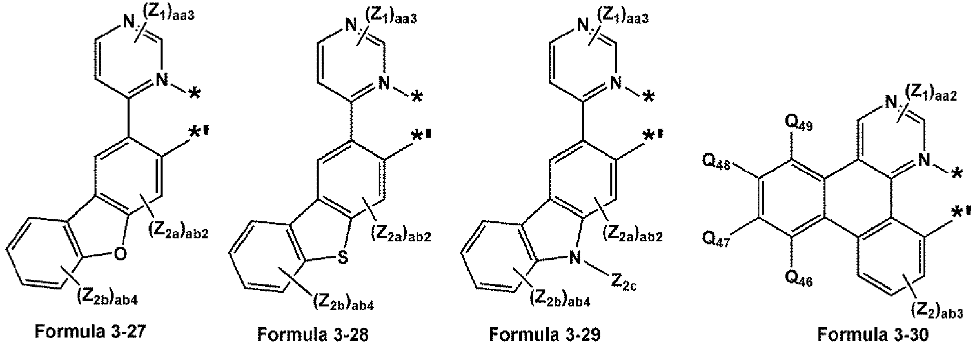 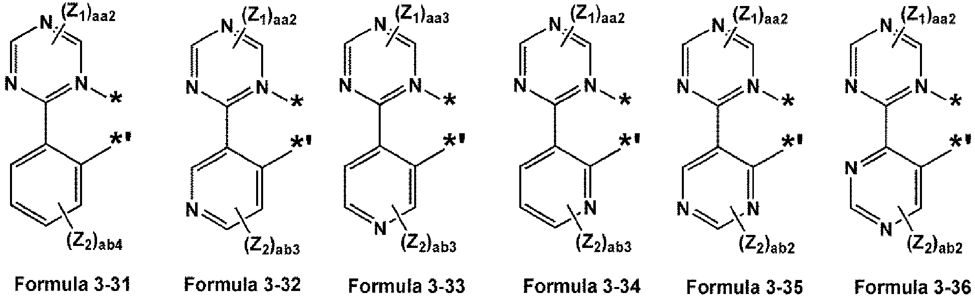 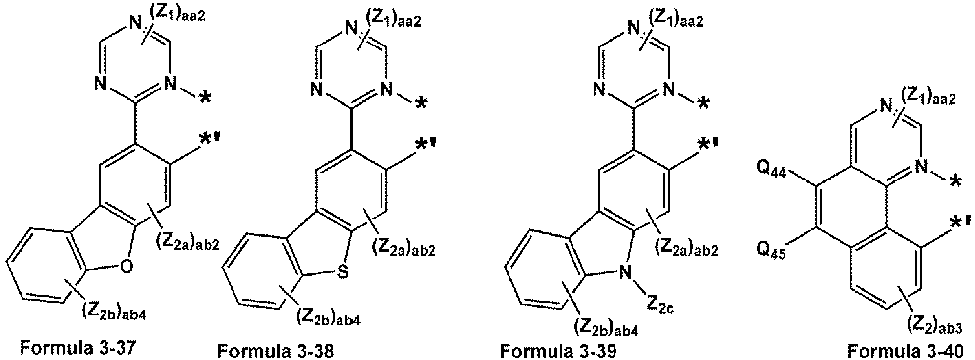 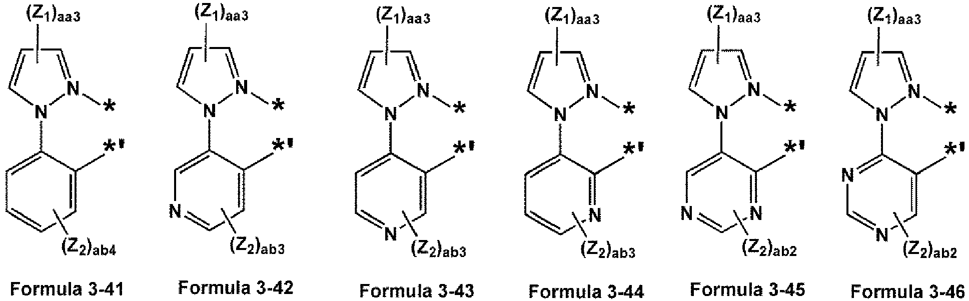 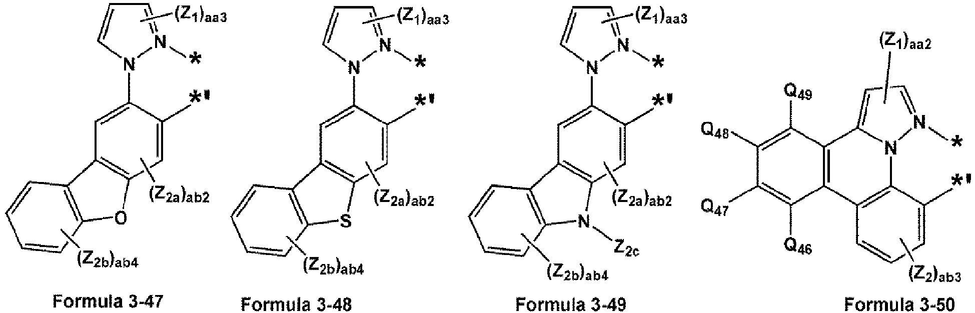 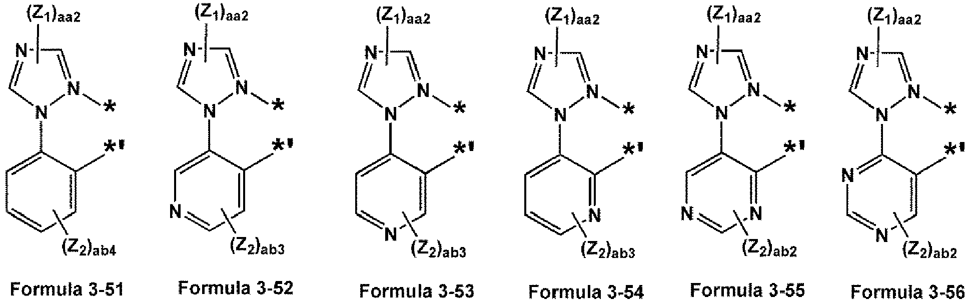 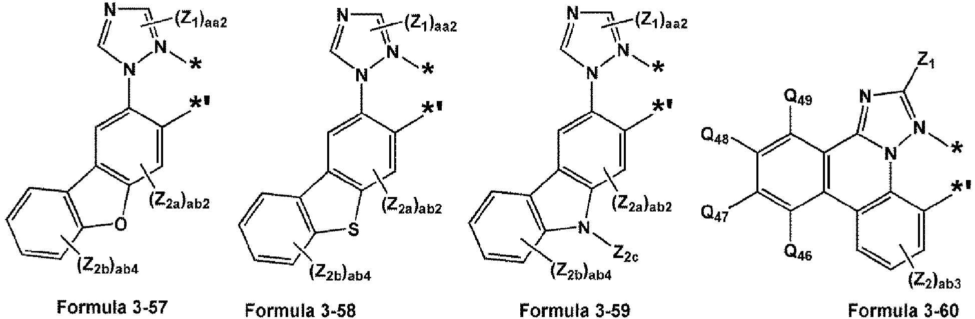 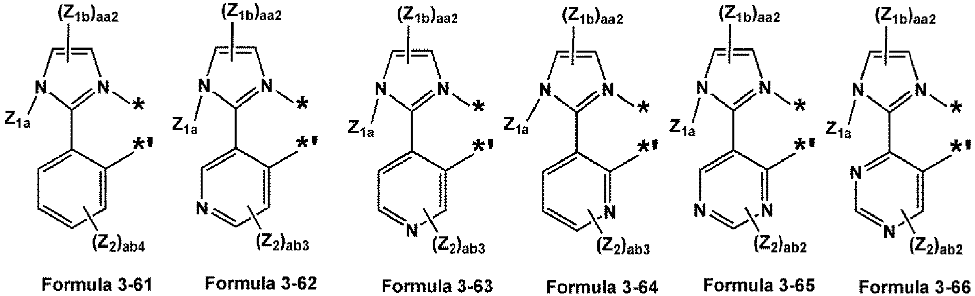 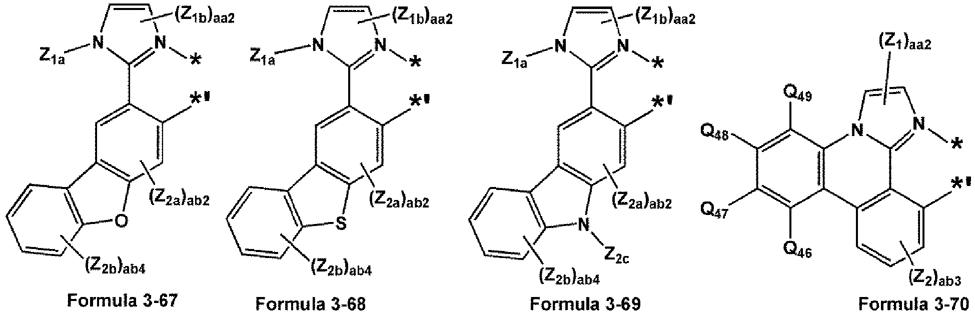 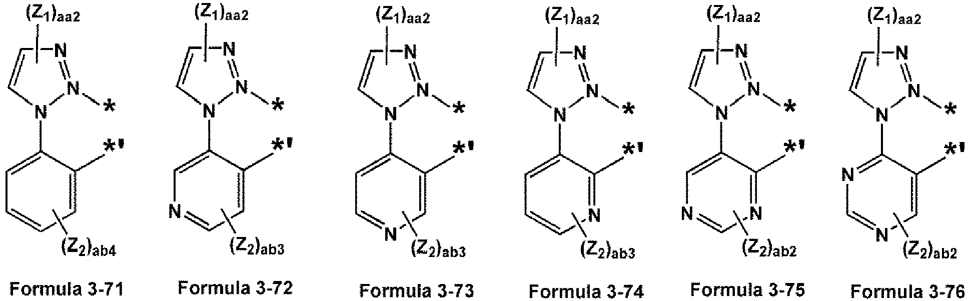 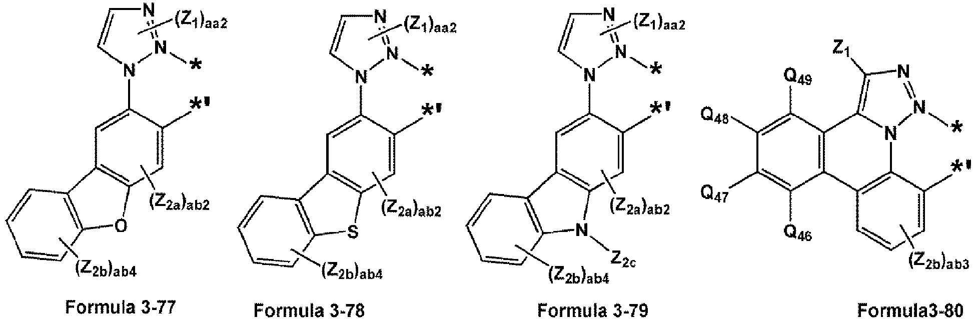 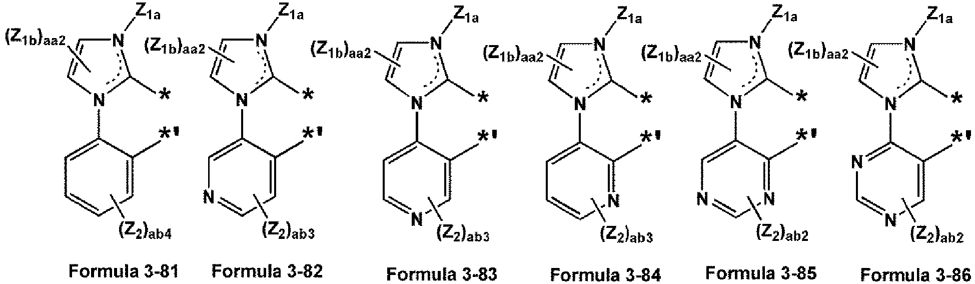 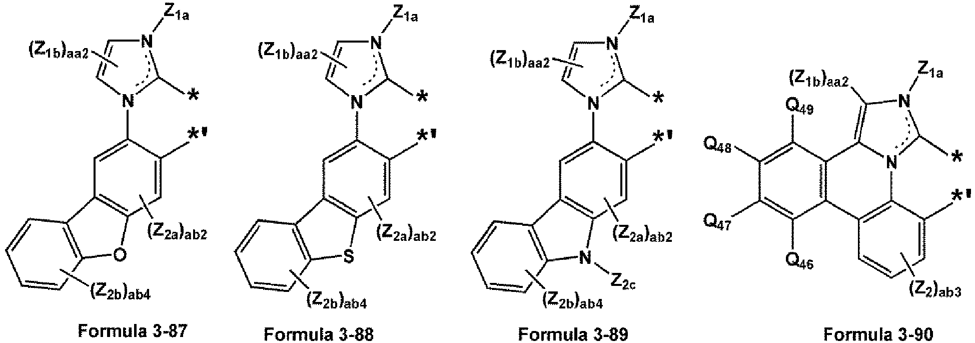 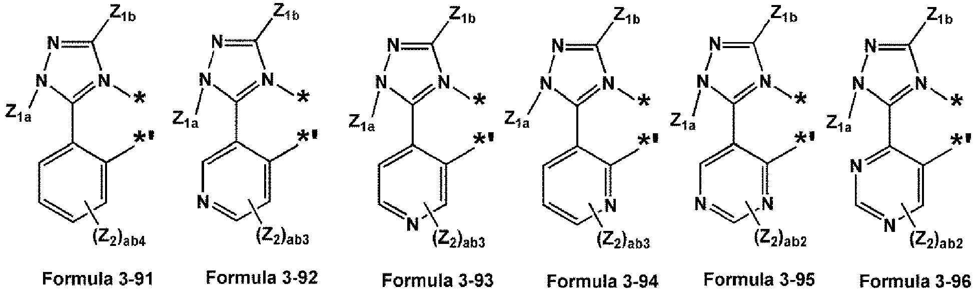 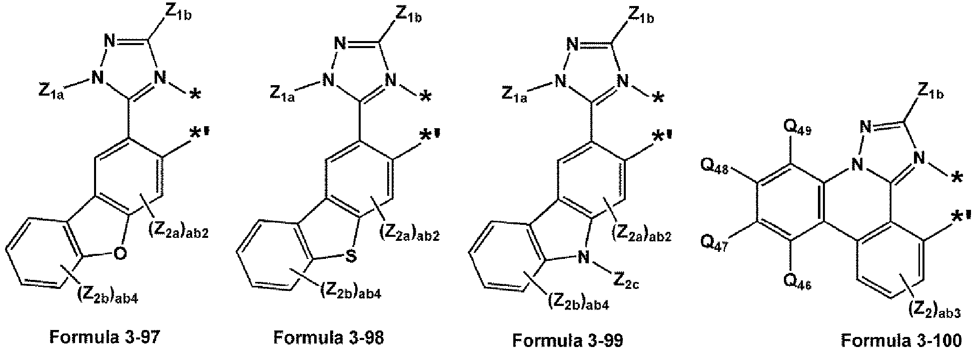 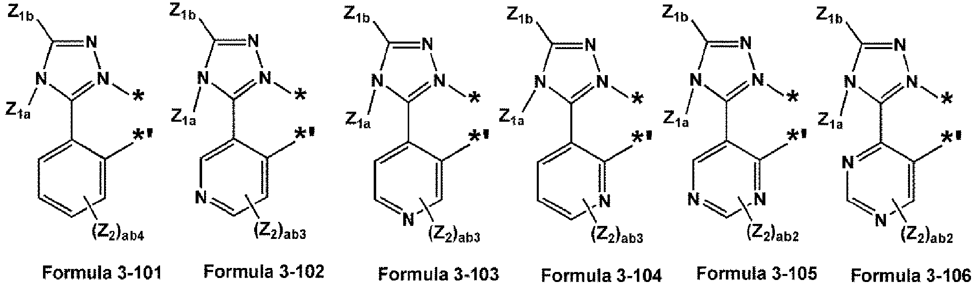 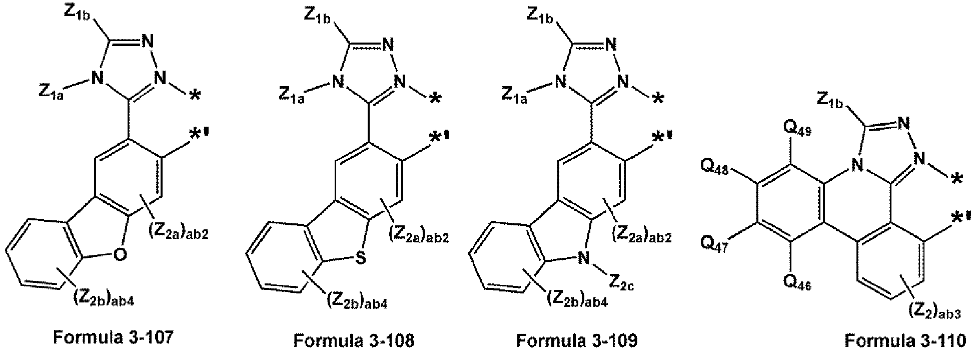 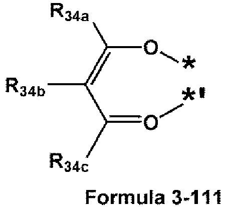
wherein in Formulae 3-1 to 3-111,
Z₁, Z₂, Z₁ₐ, Z_{1b}, Z₂ₐ, Z_{2b}, Z_{2c}, R₃₄ₐ, R_{34b}, and R_{34c} may be each independently selected from
a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, and a C₁-C₂₀ alkoxy group;
a C₁-C₂₀ alkyl group and a C₁-C₂₀ alkoxy group, each substituted with at least one selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl a pyridazinyl group, an isoindolyl group, an indolyl group, an indazolyl group, a purinyl a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, benzothiophenyl group, an isobenzothiazolyl group, a benzoxazolyl group, an isobenzoxazolyl group, a triazolyl group, a tetrazolyl group, an oxadiazolyl group, a group, a dibenzofuranyl group, a dibenzothiophenyl group, a benzocarbazolyl group, a dibenzocarbazolyl group, an imidazopyridinyl group, and an imidazopyrimidinyl group; and
-N(Q₁)(Q₂), -Si(Q₃)(Q₄)(Q₅), -B(Q₆)(Q₇), and -P(=O)(Q₈)(Q₉);
Q₁ to Q₉ and Q₄₄ to Q₄₉ may be each independently selected from
   -CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, and a phenyl group, and a naphthyl group, each substituted with at least one selected from a deuterium and a C₁-C₁₀ alkyl group,
aa2 and ab2 are each independently 1 or 2,
aa3 and ab3 are each independently selected from 1, 2, and 3,
aa4 and ab4 may be each independently selected from, 1,2,3, and 4, and
* and *' each indicate binding sites to M in Formula 1.

Z₁, Z₂, Z₁ₐ, Z_{1b}, Z₂ₐ, Z_{2b}, Z_{2c}, R₃₄ₐ, R_{34b}, and R_{34c} in Formulae 3-1 to 3-111 may be each independently selected from
a hydrogen, a deuterium, -F, a cyano group, a nitro group, -SF₅, a methyl group, an ethyl group, an n-propyl group, an isopropyl group, an n-butyl group, an isobutyl group, a sec-butyl group, a tert-butyl group, an n-pentyl group, an isopentyl group, a sec-pentyl a tert-pentyl group, an n-hexyl group, an isohexyl group, a sec-hexyl group, a tert-hexyl group, an n-heptyl group, an isoheptyl group, a sec-heptyl group, a tert-heptyl group, an n-n-octyl group, an isooctyl group, a sec-octyl group, a tert-octyl group, an n-nonyl group, an isononyl group, a sec-nonyl group, a tert-nonyl group, an n-decyl group, an isodecyl group, sec-decyl group, a tert-decyl group, a methoxy group, an ethoxy group, a propoxy group, a butoxy group, a pentoxy group, a cyclopentyl group, a cyclohexyl group, a cycloheptyl a cyclooctyl group, an adamantanyl, norbornanyl group, a norbornenyl, a cyclopentenyl group, a cyclohexenyl group, a cycloheptenyl group, a phenyl group, a naphthyl group, a pyridinyl group, and a pyrimidinyl group;
a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an isohexyl a sec-hexyl group, a tert-hexyl group, an n-heptyl group, an isoheptyl group, a sec-heptyl group, a tert-heptyl group, an n-octyl group, an isooctyl group, a sec-octyl group, a tert-group, an n-nonyl group, an isononyl group, a sec-nonyl group, a tert-nonyl group, an n-n-decyl group, an isodecyl group, a sec-decyl group, a tert-decyl group, a methoxy group, ethoxy group, a propoxy group, a butoxy group, a pentoxy group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a pyridinyl group, and a pyrimidinyl group, each substituted with at least one selected from a deuterium, -F, -CD₃, -CD₂H, - -CF₃, -CF₂H, -CFH₂, a cyano group, a nitro group, a C₁-C₁₀ alkyl group, a C₁-C₁₀ alkoxy group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a pyridinyl group, and a pyrimidinyl group;

-N(Q₁)(Q₂), -Si(Q₃)(Q₄)(Q₅), -B(Q₆)(Q₇), and -P(=O)(Q₈)(Q₉);

Q₁ to Q₉ may be each independently selected from
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium and a C₁-C₁₀ alkyl group, but embodiments are not limited thereto.

In some embodiments, L₂ in Formula 1 may be selected from ligands represented by Formulae 3-1 (1) to 3-1 (59) below and Formula 3-111 above:

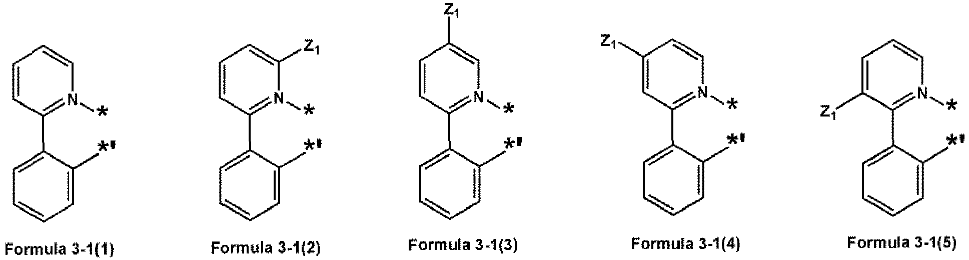

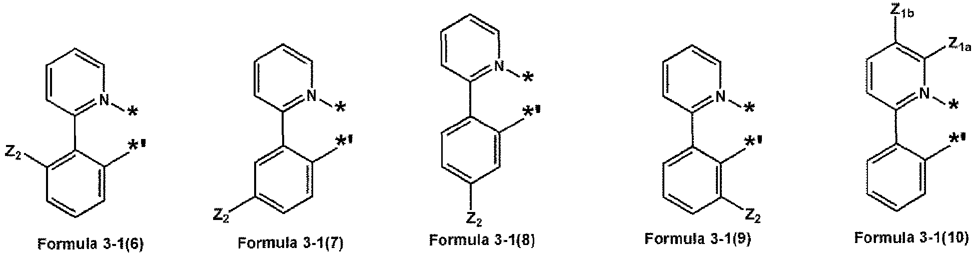

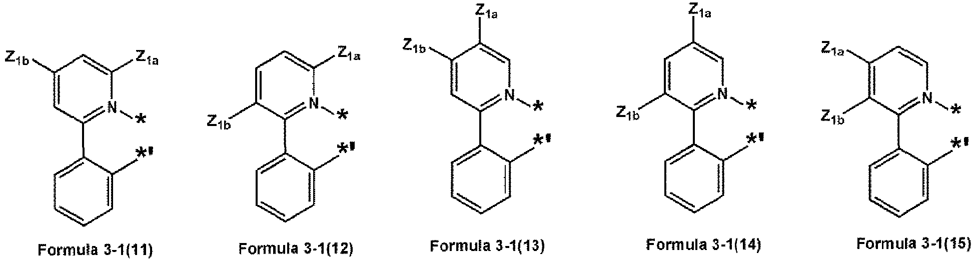

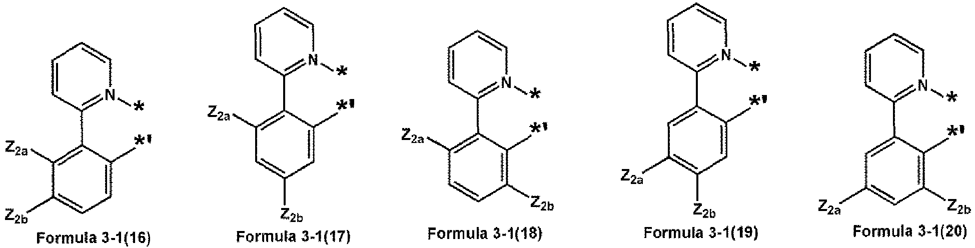

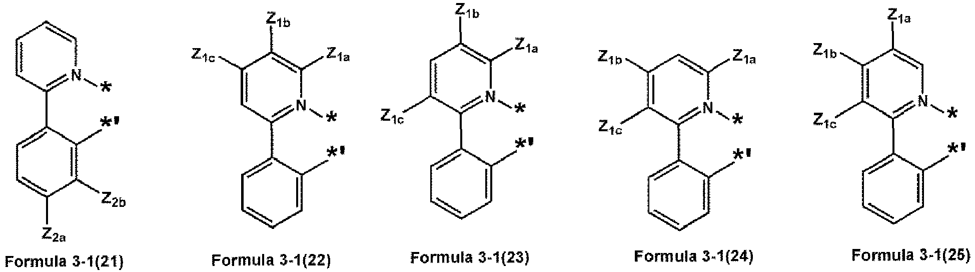

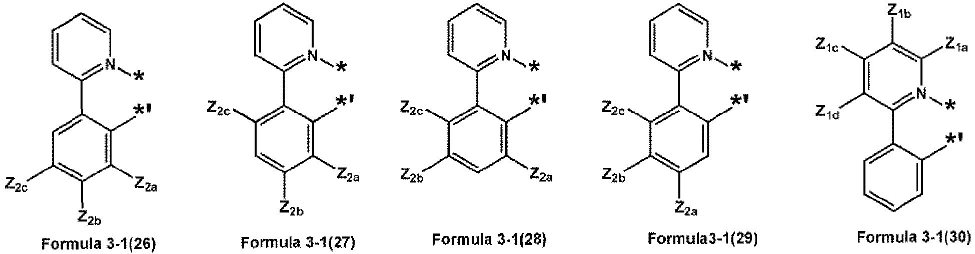

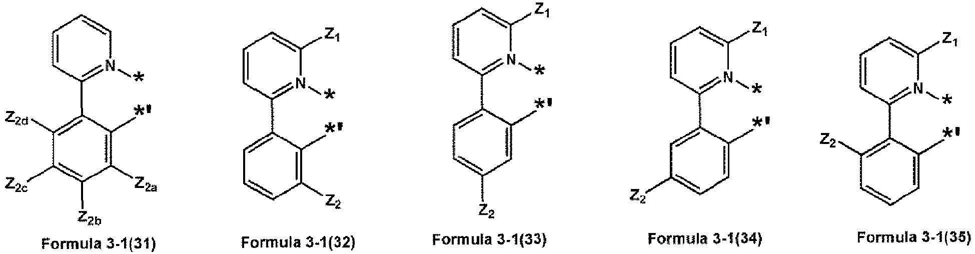

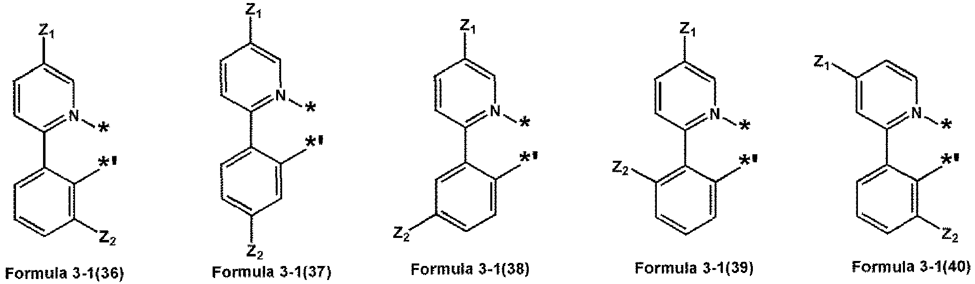

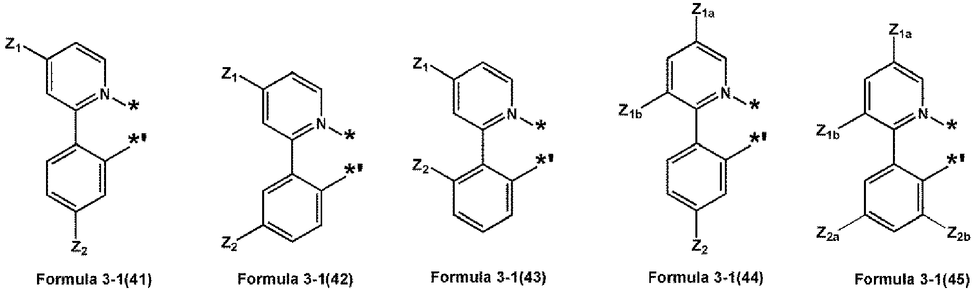

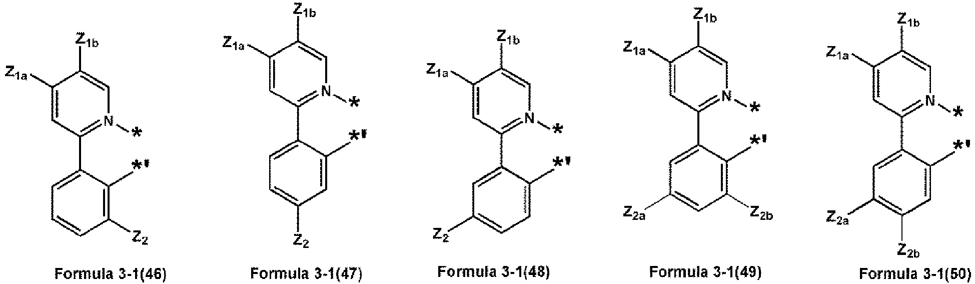

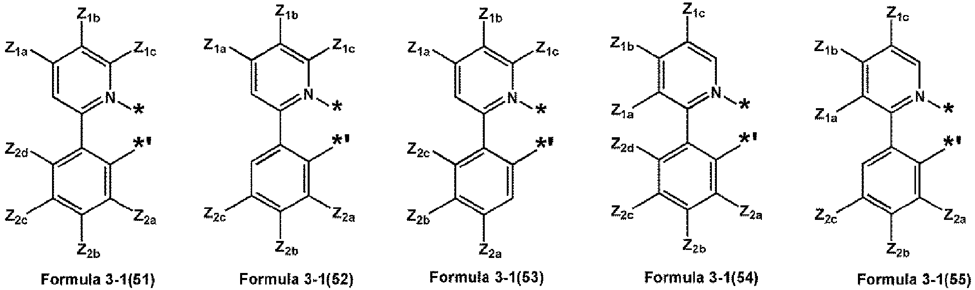

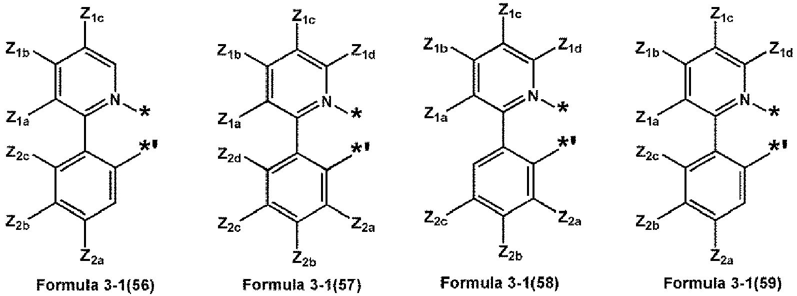

For example, in Formulae 3-1 (1) to 3-1 (59) and Formula 3-111:
Z₁, Z₂, Z₁ₐ, Z_{1b}, Z_{1c}, Z_{1d}, Z₂ₐ, Z_{2b}, Z_{2c}, Z_{2d}, R₃₄ₐ, R_{34b}, and R_{34c} are each selected from a deuterium, -F, a cyano group, a nitro group, -SF₅, -CH₃, -CD₃, -CD₂H, - -CF₃, -CF₂H, -CFH₂, -Si(Q₃)(Q₄)(Q₅), groups represented by Formulae 9-1 to 9-17, and groups represented by Formulae 10-1 to 10-30,
Q₃ to Q₅ may be each independently selected from
   -CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium and a C₁-C₁₀ alkyl group, and
* and *' are binding sites to M in Formula 1.

In some embodiments, in Formula 1, M is Ir and the sum of n1 and n2 is 3; or M is Pt and the sum of n1 and n2 is 2,
the organometallic compound represented by Formula 1 does not include an ionic group, and
L₁ in Formula 1 may be selected from ligands represented by Formulae 2A-1 to 2A-16, 2AA-1, 2AA-2, 2AA-3, 2AA-4, and 2AB, but embodiments are not limited thereto.
In some embodiments, in Formula 1, M is Ir and the sum of n1 and n2 is 3; or M is Pt and the sum of n1 and n2 is 2,
the organometallic compound represented by Formula 1 does not include an ionic group,
L₁ in Formula 1 is selected from ligands represented by Formulae 2A-1, 2A-5, 2AA-1 and 2AB, but embodiments are not limited thereto.
In some embodiments, in Formula 1, M is Ir and the sum of n1 and n2 is 3; or M is Pt and the sum of n1 and n2 is 2, the organometallic compound represented by Formula 1 is neutral, L₁ in Formula 1 is selected from ligands represented by Formulae 2A-1, 2A-5, 2AA-1, and 2AB, L₂ in Formula 1 is selected from ligands represented by Formulae 3-1 to 3-111 (for example, ligands represented by Formulae 3-1(1) to 3-1(59) and 3-111), but embodiments are not limited thereto.
In some embodiments, in Formula 1, M is Ir and the sum of n1 and n2 is 3; or M is Pt and the sum of n1 and n2 is 2,
the organometallic compound represented by Formula 1 does not include an ionic group, and
L₁ in Formula 1 is selected from ligands represented by Formulae 2A(1) to 2A(40), but embodiments are not limited thereto.
In some embodiments, in Formula 1, M is Ir and the sum of n1 and n2 is 3; or M is Pt and the sum of n1 and n2 is 2,
the organometallic compound represented by Formula 1 does not include an ionic group,
L₁ in Formula 1 is selected from ligands represented by Formulae 2A(1) to 2A(40), and
L₂ in Formula 1 is selected from ligands represented by Formulae 3-1 to 3-111 (for example, ligands represented by Formulae 3-1 (1) to 3-1 (59) and 3-111), but embodiments are not limited thereto

For example, the organometallic compound represented by Formula 1 may be one of Compounds 1 to 481 below, but is not limited thereto.

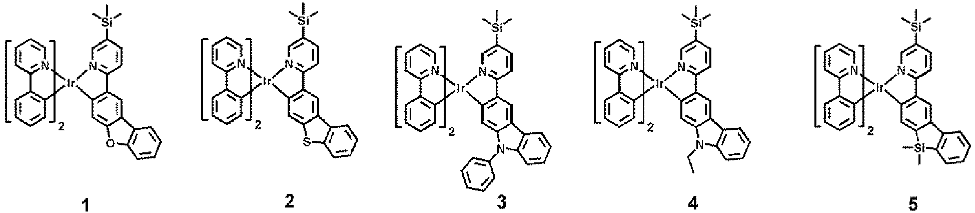

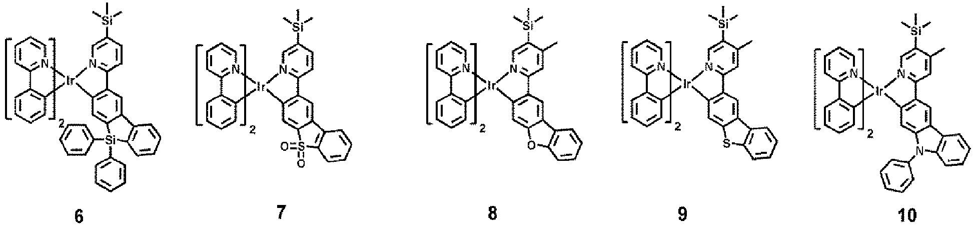

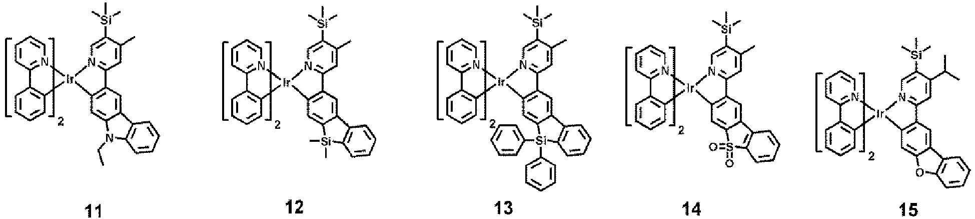

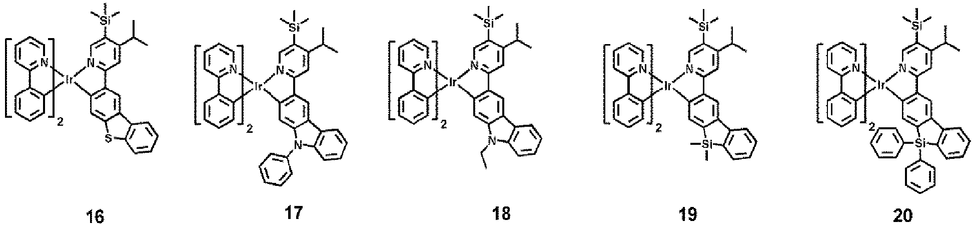

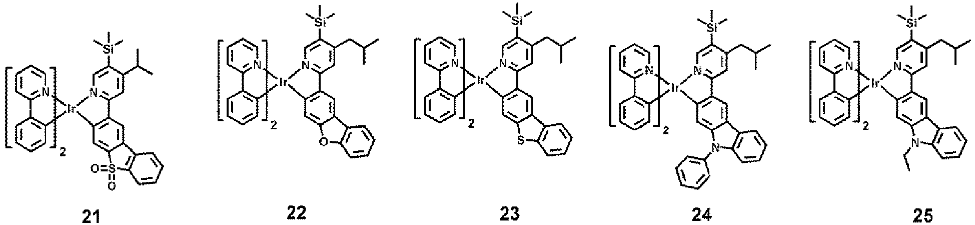

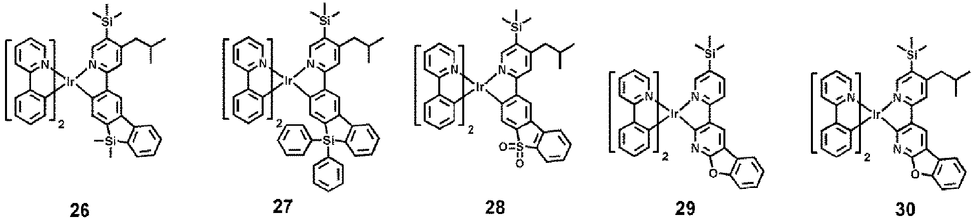

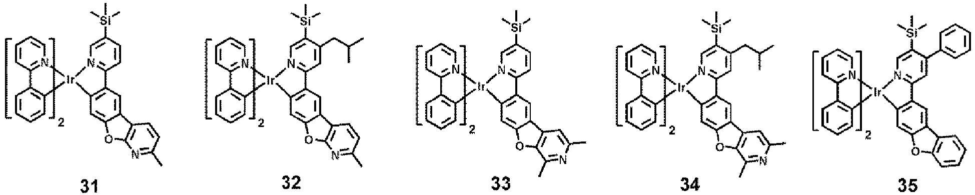

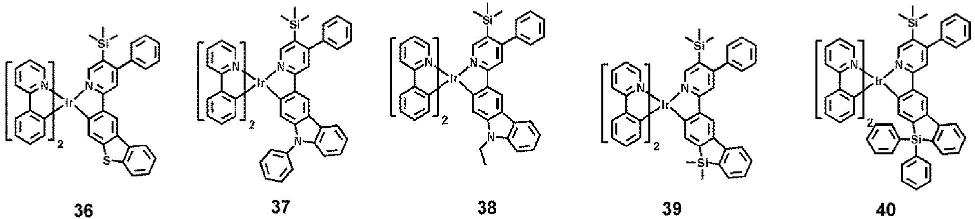

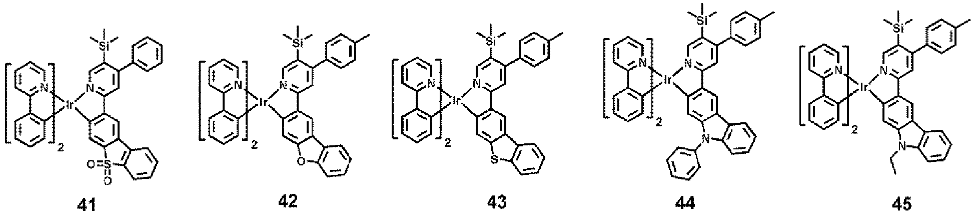

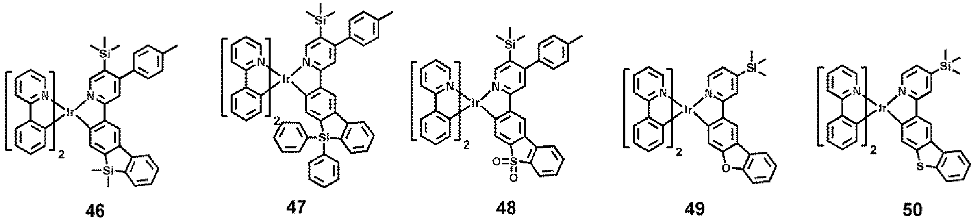

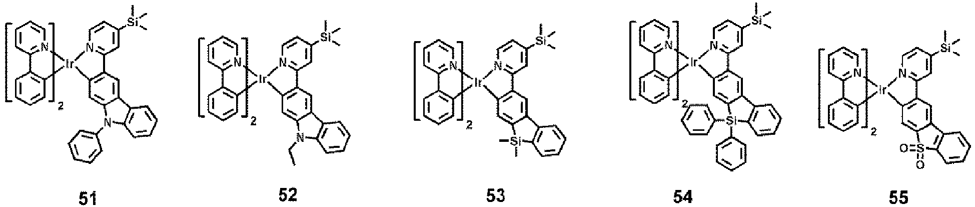

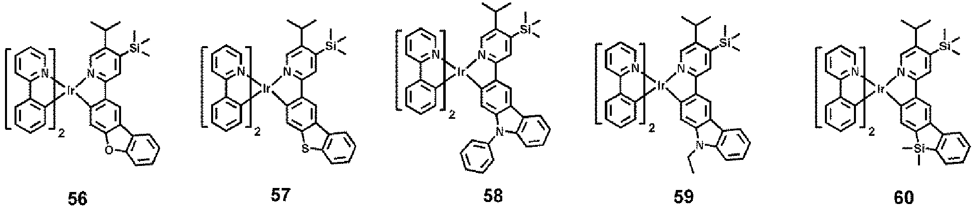

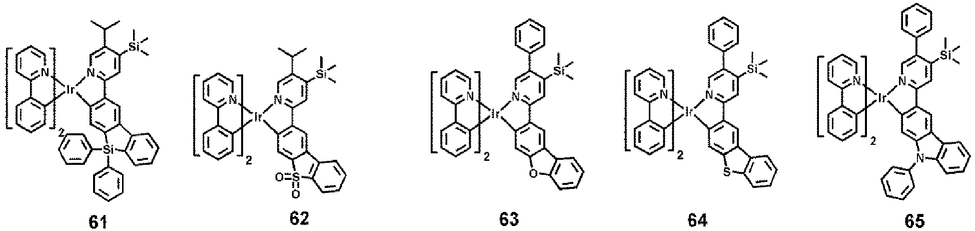

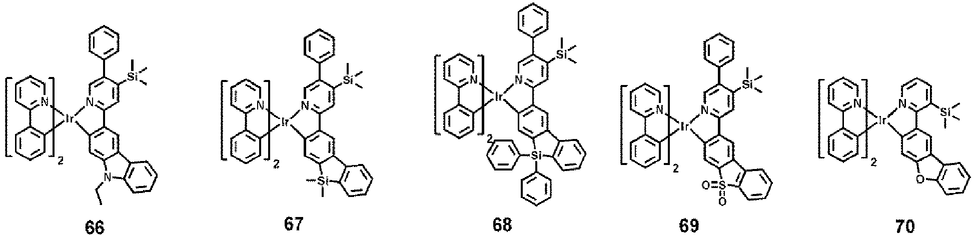

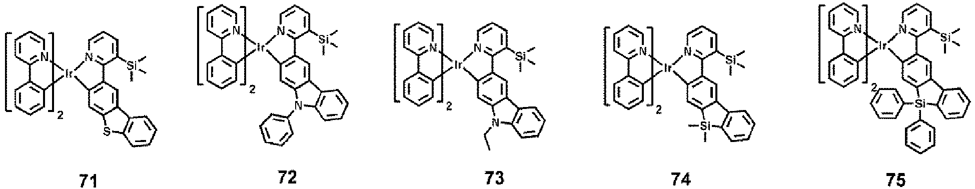

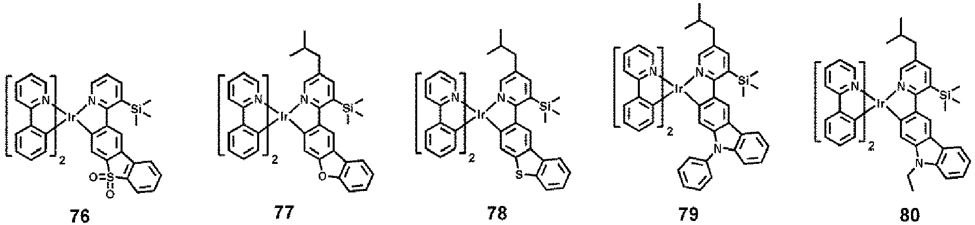

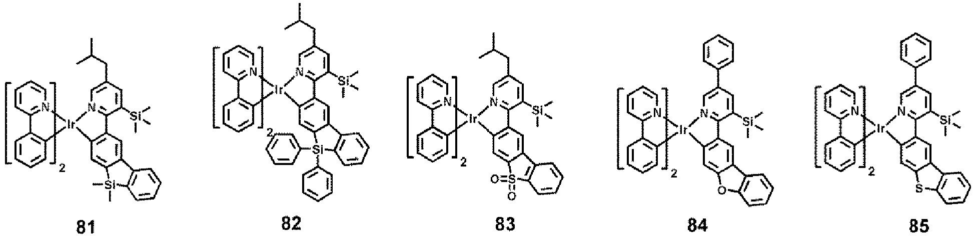

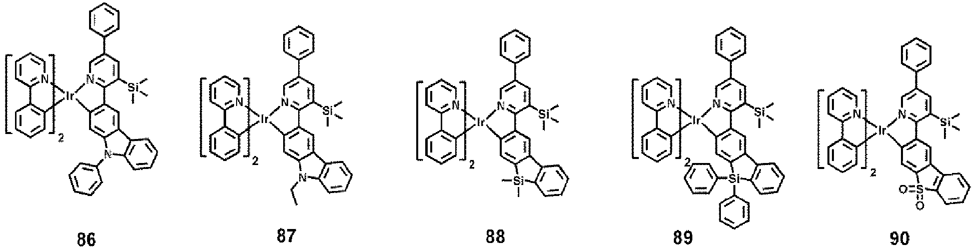

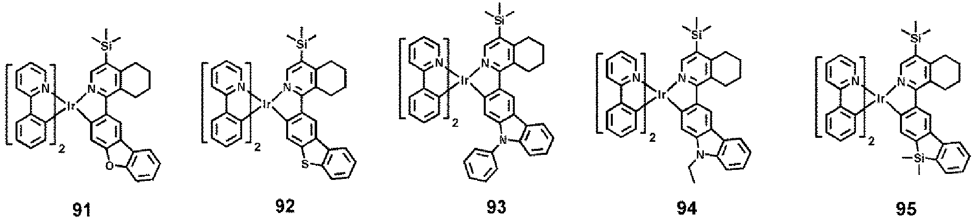

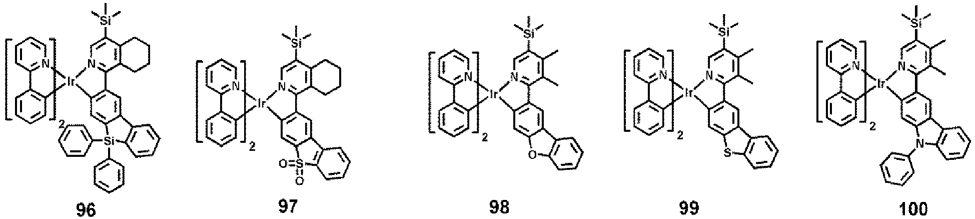

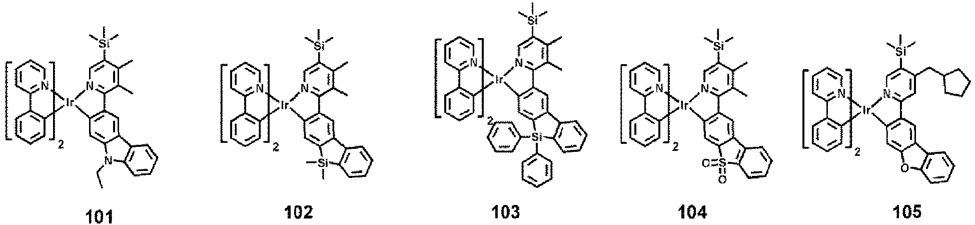

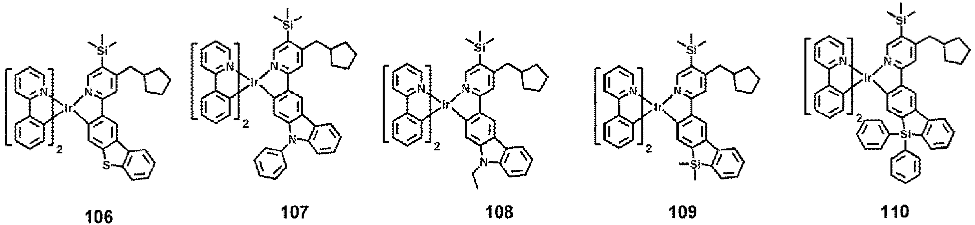

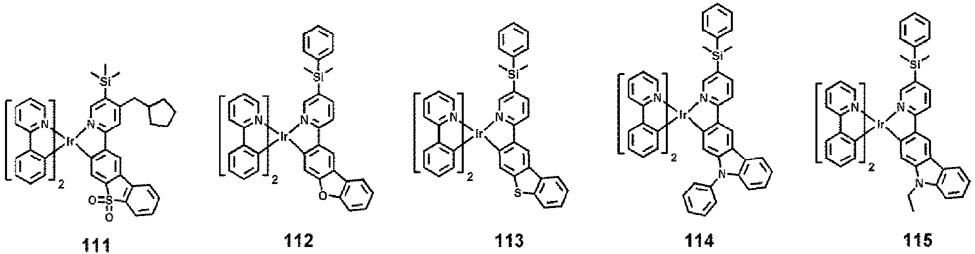

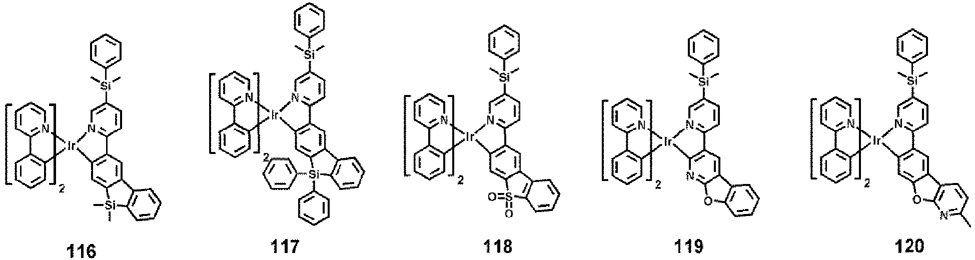

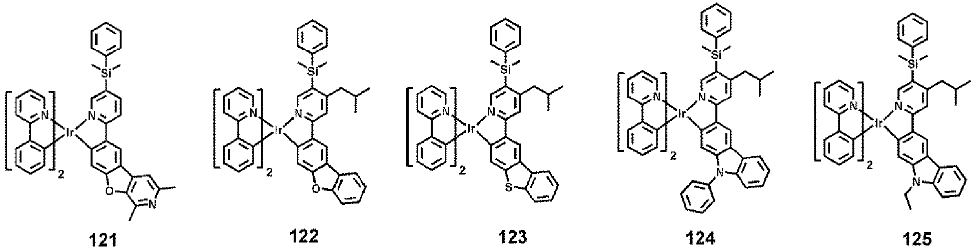

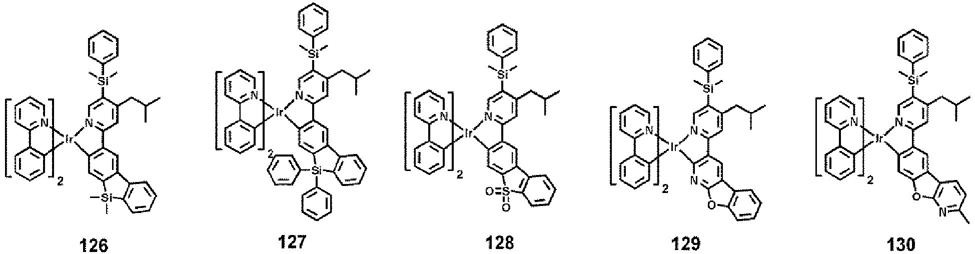

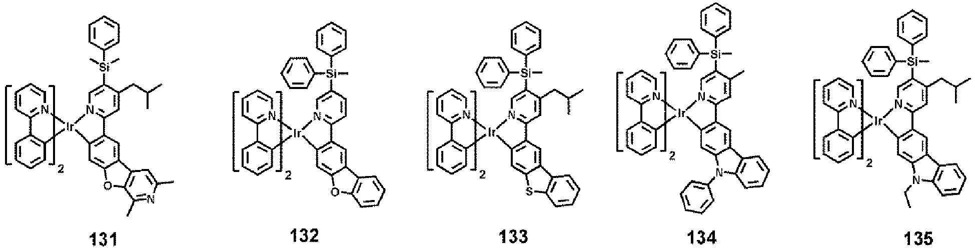

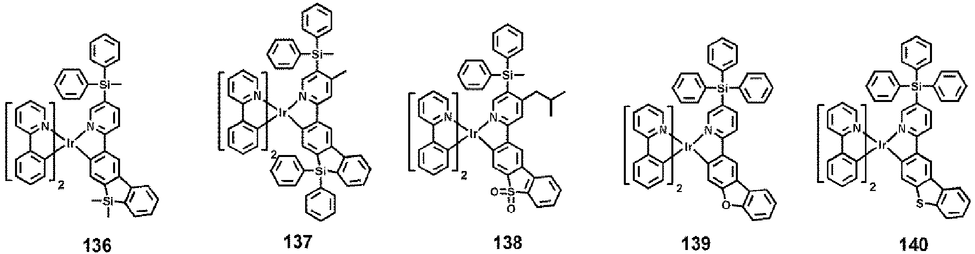

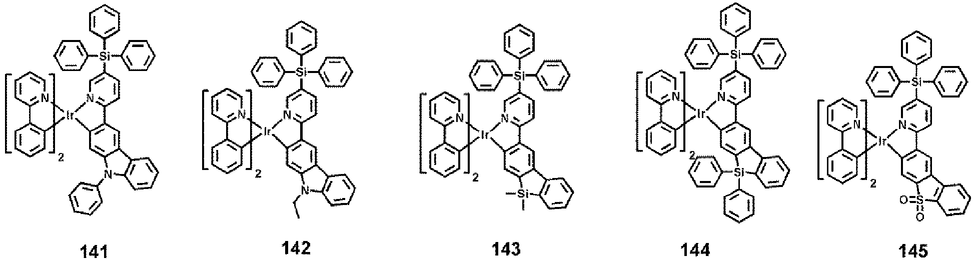

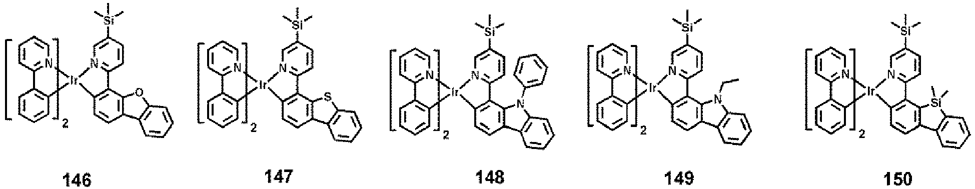

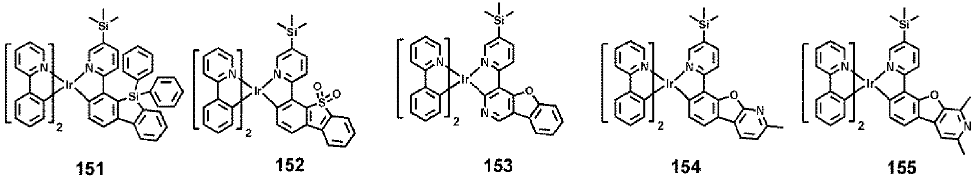

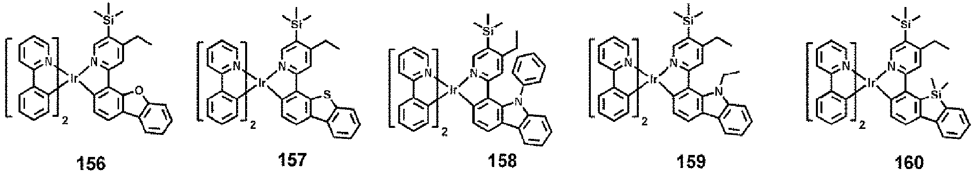

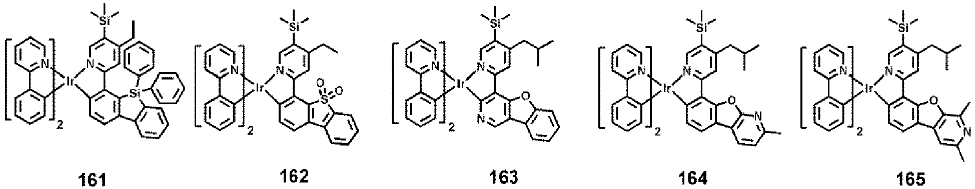

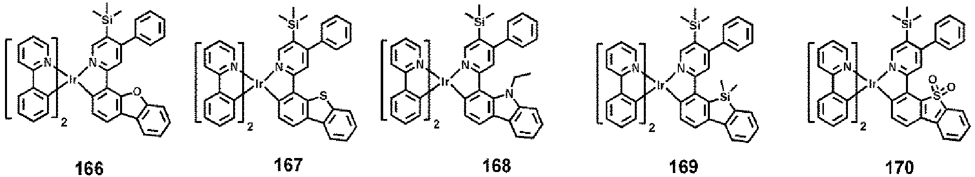

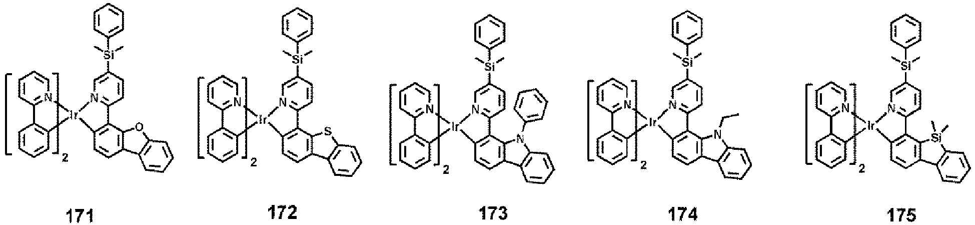

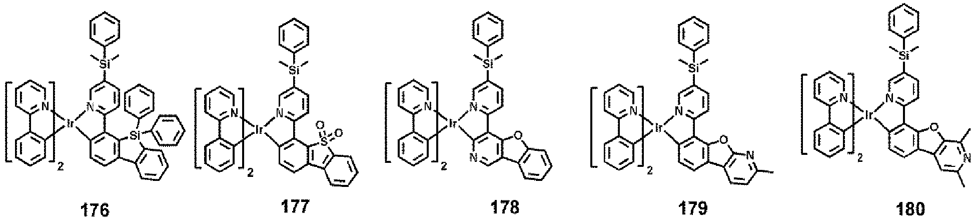

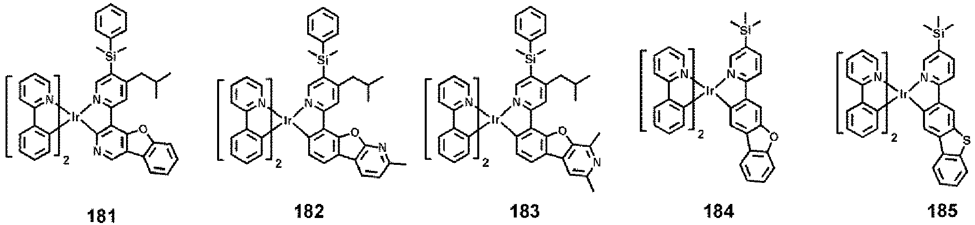

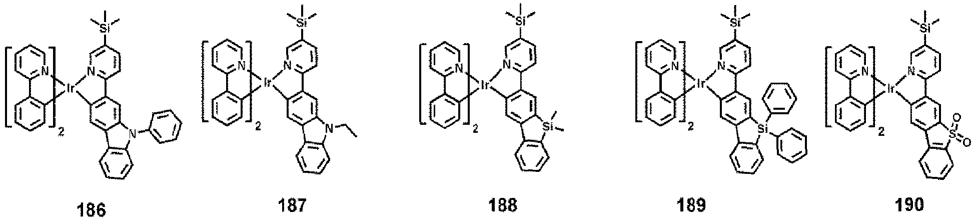

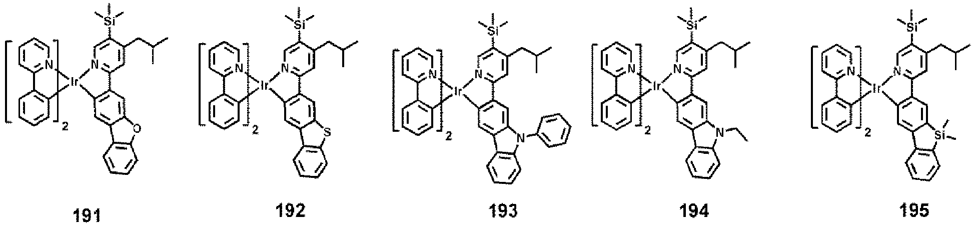

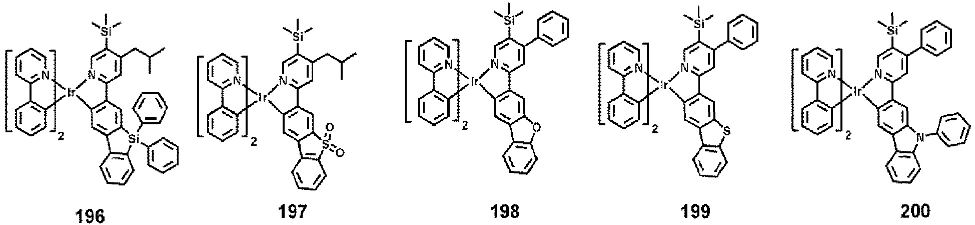

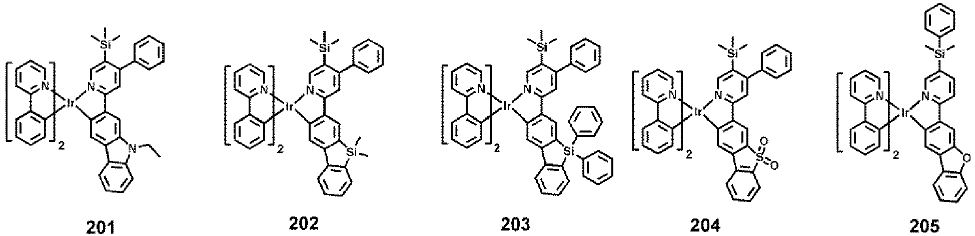

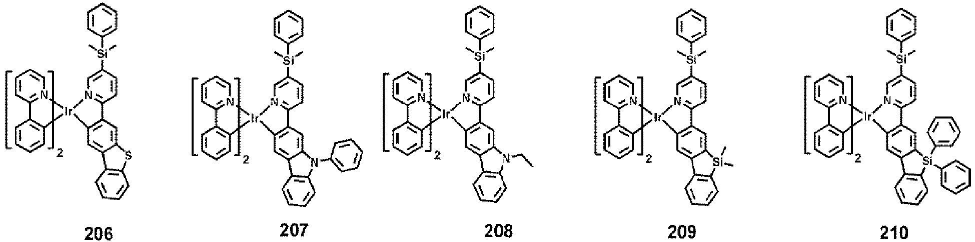

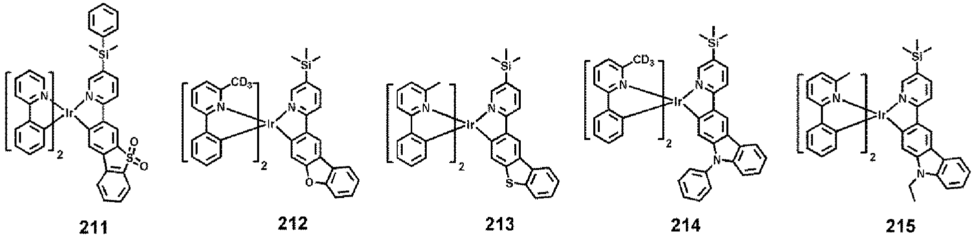

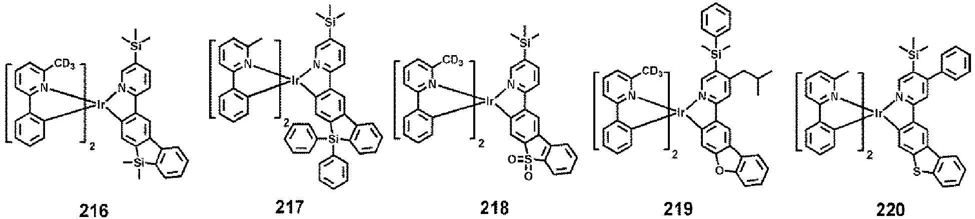

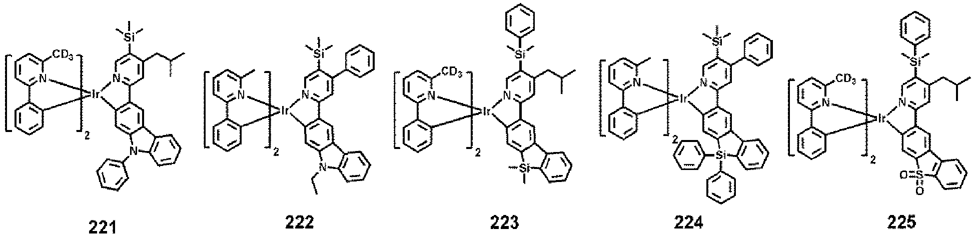

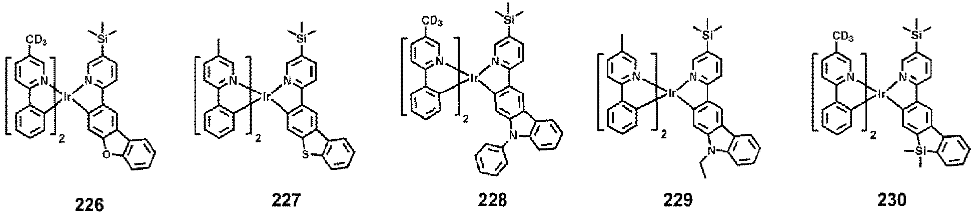

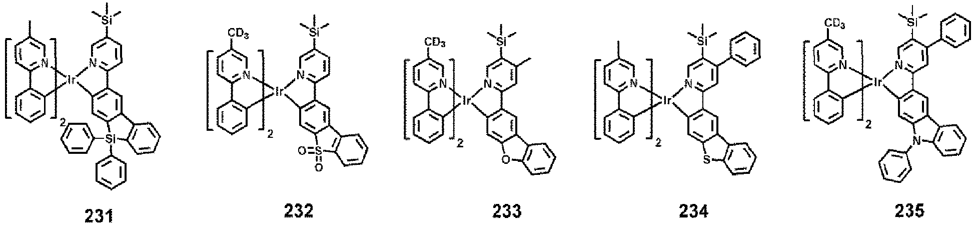

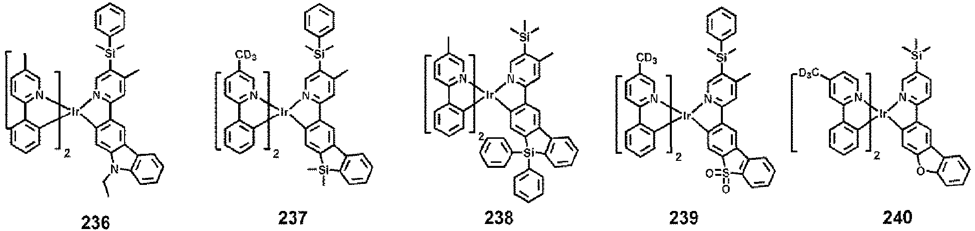

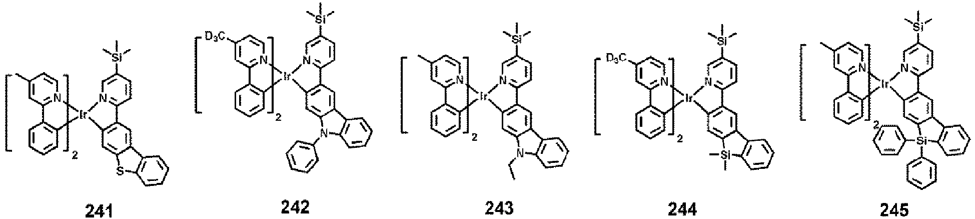

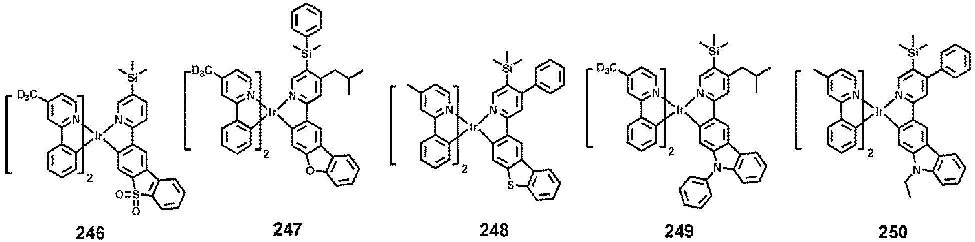

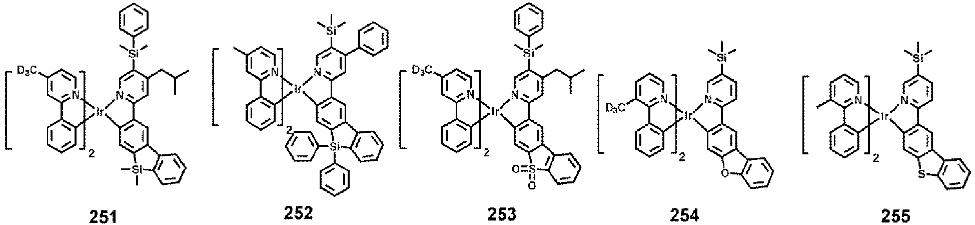

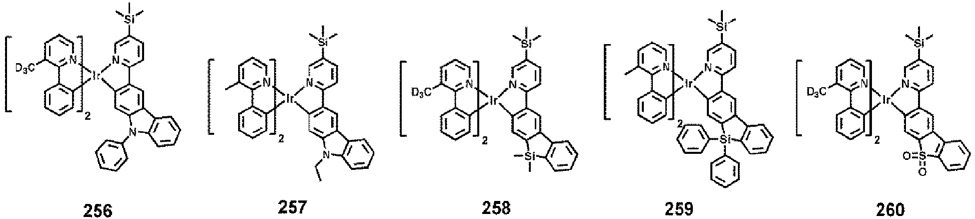

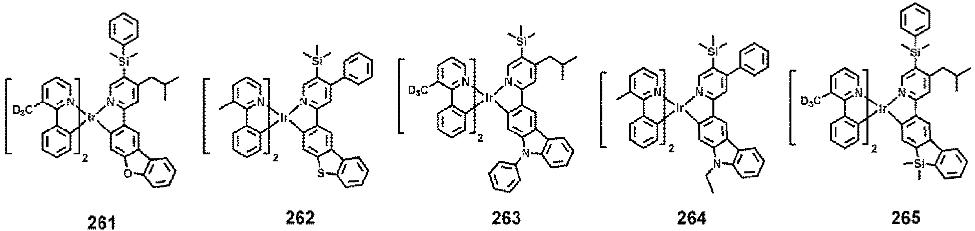

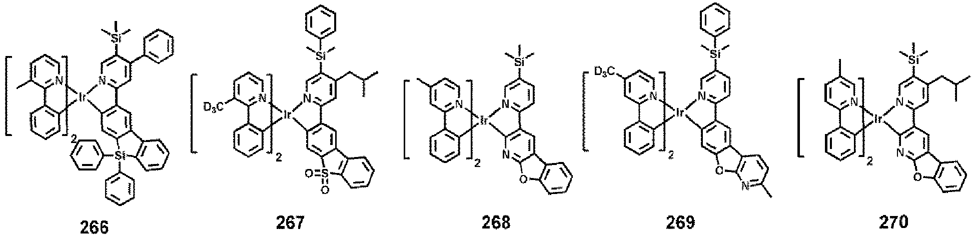

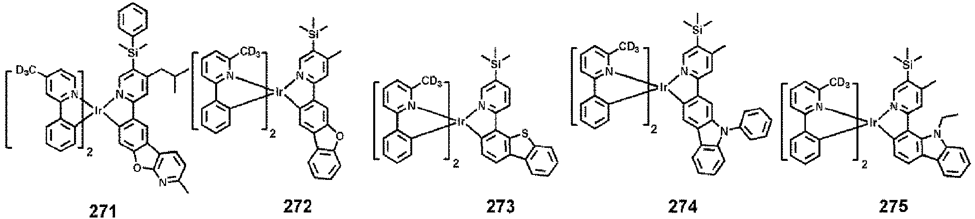

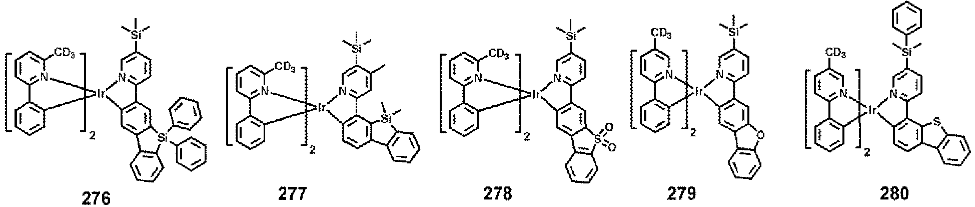

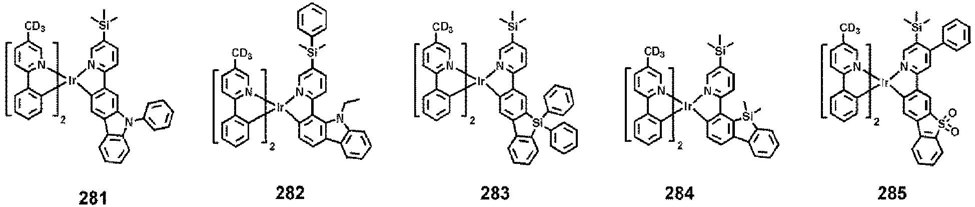

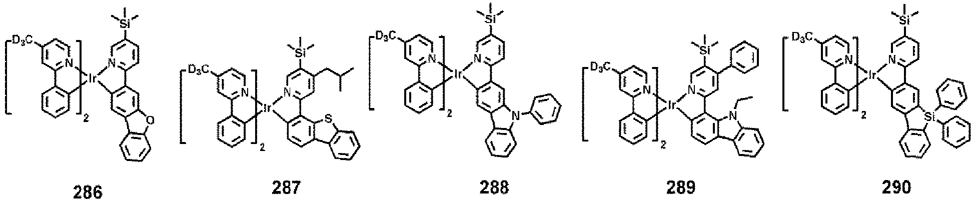

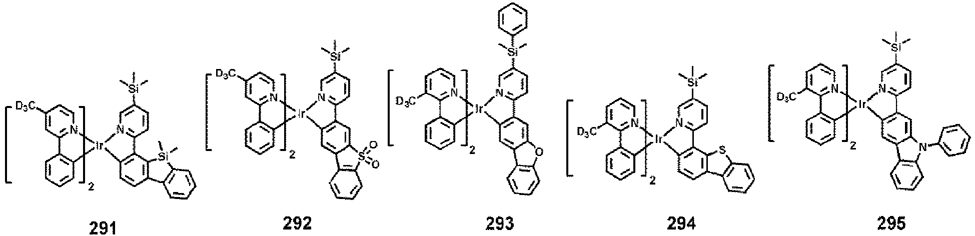

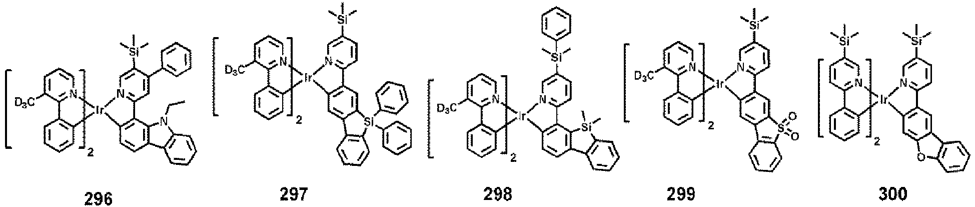

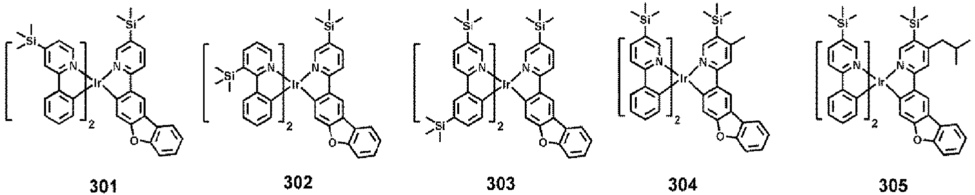

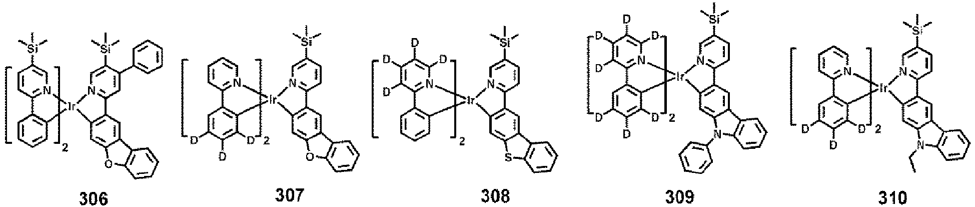

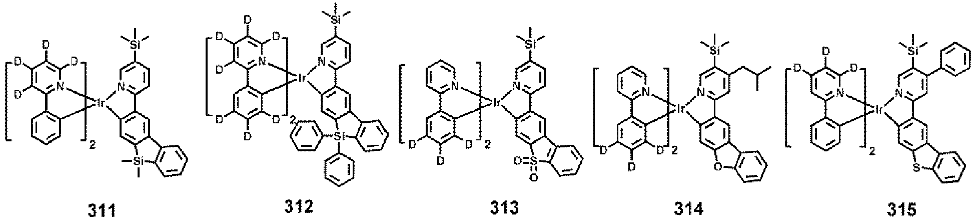

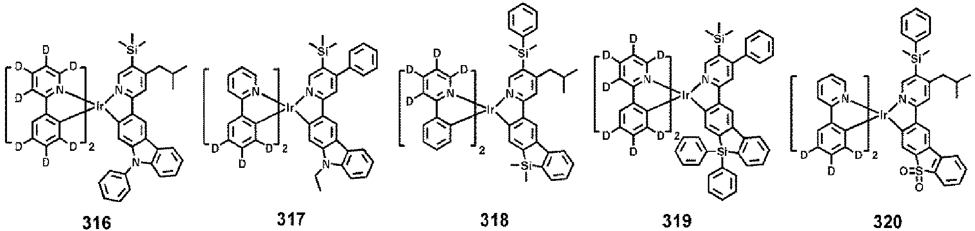

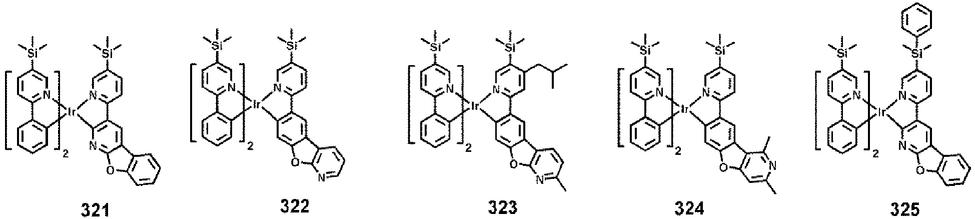

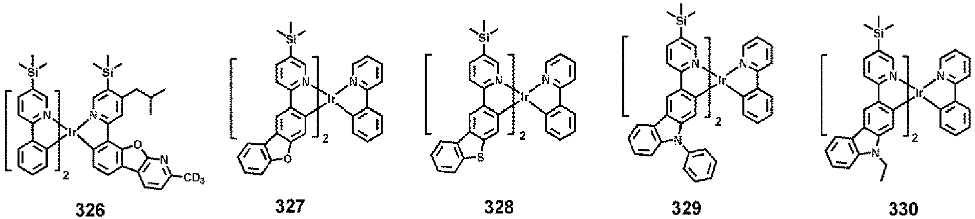

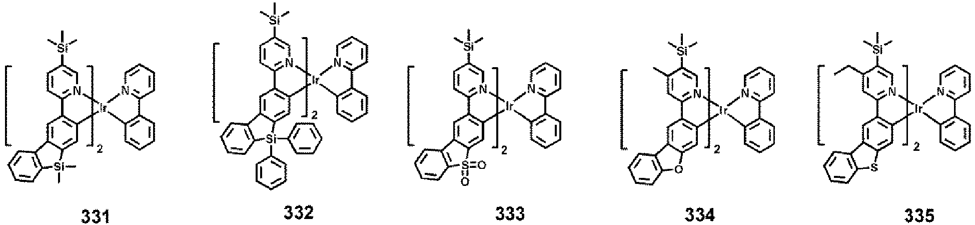

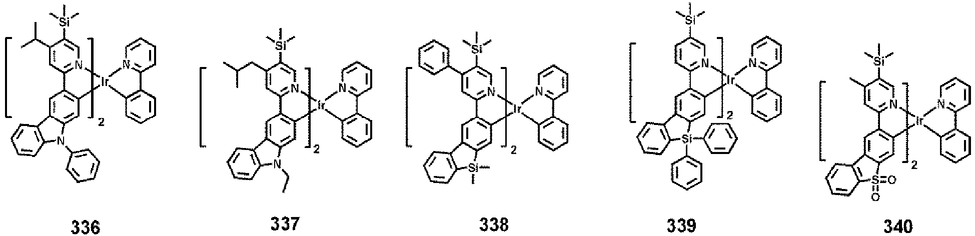

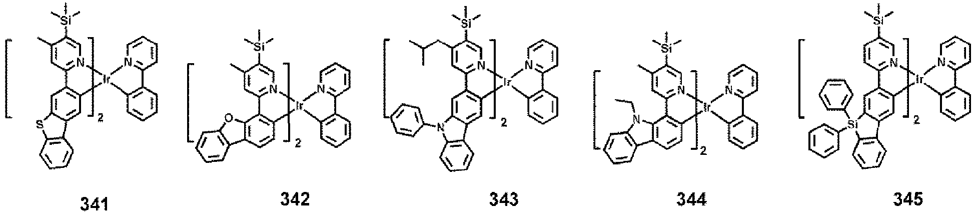

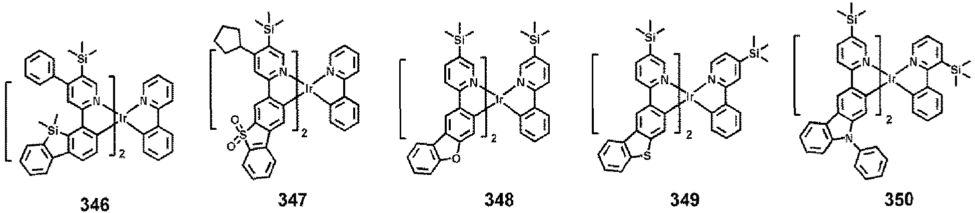

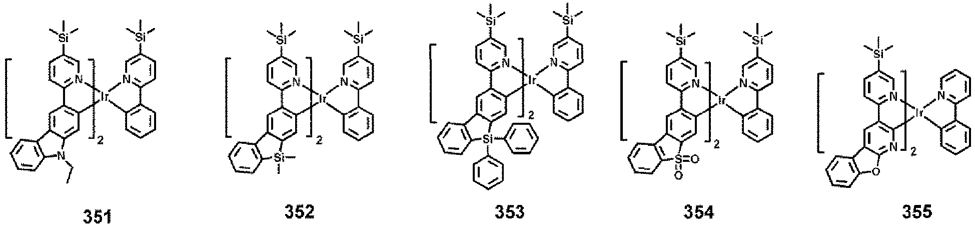

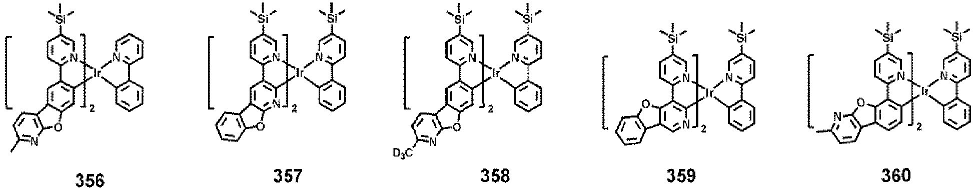

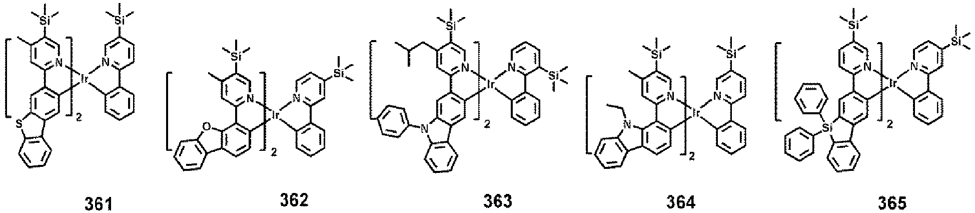

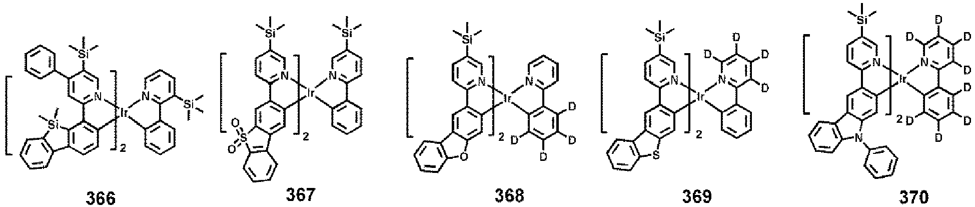

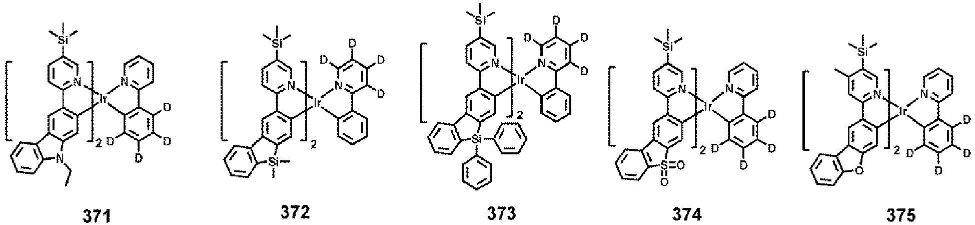

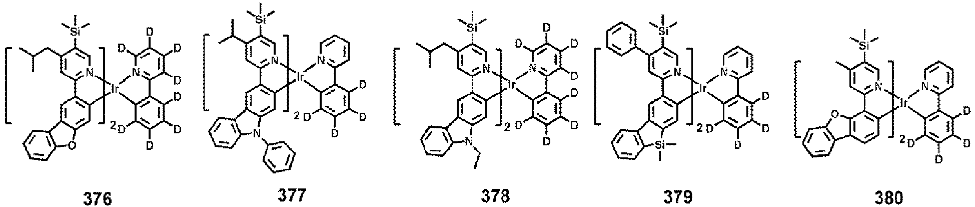

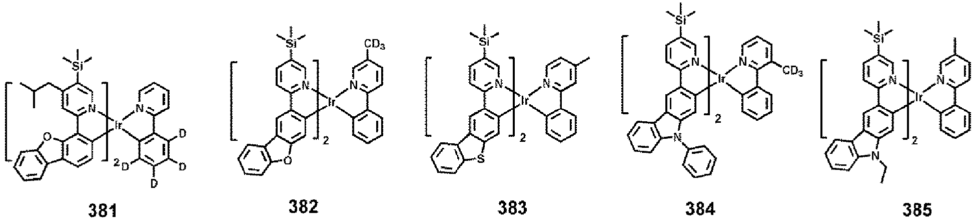

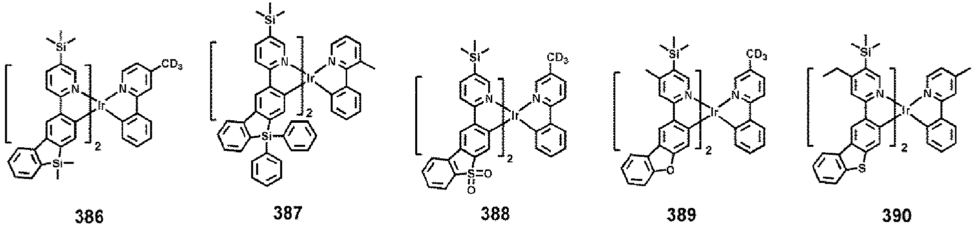

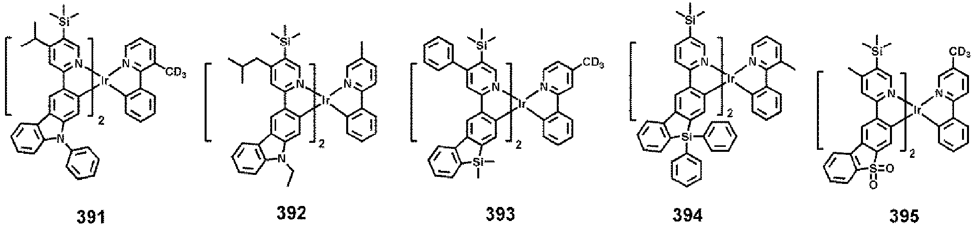

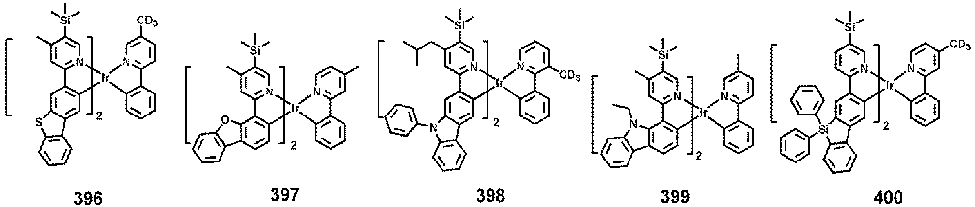

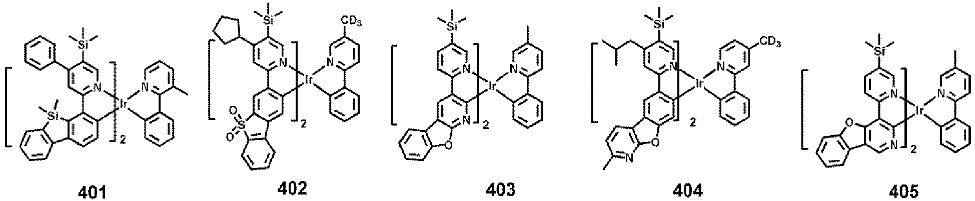

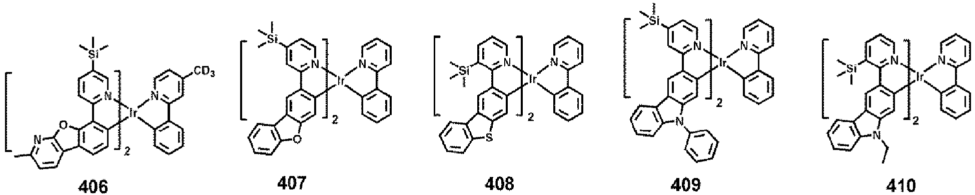

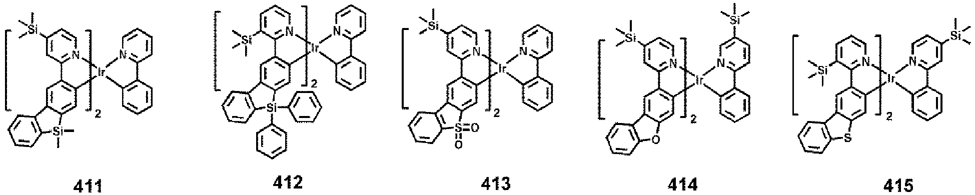

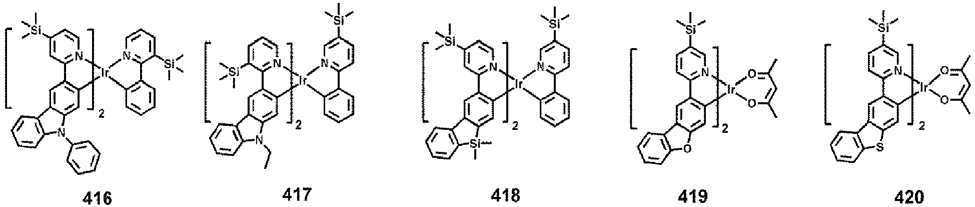

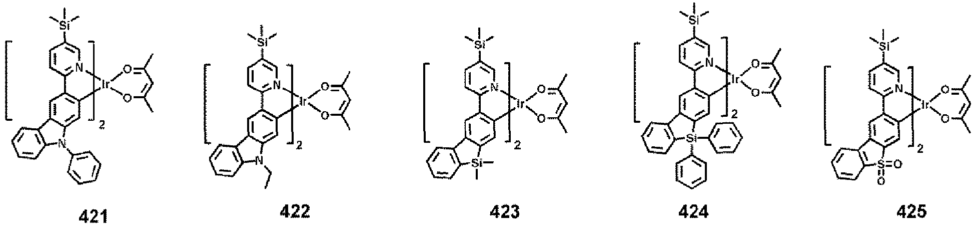

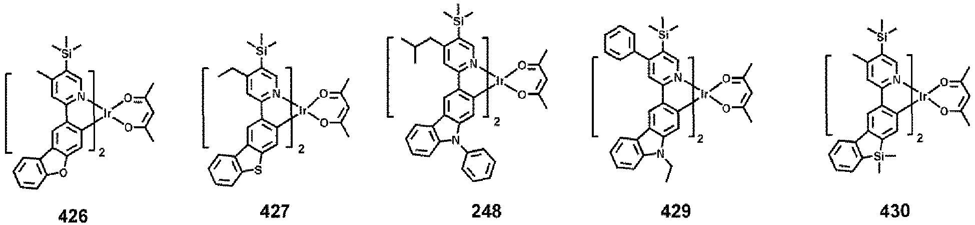

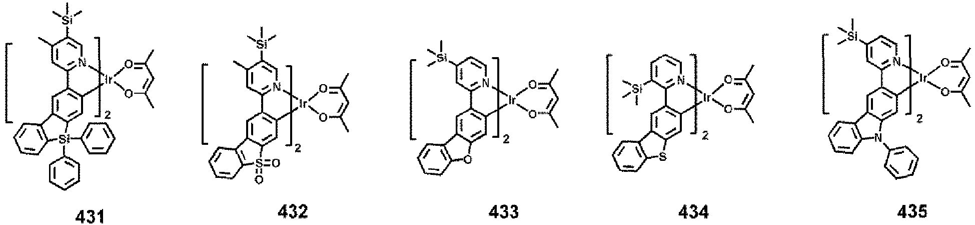

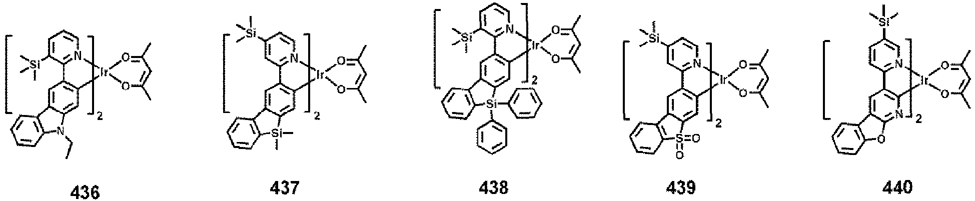

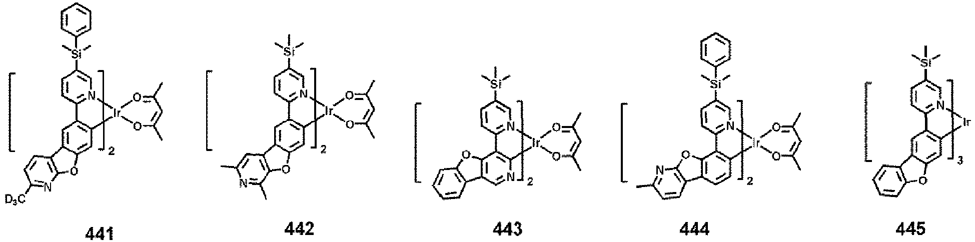

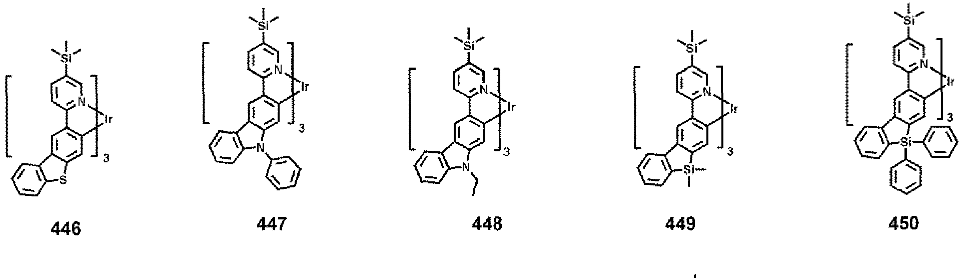

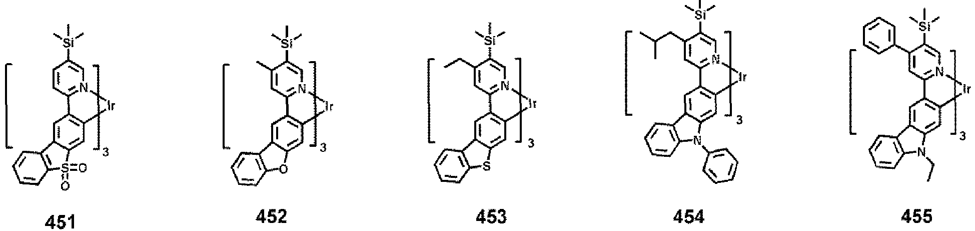

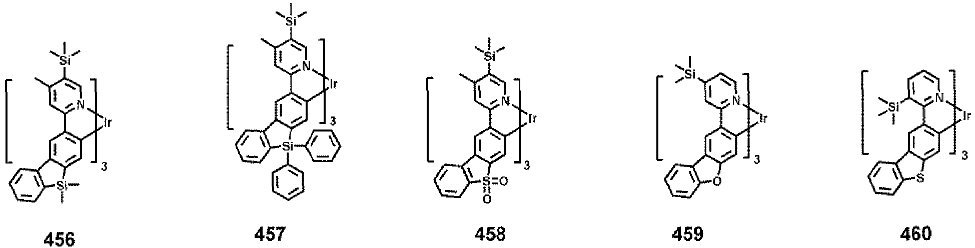

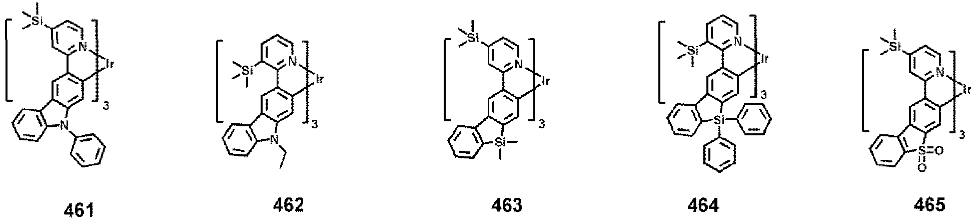

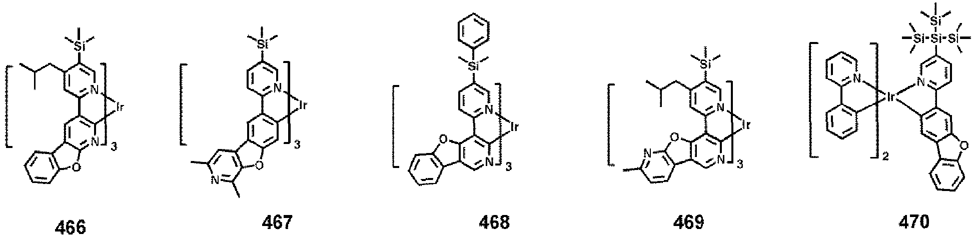

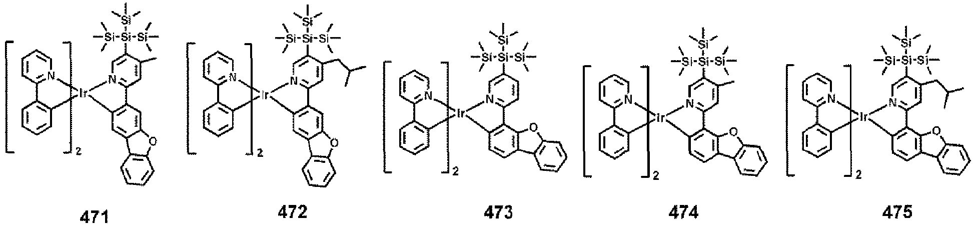

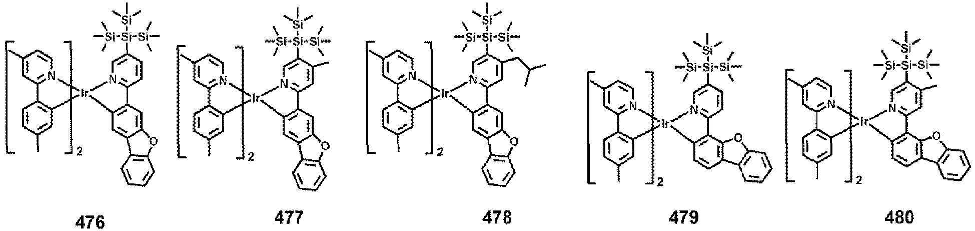

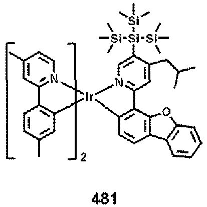

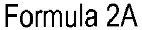

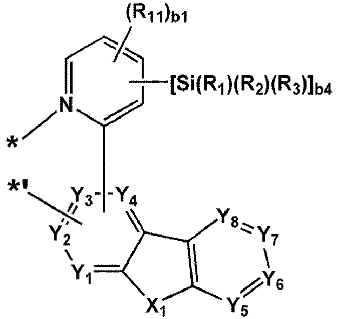

Regarding the organometallic compound represented by Formula 1, L₁ is selected from a ligand represented by Formula 2A, and b4 in Formula 2A is 1 or more. That is, a substituent of a pyridine-based ring in Formula 2A may include at least one group - Si(R₁)(R₂)(R₃). Group -Si(R₁)(R₂)(R₃) increases spin density of metal M in Formula 1. Accordingly, an organic light-emitting device using the organometallic compound represented by Formula 1 having the ligand represented by Formula 2A may have high efficiency.

Also, X₁ in Formula 2A may be selected from O, S, S(=O)₂, N(R₂₁), and Si(R₂₂)(R₂₃). When X₁ is selected from the groups above, charge mobility of the organometallic compound represented by Formula 1 having the ligand represented by Formula 2A improves, and energy levels thereof are easily controllable. Accordingly, efficiency and lifespan of an organic light-emitting device using the organometallic compound may be improved.

For example, HOMO, LUMO, singlet (S₁) and triplet (T₁) energy levels of the organometallic compounds 1, 2, 8, 22, 139, 146, 304, 305, 321, 323, 327 and 419 were evaluated by using a DFT method of Gaussian program (structurally optimized at a level of B3LYP, 6-31 G(d,p)). Evaluation results are shown in Table 1 below.

**Table 1**

| Compound No. | HOMO(eV) | LUMO(eV) | S₁ energy level (eV) | T₁ energy level (eV) |
|---|---|---|---|---|
| Compound 1 | -4.842 | -1.262 | 2.887 | 2.616 |
| Compound 2 | -4.874 | -1.309 | 2.869 | 2.591 |
| Compound 8 | -4.812 | -1.249 | 2.875 | 2.608 |
| Compound 22 | -4.812 | -1.250 | 2.889 | 2.633 |
| Compound 139 | -4.827 | -1.283 | 2.867 | 2.589 |
| Compound 146 | -4.829 | -1.261 | 2.872 | 2.510 |
| Compound 304 | -4.781 | -1.267 | 2.837 | 2.586 |
| Compound 305 | -4.773 | -1.244 | 2.852 | 2.600 |
| Compound 321 | -4.856 | -1.369 | 2.803 | 2.555 |
| Compound 323 | -4.820 | -1.281 | 2.849 | 2.591 |
| Compound 327 | -4.863 | -1.304 | 2.887 | 2.614 |
| Compound 419 | -4.756 | -1.331 | 2.753 | 2.525 |

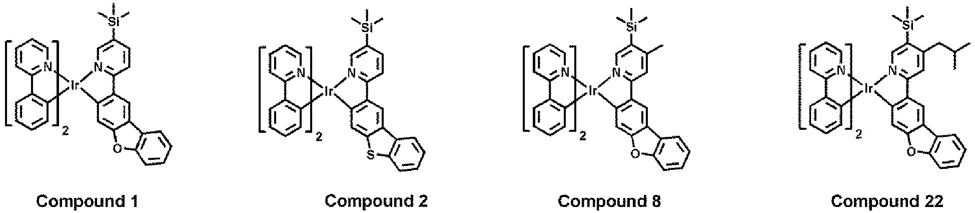

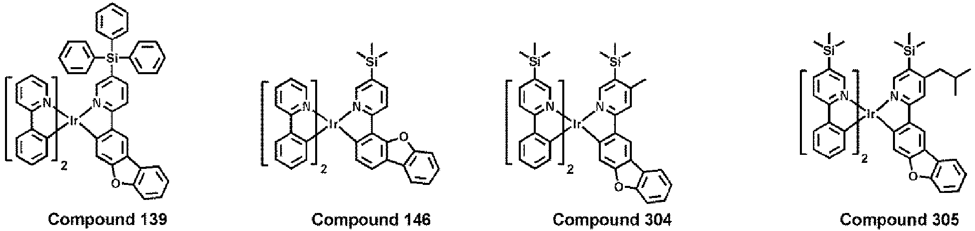

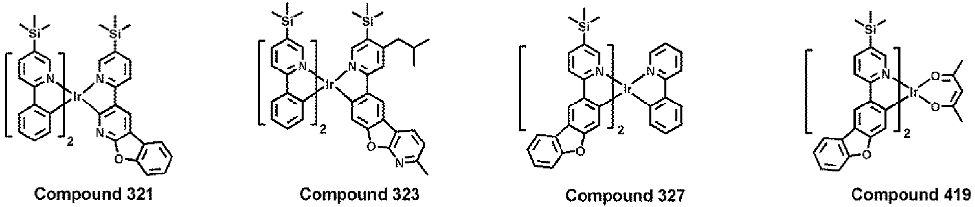

From Table 1, it is confirmed that the organometallic compound represented by Formula 1 has electric characteristics that are suitable for use as a material for manufacturing a device, for example, an organic light-emitting device.

Synthesis methods of the organometallic compound represented by Formula 1 may be recognizable by one of ordinary skill in the art by referring to Synthesis Examples provided below.

The organometallic compound represented by Formula 1 is suitable for use in an organic layer of an organic light-emitting device, for example, for use as a dopant in an emission layer of the organic layer. Thus, another aspect provides an organic light-emitting device that includes:
a first electrode;
a second electrode; and
an organic layer disposed between the first electrode and the second electrode, wherein the organic layer includes an emission layer and at least one organometallic compound represented by Formula 1.

The organic light-emitting device may have, due to the inclusion of an organic layer including the organometallic compound represented by Formula 1, a low driving voltage, high efficiency, high power, and a long lifespan.

The organometallic compound of Formula 1 may be used between a pair of electrodes of an organic light-emitting device. For example, the organometallic compound represented by Formula 1 may be included in the emission layer. In this regard, the organometallic compound may act as a dopant, and the emission layer may further include a host (that is, an amount of the organometallic compound represented by Formula 1 is smaller than an amount of the host).

The expression "(an organic layer) includes at least one organometallic compounds" used herein may include an embodiment in which (an organic layer) includes identical organometallic compounds of Formula 1 and an embodiment in which (an organic layer) includes two or more different organometallic compounds of Formula 1.

For example, the organic layer may include, as the organometallic compound, only Compound 1. In this regard, Compound 1 may be included in an emission layer of the organic light-emitting device. In some embodiments, the organic layer may include, as the organometallic compound, Compound 1 and Compound 2. In this regard, Compound 1 and Compound 2 may be included in an identical layer (for example, Compound 1 and Compound 2 all may be included in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

For example, the first electrode is an anode, and the second electrode is a cathode, and the organic layer includes i) a hole transport region between the first electrode and the emission layer, and ii) an electron transport region between the emission layer and the second electrode, and the hole transport region includes at least one selected from a hole injection layer, a hole transport layer, and an electron blocking layer, and the electron transport region includes at least one selected from a hole blocking layer, an electron transport layer, and an electron injection layer.

The term "organic layer" as used herein refers to a single layer and/or a plurality of layers disposed between the first electrode and the second electrode of an organic light-emitting device. The "organic layer" may include, in addition to an organic compound, an organometallic complex including metal.

FIG. 1 is a schematic view of an organic light-emitting device 10 according to an embodiment. Hereinafter, the structure of an organic light-emitting device according to an embodiment and a method of manufacturing an organic light-emitting device according to an embodiment will be described in connection with FIG. 1. The organic light-emitting device 10 includes a first electrode 11, an organic layer 15, and a second electrode 19, which are sequentially stacked.

In FIG. 1, a substrate may be additionally disposed under the first electrode 11 or above the second electrode 19. As the substrate, any substrate that is used in general organic light-emitting devices may be used. The substrate may be a glass substrate or transparent plastic substrate, each with excellent mechanical strength, thermal stability, transparency, surface smoothness, ease of handling, and water-resistance.

The first electrode 11 may be formed by depositing or sputtering a material for forming the first electrode on the substrate. The first electrode 11 may be an anode. The material for the first electrode 11 may be selected from materials with a high work function to allow holes be easily provided. The first electrode 11 may be a reflective electrode or a transmissive electrode. The material for the first electrode may be, for example, indium tin oxide (ITO), indium zinc oxide (IZO), tin oxide (SnO₂), and zinc oxide (ZnO). In some embodiments, magnesium (Mg), aluminum (Al), aluminum-lithium (Al-Li), calcium (Ca), magnesium-indium (Mg-In), or magnesium-silver (Mg-Ag) may be used as the material for the first electrode.

The first electrode 11 may have a single-layer structure or a multi-layer structure including two or more layers. For example, the first electrode 11 may have a three-layered structure of ITO/Ag/ITO, but the structure of the first electrode 11 is not limited thereto.

An organic layer 15 is disposed on the first electrode 11.

The organic layer 15 may include a hole transport region, an emission layer, and an electron transport region.

The hole transport region may be disposed between the first electrode 11 and the emission layer.

The hole transport region may include at least one selected from a hole injection layer, a hole transport layer, an electron blocking layer, and a buffer layer.

The hole transport region may include only either a hole injection layer or a hole transport layer. In some embodiments, the hole transport region may have a structure of hole injection layer/hole transport layer or hole injection layer/hole transport layer/electron blocking layer, which are sequentially stacked in this stated order from the first electrode 11.

A hole injection layer hole injection layer may be formed on the first electrode 11 by using various methods, such as vacuum deposition, spin coating, casting, or Langmuir-Blodgett (LB).

When a hole injection layer is formed by vacuum deposition, the deposition conditions may vary according to a material that is used to form the hole injection layer, and the structure and thermal characteristics of the hole injection layer. For example, the deposition conditions may include a deposition temperature of about 100 to about 500°C, a vacuum pressure of about 10⁻⁸ to about 10⁻³ torr, and a deposition rate of about 0.001 nm to about 10 nm per second (nm/sec) (0.01 to about 100 Angstroms per second (Å/sec)). However, the deposition conditions are not limited thereto.

When the hole injection layer is formed using spin coating, coating conditions may vary according to the material used to form the hole injection layer, and the structure and thermal properties of the hole injection layer. For example, a coating speed may be from about 2,000 revolutions per minute (rpm) to about 5,000 rpm, and a temperature at which a heat treatment is performed to remove a solvent after coating may be from about 80°C to about 200°C. However, the coating conditions are not limited thereto.

Conditions for a hole transport layer and an electron blocking layer may be understood by referring to conditions for forming the hole injection layer.
The hole transport region may include at least one selected from m-MTDATA, TDATA, 2-TNATA, NPB, β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (PANI/CSA), (polyaniline)/poly(4-styrenesulfonate) (Pani/PSS), a compound represented by Formula 201 below, and a compound represented by Formula 202 below: 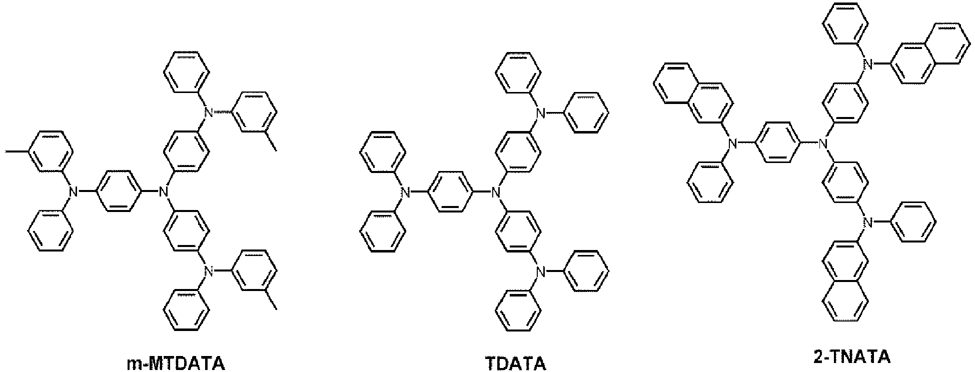 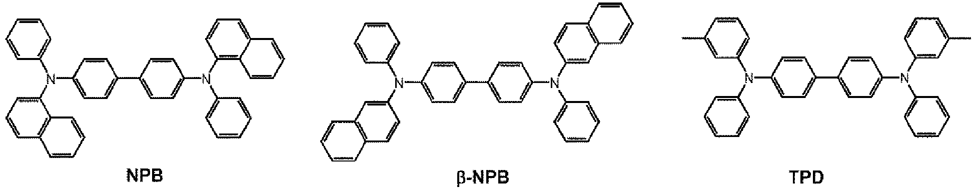 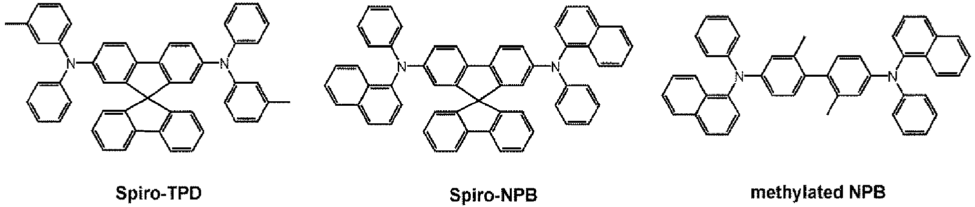 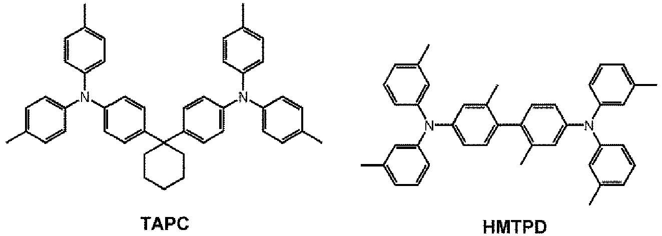 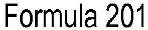 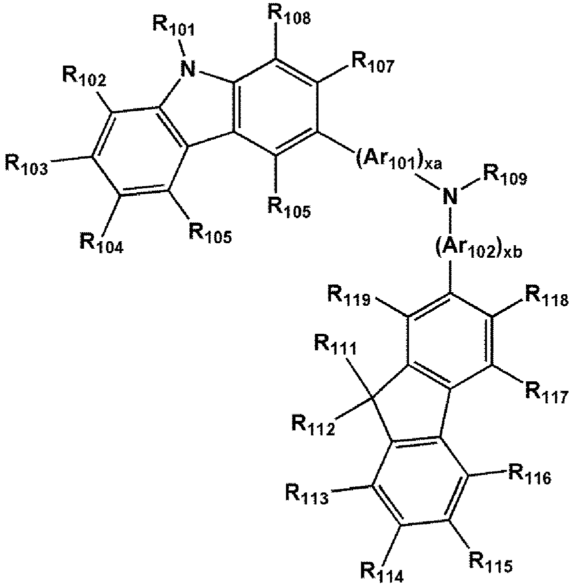 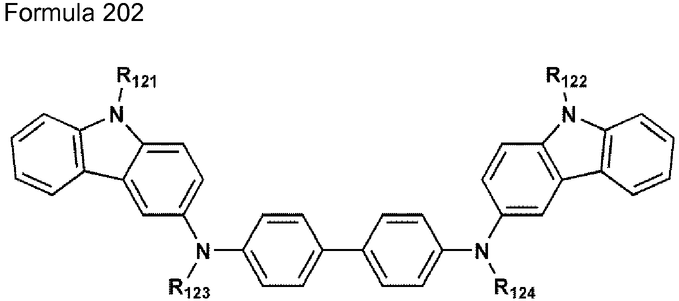 Ar₁₀₁ to Ar₁₀₂ in Formula 201 may be each independently selected from
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group; and
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group, each substituted with at least one selected from a deuterium, -F, -Cl, -Br, -I, a hydroxyl group, a cyano group, a nitro group, an amino group, amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed group, and a monovalent non-aromatic condensed heteropolycyclic group.

In Formula 201, xa and xb may be each independently an integer of 0 to 5, or 0, 1, or 2. For example, xa is 1 and xb is 0, but xa and xb are not limited thereto.
R₁₀₁ to R₁₀₈, R₁₁₁ to R₁₁₉ and R₁₂₁ to R₁₂₄ in Formulae 201 and 202 may be each independently selected from
a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, a pentyl group, a hexyl group, and so on), or a C₁-C₁₀ alkoxy group (for example, a methoxy group, an ethoxy group, a propoxy group, a butoxy group, a pentoxy group, and so on);
a C₁-C₁₀ alkyl group or a C₁-C₁₀ alkoxy group, each substituted with at least one selected from a deuterium, -F, -Cl, -Br, -I, a hydroxyl group, a cyano group, a nitro group, amino group, an amidino group, a hydrazine group, a hydrazone group, a carboxylic acid group or a salt thereof, a sulfonic acid group or a salt thereof, and a phosphoric acid group a salt thereof;
a phenyl group, a naphthyl group, an anthracenyl group, a fluorenyl group, and a pyrenyl group; and
a phenyl group, a naphthyl group, an anthracenyl group, a fluorenyl group, and a pyrenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, and a C₁-C₁₀ alkoxy group, but they are not limited thereto.
R₁₀₉ in Formula 201 may be selected from
a phenyl group, a naphthyl group, an anthracenyl group and a pyridinyl group; and
a phenyl group, a naphthyl group, an anthracenyl group and a pyridinyl group, each substituted with at least one selected from a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, an anthracenyl group, and a pyridinyl group.

According to an embodiment, the compound represented by Formula 201 may be represented by Formula 201A, but is not limited thereto:

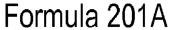

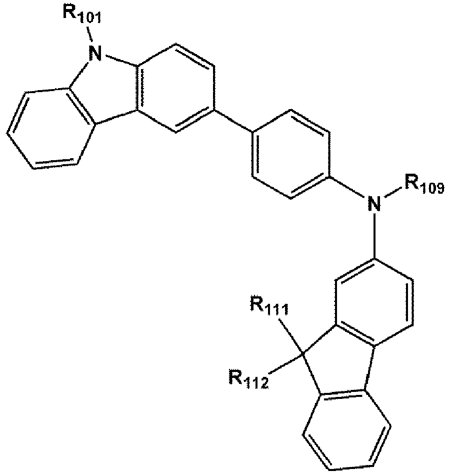

R₁₀₁, R₁₁₁, R₁₁₂, and R₁₀₉ in Formula 201A may be understood by referring to the description provided herein.
For example, the compound represented by Formula 201, and the compound represented by Formula 202 may include compounds HT1 to HT20 illustrated below, but are not limited thereto.

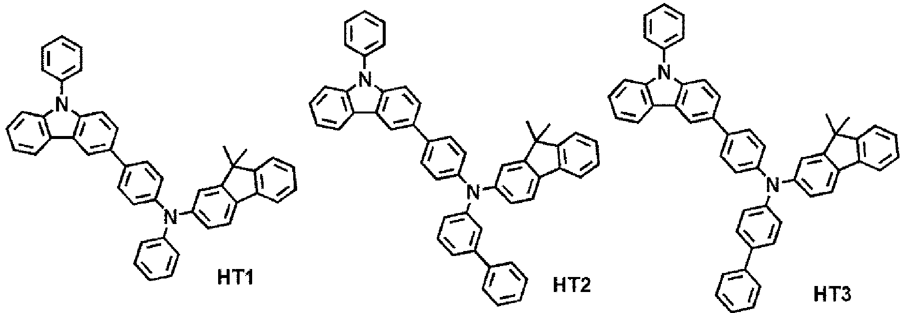

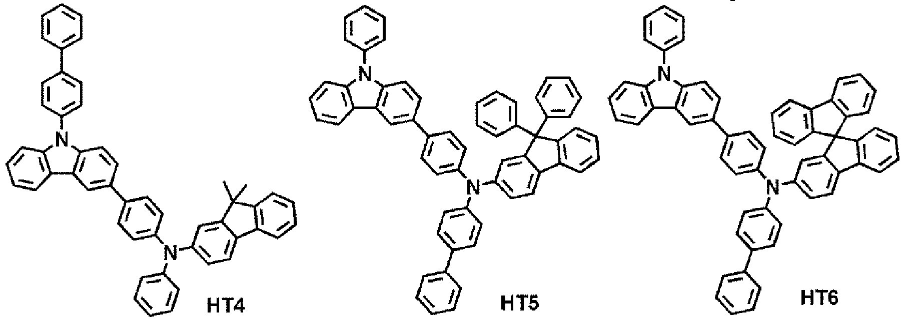

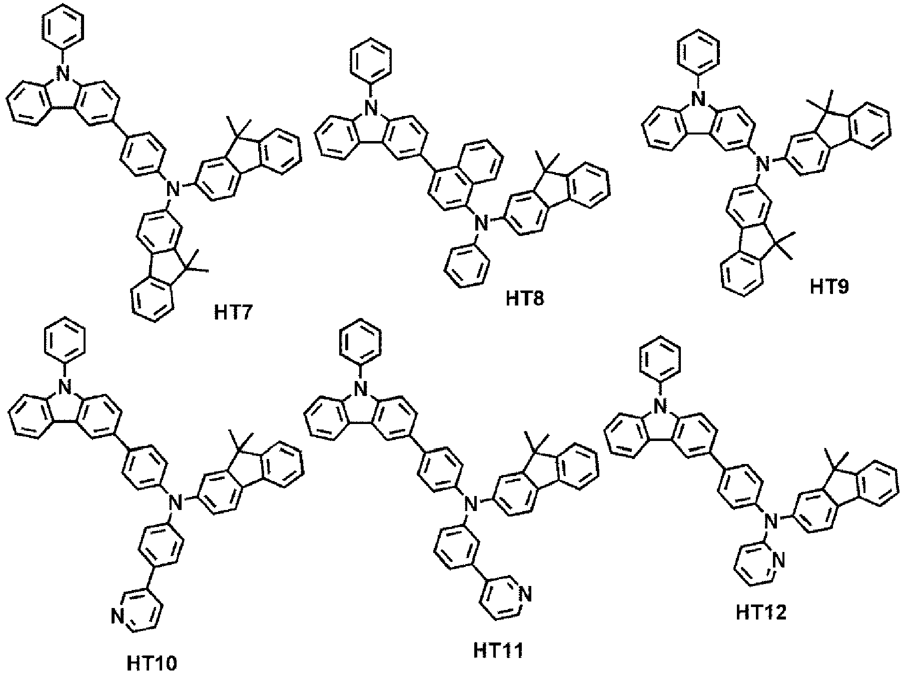

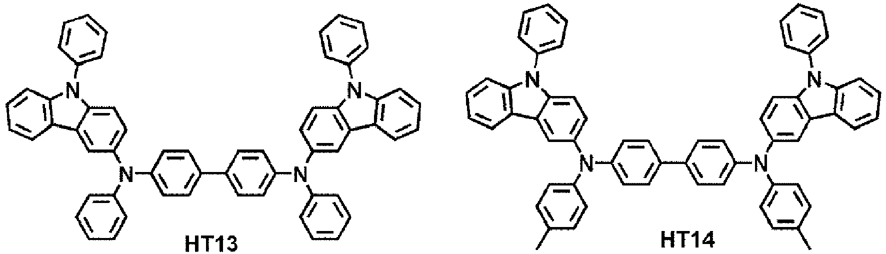

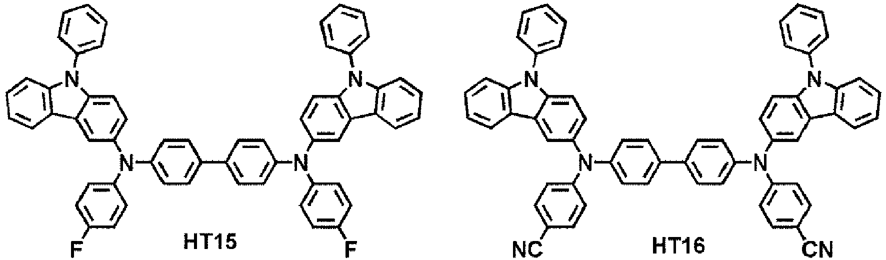

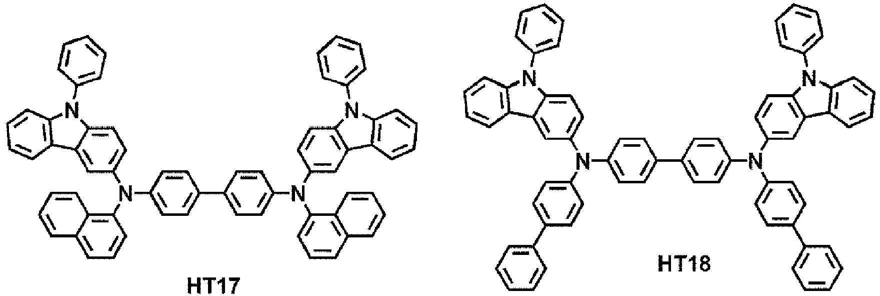

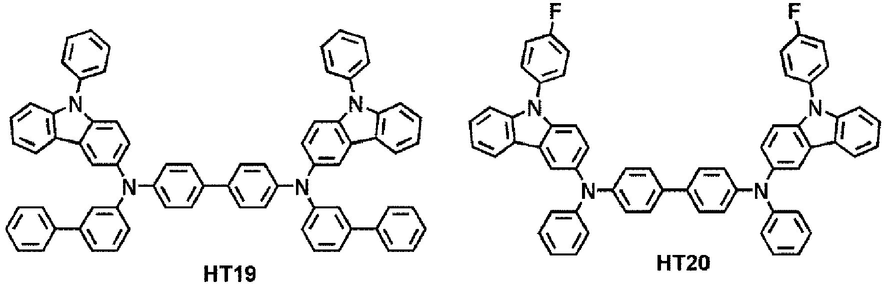

A thickness of the hole transport region may be in a range of about 10 nm (100 Angstroms (Å)) to about 1,000 nm (10,000 Å), for example, about 10 nm (100 Å) to about 100 nm (1,000 Å). When the hole transport region includes a hole injection layer and a hole transport layer, the thickness of the hole injection layer may be in a range of about 10 nm (100 A) to about 1,000 nm (10,000 Å), and for example, about 10 nm (100 Å) to about 100 nm (1,000 Å), and the thickness of the hole transport layer may be in a range of about 5 nm (50 A) to about 200 nm (2,000 Å), and for example, about 10 nm (100 A) to about 150 nm (1,500 Å). When the thicknesses of the hole transport region, the hole injection layer, and the hole transport layer are within these ranges, satisfactory hole transporting characteristics may be obtained without a substantial increase in driving voltage. The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be one selected from a quinone derivative, a metal oxide, and a cyano group-containing compound, but embodiments are not limited thereto. Non-limiting examples of the p-dopant are a quinone derivative, such as tetracyanoquinonedimethane (TCNQ) or 2,3,5,6-tetrafluoro-tetracyano-1,4-benzoquinonedimethane (F4-TCNQ); a metal oxide, such as a tungsten oxide or a molybdenium oxide; and a cyano group-containing compound, such as Compound HT-D1 below, but are not limited thereto.

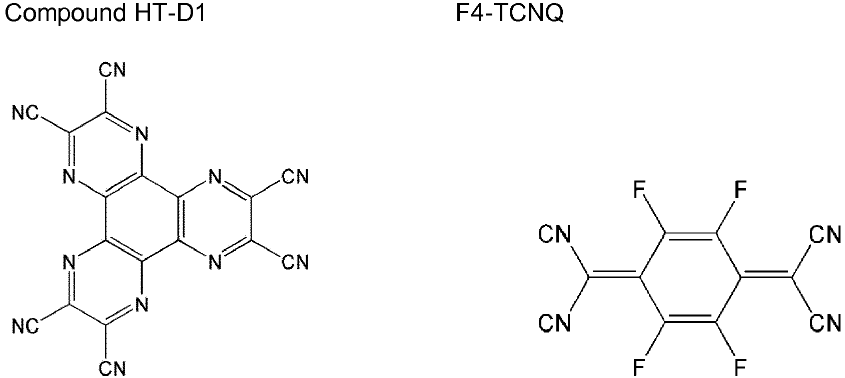

The hole transport region may include a buffer layer.

Also, the buffer layer may compensate for an optical resonance distance according to a wavelength of light emitted from the emission layer, and thus, efficiency of a formed organic light-emitting device may be improved.

Then, an emission layer (EML) may be formed on the hole transport region by vacuum deposition, spin coating, casting, LB deposition, or the like. When the emission layer is formed by vacuum deposition or spin coating, the deposition or coating conditions may be similar to those applied to form the hole injection layer, although the deposition or coating conditions may vary according to the material that is used to form the emission layer. Meanwhile, when the hole transport region includes an electron blocking layer, a material for the electron blocking layer may be selected from materials for the hole region described above and materials for a host to be explained later. However, the material for the electron blocking layer is not limited thereto. For example, when the hole transport region includes an electron blocking layer, a material for the electron blocking may be mCP, which will be explained below.

The emission layer may include a host and a dopant, and the dopant may include the organometallic compound represented by Formula 1.
The host may include at least one selected form TPBi, TBADN, ADN (also referred to as "DNA"), CBP, CDBP, TCP, mCP, Compound H50, and Compound H51:

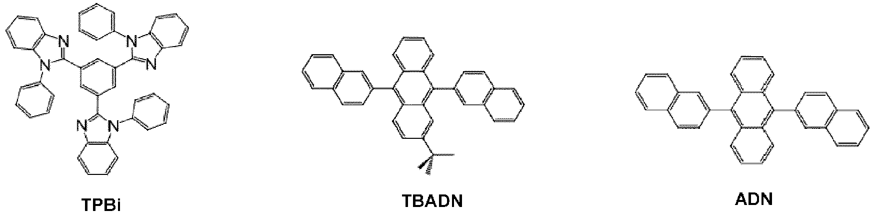

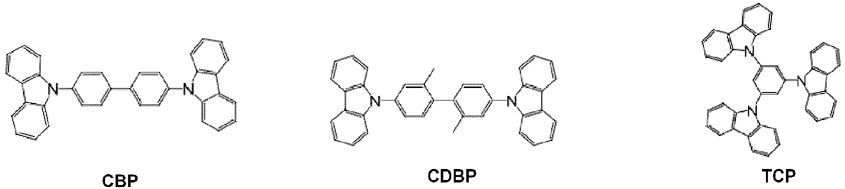

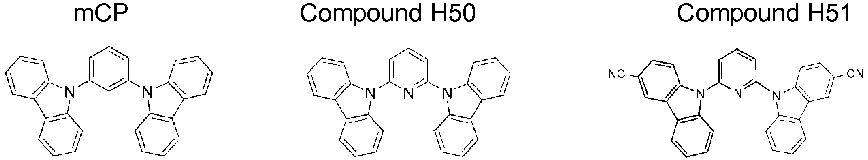

In some embodiments, the host may further include a compound represented by Formula 301 below. 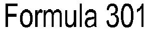 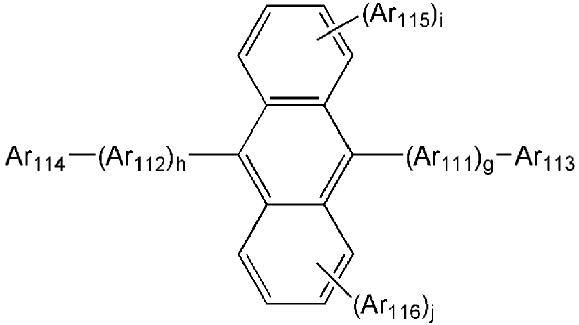 Ar₁₁₁ to Ar₁₁₂ in Formula 301 may be each independently selected from
a phenylene group, a naphthylene group, a phenanthrenylene group, and a pyrenylene group; and
a phenylene group, a naphthylene group, a phenanthrenylene group, and a pyrenylene group, each substituted with at least one selected from a phenyl group, a naphthyl group, and an anthracenyl group.

Ar₁₁₃ to Ar₁₁₆ in Formula 301 may be each independently selected from
a C₁-C₁₀ alkyl group, a phenyl group, a naphthyl group, a phenanthrenyl group, and a pyrenyl group; and
a phenyl group, a naphthyl group, a phenanthrenyl group, and a pyrenyl group, each substituted with at least one selected from a phenyl group, a naphthyl group, and an anthracenyl group.
g, h, i, and j in Formula 301 may be each independently an integer of 0 to 4, for example, an integer of 0, 1, or 2.

Ar₁₁₃ to Ar₁₁₆ in Formula 301 may be each independently selected from
a C₁-C₁₀ alkyl group substituted with at least one selected from a phenyl group, a naphthyl group, and an anthracenyl group;
a phenyl group, a naphthyl group, an anthracenyl group, a pyrenyl, a phenanthrenyl group, and a fluorenyl group;
a phenyl group, a naphthyl group, an anthracenyl group, a pyrenyl group, a phenanthrenyl group, and a fluorenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a phenyl group, a naphthyl group, an anthracenyl group, a pyrenyl group, a phenanthrenyl group, and a fluorenyl group; and 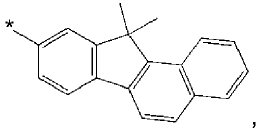 but embodiments are not limited thereto.

In some embodiments, the host may include a compound represented by Formula 302 below:

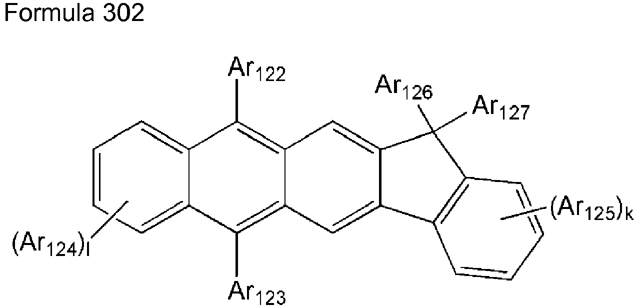

Ar₁₂₂ to Ar₁₂₅ in Formula 302 are the same as described in detail in connection with Ar₁₁₃ in Formula 301.

Ar₁₂₆ and Ar₁₂₇ in Formula 302 may be each independently a C₁-C₁₀ alkyl group (for example, a methyl group, an ethyl group, or a propyl group).

k and I in Formula 302 may be each independently an integer of 0 to 4. For example, k and I may be 0, 1, or 2.
The compound represented by Formula 301 and the compound represented by Formula 302 may include Compounds H1 to H42 illustrated below, but are not limited thereto.

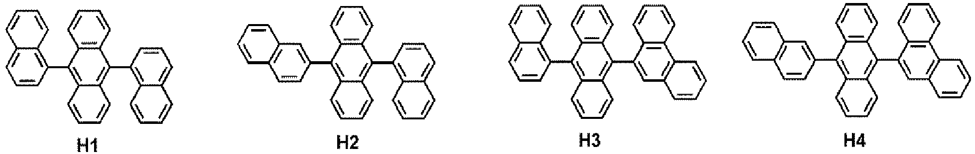

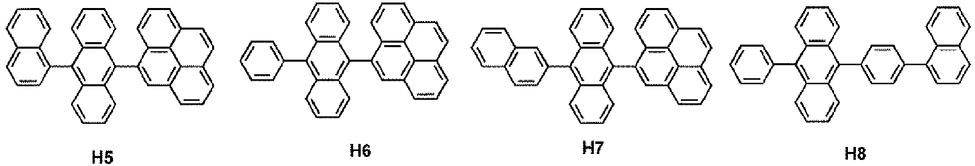

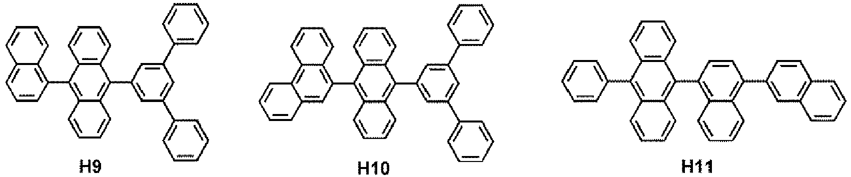

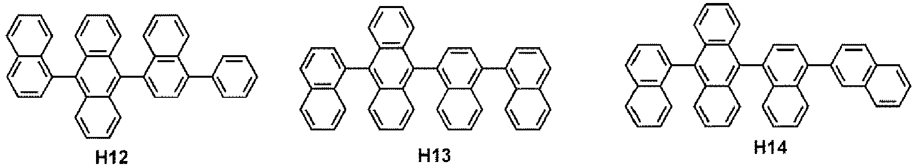

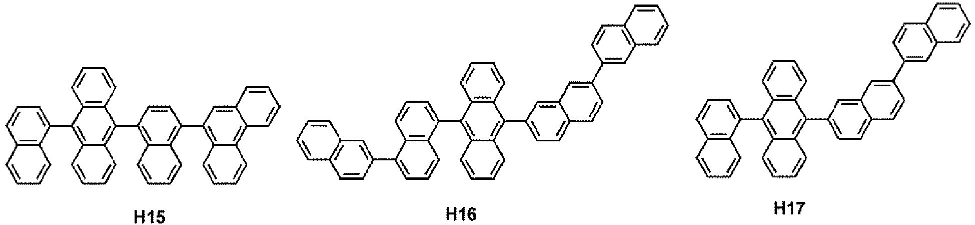

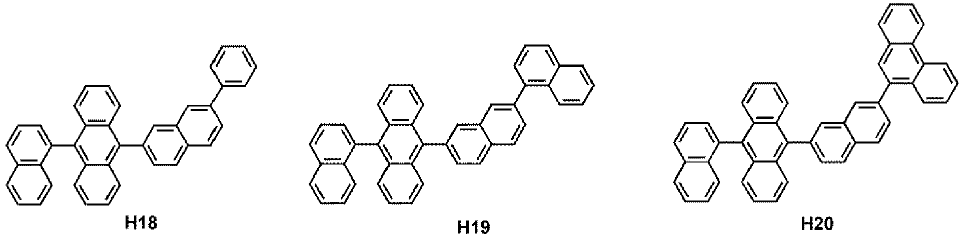

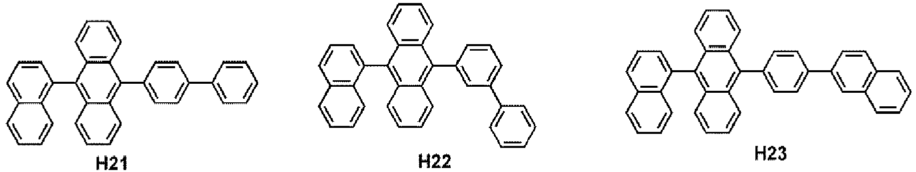

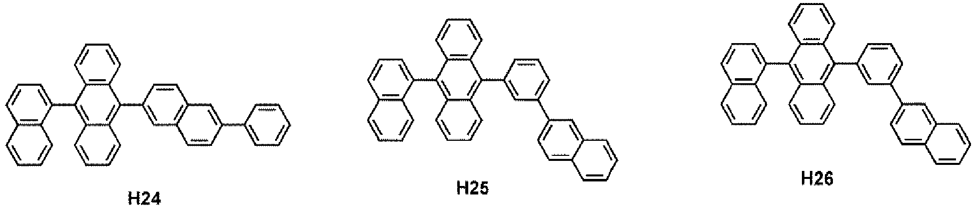

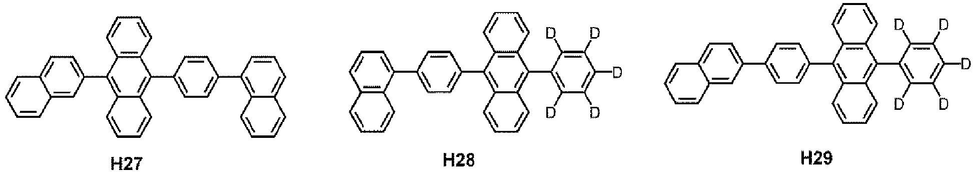

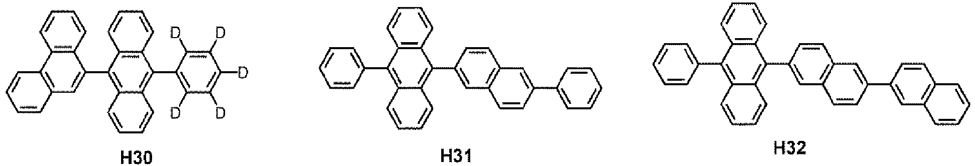

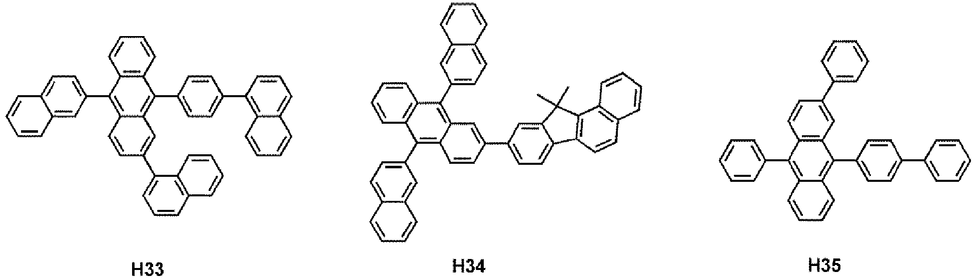

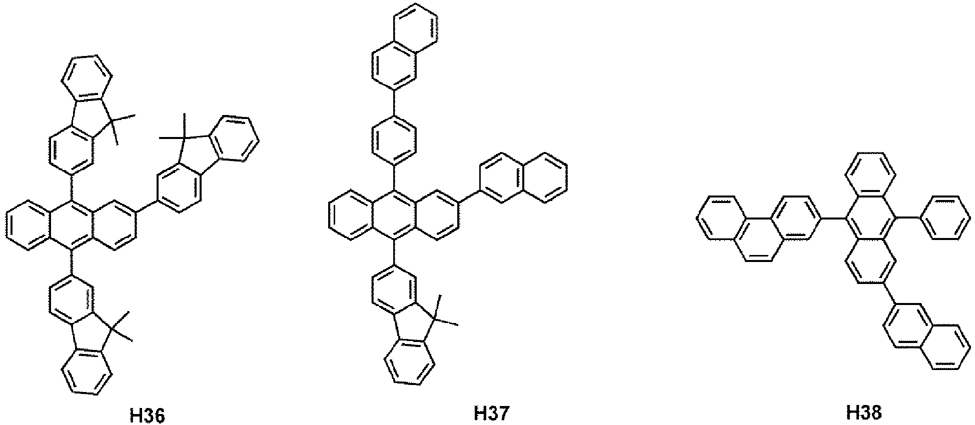

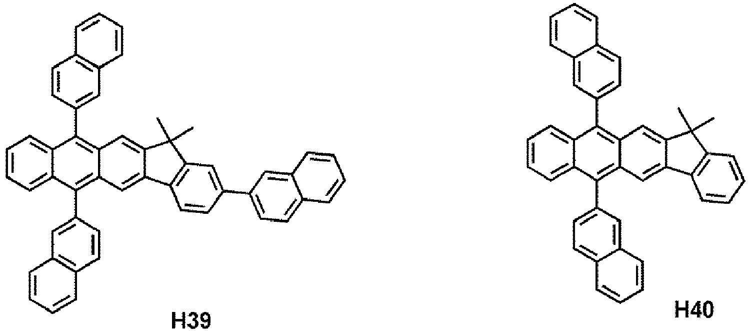

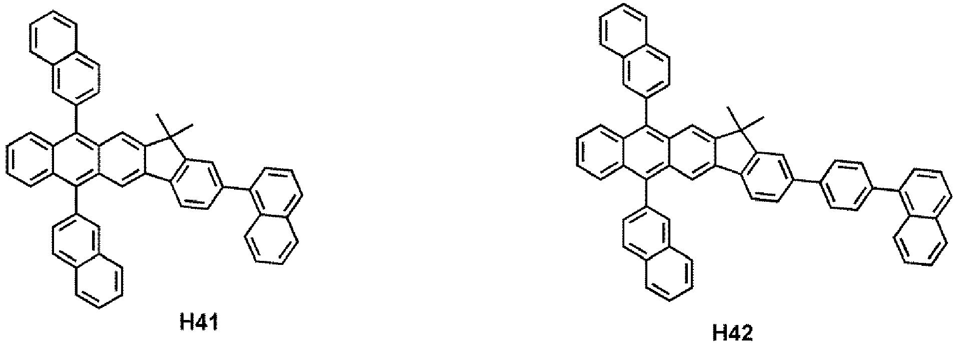

When the organic light-emitting device is a full color organic light-emitting device, emission layer may be patterned into a red emission layer, a green emission layer, and a blue emission layer. In some embodiments, due to a stack structure including a red emission layer, a green emission layer, and/or a blue emission layer, the emission layer emit white light.

When the emission layer includes a host and a dopant, an amount of the dopant may be in a range of about 0.01 to about 15 parts by weight based on 100 parts by weight of the host, but is not limited thereto.

A thickness of the emission layer may be in a range of about 10 nm (100 Å) to about 100 nm (1000 Å), for example, about 20 nm (200 Å) to about 60 nm (600 Å). When the thickness of the emission layer is within this range, excellent light-emission characteristics may be obtained without a substantial increase in driving voltage.

Then, an electron transport region may be disposed on the emission layer.

The electron transport region may include at least one selected from a hole blocking layer, an electron transport layer, and an electron injection layer.

For example, the electron transport region may have a structure of hole blocking layer/electron transport layer/electron injection layer or a structure of electron transport layer/electron injection layer, but the structure of the electron transport region is not limited thereto. The electron transport layer may have a single-layered structure or a multi-layer structure including two or more different materials.

Conditions for forming the hole blocking layer, the electron transport layer, and the electron injection layer which constitute the electron transport region may be understood by referring to the conditions for forming the hole injection layer.

When the electron transport layer includes a hole blocking layer, the hole blocking layer may include, for example, at least one of BCP, Bphen, and Balq but is not limited thereto.

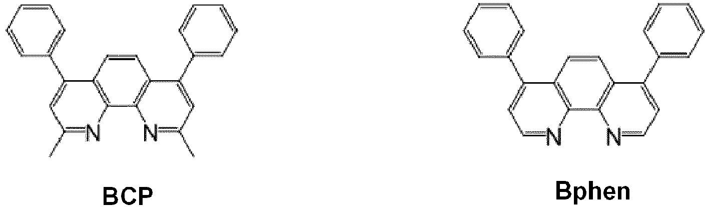

A thickness of the hole blocking layer may be in a range of about 2 nm (20 Å) to about 100 nm (1,000 Å), for example, about 3 nm (30 Å) to about 30 nm (300 Å). When the thickness of the hole blocking layer is within these ranges, the hole blocking layer may have improved hole blocking ability without a substantial increase in driving voltage.

The electron transport layer may further include at least one selected from BCP, Bphen, Alq₃, BAlq, TAZ, and NTAZ.

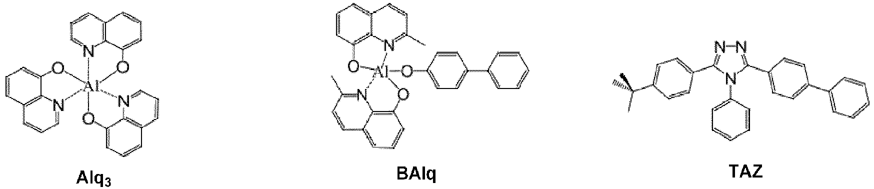

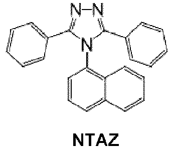

In some embodiments, the electron transport layer may include at least one of ET1 and ET2, but are not limited thereto:

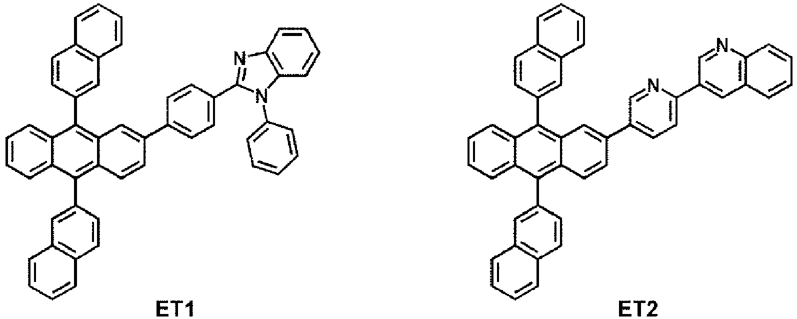

A thickness of the electron transport layer may be in a range of about 10 nm (100 Å) to about 100 nm (1,000 Å), for example, about 15 nm (150 Å) to about 50 nm (500 Å). When the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, Compound ET-D1 (lithium quinolate, LiQ) or ET-D2.

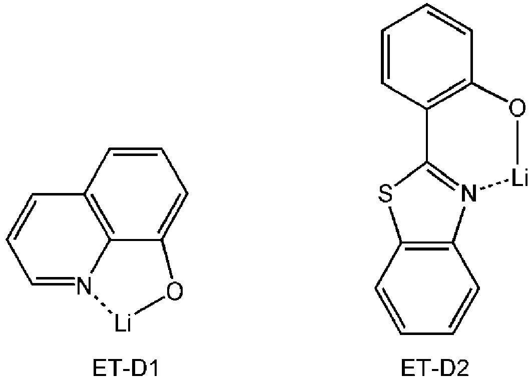

The electron transport region may include an electron injection layer (EIL) that allows electrons to be easily provided from a second electrode 19.

The electron injection layer may include at least one selected from, LiF, NaCl, CsF, Li₂O, BaO, and LiQ.

A thickness of the electron injection layer may be in a range of about 0.1 nm (1 Å) to about 10 nm (100 Å), about 0.3 nm (3 Å) to about 9 nm (90 Å). When the thickness of the electron injection layer is within the range described above, the electron injection layer may have satisfactory electron injection characteristics without a substantial increase in driving voltage.

The second electrode 19 is disposed on the organic layer 15. The second electrode 19 may be a cathode. A material for forming the second electrode 19 may be selected from metal, an alloy, an electrically conductive compound, and a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be used as a material for forming the second electrode 19. In some embodiments, to manufacture a top emission type light-emitting device, a transmissive electrode formed using ITO or IZO may be used as the second electrode 19.

Hereinbefore, the organic light-emitting device has been described with reference to FIG. 1, but is not limited thereto.

A C₁-C₆₀ alkyl group as used herein refers to a linear or branched aliphatic hydrocarbon monovalent group having 1 to 60 carbon atoms. Detailed examples thereof are a methyl group, an ethyl group, a propyl group, an isobutyl group, a sec-butyl group, a tert-butyl group, a pentyl group, an iso-amyl group, and a hexyl group. A C₁-C₆₀ alkylene group as used herein refers to a divalent group having the same structure as the C₁-C₆₀ alkyl group.

A C₁-C₆₀ alkoxy group as used herein refers to a monovalent group represented by -OA₁₀₁ (wherein A₁₀₁ is the C₁-C₆₀ alkyl group). Detailed examples thereof are a methoxy group, an ethoxy group, and an isopropyloxy group.

A C₂-C₆₀ alkenyl group as used herein refers to a hydrocarbon group having at least one carbon-carbon double bond in the middle or at the terminal of the C₂-C₆₀ alkyl group. Detailed examples thereof are an ethenyl group, a propenyl group, and a butenyl group. A C₂-C₆₀ alkenylene group as used herein refers to a divalent group having the same structure as the C₂-C₆₀ alkenyl group.

A C₂-C₆₀ alkynyl group as used herein refers to a hydrocarbon group having at least one carbon-carbon triple bond in the middle or at the terminal of the C₂-C₆₀ alkyl group. Detailed examples thereof are an ethynyl group, and a propynyl group. A C₂-C₆₀ alkynylene group as used herein refers to a divalent group having the same structure as the C₂-C₆₀ alkynyl group.

A C₃-C₁₀ cycloalkyl group as used herein refers to a monovalent hydrocarbon monocyclic group having 3 to 10 carbon atoms. Detailed examples thereof are a cyclopropyl group, a cyclobutyl group, a cyclopentyl group, a cyclohexyl group, and a cycloheptyl group. A C₃-C₁₀ cycloalkylene group as used herein refers to a divalent group having the same structure as the C₃-C₁₀ cycloalkyl group.

A C₁-C₁₀ heterocycloalkyl group as used herein refers to a monovalent monocyclic group having at least one hetero atom selected from N, O, P, and S as a ring-forming atom and 1 to 10 carbon atoms. Detailed examples thereof are a tetrahydrofuranyl group, and a tetrahydrothiophenyl group. A C₁-C₁₀ heterocycloalkylene group as used herein refers to a divalent group having the same structure as the C₁-C₁₀ heterocycloalkyl group.

A C₃-C₁₀ cycloalkenyl group as used herein refers to a monovalent monocyclic group that has 3 to 10 carbon atoms and at least one double bond in the ring thereof, and which is not aromatic. Detailed examples thereof are a cyclopentenyl group, a cyclohexenyl group, and a cycloheptenyl group. A C₃-C₁₀ cycloalkenylene group as used herein refers to a divalent group having the same structure as the C₃-C₁₀ cycloalkenyl group. A C₁-C₁₀ heterocycloalkenyl group as used herein refers to a monovalent group that has at least one hetero atom selected from N, O, P, and S as a ring-forming 1 to 10 carbon atoms, and at least one double bond in its ring. Detailed examples of the C₁-C₁₀ heterocycloalkenyl group are a 2,3-dihydrofuranyl group and a 2,3-group. A C₁-C₁₀ heterocycloalkenylene group as used herein refers to a divalent group having the same structure as the C₁-C₁₀ heterocycloalkenyl group.

A C₆-C₆₀ aryl group as used herein refers to a monovalent group having a carbocyclic aromatic system having 6 to 60 carbon atoms, and a C₆-C₆₀ arylene group as used herein refers to a divalent group having a carbocyclic aromatic system having 6 to 60 carbon atoms. Detailed examples of the C₆-C₆₀ aryl group are a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the rings may be fused to each other.

A C₁-C₆₀ heteroaryl group as used herein refers to a monovalent group having a carbocyclic aromatic system that has at least one hetero atom selected from N, O, P, and S as a ring-forming atom, and 1 to 60 carbon atoms. A C₁-C₆₀ heteroarylene group as used herein refers to a divalent group having a carbocyclic aromatic system that has at least one hetero atom selected from N, O, P, and S as a ring-forming atom, and 1 to 60 carbon atoms. Examples of the C₁-C₆₀ heteroaryl group are a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include two or more rings, the rings may be fused to each other.

A C₆-C₆₀ aryloxy group as used herein indicates -OA₁₀₂ (wherein A₁₀₂ is the C₆-C₆₀ aryl group), and a C₆-C₆₀ arylthio group as used herein indicates -SA₁₀₃ (wherein A₁₀₃ is the C₆-C₆₀ aryl group).

A monovalent non-aromatic condensed polycyclic group as used herein refers to a monovalent group (for example, having 8 to 60 carbon atoms) that has two or more rings condensed to each other, only carbon atoms as a ring forming atom, and which is non-non-aromatic in the entire molecular structure. A detailed example of the monovalent non-non-aromatic condensed polycyclic group is a fluorenyl group. A divalent non-aromatic condensed polycyclic group as used herein refers to a divalent group having the same structure as the monovalent non-aromatic condensed polycyclic group.

A monovalent non-aromatic condensed heteropolycyclic group as used herein refers to a monovalent group (for example, having 2 to 60 carbon atoms) that has two or more rings condensed to each other, has a heteroatom selected from N, O P, and S, other than carbon atoms, as a ring forming atom, and which is non-aromatic in the entire molecular structure. An example of the monovalent non-aromatic condensed heteropolycyclic group is a carbazolyl group. A divalent non-aromatic condensed heteropolycyclic group as used herein refers to a divalent group having the same structure as the monovalent non-aromatic condensed heteropolycyclic group.

At least one of substituents of the substituted C₁-C₆₀ alkyl group, substituted C₂-C₆₀ alkenyl group, substituted C₂-C₆₀ alkynyl group, substituted C₁-C₆₀ alkoxy group, substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₆-C₆₀ aryloxy group, substituted C₆-C₆₀ arylthio group, substituted C₁-C₆₀ heteroaryl group, substituted monovalent non-aromatic condensed polycyclic group, and substituted monovalent non-aromatic condensed heteropolycyclic group is selected from
a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from a deuterium, -F, -Cl, -Br, -I,-CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -B(Q₁₆)(Q₁₇), and-P(=O)(Q₁₈)(Q₁₉); a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from a deuterium, -F, -Cl, -Br, -I, -CD₃, -CD₂H,--CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed group, a monovalent non-aromatic condensed heteropolycyclic group, -N(Q₂₁)(Q₂₂),--Si(Q₂₃)(Q₂₄)(Q₂₅), -B(Q₂₆)(Q₂₇), and -P(=O)(Q₂₈)(Q₂₉); and

-N(Q₃₁)(Q₃₂), -Si(Q₃₃)(Q₃₄)(Q₃₅), -B(Q₃₆)(Q₃₇), and -P(=O)(Q₃₈)(Q₃₉);

wherein Q₁ to Q₉, Q₁₁ to Q₁₉, Q₂₁ to Q₂₉, and Q₃₁ to Q₃₉ may be each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group.

Hereinafter, a compound and an organic light-emitting device according to embodiments are described in detail with reference to Synthesis Example and Examples. However, the organic light-emitting device is not limited thereto. The wording "B was used instead of A" used in describing Synthesis Examples means that an amount of A used was identical to an amount of B used, in terms of a molar equivalent.

### Example

### Synthesis Example 1: Synthesis of Compound 1

### Synthesis of Compound A1

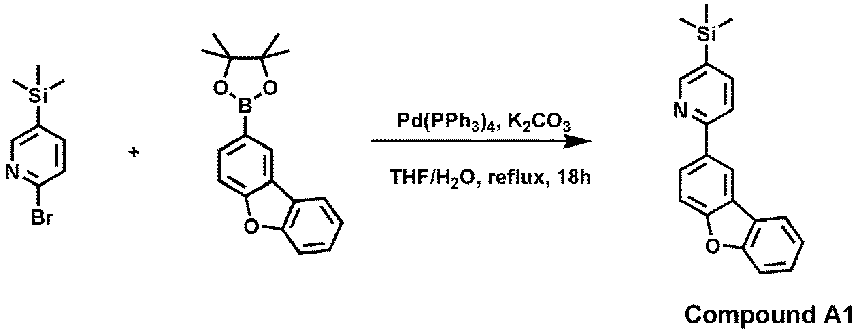

210 milliliters (mL) of tetrahydrofuran (THF) and 70 mL of distilled water were mixed with 2-bromo-5-(trimethylsilyl)pyridine (9 grams (g), 39.09 millimoles (mmol)), 2-(dibenzo[b,d]furan-2-yl)-4,4,5,5-tetramethyl-1,3,2-dioxaborolane (13.22 g, 44.96 mmol), Pd(PPh₃)₄ (2.26 g, 1.95 mmol), and K₂CO₃ (16.21 g, 117.27 mmol). The resultant mixture was stirred under reflux for 18 hours. The temperature was decreased to room temperature (about 25°C). The product was extracted by using methylene chloride (MC). The organic layer was dried with anhydrous magnesium sulfate (MgSO₄) and the solution was filtered. The obtained filtrate was concentrated and the obtained residual was purified by column chromatography (MC:Hexane = 1:1) to obtain 7.4 g (60%) of Compound A1.

### Synthesis of Compound M2A

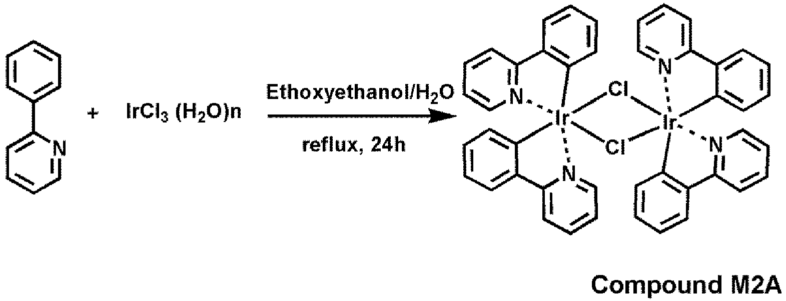

2-phenylpyridine (14.66 g, 94.44 mmol) and iridium chloride (14.80 g, 41.97 mmol) were mixed with 210 mL of ethoxyethanol and 70 mL of distilled water. The mixture was stirred under reflux for 24 hours to carry out the reaction. Upon completion of the reaction, the temperature was reduced to room temperature. The resultant solid was separated by filtration and thoroughly washed with water, methanol, and hexane in the stated order. The obtained solid was dried in a vacuum oven to obtain 19.5 g (87%) of Compound M2A.

### Synthesis of Compound M1A

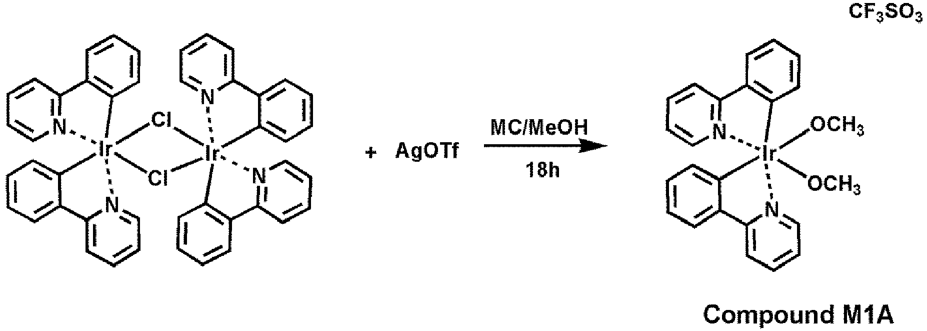

Compound M2A (6.01 g, 5.60 mmol) was mixed with 45 mL of MC, and a solution of AgOTf (2.88 g, 11.21 mmol) in 15 mL of methanol was added thereto. The flask was wrapped with an aluminum foil to block the sunlight, and the mixture was stirred at room temperature for 18 hours to carry out the reaction. The generated solid was removed by celite filtration, and a filtrate was concentrated under reduced pressure. The obtained (Compound M1A) was used for the subsequent reaction without purification.

### Synthesis of Compound 1

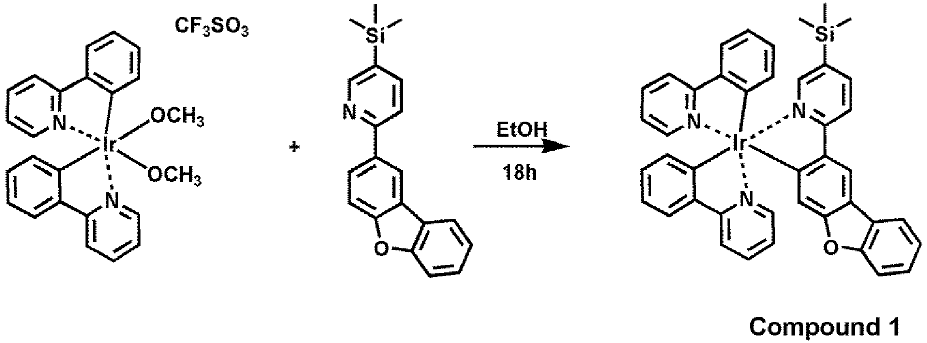

Compound M1A (8 g, 11.22 mmol) and Compound A1 (4.28 g, 13.47 mmol) were mixed with 100 mL of ethanol, and the resulting mixture was stirred under reflux for 18 hours to carry out the reaction. Upon completion of the reaction, the temperature was reduced to room temperature. The resultant mixture was filtered to separate a solid, which was thoroughly washed with ethanol and hexane. The product was purified by column chromatography (MC: hexane=40:60) to obtain 2.54 g (28%) of Compound 1. The obtained product was confirmed by Mass Spectroscopy and HPLC analysis.
HRMS(MALDI) calcd for C₄₂H₃₄IrN₃OSi: m/z 817.2100, Found: 817.2104

### Synthesis Example 2: Synthesis of Compound 3

### Synthesis of Compound B1

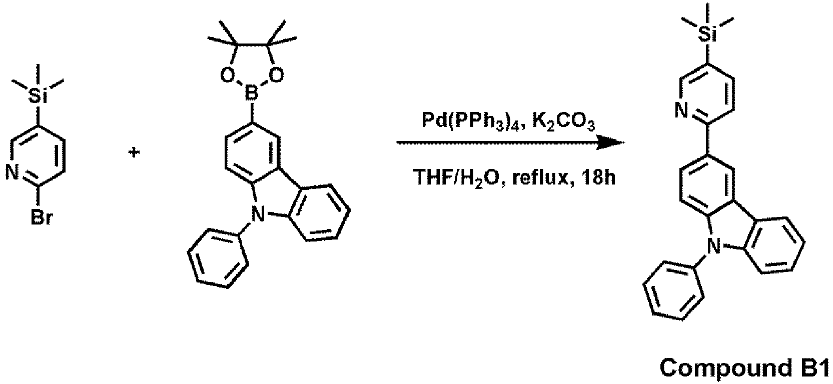

8.5 g (55%) of Compound B1 was prepared in the same manner as used to synthesize Compound A1 in Synthesis Example 1, except that 2-bromo-5-(trimethylsilyl)pyridine (9 g, 39.09 mmol) and 9-phenyl-3-(4,4,5,5-tetramethyl-1,3,2-dioxaborolan-2-yl)-9H-carbazole (13.47 g, 46.92 mmol) were used instead of 2-bromo-5-(trimethylsilyl)pyridine (9 g, 39.09 mmol) and 2-(dibenzo[b,d]furan-2-yl)-4,4,5,5-tetramethyl-1,3,2-dioxaborolane (13.22 g, 44.96 mmol), respectively.

### Synthesis of Compound 3

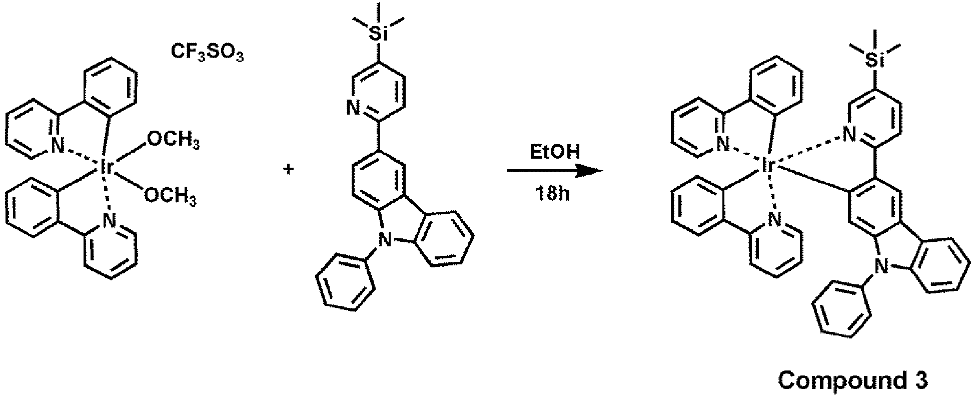

2.4 g (32%) of Compound 3 was obtained in the same manner as used to Compound 1 in Synthesis Example 1, except that Compound M1A (6.00 g, 8.42 mmol) Compound B1 (3.97 g, 10.10 mmol) were used instead of Compound M1A (8 g, 11.22 and Compound A1 (4.28 g, 13.47 mmol), respectively. The obtained product was confirmed by Mass Spectroscopy and HPLC analysis.
HRMS(MALDI) calcd for C₄₈H₃₉IrN₄Si: m/z 892.2573, Found: 892.2575

### Synthesis Example 3: Synthesis of Compound 8

### Synthesis of Compound C3

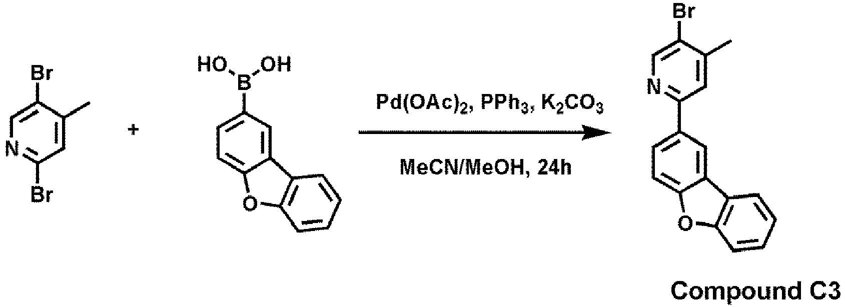

2,5-dibromo-4-methylpyridine (18.55 g, 73.92 mmol), dibenzo[b,d]furan-2-ylboronic acid (18.81 g, 88.70 mmol), Pd(OAc)₂ (1.66 g, 7.39 mmol), PPh₃ (3.88 g, 14.78 mmol), and K₂CO₃ (20.43 g, 147.84 mmol) were mixed with 200 mL of acetonitrile and 100 mL of methanol. The resultant mixture was stirred at a temperature of 50°C for 18 hours. Upon completion, the reaction mixture was cooled to room temperature and filtered. The product was extracted with methylene chloride (MC). The combined organic extracts were dried over anhydrous magnesium sulfate (MgSO₄) and filtered. A filtrate was subjected to reduced pressure and the obtained residual was purified by column chromatography (MC:Hx = 60:40) to obtain 13.0 g (52%) of Compound C3.

### Synthesis of Compound C2

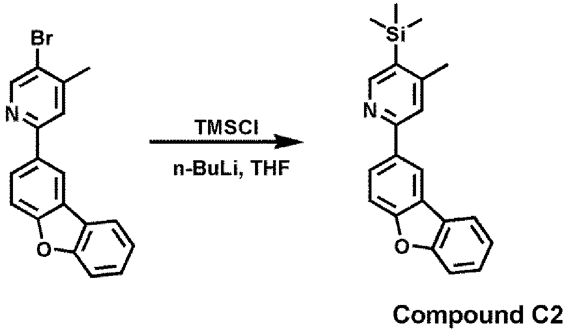

300 mL of THF was added to Compound C3 (12.24 g, 36.20 mmol) and the mixture was cooled to a temperature of -78°C. A 1.6 molar (M) solution of n-BuLi (33.94 mL, 54.30 mmol) was slowly added thereto, and the resulting mixture was stirred at a temperature of -78°C for 1 hour. TMSCI (6.89 mL, 54.30 mmol) was added thereto, and a reaction was carried out at a temperature of -78°C for 1 hour, and then warmed to room temperature and the reaction was continued for 12 hours. The organic layer separated therefrom was extracted with methylene chloride (MC). and the combined organic extracts were dried with anhydrous magnesium sulfate. The dried solution was filtered and the filtrate was concentrated under reduced pressure. The crude product was purified by column chromatography (EA:Hexane = 4:96) to obtain 8.0 g (67%) of Compound C2.

### Synthesis of Compound 8

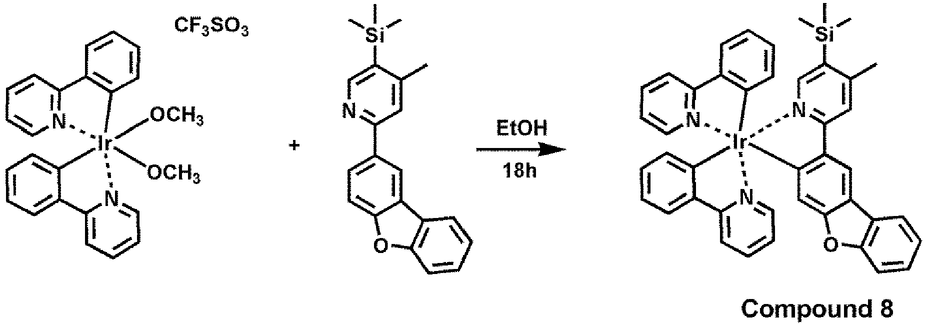

2.05 g (29%) of Compound 8 was prepared in the same manner as Compound 1 in Synthesis Example 1, except that Compound M1A (6.00 g, 8.42 mmol) and Compound C2 (3.35 g, 10.11 mmol) were used instead of Compound M1A (8 g, 11.22 mmol) and Compound A1 (4.46 g, 13.47 mmol), respectively. The obtained product was confirmed by Mass Spectroscopy and HPLC analysis.
HRMS(MALDI) calcd for C₄₃H₃₆IrN₃OSi: m/z 831.2257, Found: 831.2259

### Synthesis Example 4: Synthesis of Compound 22

### Synthesis of Compound C1

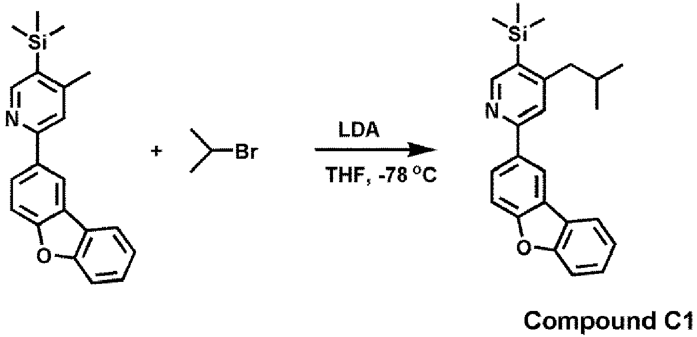

Compound C2 (7.1 g, 21.42 mmol) was mixed with 100 mL of THF, and the mixture was cooled to a temperature of -78°C. Lithium diisopropylamide (LDA, 26.8 mL, 53.54 mmol) was slowly added thereto. The resulting mixture was stirred at a temperature of -78°C for 1 hour and at room temperature for 1.5 hours to perform the reaction. The temperature was reduced to -78°C. 2-bromopropane (5.03 mL, 53.54 mmol) was slowly added to the resulting mixture, the reaction mixture was warmed to room temperature, and the reaction was carried out for 12 hours. The product was extracted with MC. The combined organic extracts were dried over anhydrous magnesium sulfate. The dried organic solution was filtered and a filtrate was concentrated under reduced pressure. The product was purified by column chromatography (EA:Hexane = 4:96) to obtain 6.80 g of Compound C1.

### Synthesis of Compound 22

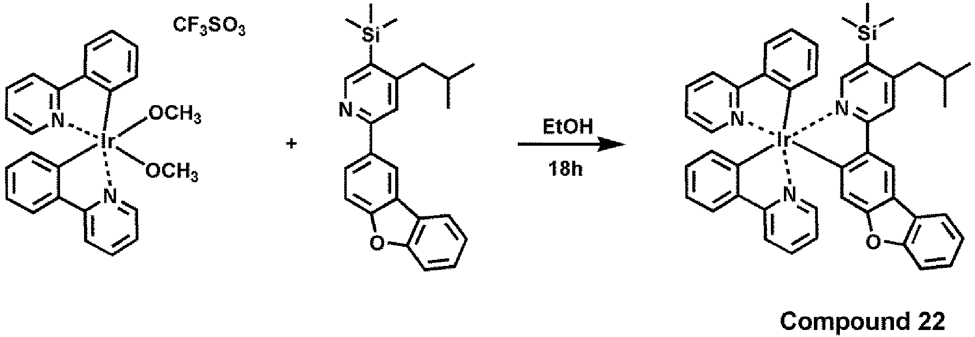

2.30 g (31%) of Compound 22 was prepared in the same manner as Compound 1 in Synthesis Example 1, except that Compound M1A (6.00 g, 8.42 mmol) and Compound C1 (3.77 g, 10.10 mmol) were used instead of Compound M1A (8g, 11.22 mmol) and Compound A1 (4.28 g, 13.47 mmol), respectively. The obtained product was confirmed by Mass Spectroscopy and HPLC analysis.
HRMS(MALDI) calcd for C₄₆H₄₂IrN₃OSi: m/z 873.2726, Found: 873.2720

### Synthesis Example 5: Synthesis of Compound 35

### Synthesis of Compound D3

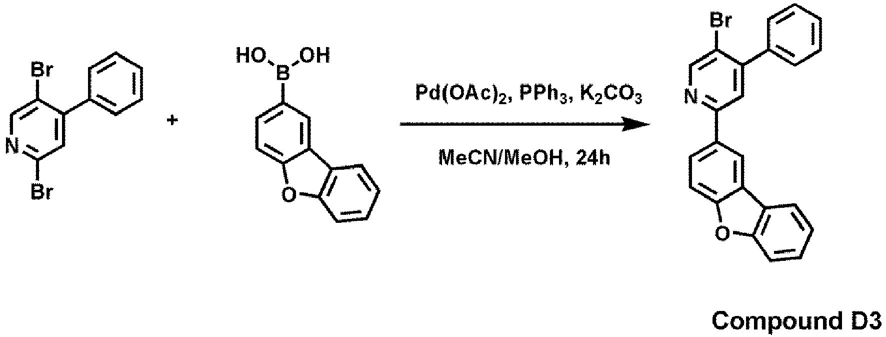

13.7 g (69%) of Compound D3 was prepared in the same manner as Compound C3 of Synthesis Example 3, except that 2,5-dibromo-4-phenylpyridine (15.64 g, 49.97 mmol) and dibenzo[b,d]furan-2-ylboronic acid (12.71 g, 55.96 mmol) were used instead of 2,5-dibromo-4-methylpyridine (18.55 g, 73.92 mmol) and dibenzo[b,d]furan-2-ylboronic acid (18.81 g, 88.70 mmol), respectively.

### Synthesis of Compound D2

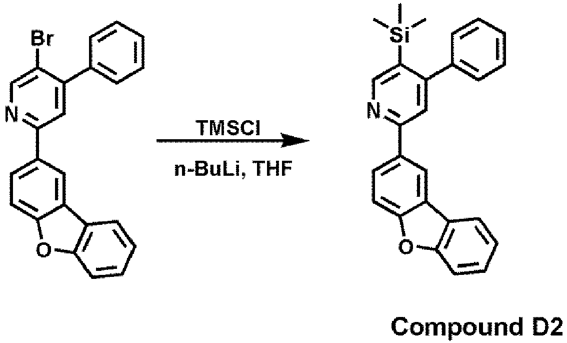

6.6 g (66%) of Compound D2 was prepared in the same manner as Compound C2 in Synthesis Example 3, except that Compound D3 (10.17 g, 25.41 mmol) was used instead of Compound C3 (12.24 g, 36.20 mmol).

### Synthesis of Compound 35

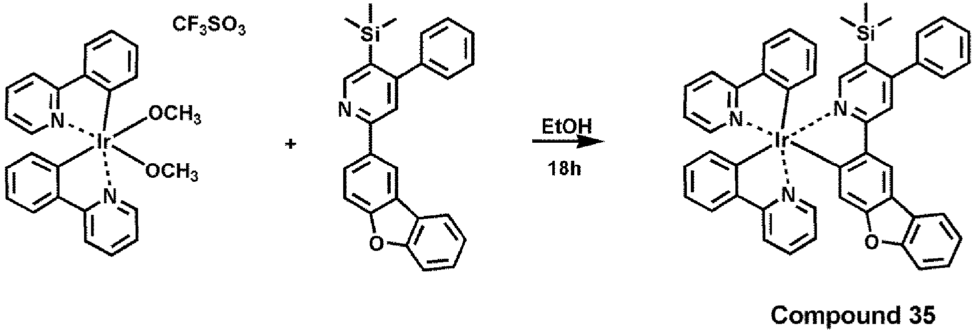

1.8 g (24%) of Compound 35 was prepared in the same manner as Compound 1 in Synthesis Example 1, except that Compound M1A (6.00 g, 8.41 mmol) and Compound D2 (3.97 g, 10.09 mmol) were used instead of Compound M1A (8 g, 11.22 mmol) and Compound A1 (4.46 g, 13.47 mmol), respectively. The obtained product was confirmed by Mass Spectroscopy and HPLC analysis.
HRMS(MALDI) calcd for C₄₈H₃₈IrN₃OSi: m/z 893.2413, Found: 893.2417

### Synthesis Example 6: Synthesis of Compound 300

### Synthesis of Compound M2B

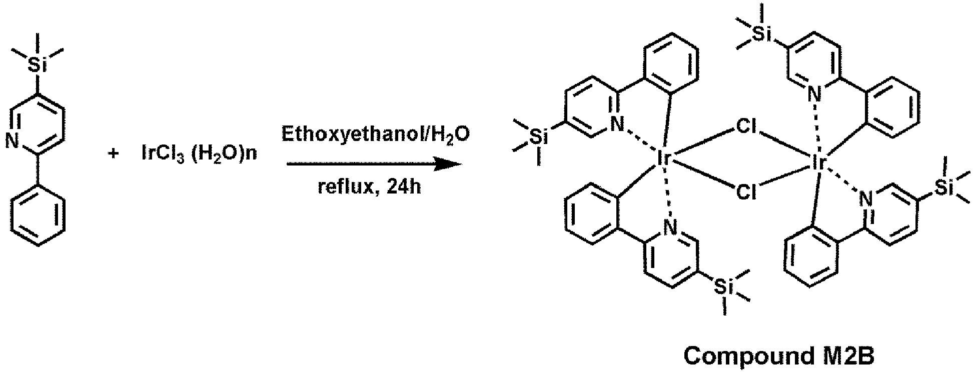

17.2 g (86%) of Compound M2B was prepared in the same manner as Compound M2A in Synthesis Example 1, except that 2-phenyl-5-(trimethylsilyl)pyridine (15.05 g, 66.14 mmol) and iridium chloride (4.10 g, 11.62 mmol) were respectively used instead of 2-2-phenylpyridine (14.66 g, 94.44 mmol) and iridium chloride (14.80 g, 41.97 mmol).

### Synthesis of Compound M1 B

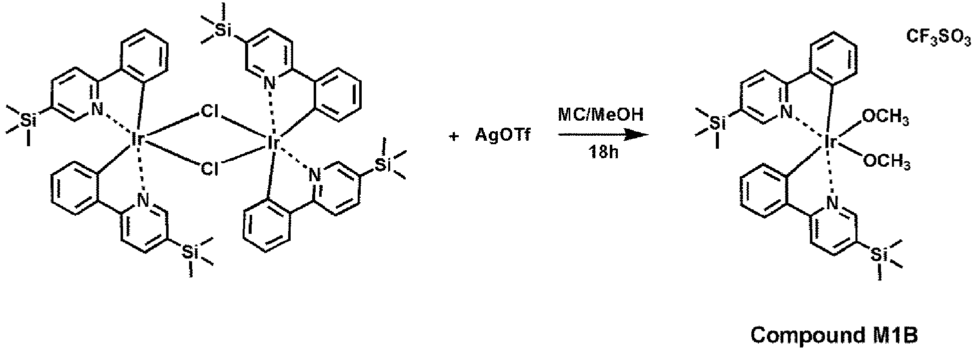

Compound M1 B was prepared in the same manner as Compound M1A in Synthesis Example 1, except that Compound M2B (4.76 g, 3.5 mmol) was used instead of Compound M2A (6.01 g, 5.60 mmol).

### Synthesis of Compound 300

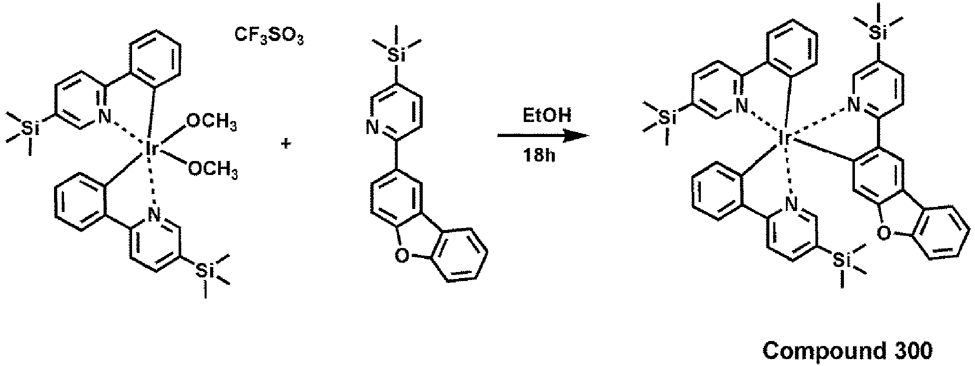

1.3 g (19%) of Compound 300 was prepared in the same manner as Compound 1 Synthesis Example 1, except that Compound M1 B (6.00 g, 6.99 mmol) and Compound A1 (2.66 g, 8.39 mmol) were used instead of Compound M1A (8 g, 11.22 mmol) and A1 (4.46 g, 13.47 mmol), respectively. The obtained product was confirmed by Mass Spectroscopy and HPLC analysis.
HRMS(MALDI) calcd for C₄₈H₅₀IrN₃OSi₃: m/z 961.2891, Found: 961.2887

### Synthesis Example 7: Synthesis of Compound 305

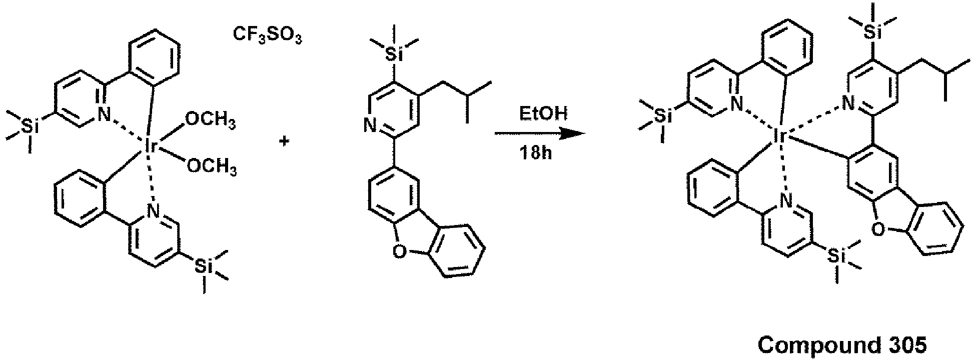

1.4 g (20%) of Compound 305 was prepared in the same manner as Compound 1 in Synthesis Example 1, except that Compound M1 B (6.00 g, 6.99 mmol) and Compound C1 (3.14 g, 8.39 mmol) were used instead of Compound M1A (8 g, 11.22 mmol) and Compound A1 (4.46 g, 13.47 mmol), respectively. The obtained product was confirmed by Mass Spectroscopy and HPLC analysis.
HRMS(MALDI) calcd for C₅₂H₅₈IrN₃OSi₃: m/z 1017.3517, Found: 1017.3512

### Synthesis Example 8: Synthesis of Compound 322

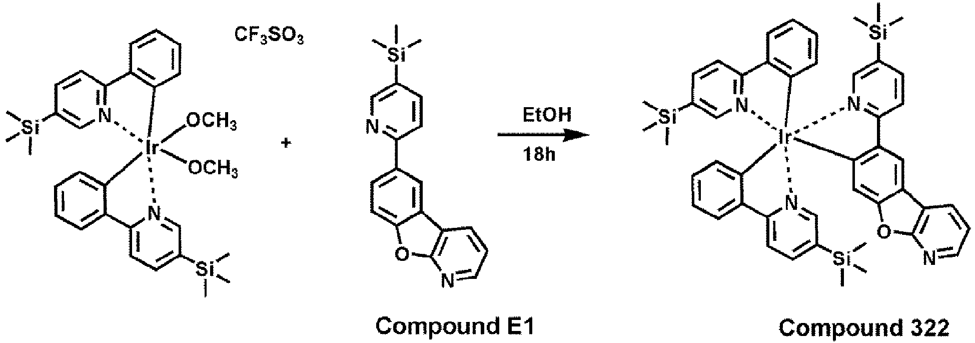

1.1 g (16%) of Compound 322 was prepared in the same manner as used to synthesize Compound 1 in Synthesis Example 1, except that Compound M1B (6.00 g, 6.99 mmol) and Compound E1 (2.78 g, 8.74 mmol) were used instead of Compound M1A (8g, 11.22 mmol) and Compound A1 (4.46 g, 13.47 mmol), respectively. The obtained product was confirmed by Mass Spectroscopy and HPLC analysis.
HRMS(MALDI) calcd for C₄₇H₄₉IrN₄OSi₃: m/z 962.2843, Found: 962.2843

### Synthesis Example 9: Synthesis of Compound 327

### Synthesis of Compound M2C

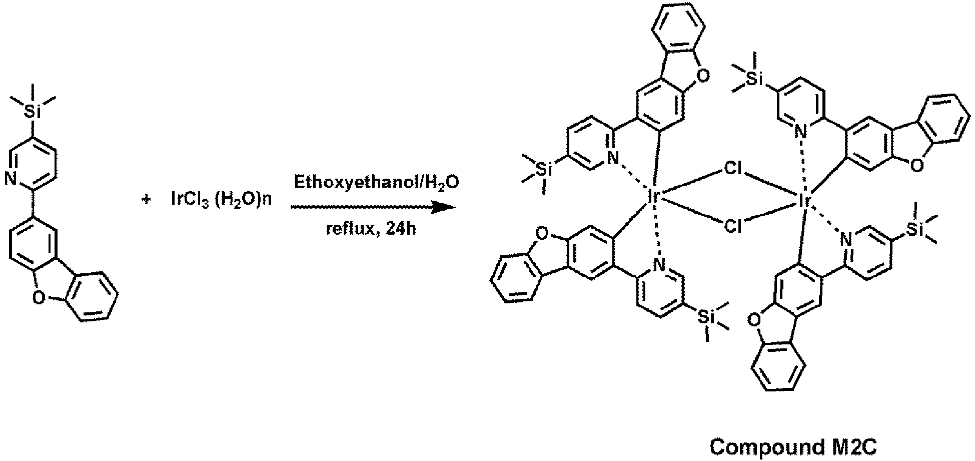

8.3 g (83%) of Compound M2C was prepared in the same manner as Compound M2A in Synthesis Example 1, except that Compound A1 (8.3 g, 26.15 mmol) and iridium chloride (4.10 g, 11.62 mmol) were used instead of 2-phenylpyridine (14.66 g, 94.44 mmol) and iridium chloride (14.80 g, 41.97 mmol), respectively.

### Synthesis of Compound M1C

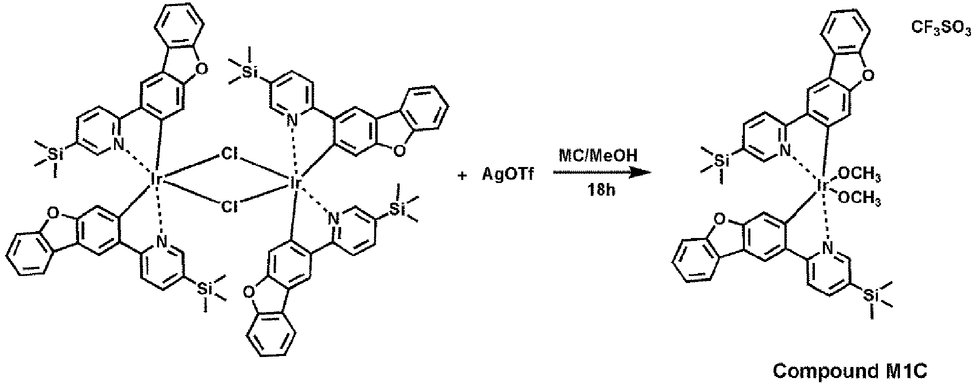

Compound M1C was prepared in the same manner as Compound M1A in Synthesis Example 1, except that Compound M2C (4.973 g, 2.89 mmol) was used instead of Compound M2A (6.01 g, 5.60 mmol).

### Synthesis of Compound 293

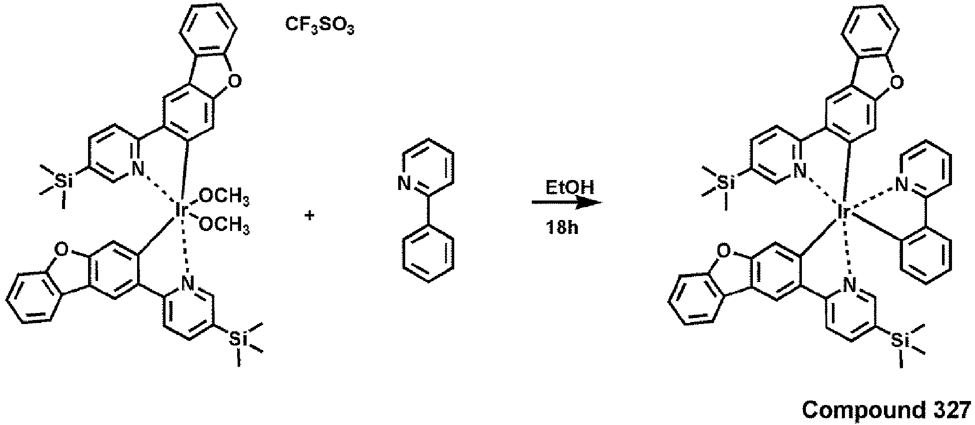

1.4 g (25%) of Compound 327 was prepared in the same manner as Compound 1 in Synthesis Example 1, except that Compound M1 C (6.00 g, 5.78 mmol) and phenylpyridine (1.08 g, 6.94 mmol) were used instead of Compound M1A (8g, 11.22 mmol) and Compound A1 (4.46 g, 13.47 mmol), respectively. The obtained product was confirmed by Mass Spectroscopy and HPLC analysis.
HRMS(MALDI) calcd for C₅₁H₄₄IrN₃O₂Si₂: m/z 979.2601, Found: 979.2603

### Example 1

An ITO glass substrate was cut to a size of 50 millimeters (mm) x 50 mm x 0.5 mm, sonicated in acetone, isopropyl alcohol, and pure water, for 15 minutes in each solvent, and washed by exposure to UV ozone for 30 minutes.

Subsequently, on the ITO electrode (anode) on the glass substrate, m-MTDATA was deposited at a deposition speed of 0.1 nm/sec (1 Å/sec) to form a hole injection layer having a thickness of 60 nm (600 Å), and α-NPD was deposited on the hole injection layer at a deposition rate of 0.1 nm/sec (1 Å/sec) to form a hole transport layer having a thickness of 25 nm (250 Å).

Compound 1 (dopant) and CBP (host) were co-deposited on the hole transport layer at a deposition rate of 0.01 nm/sec (0.1 Å/sec) and a deposition rate of 0.1 nm/sec (1 Å/sec), respectively, to form an emission layer having a thickness of 40 nm (400 Å).

BAlq was deposited on the emission layer at a deposition rate of 0.1 nm/sec (1 Å/sec) to form a hole blocking layer having a thickness of 5 nm (50 Å), and Alq₃ was deposited on the hole blocking layer to form an electron transport layer having a thickness of 30 nm (300 Å). Subsequently, LiF was deposited on the electron transport layer to form an electron injection layer having a thickness of 1 nm (10 Å), and Al was vacuum deposited on the electron injection layer to form a second electrode (cathode) having a thickness of 120 nm (1,200 Å), thereby completing the manufacture of an organic light-emitting device having a structure of ITO / m-MTDATA (600Å) / α-NPD (250 Å) / CBP + 10% (Compound 1) (400 Å) / Balq(50Å) /Alq₃(300 Å) / LiF(10 Å) / Al(1,200 Å).

### Examples 2 to 9 and Comparative Example 1

Organic light-emitting devices were manufactured in the same manner as in Example 1, except that in forming an emission layer, corresponding compounds shown in Table 2 were used as a dopant instead of Compound 1.

Evaluation Example 1: Evaluation on characteristics of organic light-emitting devices. The driving voltage, efficiency, power, color purity, and lifespan (T₉₅) of the organic light-emitting devices manufactured according to Examples 1 to 9 and Comparative Example 1 were evaluated. Results thereof are shown in Table 2. This evaluation was performed using a current-voltage meter (Keithley 2400) and a luminescence meter (Minolta Cs-1000A), and the lifespan (T₉₅)(at 6000 nit) was evaluated by measuring the amount of time that elapsed until luminance was reduced to 95% of the initial brightness of

**Table 2**

| | Dopant | Driving Voltage (V) | Efficiency (cd/A) | Power (Im/W) | CIEx | CIEy | Lifespan (hr) (T₉₅) |
|---|---|---|---|---|---|---|---|
| Example 1 | Compound 1 | 5.0 | 49.0 | 30.8 | 0.339 | 0.605 | 210 |
| Example 2 | Compound 3 | 4.8 | 47.5 | 31.1 | 0.340 | 0.602 | 145 |
| Example 3 | Compound 8 | 4.9 | 48.0 | 30.8 | 0.338 | 0.607 | 195 |
| Example 4 | Compound 22 | 5.0 | 48.5 | 30.5 | 0.336 | 0.604 | 200 |
| Example 5 | Compound 35 | 5.2 | 50.5 | 30.5 | 0.356 | 0.605 | 230 |
| Example 6 | Compound 300 | 4.8 | 51.0 | 33.4 | 0.360 | 0.607 | 230 |
| Example 7 | Compound 305 | 4.9 | 50.0 | 32.0 | 0.345 | 0.605 | 210 |
| Example 8 | Compound 322 | 4.9 | 51.5 | 33.0 | 0.355 | 0.604 | 150 |
| Example 9 | Compound 327 | 4.6 | 50.5 | 34.5 | 0.340 | 0.607 | 180 |
| Comparative Example 1 | Compound A | 5.1 | 47.5 | 29.2 | 0.340 | 0.607 | 85 |

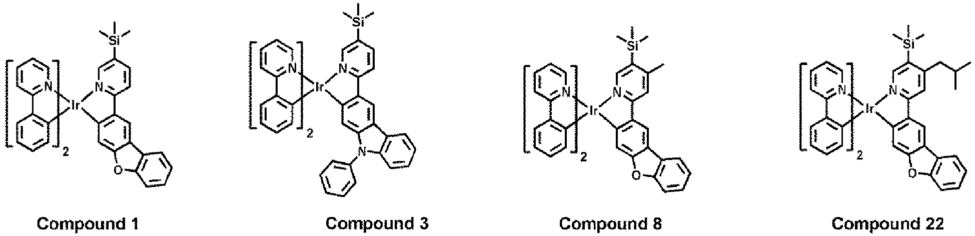

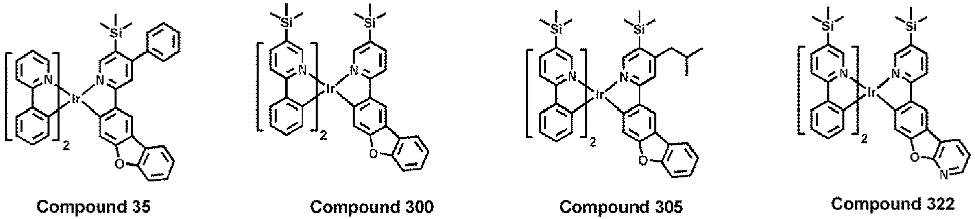

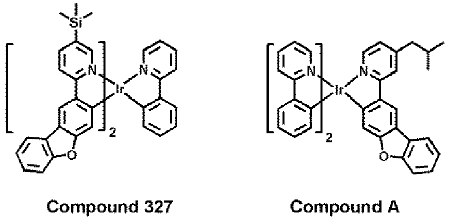

Referring to Table 2, it was confirmed that the organic light-emitting devices manufactured according to Examples 1 to 9 have a lower driving voltage, higher efficiency, higher power, higher color purity, and a longer lifespan, than the organic light-emitting devices manufactured according to Comparative Example 1.

The organometallic compound according to embodiments has excellent electric characteristics and thermal stability. Accordingly, an organic light-emitting device including the organometallic compound may have excellent driving voltage, efficiency, power, color purity, and lifespan characteristics.

It should be understood that the exemplary embodiments described therein should be considered in a descriptive sense only and not for purposes of limitation. Descriptions features or aspects within each exemplary embodiment should typically be considered as available for other similar features or aspects in other exemplary embodiments.

While one or more exemplary embodiments have been described with reference to the figures, it will be understood by those of ordinary skill in the art that various changes in form and details may be made therein without departing from the scope of the present inventive concept as defined by the following claims.

## Claims

1. An organometallic compound represented by Formula 1:
Formula 1 M(L₁)ₙ₁(L₂)ₙ₂ 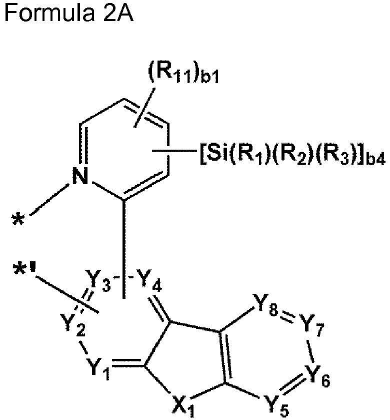
wherein
M in Formula 1 is selected from Ir, Pt, Os, Ti, Zr, Hf, Eu, Tb, Tm, and Rh,
in Formula 1, L₁ is a ligand represented by Formula 2A, n1 is 1, 2, or 3, and when n1 is 2 or more, 2 or more L₁ are identical or different,
in Formula 1, L₂ is selected from a monovalent organic ligand, a divalent organic ligand, a trivalent organic ligand, and a tetravalent organic ligand, n2 is 0, 1, 2, 3, or 4, and when n2 is 2 or more, 2 or more L₂ are identical or different,
L₁ and L₂ in Formula 1 are different from each other,
R₁ to R₃ in Formula 2A are each independently selected from a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ group, a substituted or unsubstituted C₁-C₆₀ heteroaryl group, a substituted or monovalent non-aromatic condensed polycyclic group, a substituted or unsubstituted monovalent non-aromatic condensed heteropolycyclic group, and -Si(Q₅₁)(Q₅₂)(Q₅₃),
X₁ in Formula 2A is selected from O, S, S(=O)₂, N(R₂₁), and Si(R₂₂)(R₂₃),
in Formula 2A, Y₁ is N, C(R₄₁), or a carbon atom connected to a pyridine ring, Y₂ is N, C(R₄₂), or a carbon atom connected to a pyridine ring, Y₃ is N, C(R₄₃), or a carbon atom connected to a pyridine ring, Y₄ is N, C(R₄₄), or a carbon atom connected to a pyridine ring, Y₅ is N or C(R₄₅), Y₆ is N or C(R₄₆), Y₇ is N or C(R₄₇), Y₈ is N or C(R₄₈), and one of Y₁ to Y₄ is a carbon atom connected to a pyridine ring,
R₁₁, R₂₁ to R₂₃ and R₄₁ to R₄₈ in Formula 2A are each independently selected from hydrogen, a deuterium, -F, -Cl, -Br, -I, -SF₅, a hydroxyl group, a cyano group, a nitro an amino group, an amidino group, a hydrazine group, a hydrazone group, a carboxylic group or a salt thereof, a sulfonic acid group or a salt thereof, a phosphoric acid group or a salt thereof, a substituted or unsubstituted C₁-C₆₀ alkyl group, a substituted or C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, substituted or unsubstituted C₆-C₆₀ aryl group, a substituted or unsubstituted C₆-C₆₀ group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), and--P(=O)(Q₈)(Q₉), and 2 or more R₁₁ optionally are linked to each other to form a saturated unsaturated C₄-C₆₀ ring, two or more of R₄₁ to R₄₄ are optionally linked to each other to a saturated or unsaturated C₄-C₆₀ ring, and two or more R₄₅ to R₄₈ are optionally linked to each other to form a saturated or unsaturated C₄-C₆₀ ring,
in Formula 2A, b1 is an integer selected from 0 to 3, and b4 is an integer selected from 1 to 4,
* and *' in Formula 2A are binding sites to M in Formula 1,
at least one of substituents of the substituted C₁-C₆₀ alkyl group, substituted C₂-C₆₀ alkenyl group, substituted C₂-C₆₀ alkynyl group, substituted C₁-C₆₀ alkoxy group, substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₆-C₆₀ aryloxy group, substituted C₆-C₆₀ arylthio group, substituted C₁-C₆₀ heteroaryl group, substituted monovalent non-aromatic condensed polycyclic group, and substituted monovalent non-aromatic condensed heteropolycyclic group is selected from
a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from a deuterium, -F, -Cl, -Br, -I,--CD₃, -CD₂H, -CDH₂, -CF₃, -CF₂H, -CFH₂, a hydroxyl group, a cyano group, a nitro group, amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -B(Q₁₆)(Q₁₇), and -P(=O)(Q₁₈)(Q₁₉) ;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -B(Q₂₆)(Q₂₇), and -P(=O)(Q₂₈)(Q₂₉); and
-N(Q₃₁)(Q₃₂), -Si(Q₃₃)(Q₃₄)(Q₃₅), -B(Q₃₆)(Q₃₇), and -P(=O)(Q₃₈)(Q₃₉);
wherein Q₁ to Q₉, Q₁₁ to Q₁₉, Q₂₁ to Q₂₉, Q₃₁ to Q₃₉ and Q₅₁ to Q₅₃ are each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group.

2. The organometallic compound of claim 1, wherein
in Formula 1, M is Ir and the sum of n1 and n2 is 3; or M is Pt and the sum of n1 and n2 is 2, and
the organometallic compound does not comprise an ionic group.

3. The organometallic compound of claim 1 or 2, wherein
R₁ to R₃ in Formula 2A are each independently selected from
a C₁-C₂₀ alkyl group, a C₁-C₂₀ alkoxy group, and -Si(Q₅₁)(Q₅₂)(Q₅₃);
a C₁-C₂₀ alkyl group and a C₁-C₂₀ alkoxy group, each substituted with at least one selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group; and
a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl a pyridazinyl group, an isoindolyl group, an indolyl group, an indazolyl group, a purinyl a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, benzothiophenyl group, an isobenzothiazolyl group, a benzoxazolyl group, an isobenzoxazolyl group, a triazolyl group, a tetrazolyl group, an oxadiazolyl group, a group, a dibenzofuranyl group, a dibenzothiophenyl group, a benzocarbazolyl group, a dibenzocarbazolyl group, an imidazopyridinyl group, and an imidazopyrimidinyl group; and
Q₅₁ to Q₅₃ are each independently selected from
-CH₃, -CD₃, -CD₂H, -CDH₂, -CH₂CH₃, -CH₂CD₃, -CH₂CD₂H, -CH₂CDH₂, -CHDCH₃,-CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group;
preferably wherein:
R₁ to R₃ in Formula 2A are each independently selected from
-CH₃, -CD₃, -CD₂H, -CDH₂, -CH₂CH₃, -CH₂CD₃, -CH₂CD₂H, -CH₂CDH₂, -CHDCH₃,-CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, and -Si(Q₅₁)(Q₅₂)(Q₅₃); and
an n-propyl group, an isopropyl group, an n-butyl group, an isobutyl group, a sec-sec-butyl group, a tert-butyl group, an n-pentyl group, an isopentyl group, a sec-pentyl a tert-pentyl group, a phenyl group, and a naphthyl group, each substituted with at least selected from a deuterium, a C₁-C₁₀ alkyl group, and a phenyl group; and
Q₅₁ to Q₅₃ are each independently selected from
-CH₃, -CD₃, -CD₂H, -CDH₂, -CH₂CH₃, -CH₂CD₃, -CH₂CD₂H, -CH₂CDH₂, -CHDCH₃,-CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group.

4. The organometallic compound of any of claims 1-3, wherein
R₁₁, R₂₁ to R₂₃ and R₄₁ to R₄₈ in Formula 2A are each independently selected from
a hydrogen, a deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, and a C₁-C₂₀ alkoxy group;
a C₁-C₂₀ alkyl group and a C₁-C₂₀ alkoxy group, each substituted with at least one selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic group or a salt thereof, a phosphoric acid group or a salt thereof, a C₁-C₁₀ alkyl group, a C₁-C₁₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₁₄ aryl group, a C₁-C₁₄ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₁₄ aryl group, a C₁-C₁₄ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₁₄ aryl group, a C₁-C₁₄ heteroaryl group, a monovalent non-aromatic condensed polycyclic group, and a monovalent non-aromatic condensed heteropolycyclic group, each substituted with at least one selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₁₄ aryl group, a C₁-C₁₄ heteroaryl group, a monovalent non-aromatic condensed polycyclic group, and a monovalent non-aromatic condensed heteropolycyclic group; and
-N(Q₁)(Q₂), -Si(Q₃)(Q₄)(Q₅), -B(Q₆)(Q₇), and -P(=O)(Q₈)(Q₉);
wherein Q₁ to Q₉ are each independently selected from a substituted or C₁-C₂₀ alkyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or C₆-C₁₄ aryl group, a substituted or unsubstituted C₁-C₁₄ heteroaryl group, a substituted or unsubstituted monovalent non-aromatic condensed polycyclic group, and a substituted or unsubstituted monovalent non-aromatic condensed heteropolycyclic group;
preferably wherein:
R₁₁, R₂₁ to R₂₃ and R₄₁ to R₄₈ in Formula 2A are each independently selected from
a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, and a C₁-C₂₀ alkoxy group;
a C₁-C₂₀ alkyl group and a C₁-C₂₀ alkoxy group, each substituted with at least one selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl a pyridazinyl group, an isoindolyl group, an indolyl group, an indazolyl group, a purinyl a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl a pyridazinyl group, an isoindolyl group, an indolyl group, an indazolyl group, a purinyl a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, benzothiophenyl group, an isobenzothiazolyl group, a benzoxazolyl group, an isobenzoxazolyl group, a triazolyl group, a tetrazolyl group, an oxadiazolyl group, a group, a dibenzofuranyl group, a dibenzothiophenyl group, a benzocarbazolyl group, a dibenzocarbazolyl group, an imidazopyridinyl group, and an imidazopyrimidinyl group; and
-B(Q₆)(Q₇) and -P(=O)(Q₈)(Q₉),
wherein Q₆ to Q₉ are each independently selected from
-CH₃, -CD₃, -CD₂H, -CDH₂, -CH₂CH₃, -CH₂CD₃, -CH₂CD₂H, -CH₂CDH₂, -CHDCH₃,-CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group;
more preferably wherein:
R₁₁, R₂₁ to R₂₃ and R₄₁ to R₄₈ in Formula 2A are each independently selected from
a hydrogen, a deuterium, -F, a cyano group, a nitro group, -SF₅, a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl, norbornanyl group, a norbornenyl, a cyclopentenyl group, a cyclohexenyl group, a cycloheptenyl group, a phenyl group, a naphthyl group, a pyridinyl group, and a pyrimidinyl group;
a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an isohexyl a sec-hexyl group, a tert-hexyl group, an n-heptyl group, an isoheptyl group, a sec-heptyl group, a tert-heptyl group, an n-octyl group, an isooctyl group, a sec-octyl group, a tert-group, an n-nonyl group, an isononyl group, a sec-nonyl group, a tert-nonyl group, an n-n-decyl group, an isodecyl group, a sec-decyl group, a tert-decyl group, a methoxy group, ethoxy group, a propoxy group, a butoxy group, a pentoxy group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a pyridinyl group, and a pyrimidinyl group, each substituted with at least one selected from a deuterium, -F, -CD₃, -CD₂H,--CF₃, -CF₂H, -CFH₂, a cyano group, a nitro group, a C₁-C₁₀ alkyl group, a C₁-C₁₀ alkoxy group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a pyridinyl group, and a pyrimidinyl group; and
-B(Q₆)(Q₇) and -P(=O)(Q₈)(Q₉),
wherein Q₆ to Q₉ are each independently selected from
-CH₃, -CD₃, -CD₂H, -CDH₂, -CH₂CH₃, -CH₂CD₃, -CH₂CD₂H, -CH₂CDH₂, -CHDCH₃,-CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group.

5. The organometallic compound of any of claims 1-4, wherein:
R₁₁, R₂₁ to R₂₃ and R₄₁ to R₄₈ in Formula 2A are each independently selected from a hydrogen, a deuterium, -F, a cyano group, a nitro group, -SF₅, -CH₃, -CD₃, -CD₂H, -CDH₂, -CF₃, -CF₂H, -CFH₂, groups represented by Formulae 9-1 to 9-17, and groups represented by Formulae 10-1 to 10-30: 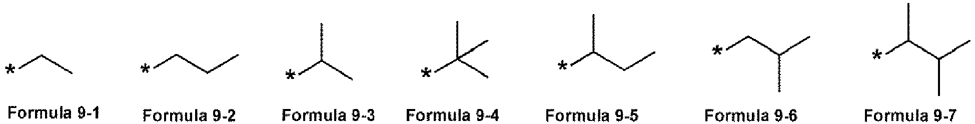 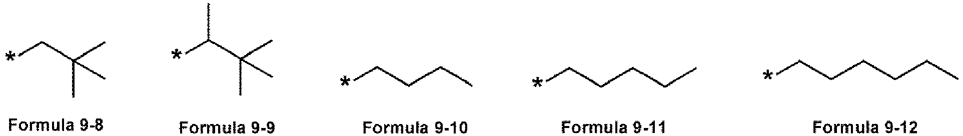 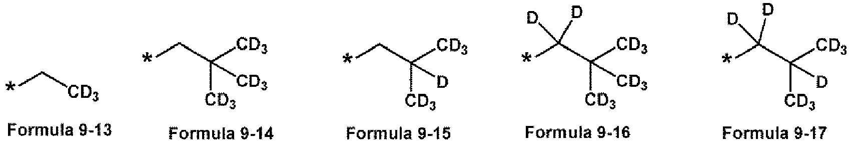 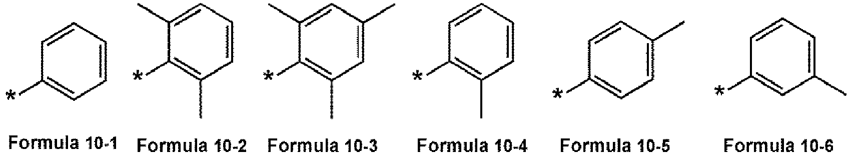 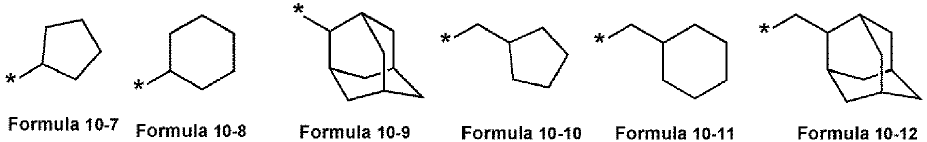 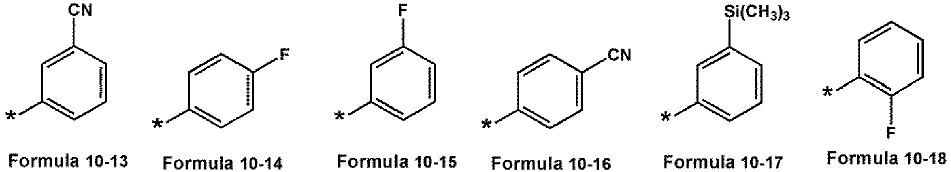 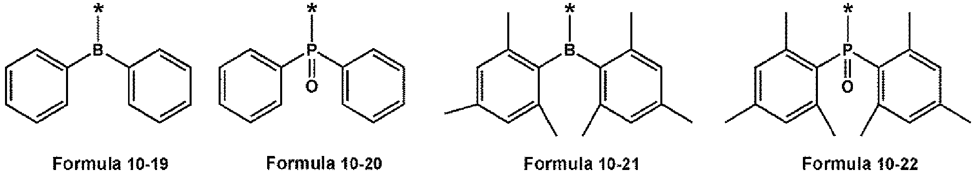 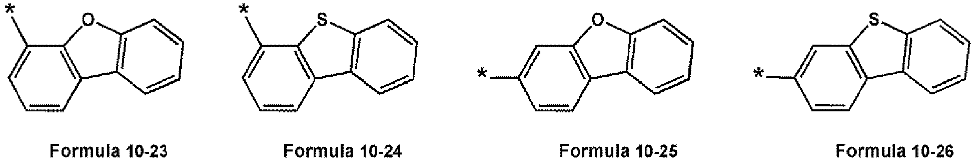 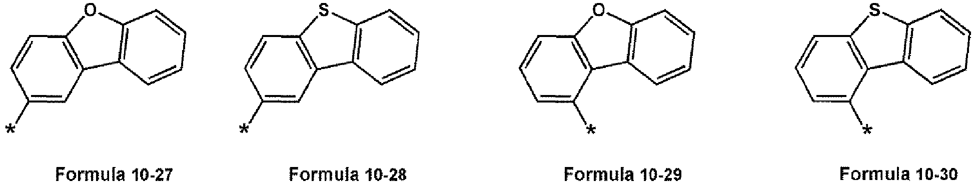
wherein in Formulae 9-1 to 9-17 and 10-1 to 10-30, * is a binding site to a neighboring atom.

6. The organometallic compound of any of claims 1-5, wherein
two groups R₁₁ in Formula 2A are linked to each other to form a substituted or unsubstituted cyclohexane or a substituted or unsubstituted benzene.

7. The organometallic compound of any of claims 1-6, wherein
L₁ is selected from ligands represented by Formulae 2A-1 to 2A-16: 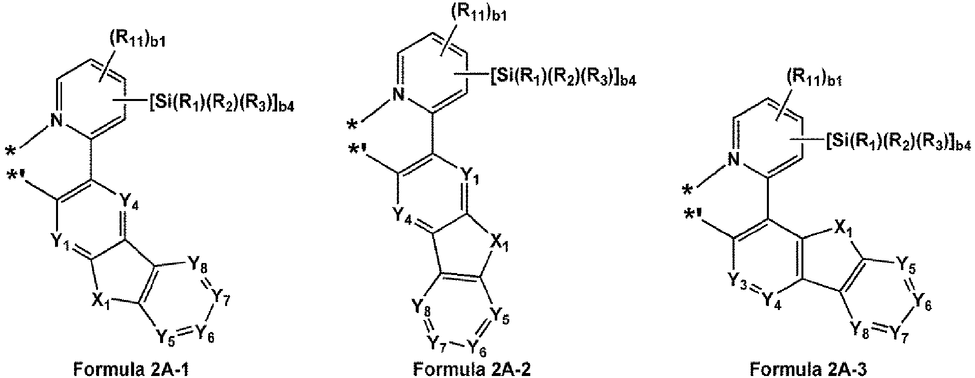 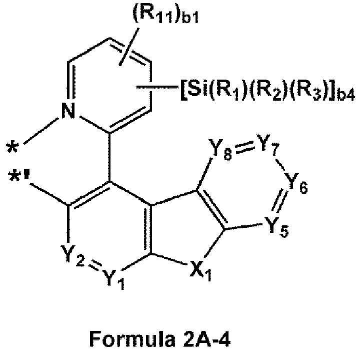 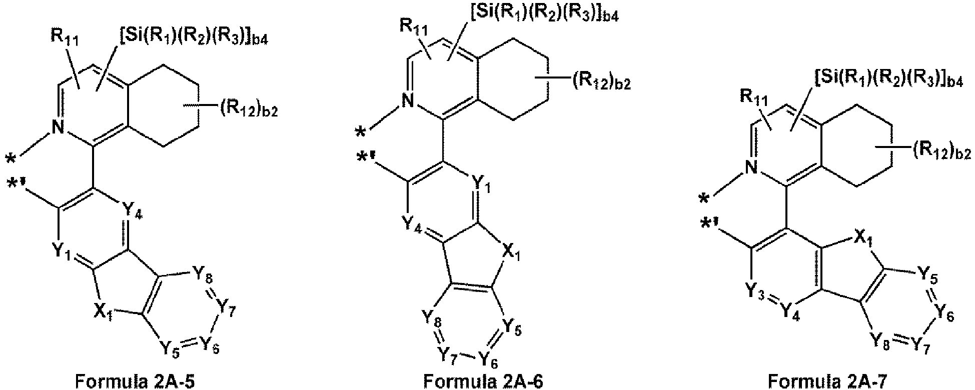 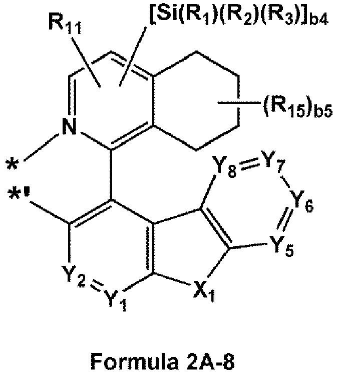 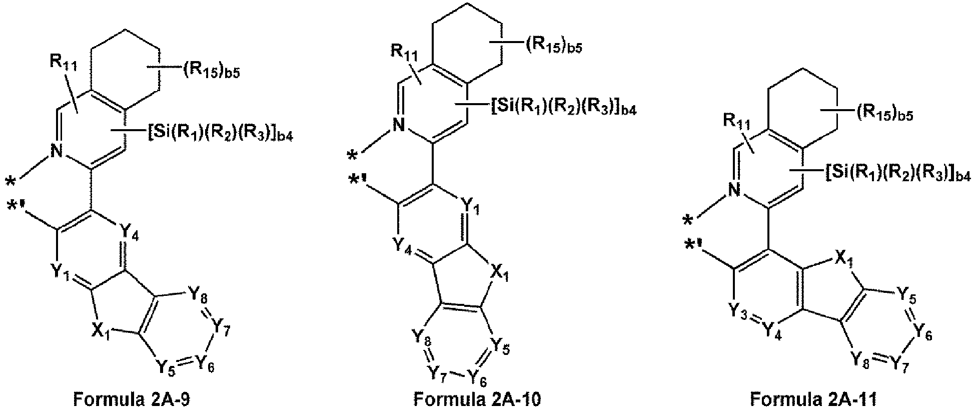 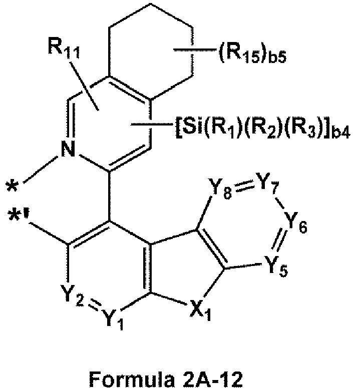 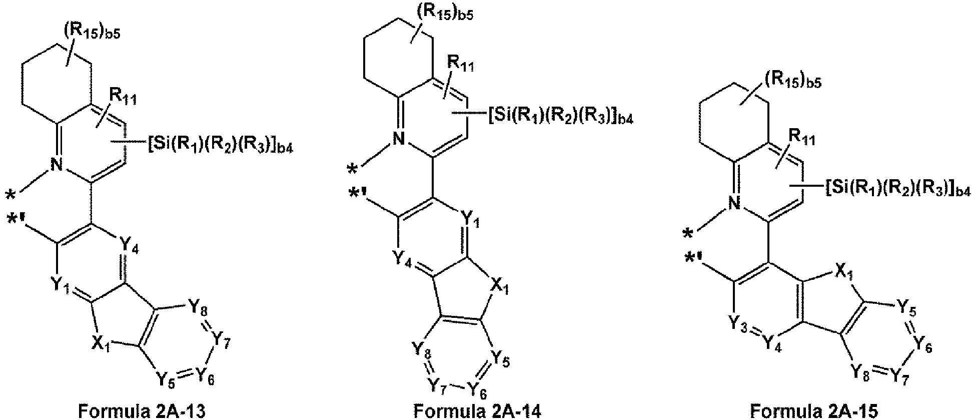 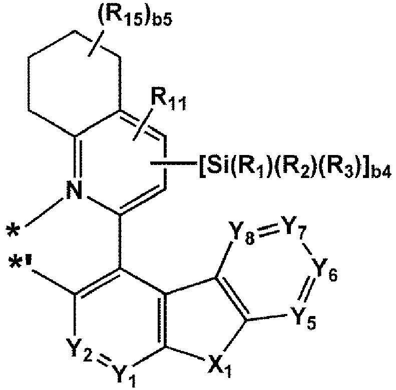 **Formula 2A-16**
wherein in Formulae 2A-1 to 2A-16, R₁ to R₃, X₁, Y₁ to Y₈, R₁₁, and b1 and b4 are the same as defined in claim 1, R₁₅ is the same as R₁₁, b5 is an integer selected from 0 to 8 and * and *' are binding sites to M in Formula 1,
preferably wherein:
in Formulae 2A-1 to 2A-16, Y₁ is C(R₄₁), Y₂ is C(R₄₂), Y₃ is C(R₄₃), Y₄ is C(R₄₄), Y₅ is C(R₄₅), Y₆ is C(R₄₆), Y₇ is C(R₄₇), and Y₈ is C(R₄₈);
in Formulae 2A-1, 2A-2, 2A-4, 2A-5, 2A-6, 2A-8, 2A-9, 2A-10, 2A-12, 2A-13, 2A-14, and 2A-16, Y₁ is N, Y₄ is C(R₄₄), Y₅ is C(R₄₅), Y₆ is C(R₄₆), Y₇ is C(R₄₇), and Y₈ is C(R₄₈);
in Formulae 2A-1, 2A-2, 2A-4, 2A-5, 2A-6, 2A-8, 2A-9, 2A-10, 2A-12, 2A-13, 2A-14, and 2A-16, Y₁ is C(R₄₁), Y₄ is C(R₄₄), Y₅ is N, Y₆ is C(R₄₆), Y₇ is C(R₄₇), and Y₈ is C(R₄₈);
in Formulae 2A-1, 2A-2, 2A-4, 2A-5, 2A-6, 2A-8, 2A-9, 2A-10, 2A-12, 2A-13, 2A-14, and 2A-16, Y₁ is C(R₄₁), Y₄ is C(R₄₄), Y₅ is C(R₄₅), Y₆ is N, Y₇ is C(R₄₇), and Y₈ is C(R₄₈);
in Formulae 2A-1, 2A-2, 2A-4, 2A-5, 2A-6, 2A-8, 2A-9, 2A-10, 2A-12, 2A-13, 2A-14, and 2A-16, Y₁ is N, Y₄ is C(R₄₄), Y₅ is N, Y₆ is C(R₄₆), Y₇ is C(R₄₇), and Y₈ is C(R₄₈);
in Formulae 2A-1, 2A-2, 2A-4, 2A-5, 2A-6, 2A-8, 2A-9, 2A-10, 2A-12, 2A-13, 2A-14, and 2A-16, Y₁ is N, Y₄ is C(R₄₄), Y₅ is C(R₄₅), Y₆ is N, Y₇ is C(R₄₇), and Y₈ is C(R₄₈);
in Formulae 2A-3, 2A-7, 2A-11, and 2A-15, Y₃ is N, Y₄ is C(R₄₄), Y₅ is C(R₄₅), Y₆ is C(R₄₆), Y₇ is C(R₄₇), and Y₈ is C(R₄₈);
in Formulae 2A-3, 2A-7, 2A-11, and 2A-15 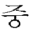 Y₃ is C(R₄₃), Y₄ is C(R₄₄), Y₅ is N, Y₆ is C(R₄₆), Y₇ is C(R₄₇), and Y₈ is C(R₄₈);
in Formulae 2A-3, 2A-7, 2A-11, and 2A-15, Y₃ is C(R₄₃), Y₄ is C(R₄₄), Y₅ is C(R₄₅), Y₆ is N, Y₇ is C(R₄₇), and Y₈ is C(R₄₈);
in Formulae 2A-3, 2A-7, 2A-11, and 2A-15, 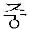 Y₃ is N, Y₄ is C(R₄₄), Y₅ is N, Y₆ is C(R₄₆), Y₇ is C(R₄₇), and Y₈ is C(R₄₈); or
in Formulae 2A-3, 2A-7, 2A-11, annd 2A-15, Y₃ is N, Y₄ is C(R₄₄), Y₅ is C(R₄₅), Y₆ is N, Y₇ is C(R₄₇), and Y₈ is C(R₄₈)

8. The organometallic compound of any of claims 1-6, wherein:
L₁ in Formula 1 is selected from groups represented by Formulae 2AA-1, 2AA-2, 2AA-3, 2AA-4, and 2AB below: 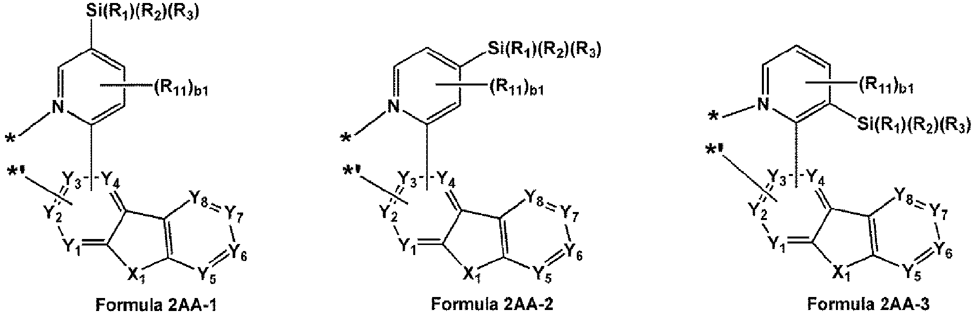 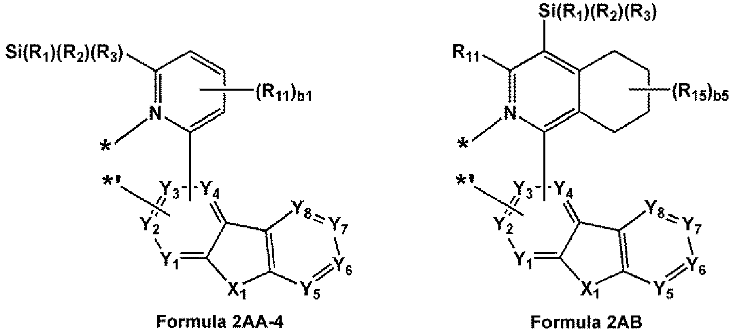
in Formulae 2AA-1, 2AA-2, 2AA-3, 2AA-4, and 2AB,
R₁ to R₃ are each independently selected from
-CH₃, -CD₃, -CD₂H, -CDH₂, -CH₂CH₃, -CH₂CD₃, -CH₂CD₂H, -CH₂CDH₂, -CHDCH₃,-CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, and -Si(Q₅₁)(Q₅₂)(Q₅₃); and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium and a C₁-C₁₀ alkyl group,
Q₅₁ to Q₅₃ are each independently selected from
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group,
X₁ is selected from O, S, S(=O)₂, N(R₂₁), and Si(R₂₂)(R₂₃),
descriptions of Y₁ to Y₈ are the same as in claim 1,
R₁₁, R₁₅, and R₂₁ to R₂₃ are each independently selected from
a hydrogen, a deuterium, -F, a cyano group, a nitro group, -SF₅, a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl, norbornanyl group, a norbornenyl, a cyclopentenyl group, a cyclohexenyl group, a cycloheptenyl group, a phenyl group, a naphthyl group, a pyridinyl group, and a pyrimidinyl group;
a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a pyridinyl group, and a pyrimidinyl group, each substituted with at least one selected from a deuterium, -F, -CD₃, -CD₂H, -CDH₂, -CF₃, -CF₂H, -CFH₂, a cyano group, a nitro group, a C₁-C₁₀ alkyl group, a C₁-C₁₀ alkoxy group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a pyridinyl group, and a pyrimidinyl group; and
-B(Q₆)(Q₇) and -P(=O)(Q₈)(Q₉),
wherein Q₆ to Q₉ are each independently selected from
-CH₃, -CD₃, -CD₂H, -CDH₂, -CH₂CH₃, -CH₂CD₃, -CH₂CD₂H, -CH₂CDH₂, -CHDCH₃,-CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, and a phenyl group, and a naphthyl group, each substituted with at least one selected from a deuterium and a C₁-C₁₀ alkyl group,
b5 is an integer selected from 0 to 8, and
* and *' are binding sites to M in Formula 1.

9. The organometallic compound of any of claims 1-6, wherein:
L₁ is selected from ligands represented by Formulae 2A(1) to 2A(40): 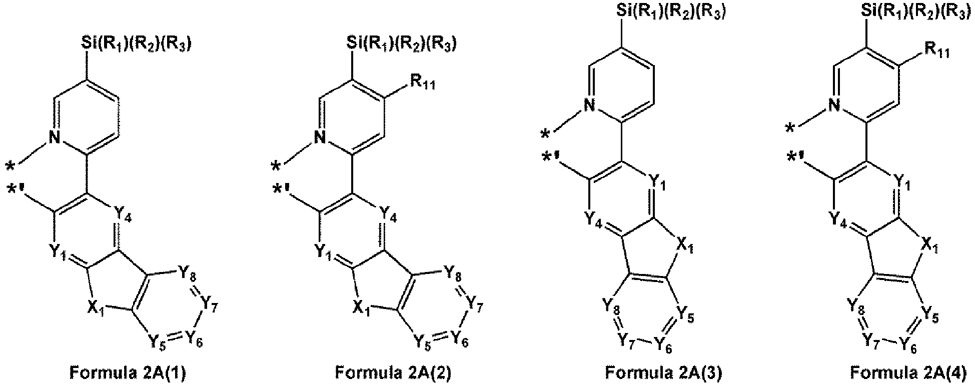 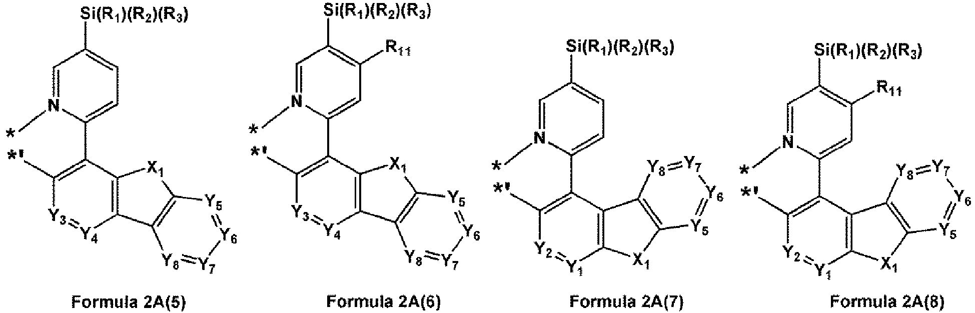 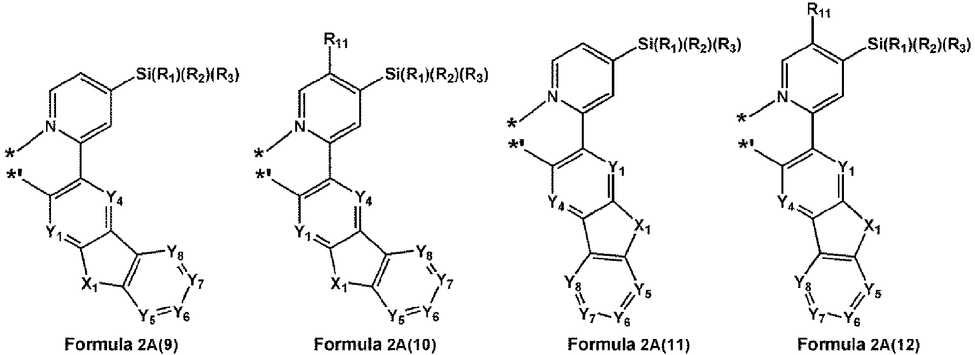 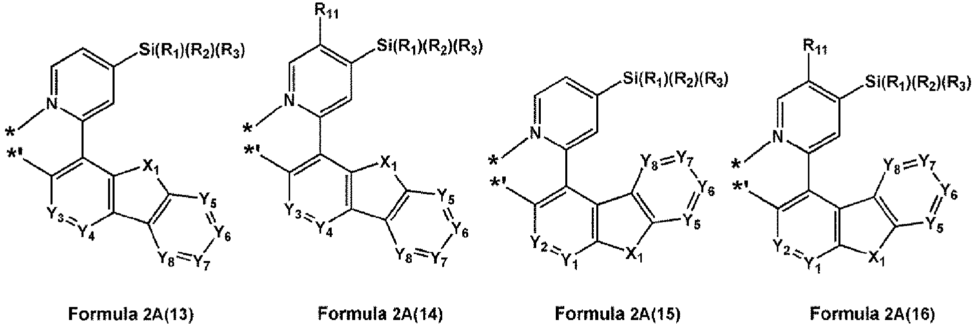 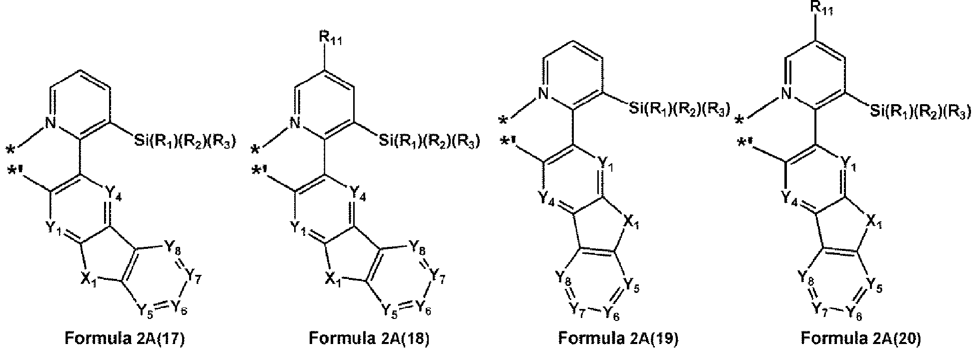 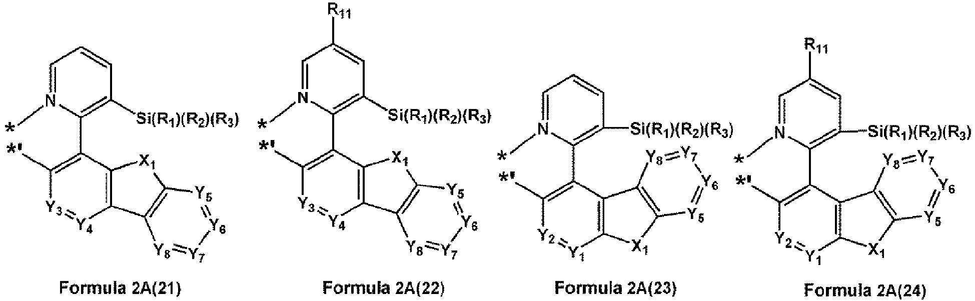 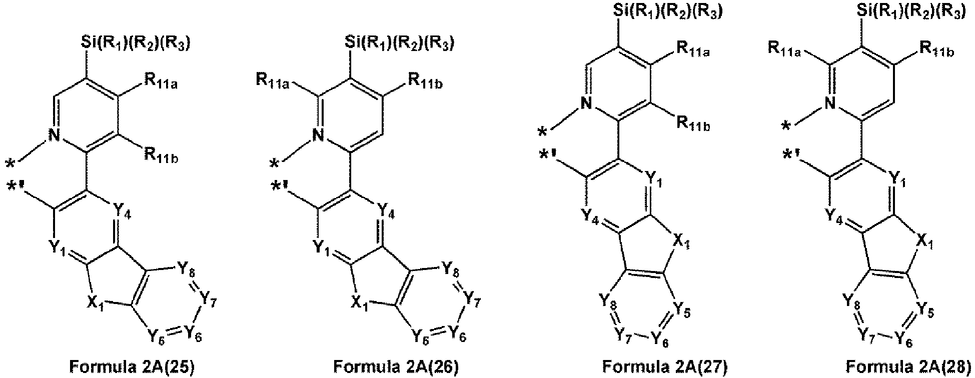 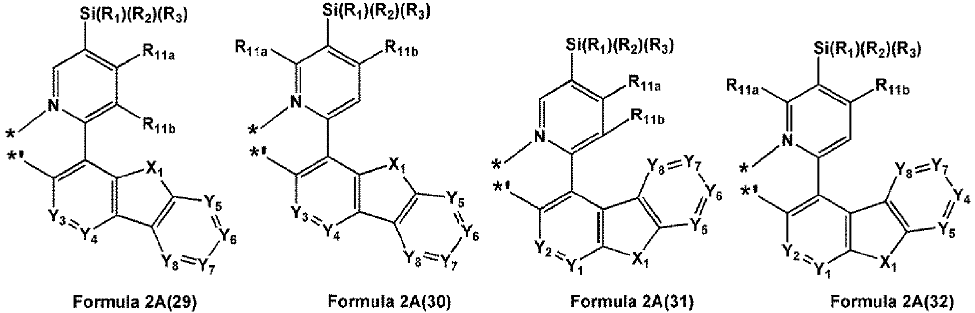 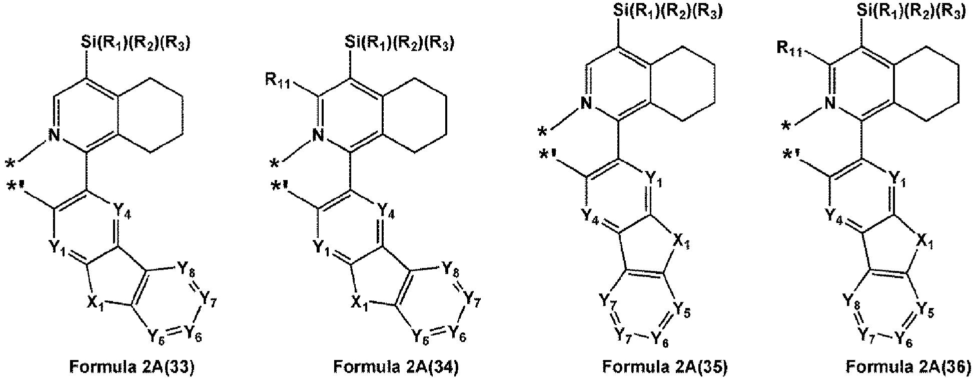 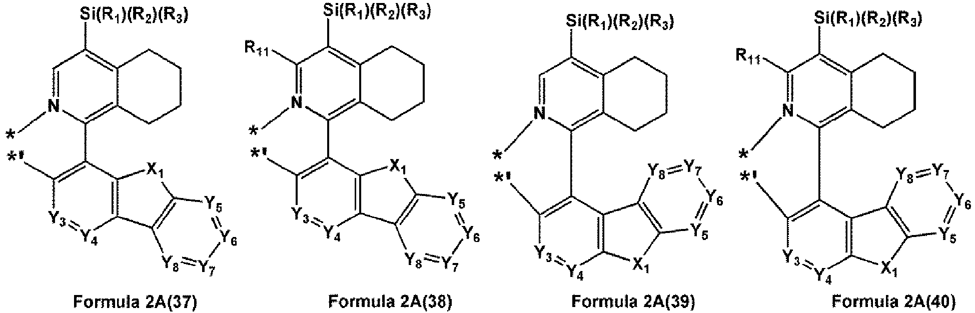
wherein in Formulae 2A(1) to 2A(40), descriptions of R₁ to R₃, X₁, Y₁ to Y₈, and R₁₁ are the same as in claim 1, R₁₁ₐ and R_{11b} are understood by referring to the description of R₁₁, provided that R₁₁, R₁₁ₐ, and R_{11b} are not hydrogen, and each of * and *' is a binding site to M in Formula 1.

10. The organometallic compound of any of claims 1-9, wherein
L₂ in Formula 1 is selected from ligands represented by Formulae 3A to 3G: 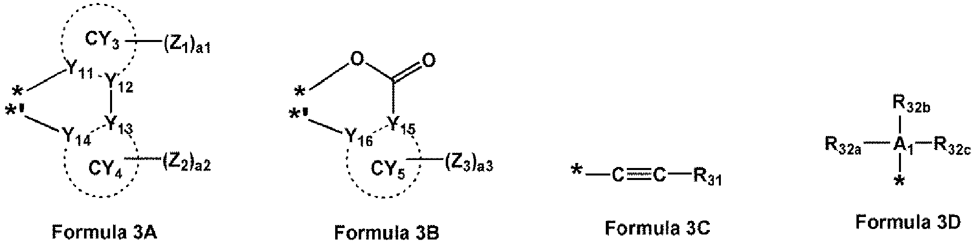 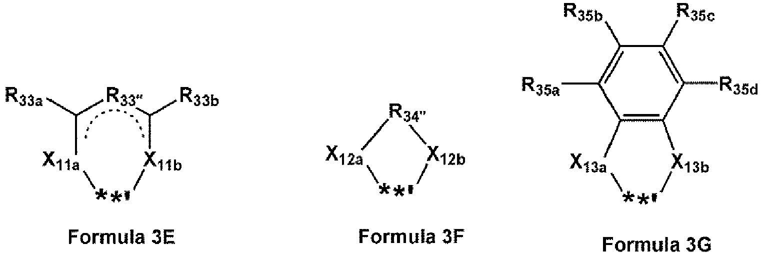
wherein in Formulae 3A to 3G,
Y₁₁ to Y₁₆ are each independently C or N, Y₁₁ and Y₁₂ are linked to each other by a single bond or a double bond, Y₁₃ and Y₁₄ are linked to each other by a single bond or a double bond, and Y₁₅ and Y₁₆ are linked to each other by a single bond or a double bond,
CY₃ to CY₅ are each independently selected from a C₅-C₆₀ carbocyclic group and a C₂-C₆₀ heterocyclic group.
a1 to a3 are each independently an integer selected from 1 to 5;
A₁ is P or As;
X₁₁ₐ, X_{11b}, X₁₂ₐ, X_{12b}, X₁₃ₐ, and X_{13b} are each independently selected from N, O, N(R₃₄), P(R₃₅)(R₃₆), and As(R₃₇)(R₃₈), provided that none of X₁₂ₐ, X_{12b}, X₁₃ₐ, and X_{13b} are N or O;
R₃₃" and R₃₄" are each independently selected from a single bond, a double bond, a substituted or unsubstituted C₁-C₅ alkylene group, a substituted or unsubstituted C₂-C₅ alkenylene group, and a substituted or unsubstituted C₆-C₁₀ arylene group;
Z₁ to Z₃, R₃₁, R₃₂ₐ, R_{32b}, R_{32c}, R₃₃ₐ, R_{33b}, R₃₄ to R₃₈, R₃₅ₐ, R_{35b}, R_{35c}, and R_{35d} are each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), and -P(=O)(Q₈)(Q₉),
* and *' each indicate binding sites to M in Formula 1;
at least one of substituents of the substituted C₁-C₅ alkylene group, substituted C₂-alkenylene group, substituted C₆-C₁₀ arylene group, substituted C₁-C₆₀ alkyl group, substituted C₂-C₆₀ alkenyl group, substituted C₂-C₆₀ alkynyl group, substituted C₁-C₆₀ group, substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₆-C₆₀ aryloxy group, substituted C₆-C₆₀ arylthio group, substituted C₁-C₆₀ heteroaryl group, substituted monovalent non-aromatic condensed polycyclic group and substituted monovalent non-aromatic condensed heteropolycyclic group is selected from
a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -B(Q₁₆)(Q₁₇), and -P(=O)(Q₁₈)(Q₁₉);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -B(Q₂₆)(Q₂₇), and -P(=O)(Q₂₈)(Q₂₉); and
-N(Q₃₁)(Q₃₂), -Si(Q₃₃)(Q₃₄)(Q₃₅), -B(Q₃₆)(Q₃₇), and -P(=O)(Q₃₈)(Q₃₉);
wherein Q₁ to Q₉, Q₁₁ to Q₁₉, Q₂₁ to Q₂₉, and Q₃₁ to Q₃₉ are each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group.

11. The organometallic compound of any of claims 1-9, wherein:
L₂ in Formula 1 is selected from ligands represented by Formulae 3-1 to 3-111: 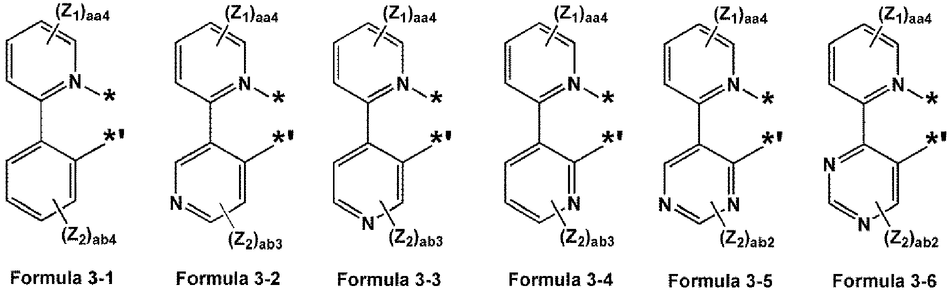 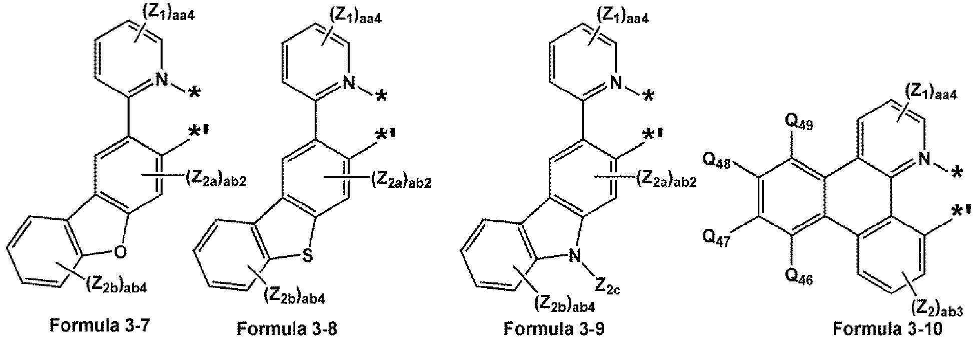 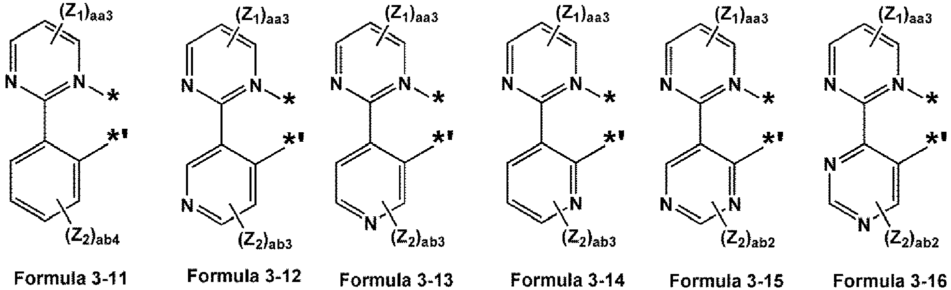 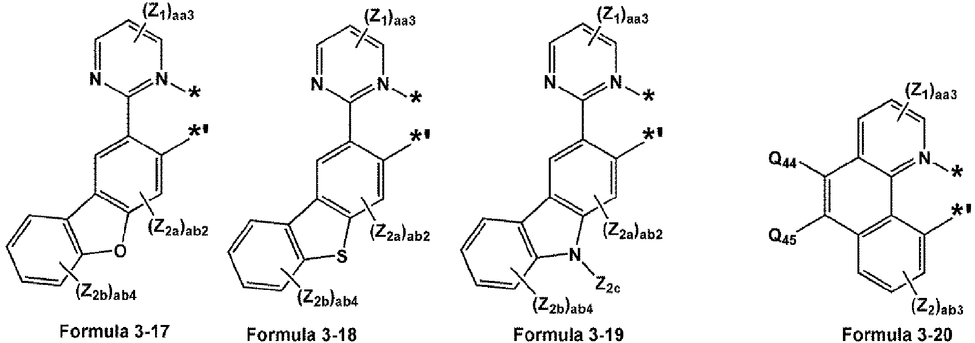 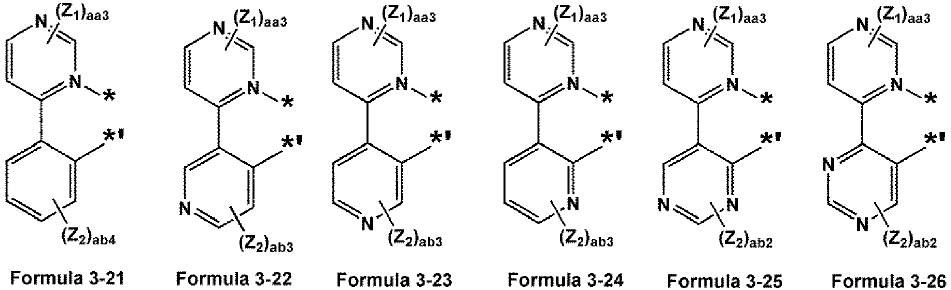 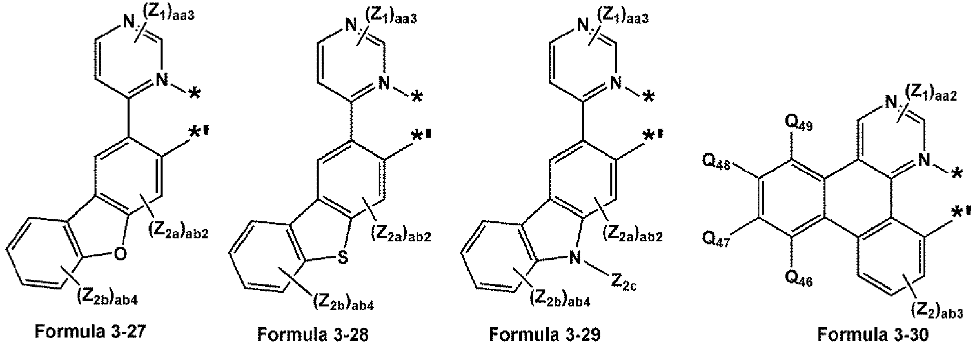 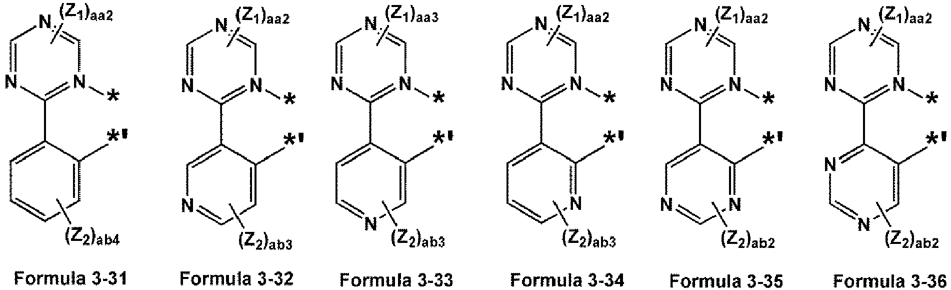 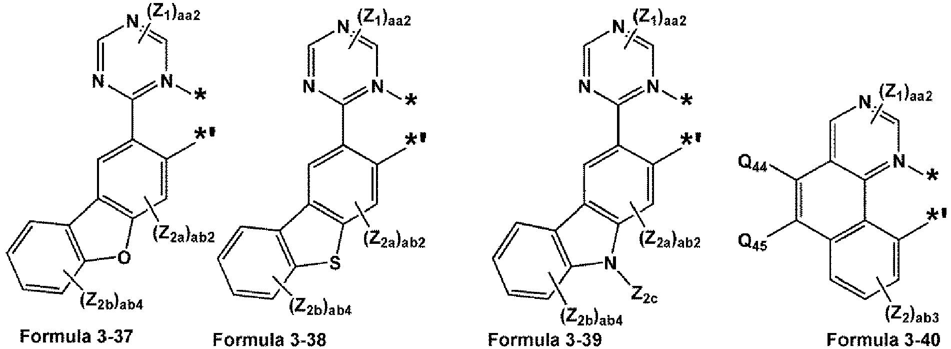 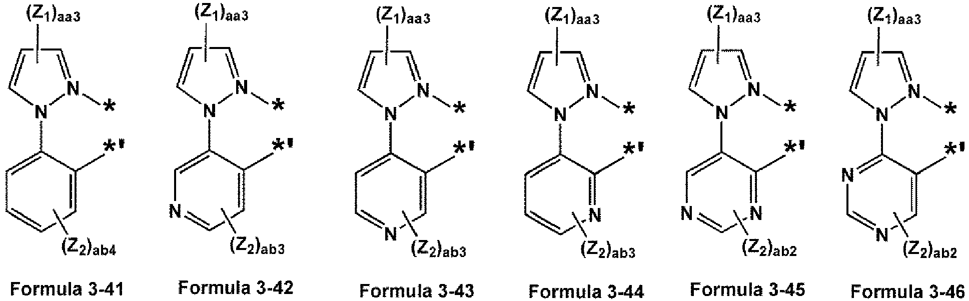 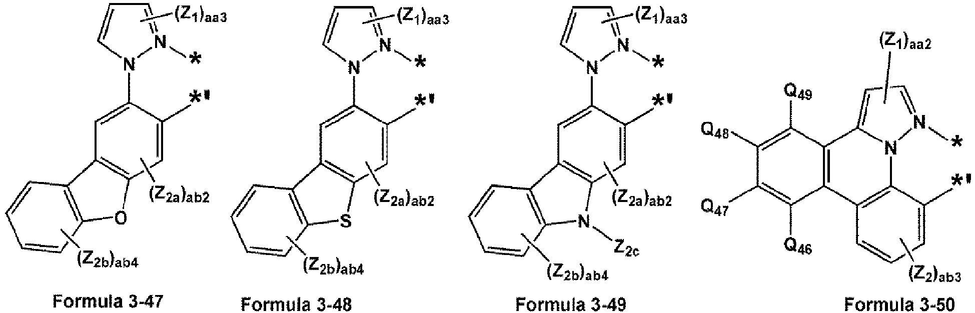 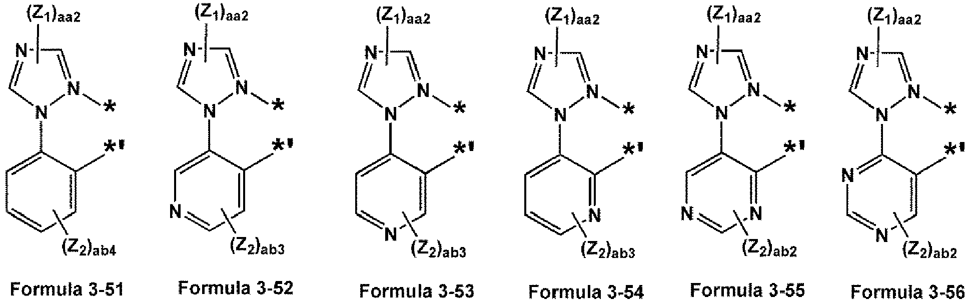 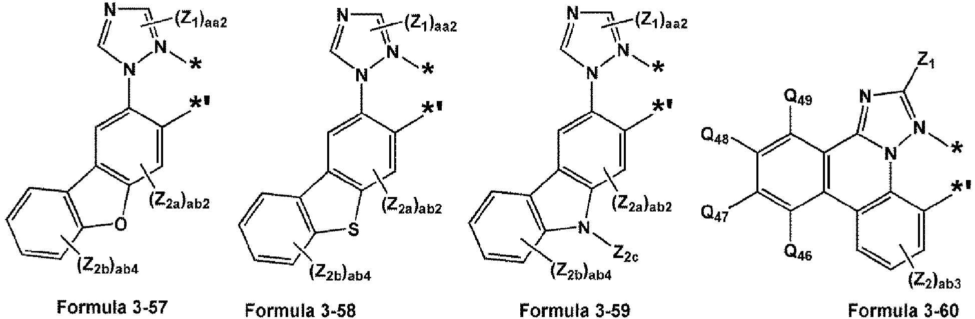 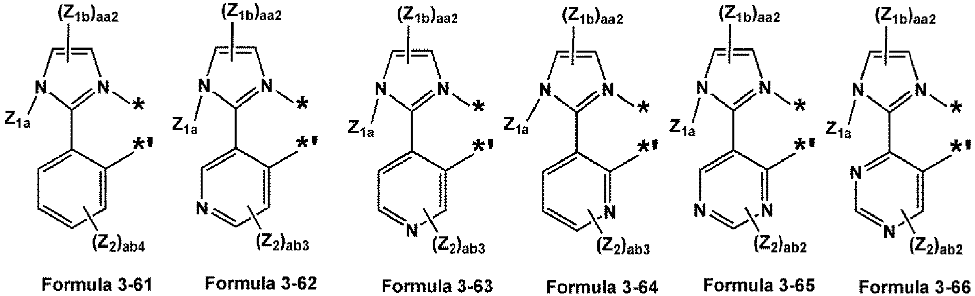 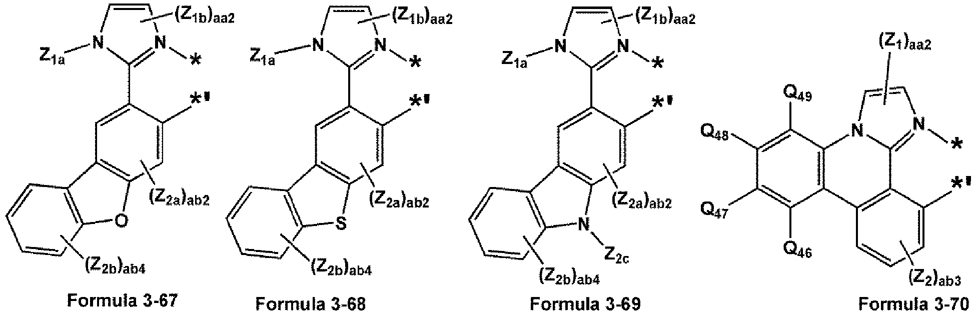 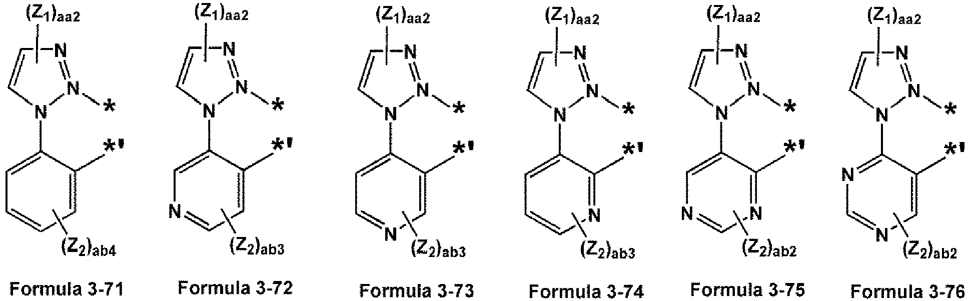 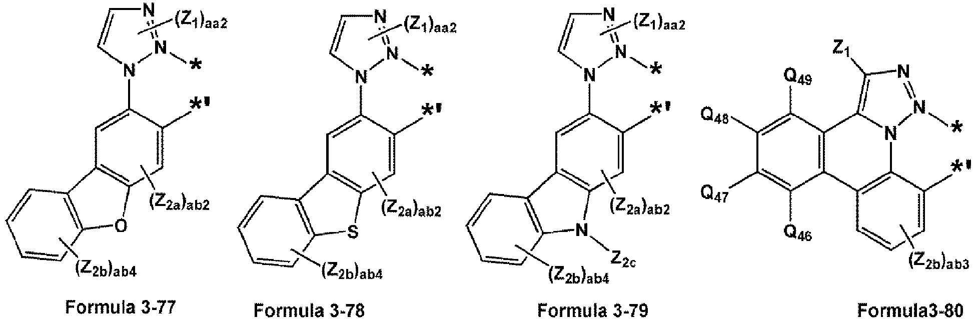 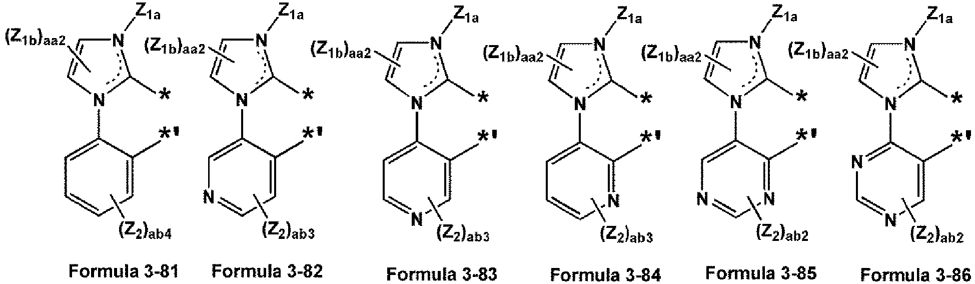 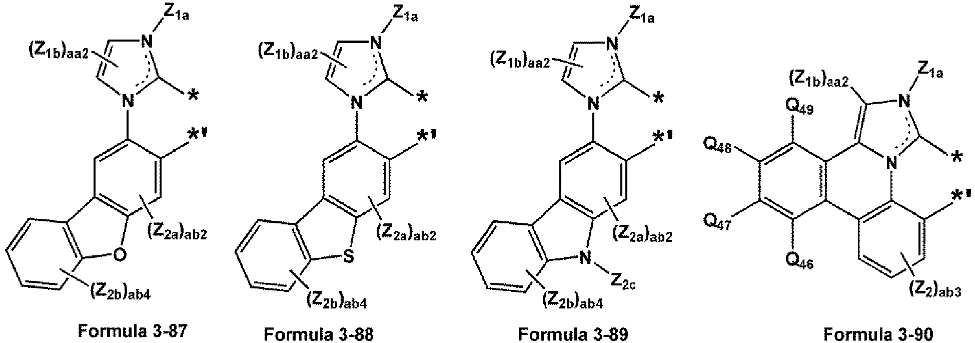 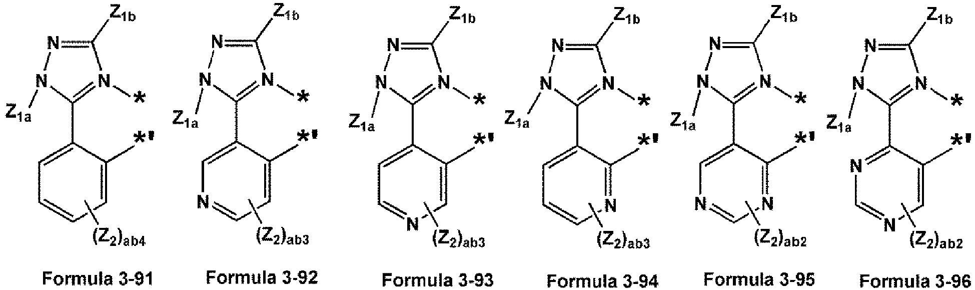 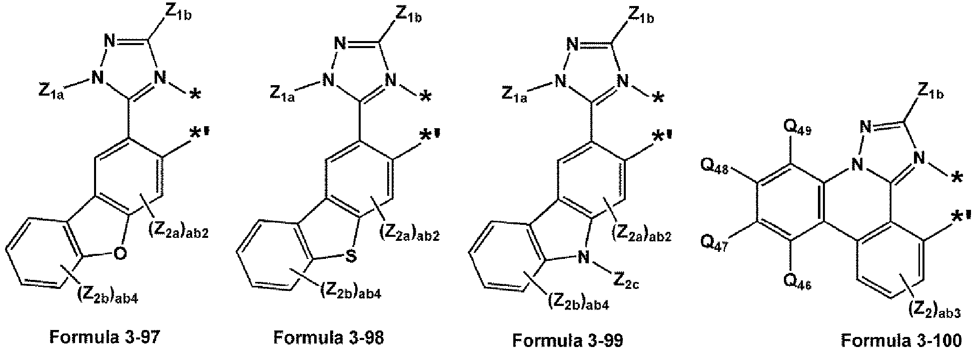 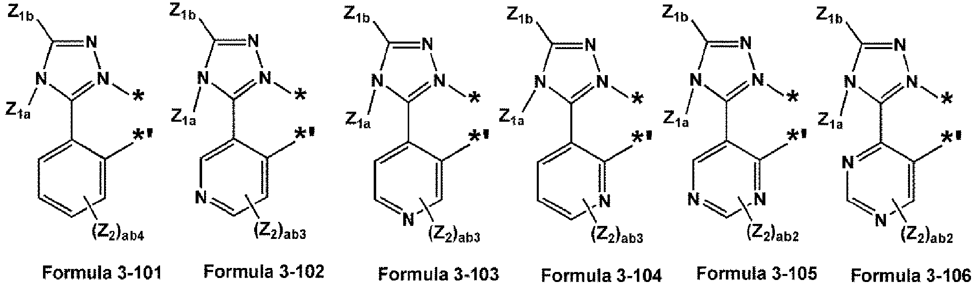 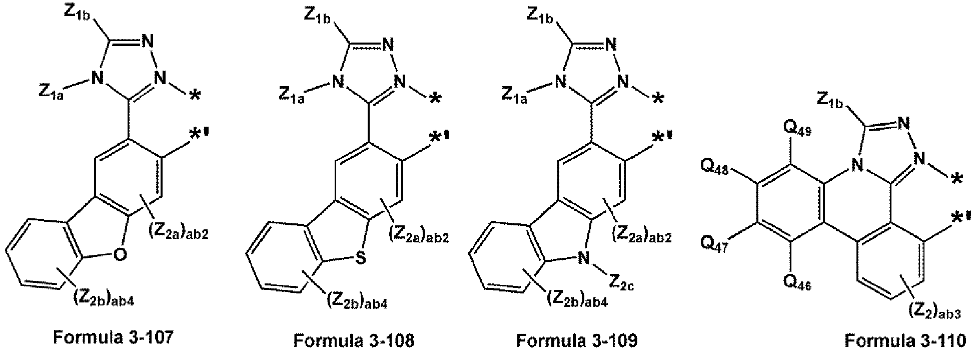 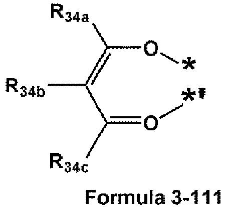
wherein in Formulae 3-1 to 3-111,
Z₁, Z₂, Z₁ₐ, Z_{1b}, Z₂ₐ, Z_{2b}, Z_{2c}, R₃₄ₐ, R_{34b}, and R_{34c} are each independently selected from
a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, and a C₁-C₂₀ alkoxy group;
a C₁-C₂₀ alkyl group and a C₁-C₂₀ alkoxy group, each substituted with at least one selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl a pyridazinyl group, an isoindolyl group, an indolyl group, an indazolyl group, a purinyl a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl a pyridazinyl group, an isoindolyl group, an indolyl group, an indazolyl group, a purinyl a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least selected from a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclooctyl group, an adamantanyl group, norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, benzothiophenyl group, an isobenzothiazolyl group, a benzoxazolyl group, an isobenzoxazolyl group, a triazolyl group, a tetrazolyl group, an oxadiazolyl group, a group, a dibenzofuranyl group, a dibenzothiophenyl group, a benzocarbazolyl group, a dibenzocarbazolyl group, an imidazopyridinyl group, and an imidazopyrimidinyl group; and
-N(Qi)(Q₂), -Si(Q₃)(Q₄)(Q₅), -B(Q₆)(Q₇), and -P(=O)(Q₈)(Q₉);
Q₁ to Q₉ and Q₄₄ to Q₄₉ are each independently selected from
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, and a phenyl group, and a naphthyl group, each substituted with at least one selected from a deuterium and a C₁-C₁₀ alkyl group,
aa2 and ab2 are each independently 1 or 2,
aa3 and ab3 are each independently selected from 1, 2, and 3,
aa4 and ab4 are each independently selected from, 1, 2, 3, and 4, and
* and *' each indicate binding sites to M in Formula 1;
preferably wherein:
L₂ in Formula 1 is selected from ligands represented by Formulae 3-1(1) to 3-1(59), and 3-111: 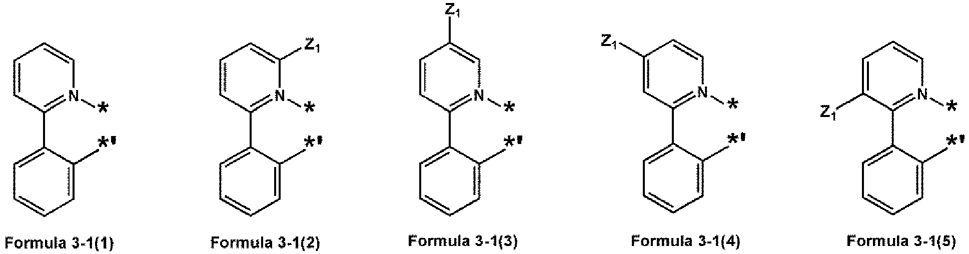 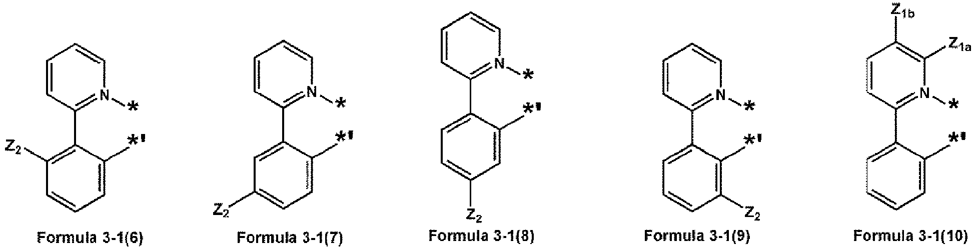 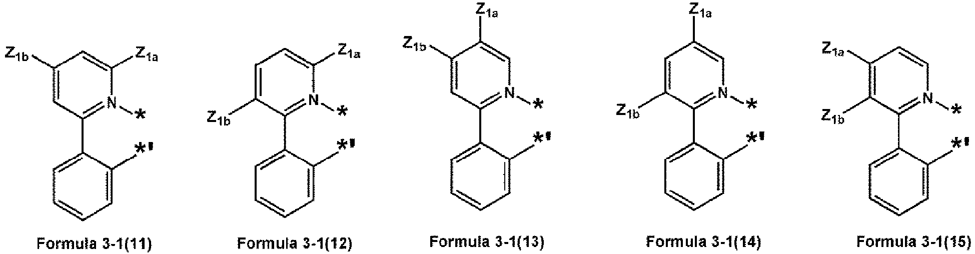 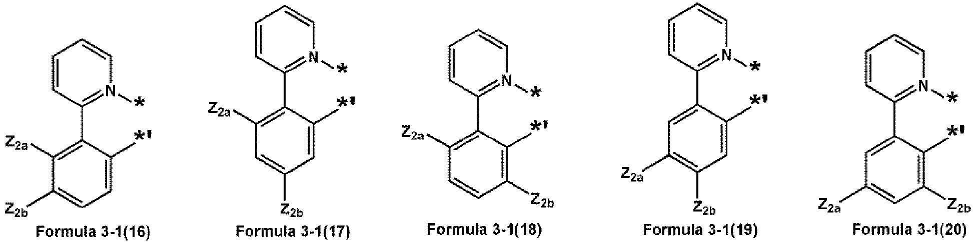 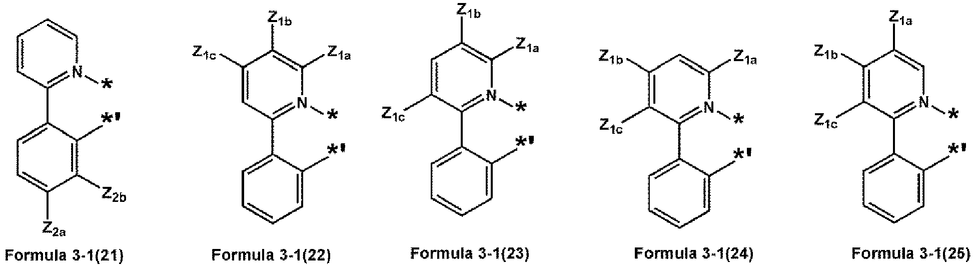 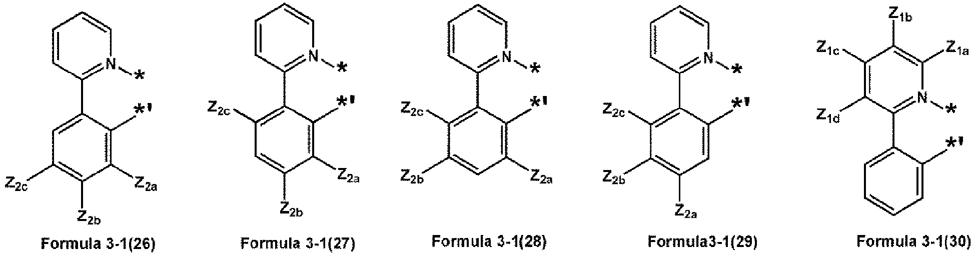 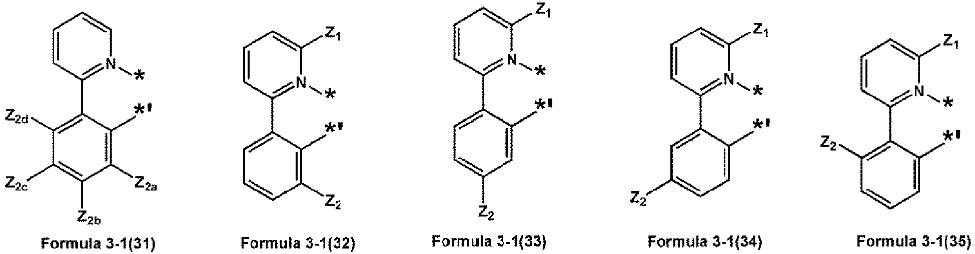 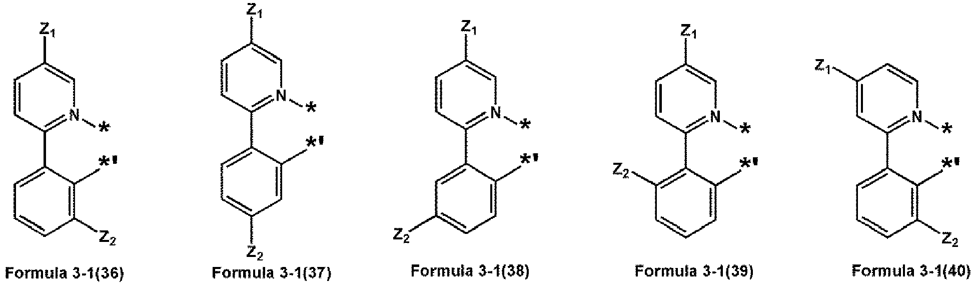 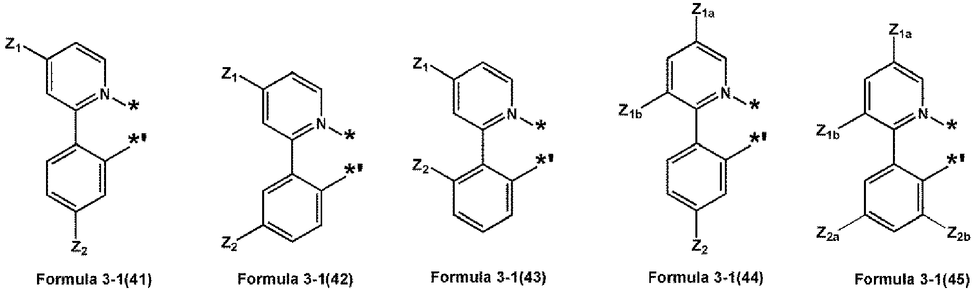 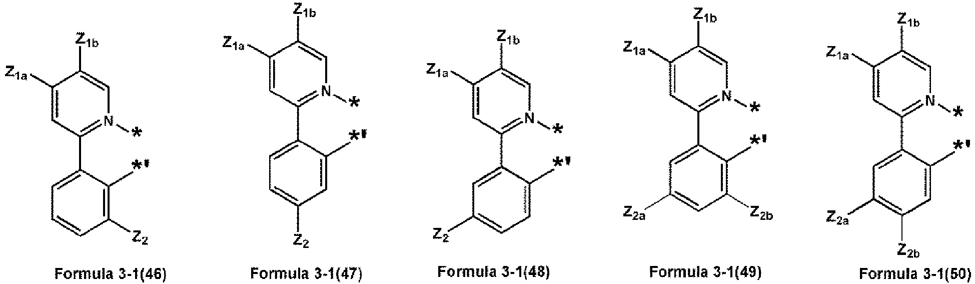 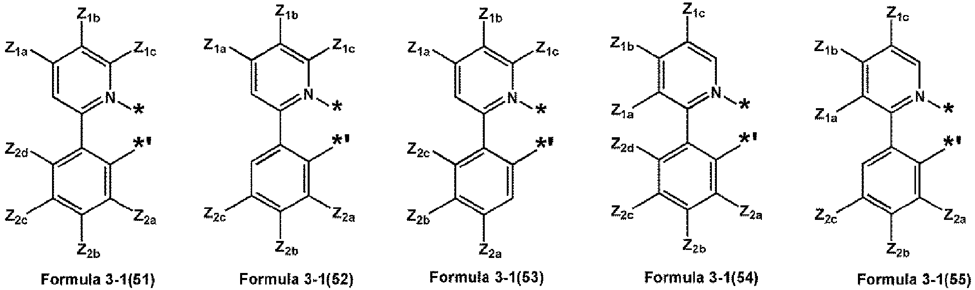 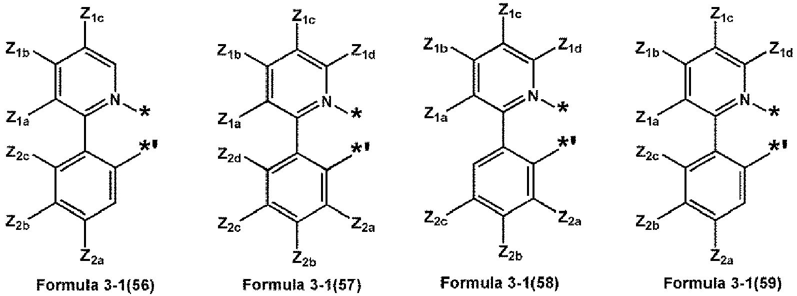 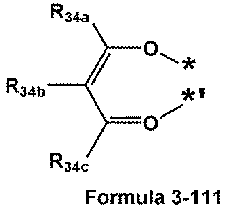
wherein in Formulae 3-1 (1) to 3-1 (59) and Formula 3-111:
Z₁, Z₂, Z₁ₐ, Z_{1b}, Z_{1c}, Z_{1d}, Z₂ₐ, Z_{2b}, Z_{2c}, Z_{2d}, R₃₄ₐ, R_{34b}, and R_{34c} are each independently selected from a deuterium, -F, a cyano group, a nitro group, -SF₅, -CH₃,-CD₃, -CD₂H, -CDH₂, -CF₃, -CF₂H, -CFH₂, -Si(Q₃)(Q₄)(Q₅), groups represented by Formulae 9-1 to 9-17, and groups represented by Formulae 10-1 to 10-30,
Q₃ to Q₅ are each independently selected from
-CH₃, -CD₃, -CD₂H, -CDH₂, -CH₂CH₃, -CH₂CD₃, -CH₂CD₂H, -CH₂CDH₂, -CHDCH₃,-CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, and a phenyl group, each substituted with at least one selected from a deuterium and a C₁-C₁₀ alkyl group, and
* and *' are binding sites to M in Formula 1, 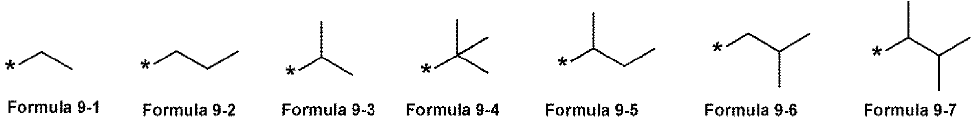 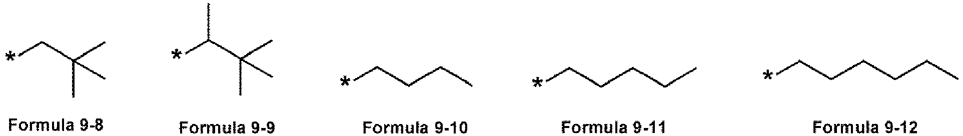 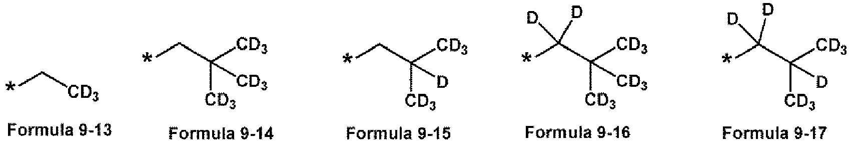 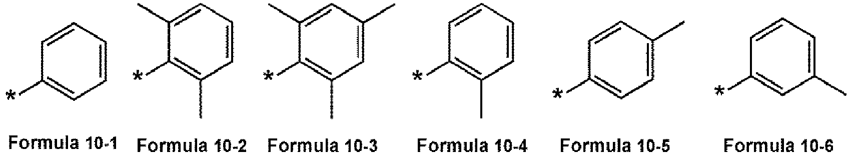 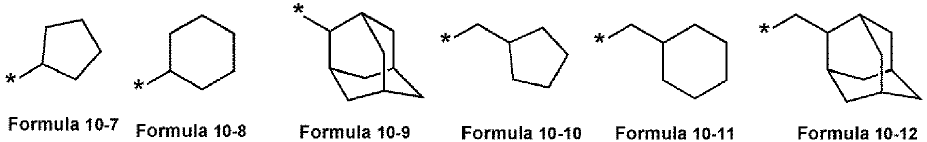 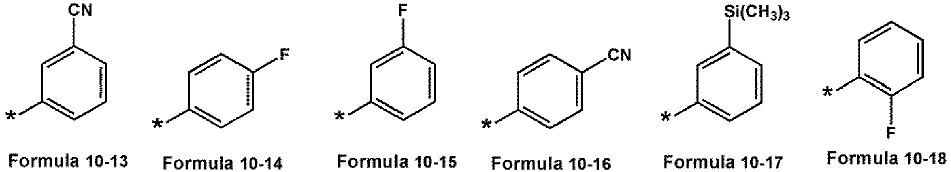 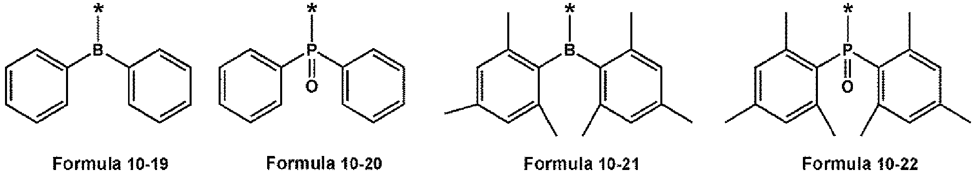 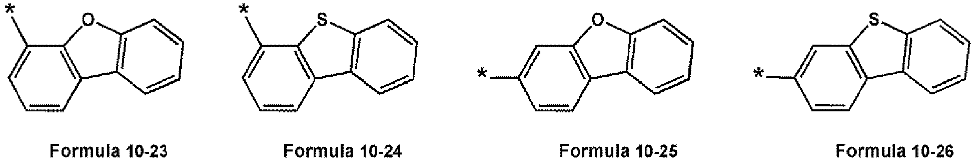 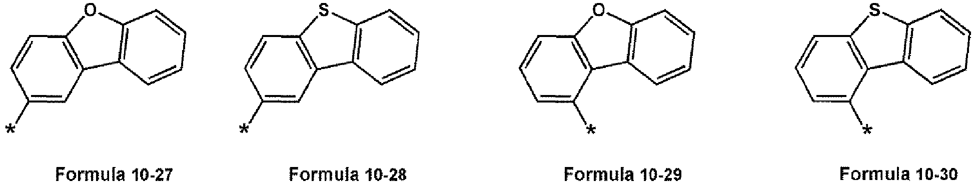
wherein in Formulae 9-1 to 9-17 and 10-1 to 10-30, * is a binding site to a neighboring atom.

12. The organometallic compound of claim 1, wherein the organometallic compound is one of Compounds 1 to 481:

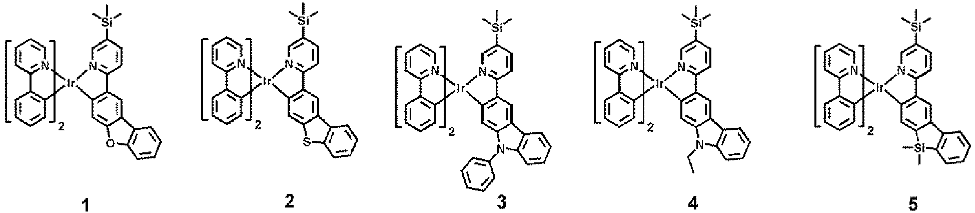

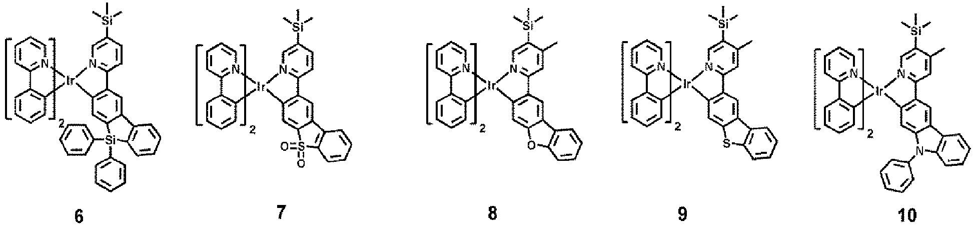

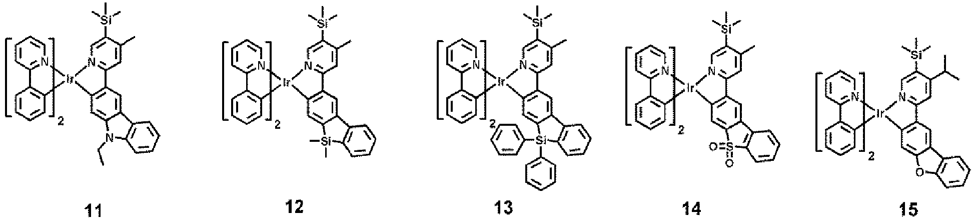

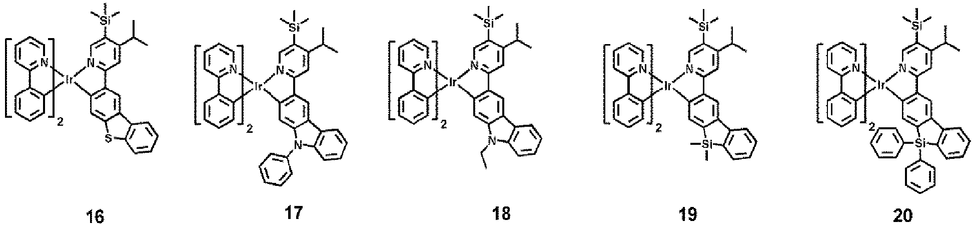

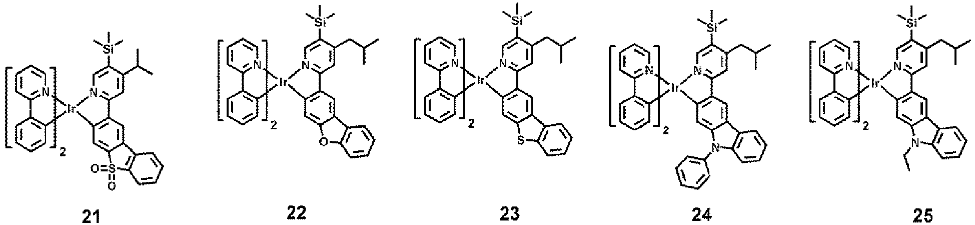

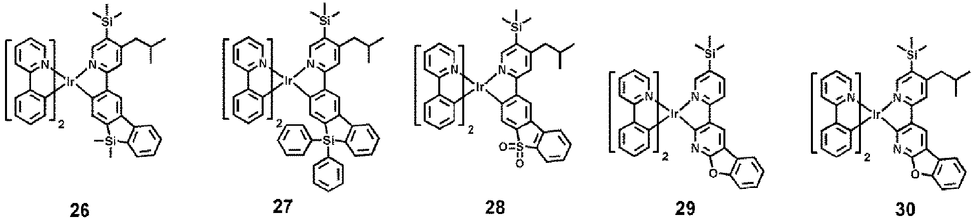

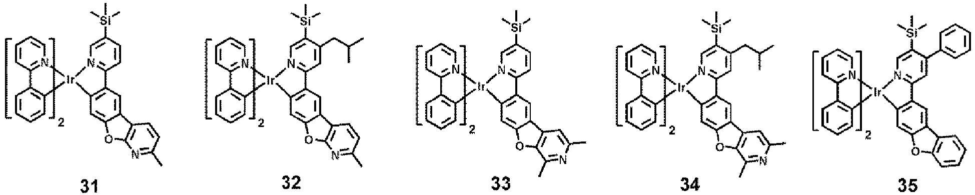

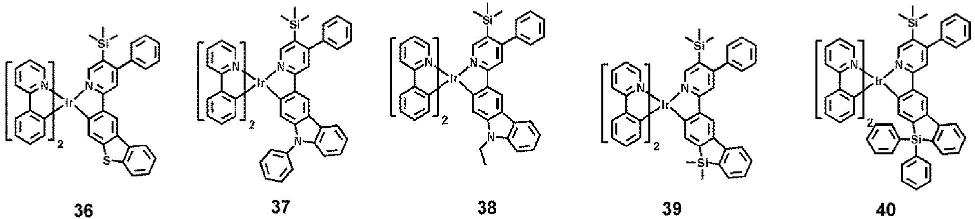

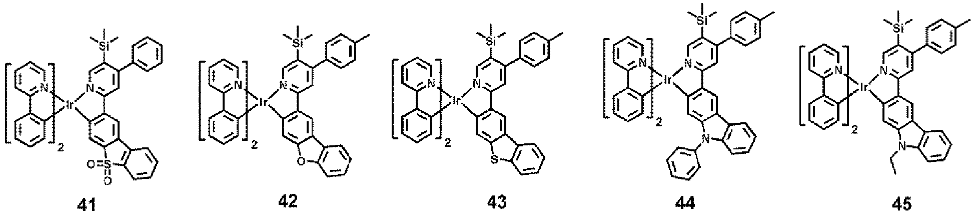

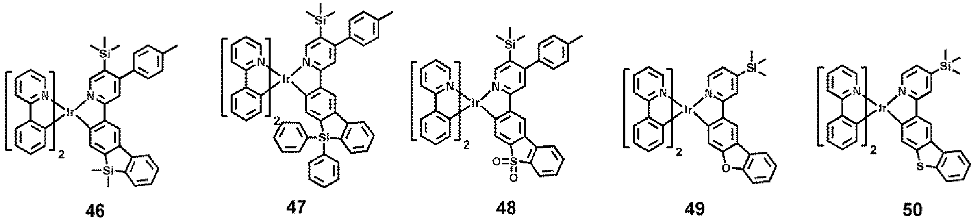

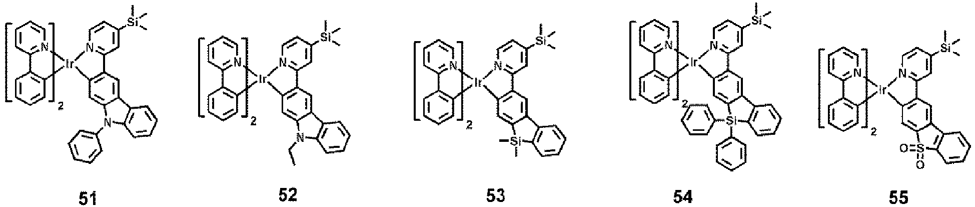

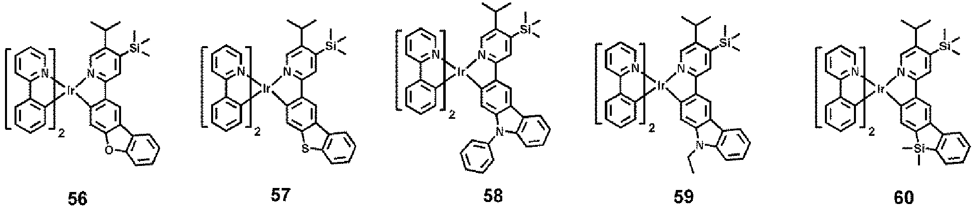

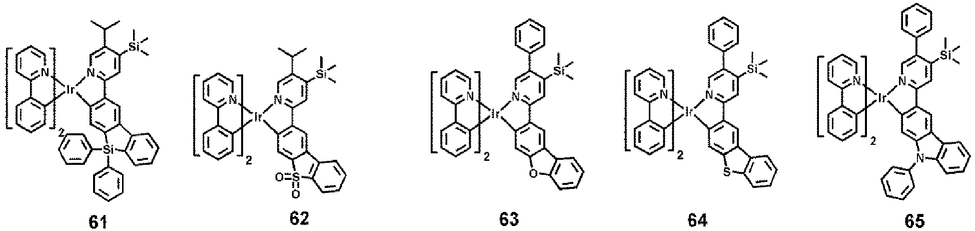

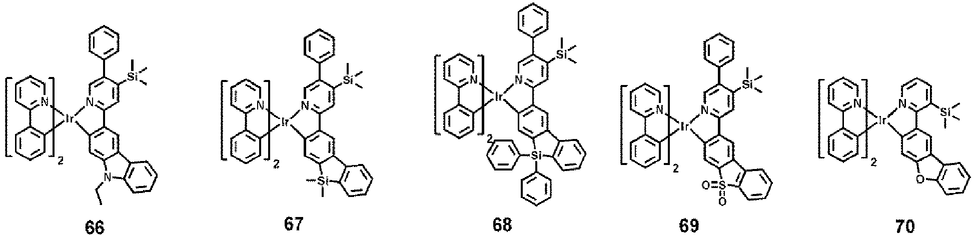

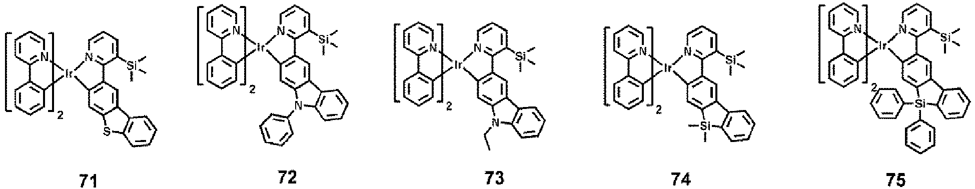

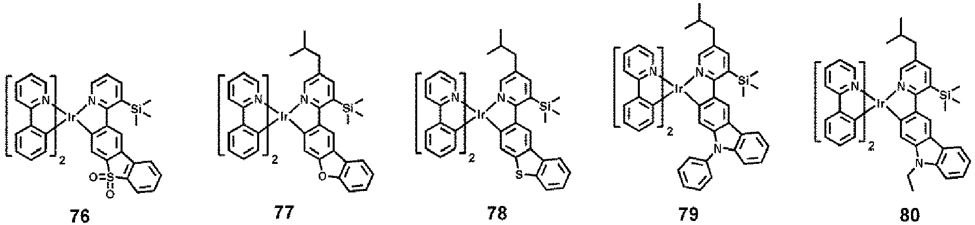

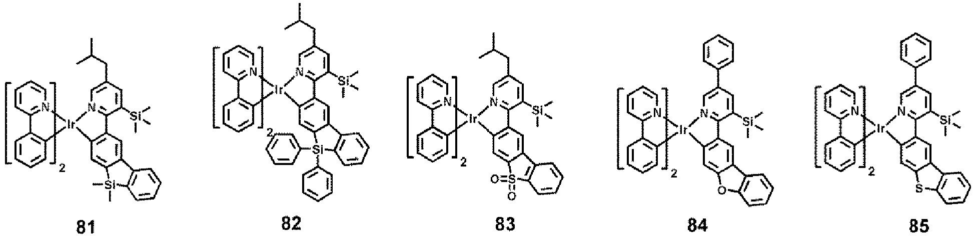

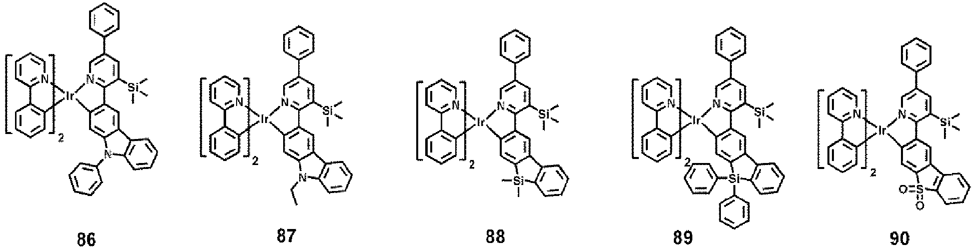

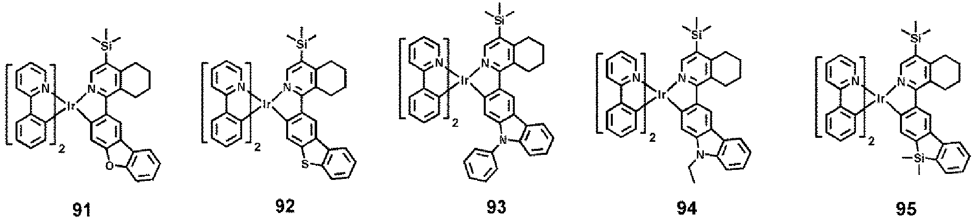

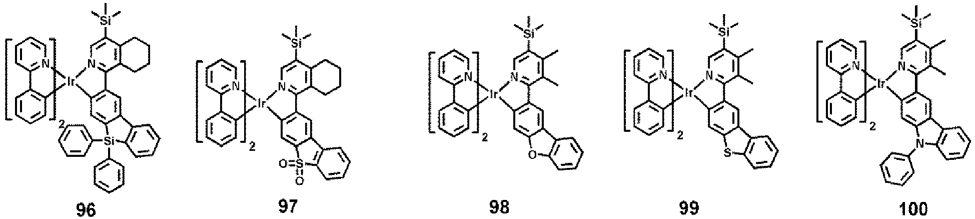

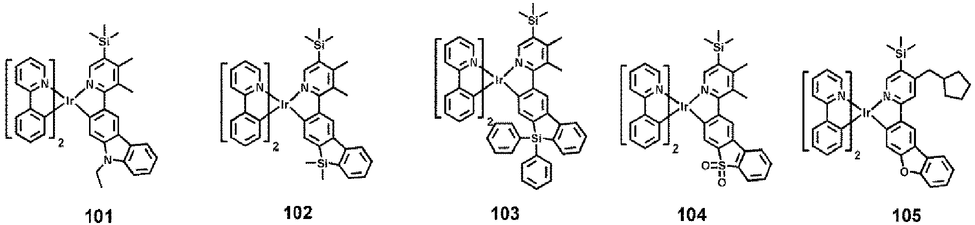

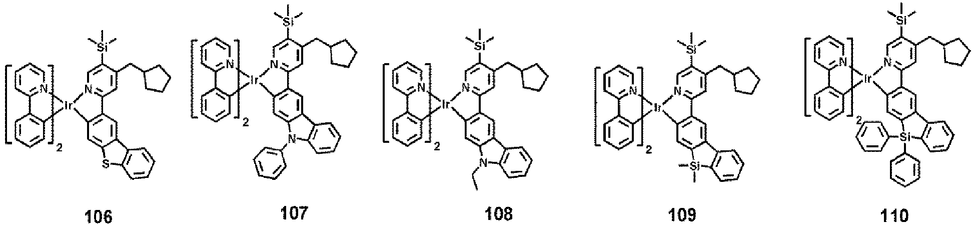

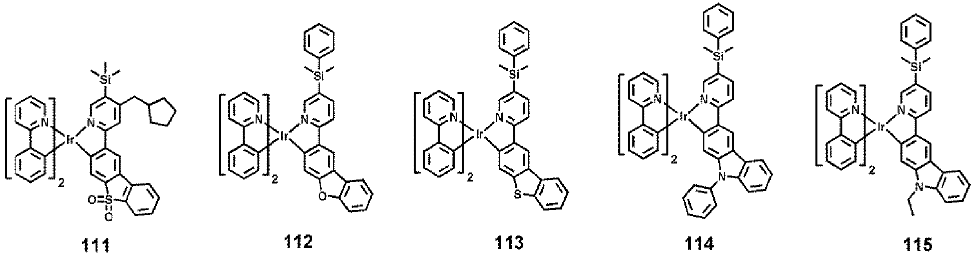

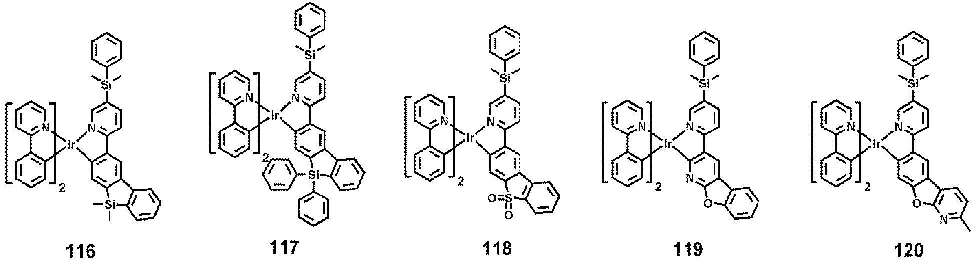

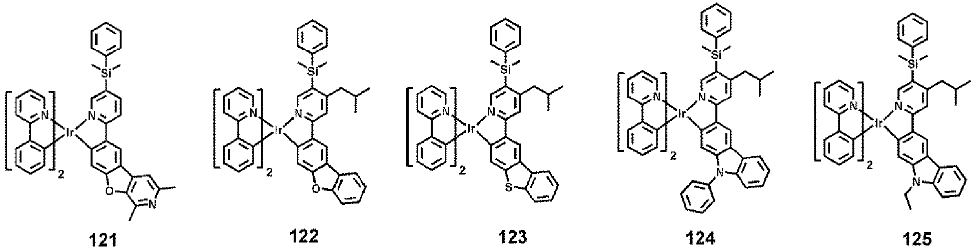

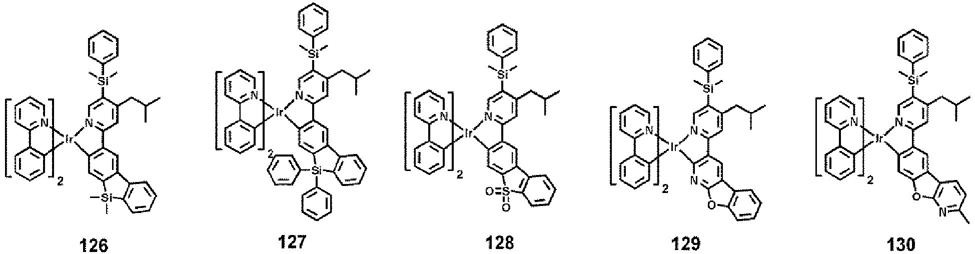

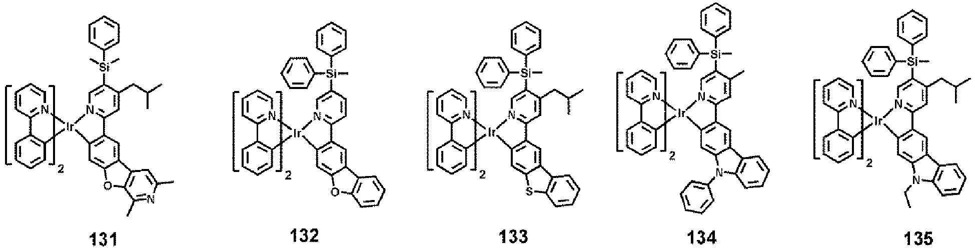

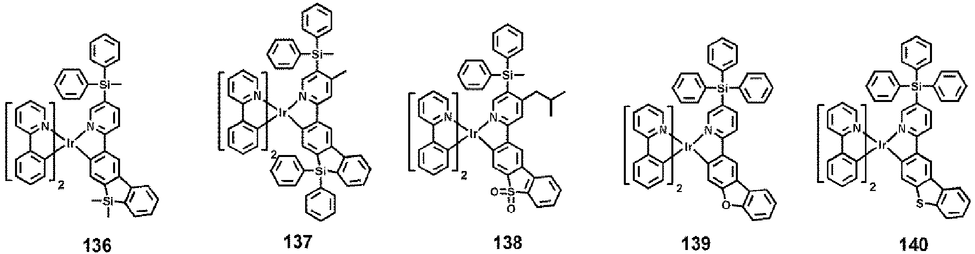

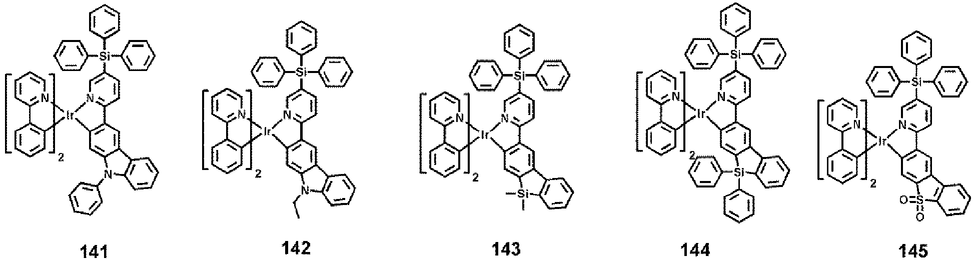

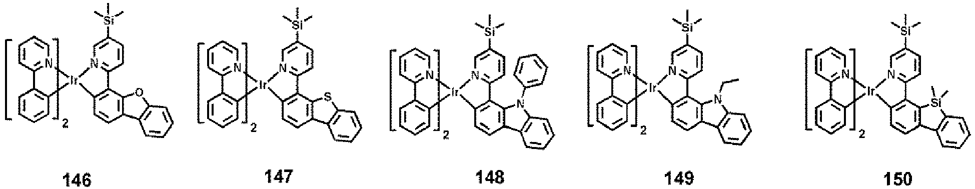

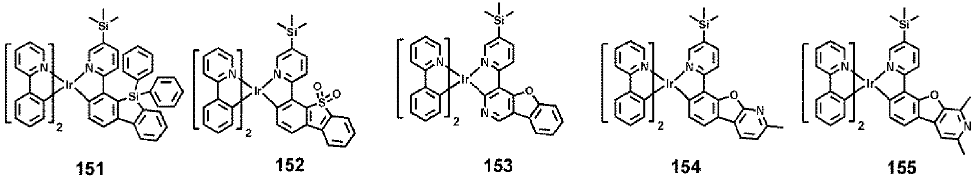

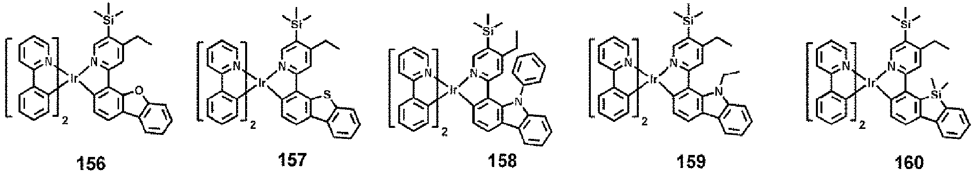

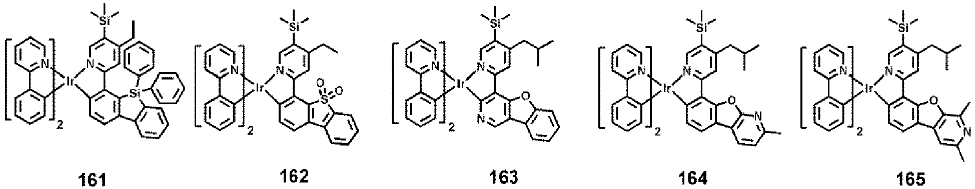

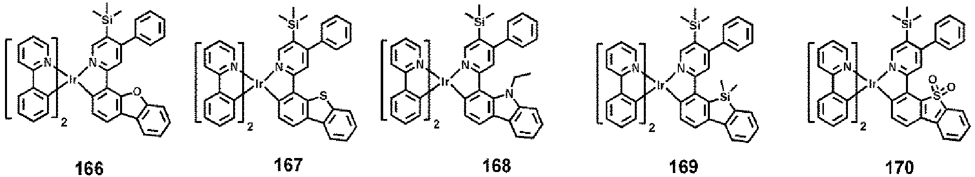

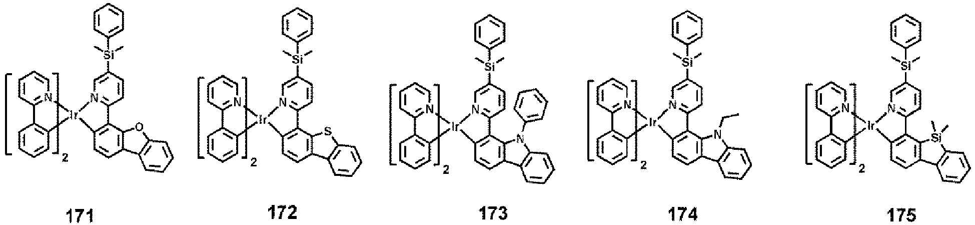

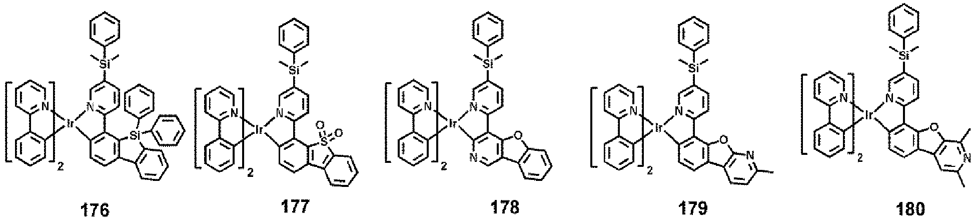

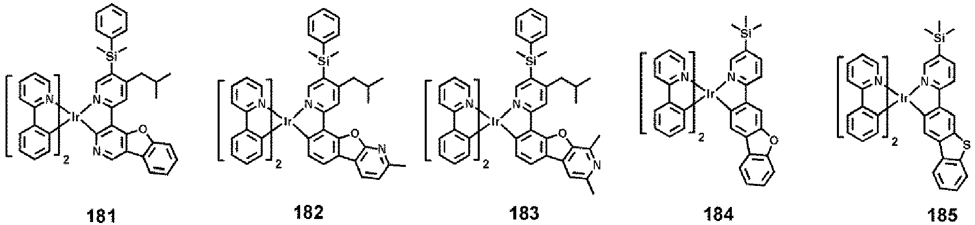

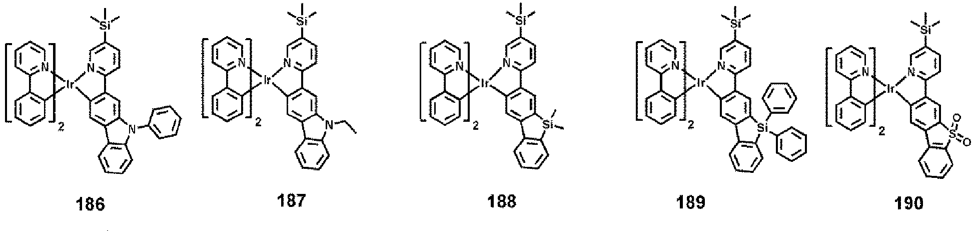

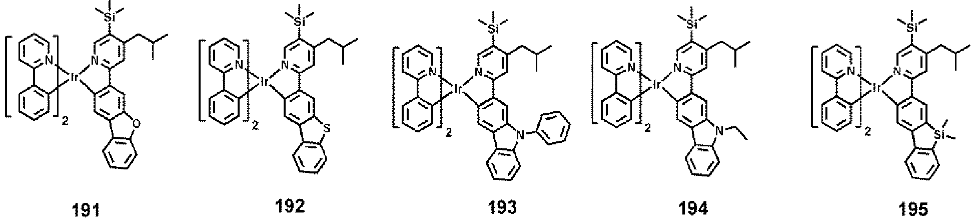

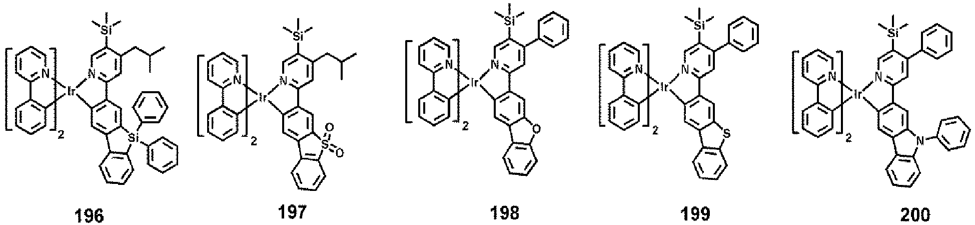

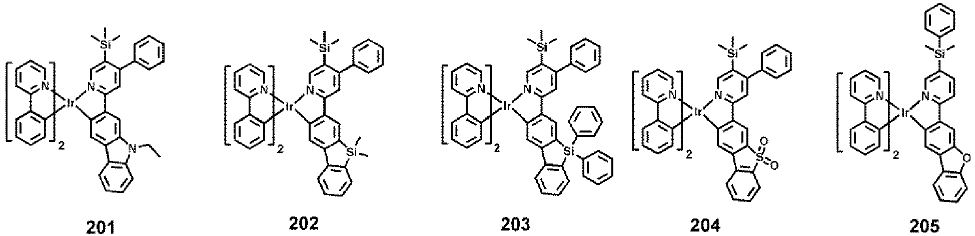

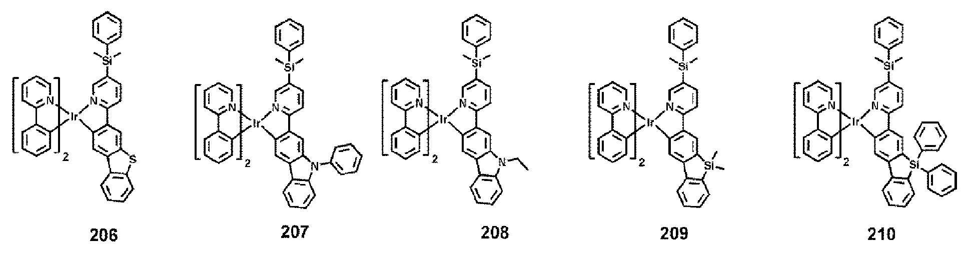

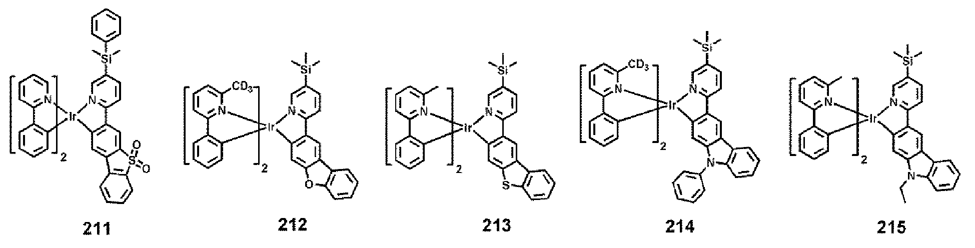

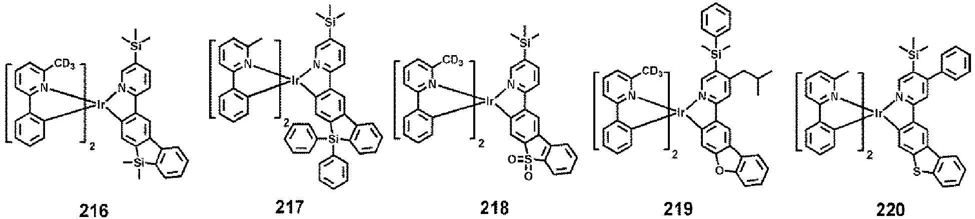

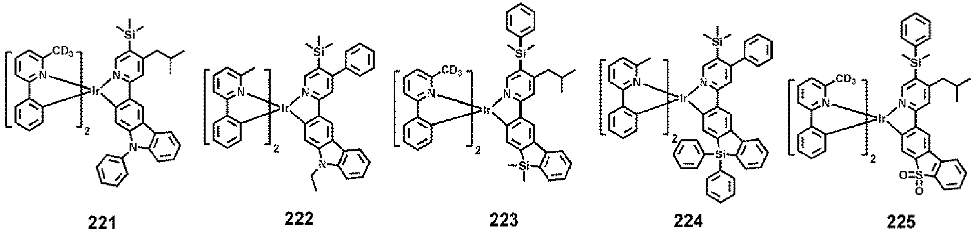

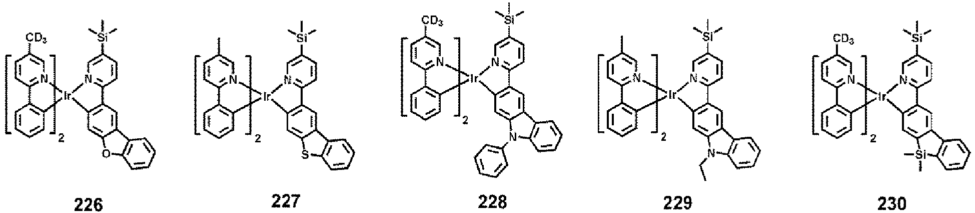

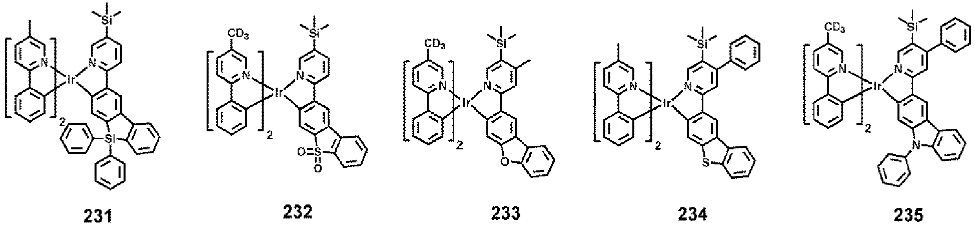

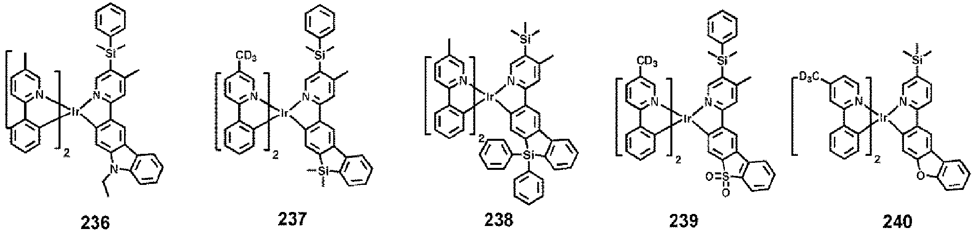

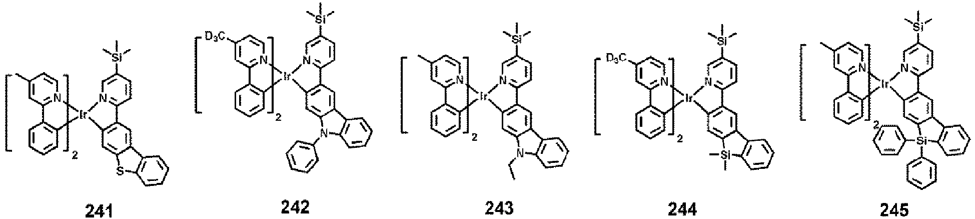

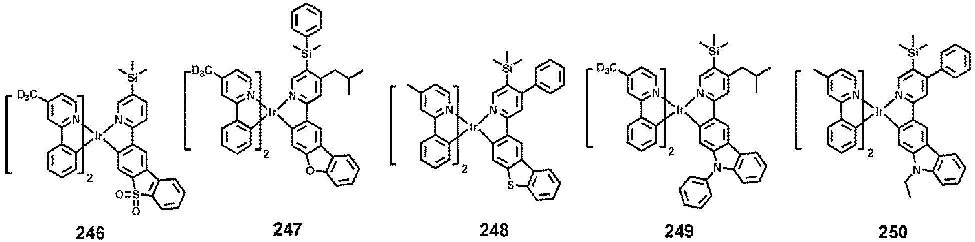

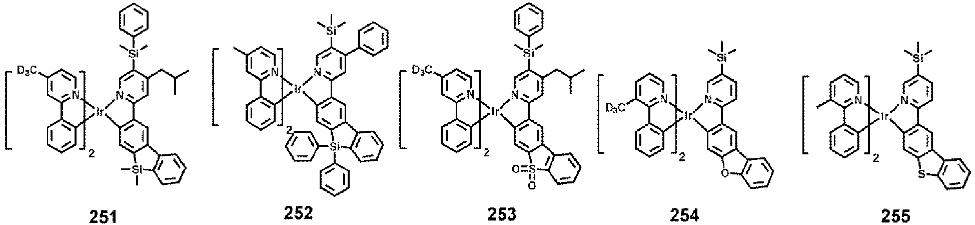

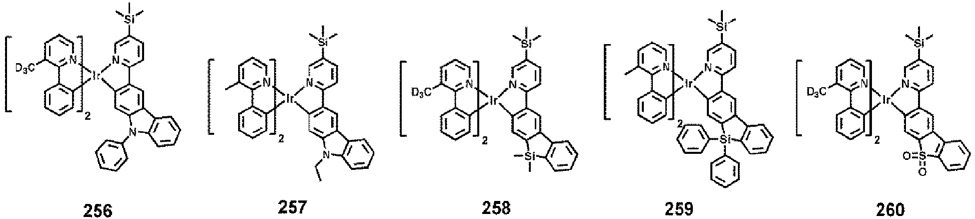

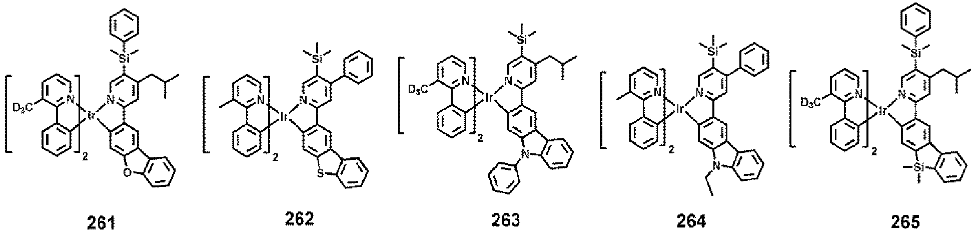

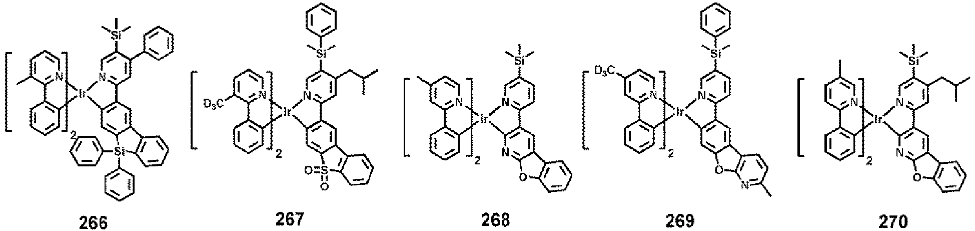

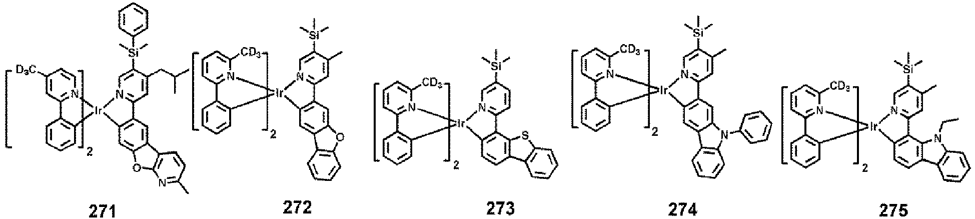

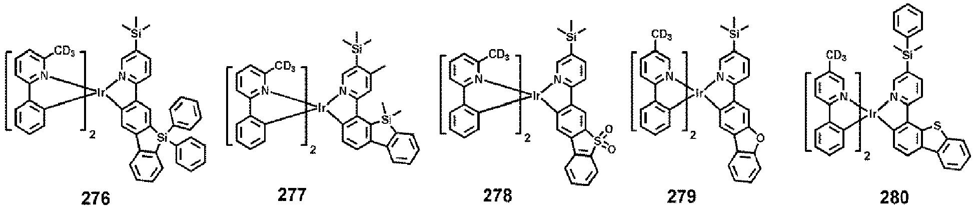

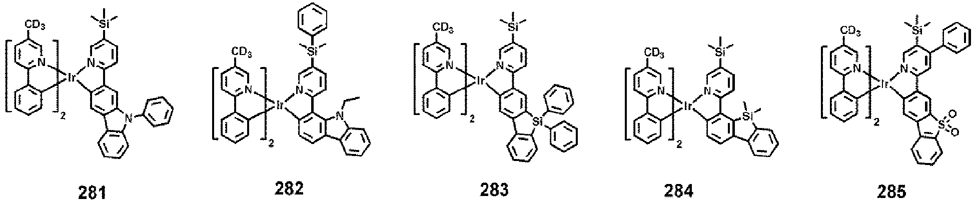

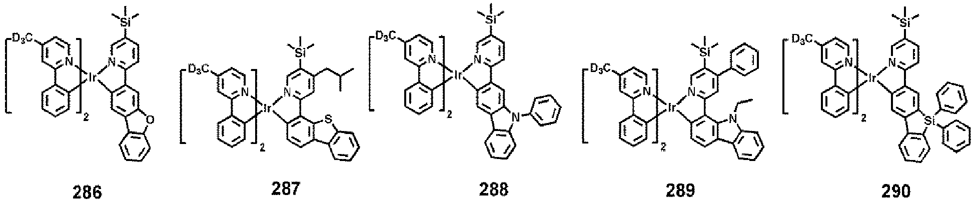

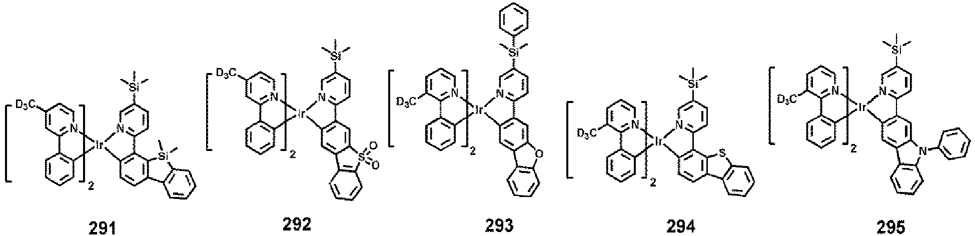

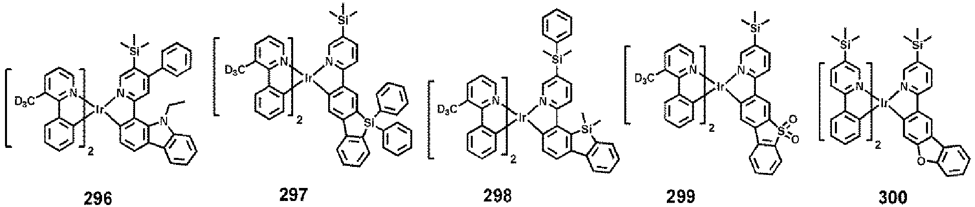

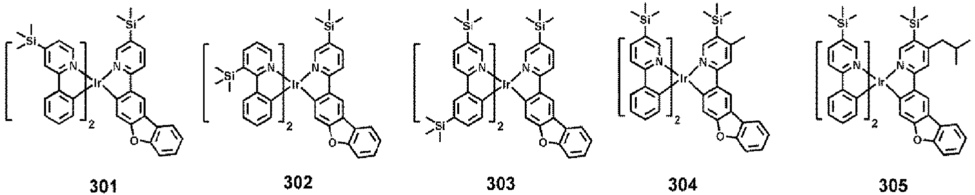

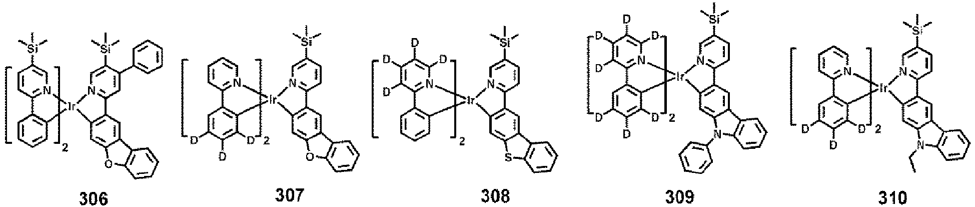

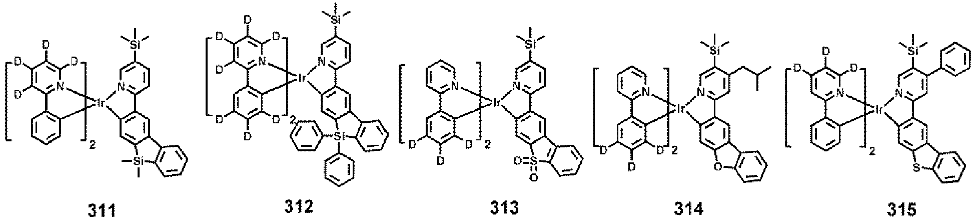

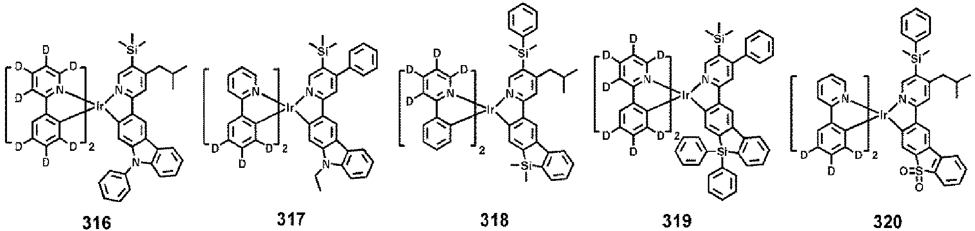

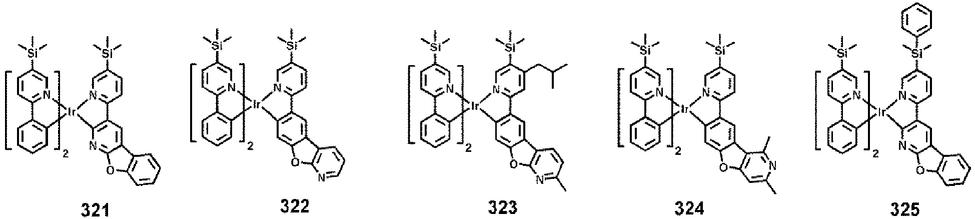

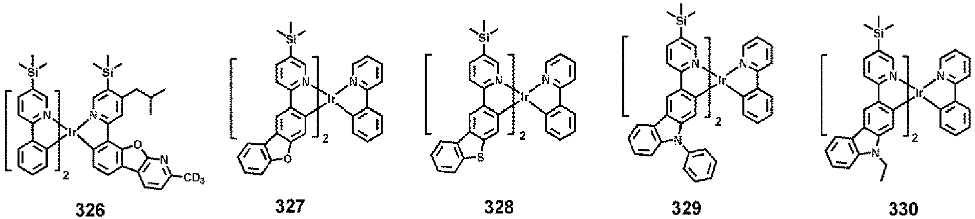

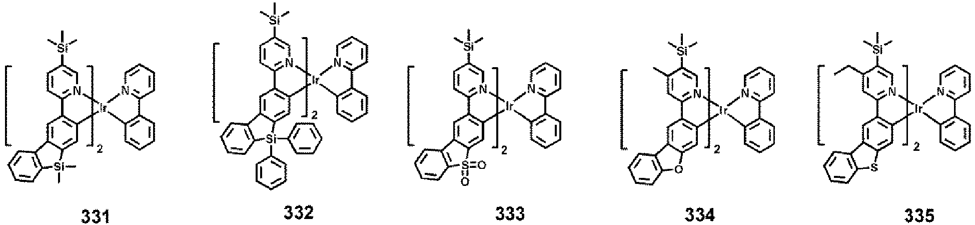

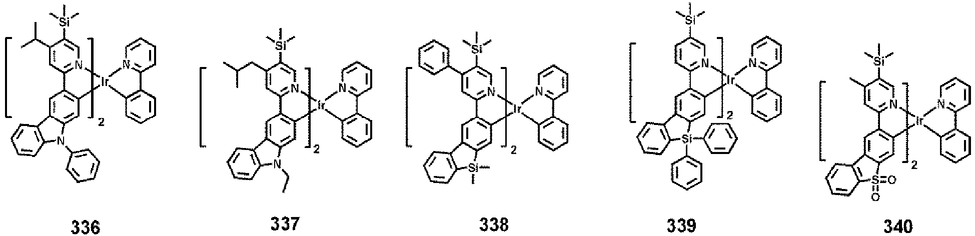

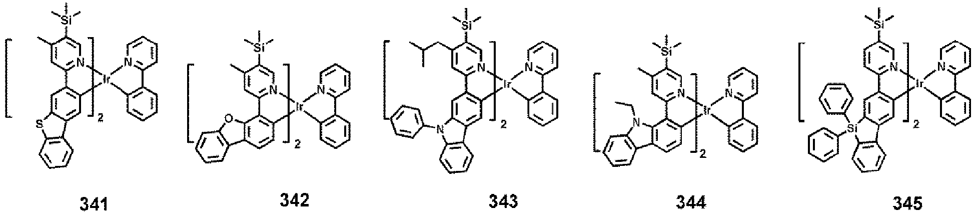

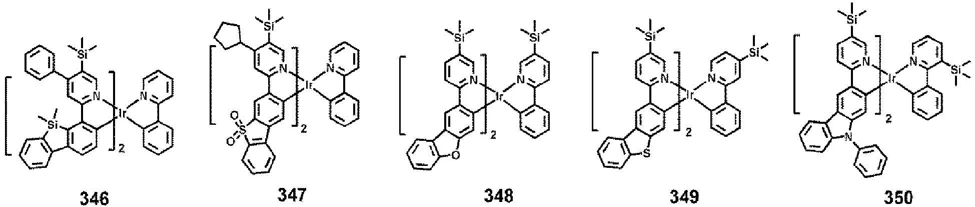

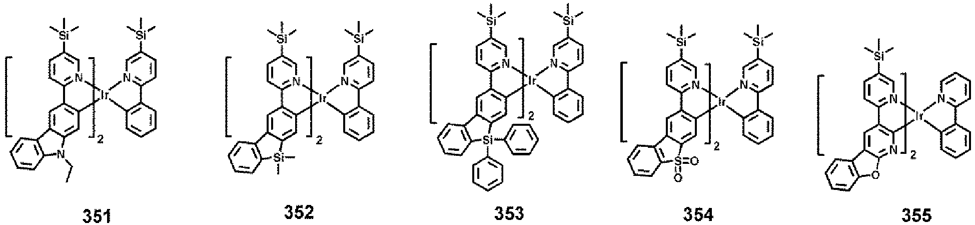

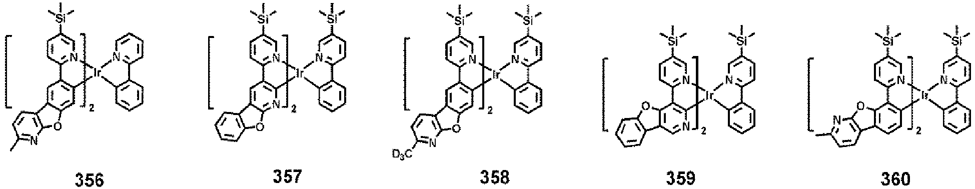

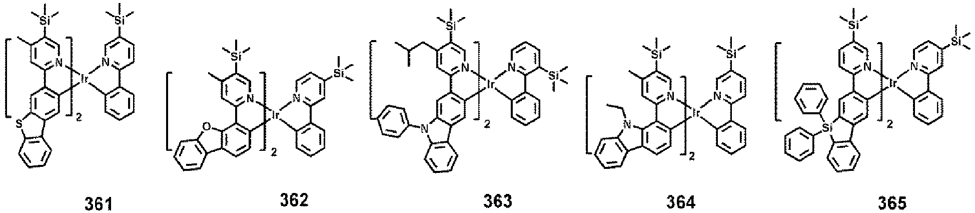

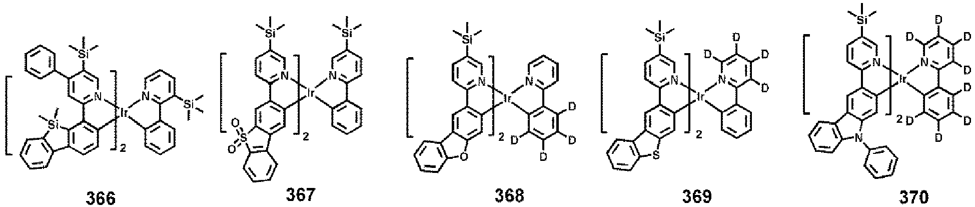

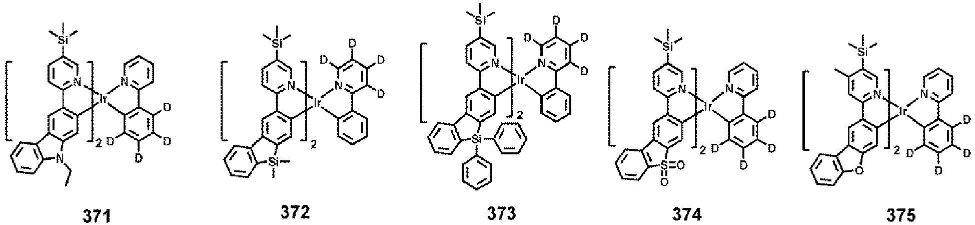

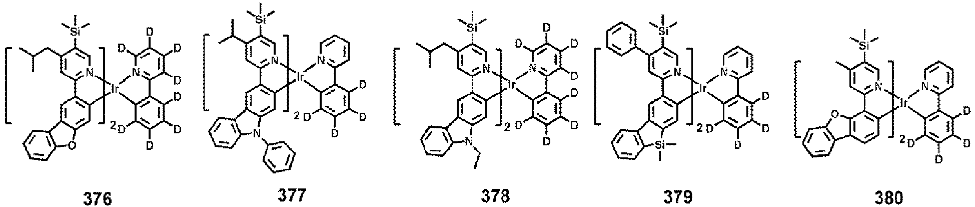

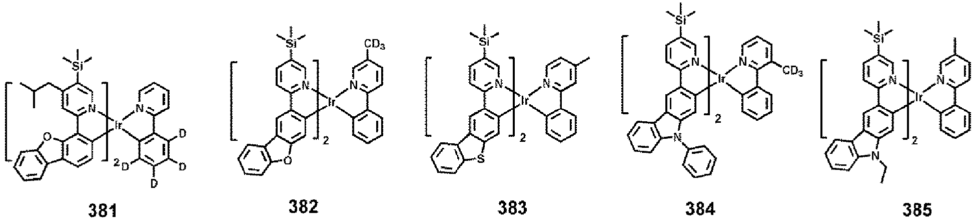

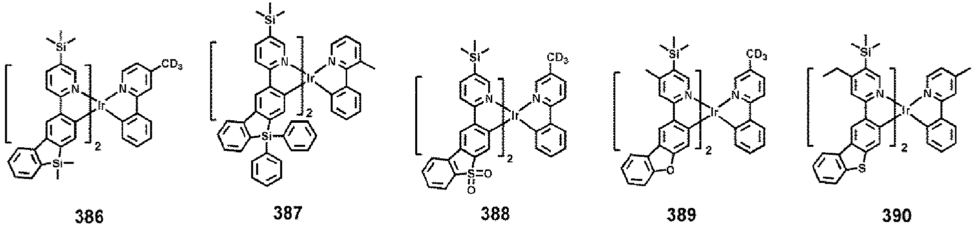

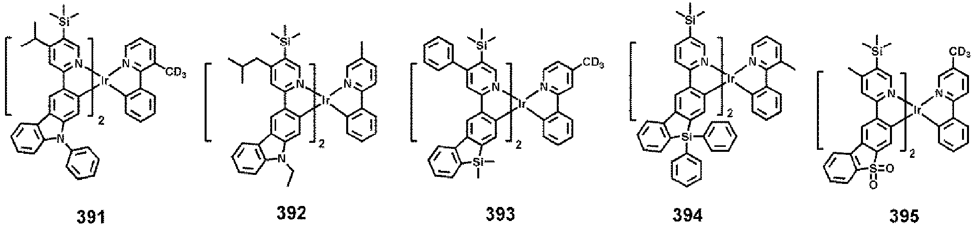

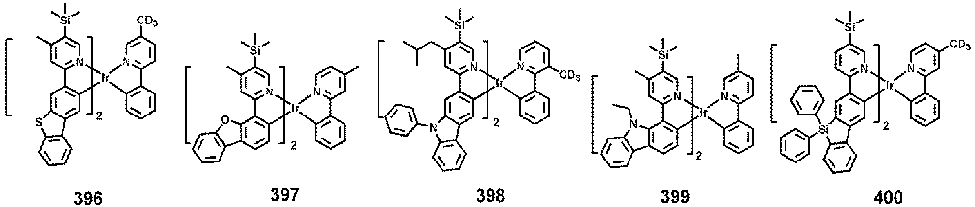

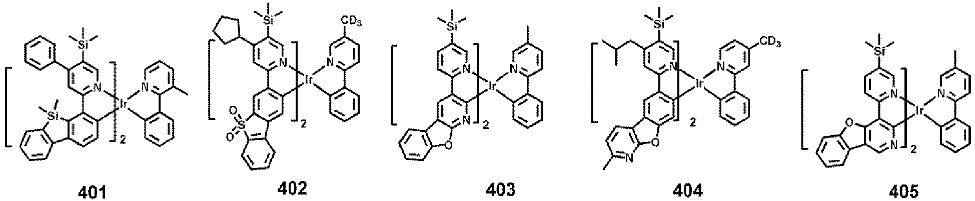

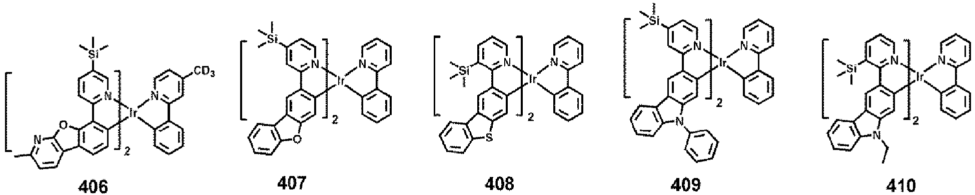

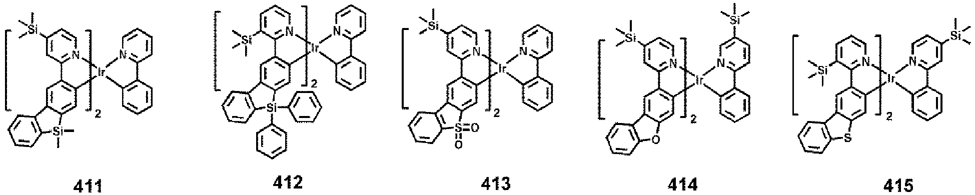

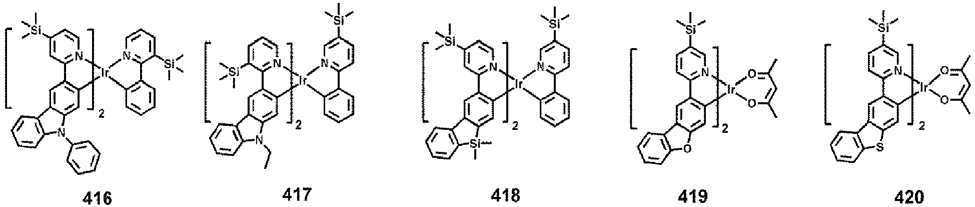

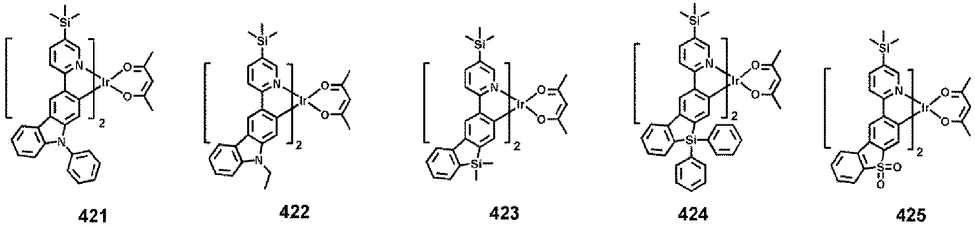

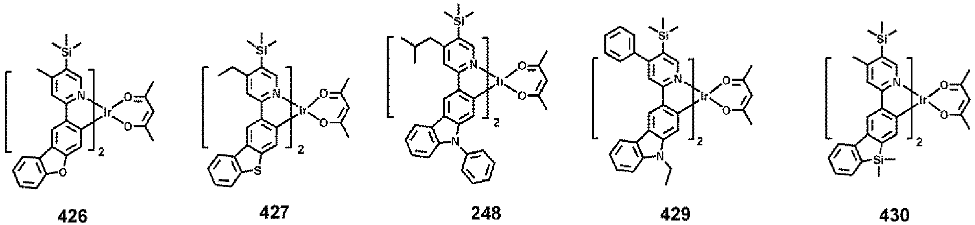

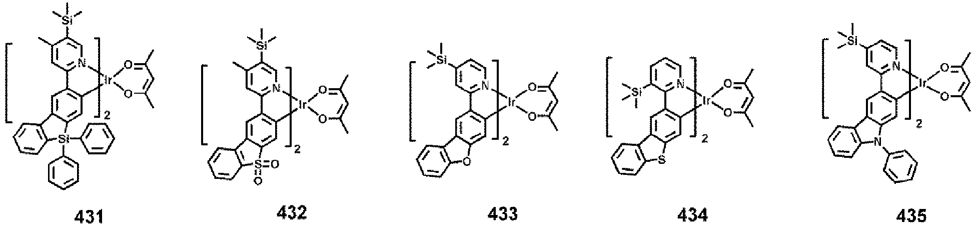

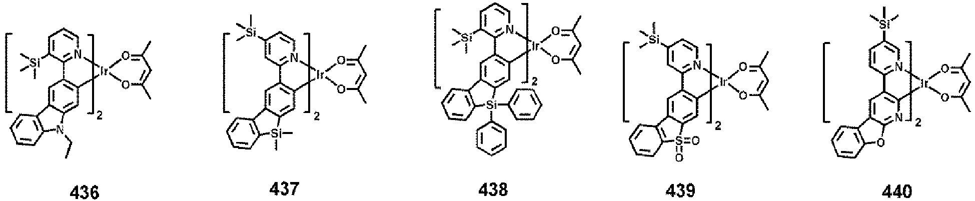

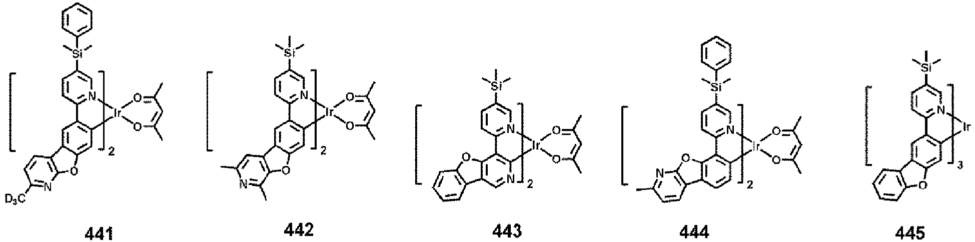

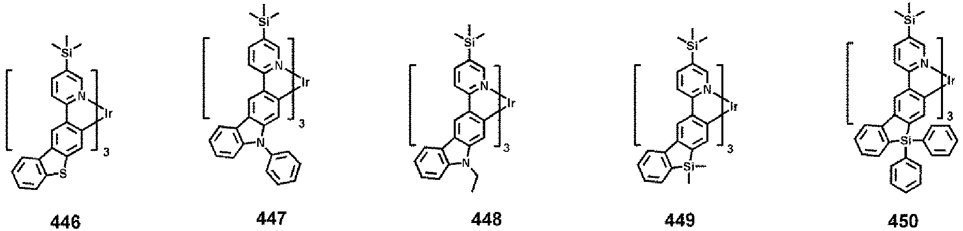

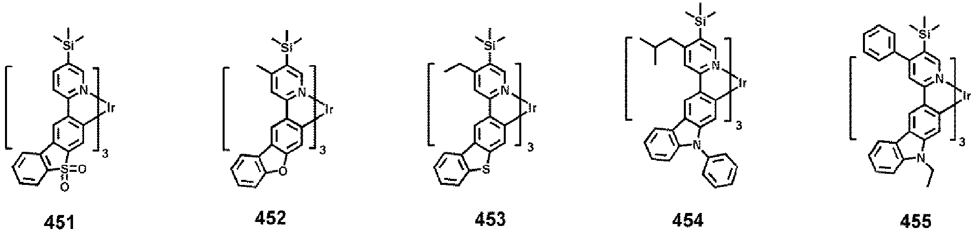

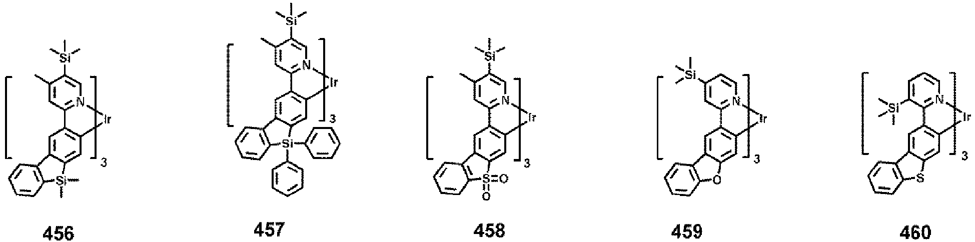

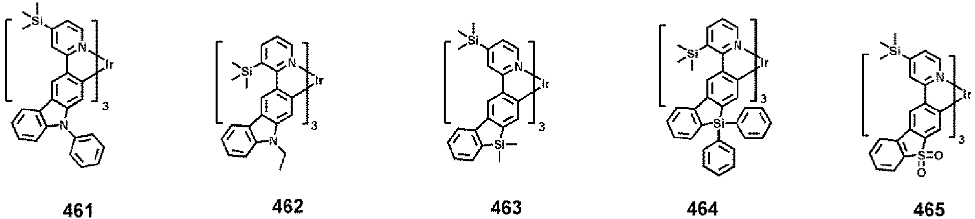

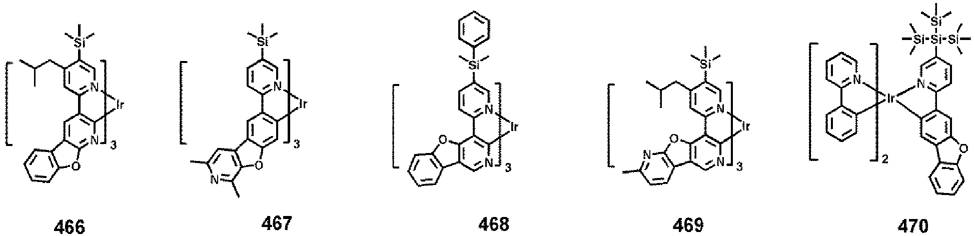

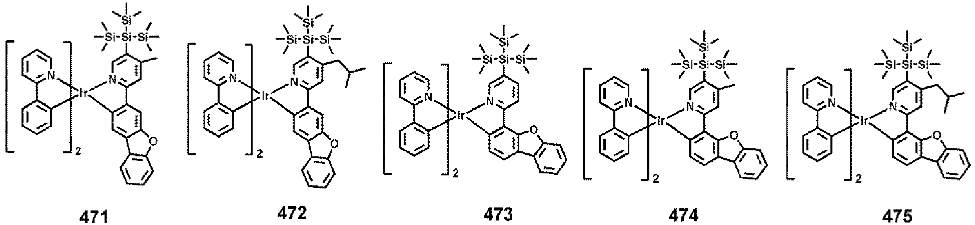

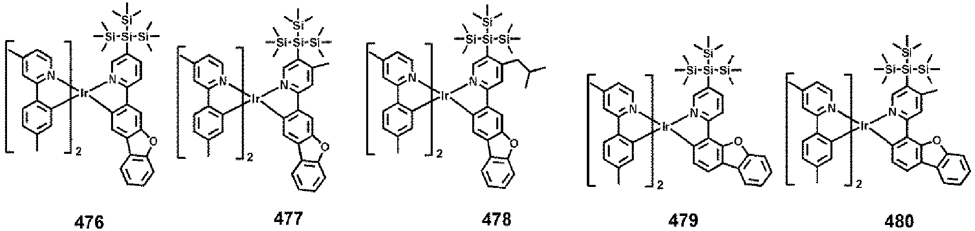

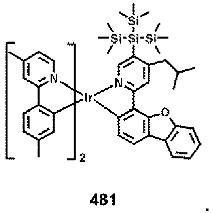

13. An organic light-emitting device comprising:
a first electrode;
a second electrode; and
an organic layer disposed between the first electrode and the second electrode,
wherein the organic layer comprises an emission layer and at least one organometallic compound of any of claims 1-12.

14. The organic light-emitting device of claim 13, wherein
the first electrode is an anode,
the second electrode is a cathode, and
the organic layer comprises a hole transport region between the first electrode and the emission layer, and an electron transport region between the emission layer and the second electrode,
wherein the hole transport region comprises at least one of a hole injection layer, a hole transport layer, and an electron blocking layer and
the electron transport region comprises at least one selected from a hole blocking layer, an electron transport layer, and an electron injection layer.

15. The organic light-emitting device of claim 13 or 14, wherein the emission layer comprises at least one organometallic compound of any of claims 1-12.

## Patentansprüche

1. Eine Organometallverbindung, dargestellt durch Formel 1:
Formel 1 M(L₁)ₙ₁(L₂)ₙ₂ 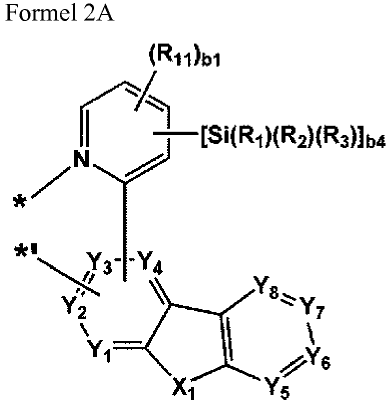
wobei
M in Formel 1 ausgewählt ist aus Ir, Pt, Os, Ti, Zr, Hf, Eu, Tb, Tm und Rh, in Formel 1 L₁ ein Ligand ist, dargestellt durch Formel 2A, n1 1, 2, oder 3 ist, und wenn n1 2 oder mehr ist, 2 oder mehr L₁ gleich oder verschieden sind,
in Formel 1 L₂ ausgewählt ist aus einem einwertigen organischen Liganden, einem zweiwertigen organischen Liganden, einem dreiwertigen organischen Liganden und einem vierwertigen organischen Liganden, n2 gleich 0, 1, 2, 3 oder 4 ist, und wenn n2 2 oder mehr ist, 2 oder mehr L₂ gleich oder verschieden sind,
L₁ und L₂ in Formel 1 voneinander verschieden sind,
R₁ bis R₃ in Formel 2A jeweils unabhängig voneinander ausgewählt sind aus einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkynylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Gruppe, einer substituierten oder unsubstituierten C₁-C₆₀-Heteroarylgruppe, einer substituierten oder einwertigen nicht-aromatischen kondensierten polycyclischen Gruppe, einer substituierten oder unsubstituierten einwertigen nicht-aromatischen kondensierten heteropolycyclischen Gruppe und -Si(Q₅₁)(Q₅₂)(Q₅₃),
X₁ in Formel 2A ausgewählt ist aus O, S, S(=O)₂, N(R₂₁) und Si(R₂₂)(R₂₃),
in Formel 2A Y₁ N, C(R₄₁) oder ein mit einem Pyridinring verbundenes Kohlenstoffatom ist, Y₂ N, C(R₄₂) oder ein mit einem Pyridinring verbundenes Kohlenstoffatom ist, Y₃ N, C(R₄₃) oder ein mit einem Pyridinring verbundenes Kohlenstoffatom ist, Y₄ N, C(R₄₄) oder ein mit einem Pyridinring verbundenes Kohlenstoffatom ist, Y₅ N oder C(R₄₅) ist, Y₆ N oder C(R₄₆) ist, Y₇ N oder C(R₄₇) ist, Y₈ N oder C(R₄₈) ist und eines von Y₁ bis Y₄ ein mit einem Pyridinring verbundenes Kohlenstoffatom ist,
R₁₁, R₂₁ bis R₂₃ und R₄₁ bis R₄₈ in Formel 2A jeweils unabhängig voneinander ausgewählt sind aus Wasserstoff, einem Deuterium, -F, -Cl, -Br, -I, -SF₅, einer Hydroxygruppe, einer Cyangruppe, einem Nitro, einer Aminogruppe, einer Amidingruppe, einer Hydrazingruppe, einer Hydrazongruppe, einer Carboxygruppe oder einem Salz davon, einer Sulfonsäuregruppe oder einem Salz davon, einer Phosphorsäuregruppe oder einem Salz davon, einer substituierten oder unsubstituierten C₁-C₆₀-Alkylgruppe, einer substituierten oder C₂-C₆₀-Alkenylgruppe, einer substituierten oder unsubstituierten C₂-C₆₀-Alkynylgruppe, einer substituierten oder unsubstituierten C₁-C₆₀-Alkoxygruppe, einer substituierten oder unsubstituierten C₃-C₁₀-Cycloalkoxygruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Hetero-cycloalkenylgruppe, einer substituierten oder unsubstituierten C₆-C₆₀-Arylgruppe, einer substituierten oder unsubstituierten C₆-C₆₀-Gruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nicht-aromatischen polycyclischen Gruppe, einer substituierten oder unsubstituierten einwertigen nicht-aromatischen kondensierten heteropolycyclischen Gruppe, -N(Q₁)(Q₂), -Si(Q₃)(Q₄)(Q₅), -B(Q₆)(Q₇) und - -P(=O)(Q₈)(Q₉), und 2 oder mehr R₁₁ gegebenenfalls miteinander verbunden sind, um einen gesättigten und ungesättigten C₄-C₆₀-Ring zu bilden, zwei oder mehr von R₄₁ bis R₄₄ gegebenenfalls miteinander verbunden sind, um einen gesättigten und ungesättigten C₄-C₆₀-Ring zu bilden, und zwei oder mehr von R₄₅ bis R₄₈ gegebenenfalls miteinander verbunden sind, um einen gesättigten und ungesättigten C₄-C₆₀-Ring zu bilden,
in Formel 2A b1 eine ganze Zahl ist, ausgewählt von 0 bis 3, und b4 eine ganze Zahl ist, ausgewählt aus 1 bis 4,
* und *' in Formel 2A Bindungsstellen zu M in Formel 1 sind,
mindestens eines der Substituenten der substituierten C₁-C₆₀-Alkylgruppe, der substituierten C₂-C₆₀-Alkenylgruppe, der substituierten C₂-C₆₀-Alkynylgruppe, der substituierten C₁-C₆₀-Alkoxygruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₆-C₆₀-Aryloxygruppe, der substituierten C₆-C₆₀-Arythiogruppe, der substituierten C₁-C₆₀-Heteroarylgruppe, der substituierten einwertigen nicht-aromatischen kondensierten polycyclischen Gruppe und der substituierten einwertigen nicht-aromatischen kondensierten heteropolycyclischen Gruppe ausgewählt ist aus:
einem Deuterium, aus -F, -Cl, -Br, -I, -CD₃, -CD₂H, -CDH₂, -CF₃, -CF₂H, -CFH₂, aus einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz derselben, einer Sulfonsäuregruppe oder einem Salz derselben, einer Phosphorsäuregruppe oder einem Salz derselben, einer C₁-C₆₀-Alkylgruppe, einer C₂-C₆₀-Alkenylgruppe, einer C₂-C₆₀-Alkynylgruppe und einer C₁-C₆₀-Alkoxygruppe;
einer C₁-C₆₀-Alkylgruppe, einer C₂-C₆₀-Alkenylgruppe, einer C₂-C₆₀-Alkynylgruppe und einer C₁-C₆₀-Alkoxygruppe, jeweils substituiert mit mindestens einem ausgewählt aus einem Deuterium, -F, -Cl, -Br, -I, -CD₃, -CD₂H, -CDH₂, -CF₃, -CF₂H, -CFH₂, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₃-C₁₀-Cycloalkylgruppe, einer C₁-C₁₀-Heteroycloalkylgruppe, einer C₃-C₁₀-Cycloalkenyl-gruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₈₀-Heteroarylgruppe, einer einwertigen nicht-aromatischen kondensierten polycyclischen Gruppe, einer einwertigen nicht-aromatischen kondensierten heteropolycyclischen Gruppe, -N(Q₁₁)(Q₁₂), -Si(Q₁₃)(Q₁₄)(Q₁₅), -B(Q₁₆)(Q₁₇) und -P(=O)(Q₁₈)(Q₁₉);
einer C₃-C₁₀-Cycloalkylgruppe, einer C₁-C₁₀-Heteroycloalkylgruppe, einer C₃-C₁₀-Cyclo-alkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht-aromatischen kondensierten polycyclischen Gruppe und einer einwertigen nicht-aromatischen kondensierten heteropolycyclischen Gruppe;
einer C₃-C₁₀-Cycloalkylgruppe, einer C₁-C₁₀-Heteroycloalkylgruppe, einer C₃-C₁₀-Cyclo-alkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht-aromatischen kondensierten polycyclischen Gruppe und einer einwertigen nicht-aromatischen kondensierten heteropolycyclischen Gruppe, jeweils substituiert mit mindestens einem ausgewählt aus einem Deuterium, -F, -Cl, -Br, -I, -CD₃, -CD₂H, -CDH₂, -CF₃, -CF₂H, -CFH₂, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkynylgruppe, einer C₁-C₆₀-Alkoxygruppe, einer C₃-C₁₀-Cycloalkylgruppe, einer C₁-C₁₀-Heteroycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht-aromatischen kondensierten polycyclischen Gruppe, einer einwertigen nicht-aromatischen kondensierten heteropolycyclischen Gruppe, -N(Q₂₁)(Q₂₂), -Si(Q₂₃)(Q₂₄)(Q₂₅), -B(Q₂₆)(Q₂₇) und -P(=O)(Q₂₈)(Q₂₉), und
-N(Q₃₁)(Q₃₂), -Si(Q₃₃)(Q₃₄)(Q₃₅), -B(Q₃₆)(Q₃₇) und -P(=O)(Q₃₈)(Q₃₉),
wobei Q₁ bis Q₉, Q₁₁ bis Q₁₉ und Q₂₁ bis Q₂₉, Q₃₁ bis Q₃₉ und Q₅₁ bis Q₅₃ jeweils unabhängig voneinander ausgewählt sind aus einem Wasserstoff, einem Deuterium, -F, -Cl, -Br, -I, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkynylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nicht-aromatischen kondensierten polycyclischen Gruppe, einer substituierten oder unsubstituierten einwertigen nicht-aromatischen kondensierten heteropolycyclischen Gruppe.

2. Organometallverbindung von Anspruch 1, wobei
in Formel 1, M gleich Ir ist und die Summe von n1 und n2 gleich 3 ist, oder M gleich Pt ist und die Summe von n1 und n2 gleich 2 ist, und
die Organometallverbindung keine Ionengruppe umfasst.

3. Organometallverbindung nach Anspruch 1 oder 2, wobei
R₁ bis R₃ in Formel 2A jeweils unabhängig voneinander ausgewählt sind aus
einer C₁-C₂₀-Alkylgruppe, einer C₁-C₂₀-Alkoxygruppe und -Si (Q₅₁), (Q₅₂), (Q₅₃),
einer C₁-C₂₀-Alkylgruppe und einer C₁-C₂₀-Alkoxygruppe, jeweils substituiert mit mindestens einem ausgewählt aus einem Deuterium, -F, -Cl, -Br, -I, -CD₃, -CD₂H, -CDH₂, -CF₃, -CF₂H, -CFH₂, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₁₀-Alkylgruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe und einer Pyrimidinylgruppe;
einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Quinolinylgruppe, einer Isoquinolinylgruppe, einer Benzoquinolinylgruppe, einer Quinoxalinylgruppe, einer Quinazolinylgruppe, einer Cinnolinylgruppe, einer Carbazolylgruppe, einer Phenanthrolinylgruppe, einer Benzoimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe, und
einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Quinolinylgruppe, einer Isoquinolinylgruppe, einer Benzoquinolinylgruppe, einer Quinoxalinylgruppe, einer Quinazolinylgruppe, einer Cinnolinylgruppe, einer Carbazolylgruppe, einer Phenanthrolinylgruppe, einer Benzoimidazolylgruppe, einer Benzofuranylgruppe, einer Benzothiophenylgruppe, einer Isobenzothiazolylgruppe, einer Benzoxazolylgruppe, einer Isobenzoxazolylgruppe, einem Triazolyl, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe, jeweils substituiert mit mindestens einem ausgewählt aus einem Deuterium, -F, -Cl, -Br, -I, -CD₃, -CD₂H, -CDH₂, -CF₃, -CF₂H, -CFH₂, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Quinolinylgruppe, einer Isoquinolinylgruppe, einer Benzoquinolinylgruppe, einer Quinoxalinylgruppe, einer Quinazolinylgruppe, einer Cinnolinylgruppe, einer Carbazolylgruppe, einer Phenanthrolinylgruppe, einer Benzoimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, , einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe, und
Q₅₁ bis Q₅₃ jeweils unabhängig voneinander ausgewählt sind aus
-CH₃, -CD₃, -CD₂H, -CDH₂, -CH₂CH₃, -CH₂CD₃, -CH₂CD₂H, -CH₂CDH₂, -CHDCH₃,-CHDCD₂H, -CHDCDH₂, -CHDCD₃, -CD₂CD₃, -CD₂CD₂H und -CD₂CDH₂;
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, und
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, ein tert-Pentylgruppe, einer Phenylgruppe und einer Naphthylgruppe, jeweils substituiert mit mindestens einem ausgewählt aus einem Deuterium, einer C₁-C₁₀-Alkylgruppe und einer Phenylgruppe;
wobei vorzugsweise:
R₁ bis R₃ in Formel 2a jeweils unabhängig voneinander ausgewählt sind aus -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H und -CD₂CDH₂;
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe, einer Naphthylgruppe und -Si(Q₅₁)(Q₅₂)(Q₅₃), und
einer n-Propylgruppe, einer Isopropylgruppe, einer n-Butylgruppe, einer Isobutylgruppe, einer sec-sec-Butylgruppe, einer tert-Butylgruppe, einer n-Pentylgruppe, einer Isopentylgruppe, sec-Pentylgruppe, einer tert-Pentylgruppe, einer Phenylgruppe und einer Naphthylgruppe, jeweils substituiert mit mindestens einem ausgewählt aus einem Deuterium, einer C₁-C₁₀-Alkylgruppe und einer Phenylgruppe, und
Q₅₁ bis Q₅₃ jeweils unabhängig voneinander ausgewählt sind aus
-CH₃, -CD₃, -CD₂H, -CDH₂, -CH₂CH₃, -CH₂CD₃, -CH₂CD₂H, -CH₂CDH₂, -CHDCH₃,-CHDCD₂H, -CHDCDH₂, -CHDCD₃, -CD₂CD₃, -CD₂CD₂H und -CD₂CDH₂;
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, und
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, jeweils substituiert mit mindestens einem ausgewählt aus einem Deuterium, einer C₁-C₁₀-Alkylgruppe und einer Phenylgruppe.

4. Organometallverbindung nach einem der Ansprüche 1 bis 3, wobei
R₁₁, R₂₁ bis R₂₃ und R₄₁ bis R₄₈ in Formel 2A jeweils unabhängig voneinander ausgewählt sind aus einem Wasserstoff, einem Deuterium, -F, -Cl, -Br, -I, -SF₅, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, eine Phosphorsäuregruppe oder einem Salz davon, einer C₁-C₂₀-Alkylgruppe und einer C₁-C₂₀-Alkoxygruppe;
einer C₁-C₂₀-Alkylgruppe und einer C₁-C₂₀-Alkoxygruppe, jeweils substituiert mit mindestens einem ausgewählt aus einem Deuterium, -F, -Cl, -Br, -I, -CD₃, -CD₂H, -CDH₂, -CF₃, -CF₂H, -CFH₂, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₁₀-Alkylgruppe, einer C₁-C₁₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₁₄-Arylgruppe, einer C₁-C₁₄-Heteroarylgruppe, einer einwertigen nicht-aromatischen kondensierten polycyclischen Gruppe und einer einwertigen nicht-aromatischen kondensierten heteropolycyclischen Gruppe;
einer C₃-C₁₀-Cycloalkylgruppe, einer C₁-C₁₀-Heteroycloalkylgruppe, einer C₃-C₁₀-Cyclo-alkenylgruppe, einer C₁-C₁₀-Heterocycloalkenylgruppe, einer C₆-C₁₄-Arylgruppe, einer C₁-C₁₄-Heteroarylgruppe, einer monovalenten nicht-aromatischen kondensierten polycyclischen Gruppe und einer monovalenten nicht-aromatischen kondensierten heteropolycyclischen Gruppe;
einer C₃-C₁₀-Cycloalkylgruppe, einer C₁-C₁₀-Heteroycloalkylgruppe, einer C₃-C₁₀-Cyclo-alkenylgruppe, einer C₁-C₁₀-Heterocycloalkenylgruppe, einer C₆-C₁₄-Arylgruppe, einer C₁-C₁₄-Heteroarylgruppe, einer monovalenten nicht-aromatischen kondensierten polycyclischen Gruppe und einer monovalenten nicht-aromatischen kondensierten heteropolycyclischen Gruppe, jeweils substituiert mit mindestens einem ausgewählt aus einem Deuterium, -F, -Cl, -Br, -I, -CD₃, -CD₂H, -CDH₂, -CF₃, -CF₂H, -CFH₂, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₂₀-Alkylgruppe, einer C₁-C₂₀-Alkoxygruppe, einer C₃-C₁₀-Cycloalkylgruppe, einer C₁-C₁₀-Heteroycloalkylgruppe, einer C₃-C₁₀-Cycloalkenylgruppe, einer C₁-C₁₀-Heterocycloalkenylgruppe, einer C₆-C₁₄-Arylgruppe, einer C₁-C₁₄-Heteroarylgruppe, einer monovalenten nicht-aromatischen kondensierten polycyclischen Gruppe und einer monovalenten nicht-aromatischen kondensierten heteropolycyclischen Gruppe, und
-N(Q₁)(Q₂), -Si(Q₃)(Q₄)(Q₅), -B(Q₆)(Q₇) und -P(=O)(Q₈)(Q₉),
wobei Q₁ bis Q₉ jeweils unabhängig voneinander ausgewählt sind aus einer substituierten oder C₁-C₂₀-Alkylgruppe, einer substituierten oder unsubstituierten C₁-C₂₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder C₆-C₁₄-Arylgruppe, einer substituierten oder unsubstituierten C₁-C₁₄-Heteroarylgruppe, einer substituierten oder unsubstituierten einwertigen nicht-aromatischen kondensierten polycyclischen Gruppe und einer substituierten oder unsubstituierten monovalenten nicht-aromatischen kondensierten heteropolycyclischen Gruppe;
wobei vorzugsweise:
R₁₁, R₂₁ bis R₂₃ und R₄₁ bis R₄₈ in Formel 2A jeweils unabhängig voneinander ausgewählt sind aus einem Wasserstoff, einem Deuterium, -F, -Cl, -Br, -I, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, -SF₅, einer C₁-C₂₀-Alkylgruppe und einer C₁-C₂₀-Alkoxygruppe;
einer C₁-C₂₀-Alkylgruppe und einer C₁-C₂₀-Alkoxygruppe, jeweils substituiert mit mindestens einem ausgewählt aus einem Deuterium, -F, -Cl, -Br, -I, -CD₃, -CD₂H, -CDH₂, -CF₃, -CF₂H, -CFH₂, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₁₀-Alkylgruppe, einer Cyclopentylgruppe, einer Cyclohexylgruppe, einer Cycloheptylgruppe, einer Cyclooctylgruppe, einer Adamantylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe und einer Pyrimidinylgruppe;
einer Cyclopentylgruppe, einer Cyclohexylgruppe, einer Cycloheptylgruppe, einer Cyclooctylgruppe, einer Adamantylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzoquinolinylgruppe, einer Chinoxalinylgruppe, einer Chinazolinylgruppe, einer Cinnolinylgruppe, einer Carbazolylgruppe, einer Phenanthrolinylgruppe, einer Benzoimidazolylgruppe, einer Benzofuranylgruppe, einer Benzothiophenylgruppe, einer Isobenzothiazolylgruppe, einer Benzoxazolylgruppe, einer Isoenzoxazolylgruppe, einer Triazolylgruppe, einer Tetrazolylgruppe, einer Oxadiazolylgruppe, einer Triazinylgruppe, einer Dibenzofuranylgruppe, ein Dibenzothiophenylgruppe, einer Benzocarbazolylgruppe, einer Dibenzocarbazolylgruppe, einer Imidazopyridinylgruppe und einer Imidazopyrimidinylgruppe;
einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Quinolinylgruppe, einer Isoquinolinylgruppe, einer Benzoquinolinylgruppe, einer Quinoxalinylgruppe, einer Quinazolinylgruppe, einer Cinnolinylgruppe, einer Carbazolylgruppe, einer Phenanthrolinylgruppe, einer Benzoimidazolylgruppe, einer Benzofuranylgruppe, einer Benzothiophenylgruppe, einer Isobenzothiazolylgruppe, einer Benzoxazolylgruppe, einer Isobenzoxazolylgruppe, einem Triazolyl, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe, jeweils substituiert mit mindestens einem ausgewählt aus einem Deuterium, -F, -Cl, -Br, -I, -CD₃, -CD₂H, -CDH₂, -CF₃, -CF₂H, -CFH₂, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Quinolinylgruppe, einer Isoquinolinylgruppe, einer Benzoquinolinylgruppe, einer Quinoxalinylgruppe, einer Quinazolinylgruppe, einer Cinnolinylgruppe, einer Carbazolylgruppe, einer Phenanthrolinylgruppe, einer Benzoimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe, und
-B(Q₆)(Q₇) und -P(=O)(Q₈)(Q₉),
wobei Q₆ bis Q₉ einzeln unabhängig voneinander ausgewählt sind aus
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H und -CD₂CDH₂;
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, und
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, ein tert-Pentylgruppe, einer Phenylgruppe und einer Naphthylgruppe, jeweils substituiert mit mindestens einem ausgewählt aus einem Deuterium, einer C₁-C₁₀-Alkylgruppe und einer Phenylgruppe;
wobei stärker bevorzugt:
R₁₁, R₂₁ bis R₂₃ und R₄₁ bis R₄₈ in Formel 2A jeweils unabhängig voneinander ausgewählt sind aus einem Wasserstoff, einem Deuterium, -F, einer Cyangruppe, einer Nitrogruppe, -SF₅, einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer n-Hexylgruppe, einer Isohexylgruppe, einer sec-Hexylgruppe, einer tert-Hexylgruppe, einer n-Heptylgruppe, einer Isoheptylgruppe, einer sec-Heptylgruppe, einer tert-Heptylgruppe, einer n-Octylgruppe, einer Isooctylgruppe, einer sec-Octylgruppe, einer tert-Octylgruppe, einer n-Nonylgruppe, einer Isononylgruppe, einer sec-Nonylgruppe, einer tert-Nonylgruppe, einer n-Decylgruppe, einer Isodecylgruppe, einer sec-Decylgruppe, einer tert-Decylgruppe, einer Methoxygruppe, einer Ethoxygruppe, einer Propoxygruppe, einer Butoxygruppe, einer Pentoxygruppe, einer Cyclopentylgruppe, einer Cyclohexylgruppe, einer Cycloheptylgruppe, einer Cyclooctylgruppe, einer Adamantylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe und einer Pyrimidinylgruppe;
einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer n-Hexylgruppe, einer Isohexylgruppe, einer sec-Hexylgruppe, einer tert-Hexylgruppe, einer n-Heptylgruppe, einer Isoheptylgruppe, einer sec-Heptylgruppe, einer tert-Heptylgruppe, einer n-Octylgruppe, einer Isooctylgruppe, einer sec-Octylgruppe, einer tert-Gruppe, einer n-Nonylgruppe, einer Isononylgruppe, einer sec-Nonylgruppe, einer tert-Nonylgruppe, einer n-n-Decylgruppe, einer Isodecylgruppe, einer sec-Decylgruppe, einer tert-Decylgruppe, einer Methoxygruppe, einer Ethoxygruppe, einer Propoxygruppe, einer Butoxygruppe, einer Pentoxygruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe und einer Pyrimidinylgruppe, jeweils substituiert mit mindestens einem ausgewählt aus einem Deuterium, -F, -CD₃, -CD₂H, - -CF₃, -CF₂H, -CFH₂, einer Cyangruppe, einer Nitrogruppe, einer C₁-C₁₀-Alkylgruppe, einer C₁-C₁₀-Alkoxygruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe und einer Pyrimidinylgruppe, und
-B(Q₆)(Q₇) und -P(=O)(Q₈)(Q₉),
wobei Q₆ bis Q₉ einzeln unabhängig voneinander ausgewählt sind aus
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H und -CD₂CDH₂;
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, und
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, jeweils substituiert mit mindestens einem ausgewählt aus einem Deuterium, einer C₁-C₁₀-Alkylgruppe und einer Phenylgruppe.

5. Organometallverbindung nach einem der Ansprüche 1 bis 4, wobei:
R₁₁, R₂₁ bis R₂₃ und R₄₁ bis R₄₈ in Formel 2A jeweils unabhängig voneinander ausgewählt sind aus einem Wasserstoff, einem Deuterium, -F, einer Cyangruppe, einer Nitrogruppe, -SF₅, -CH₃, -CD₃, -CD₂H, -CDH₂, -CF₃, -CF₂H, -CFH₂, durch Formeln 9-1 bis 9-17 dargestellten Gruppen und durch Formeln 10-1 bis 10-30 dargestellten Gruppen: 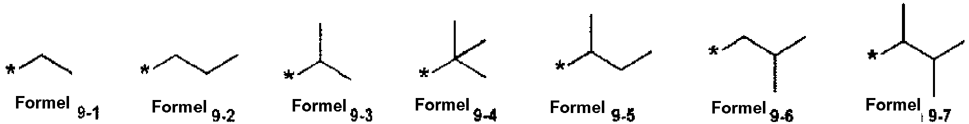 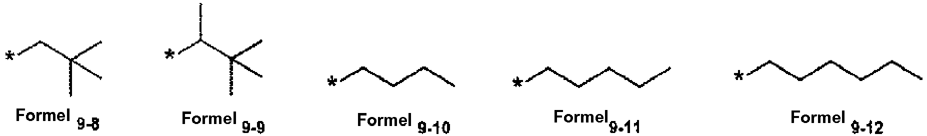 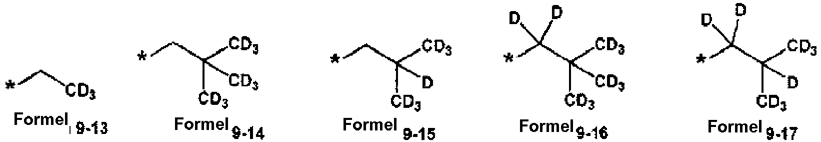 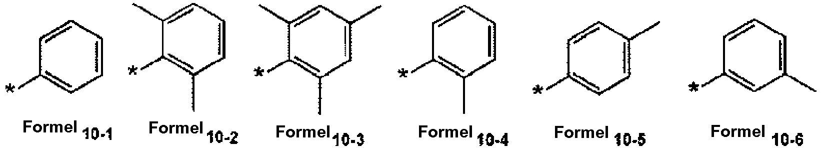 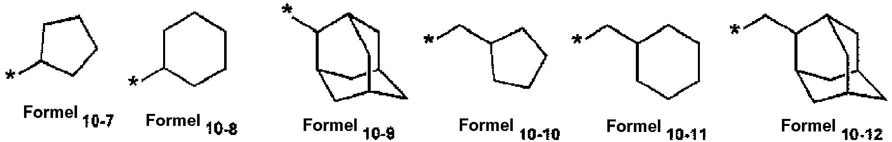 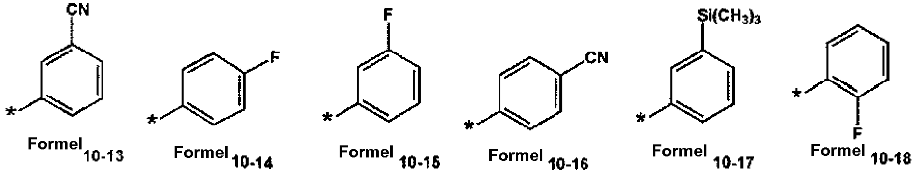 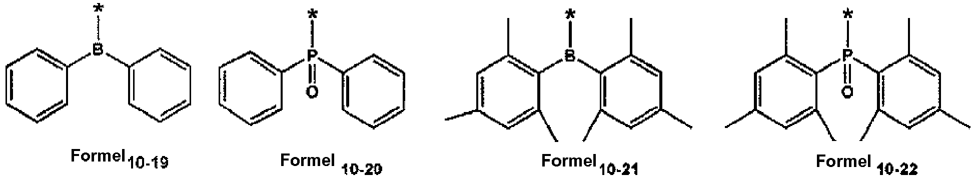 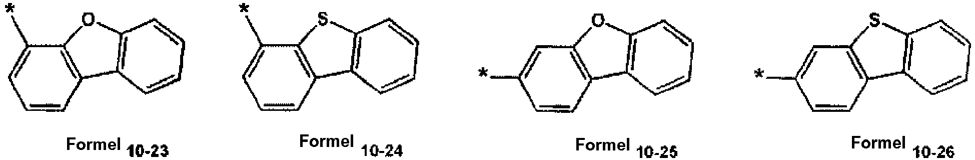 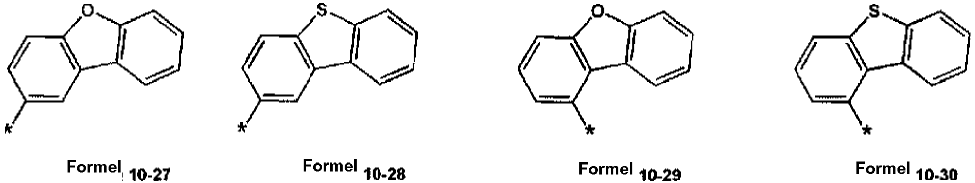
wobei in den Formeln 9-1 bis 9-17 und 10-1 bis 10-30 * eine Bindungsstelle an ein benachbartes Atom ist.

6. Organometallverbindung nach einem der Ansprüche 1 bis 5, wobei zwei Gruppen R₁₁ in Formel 2A miteinander verbunden sind, um substituiertes oder unsubstituiertes Cyclohexan oder substituiertes oder unsubstituiertes Benzol zu bilden.

7. Organometallverbindung nach einem der Ansprüche 1 bis 6, wobei L₁ ausgewählt ist aus Liganden, die durch die Formel 2A-1 bis 2A-16 dargestellt sind: 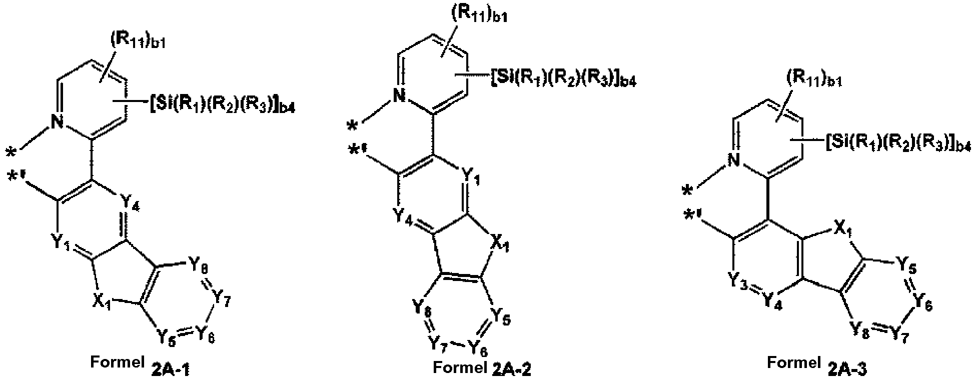 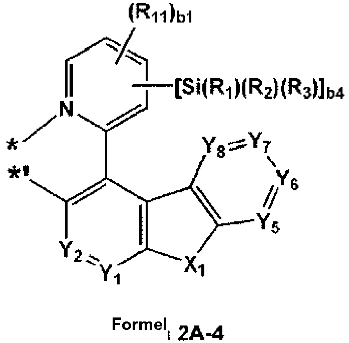 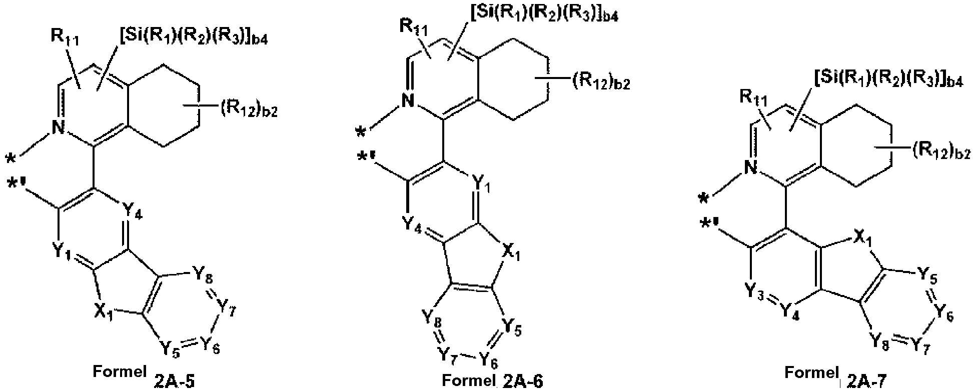 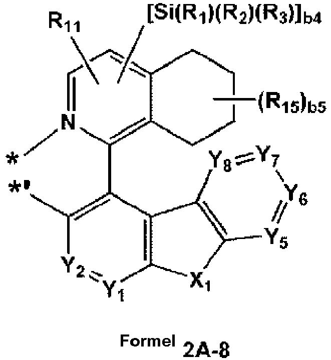 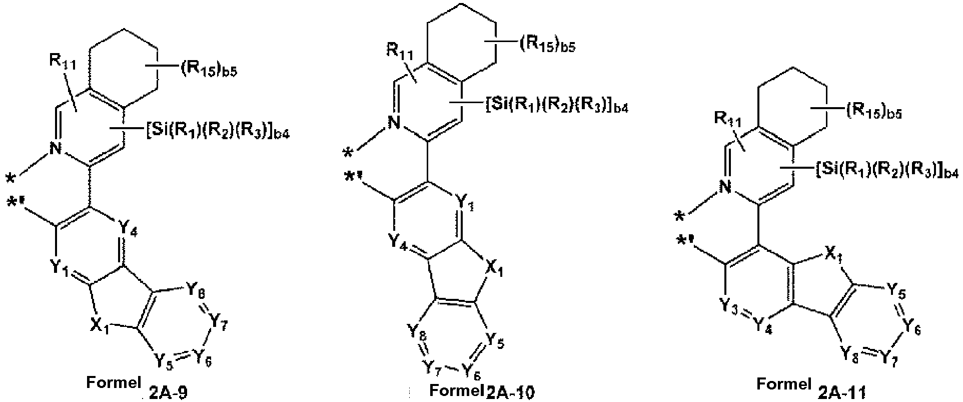 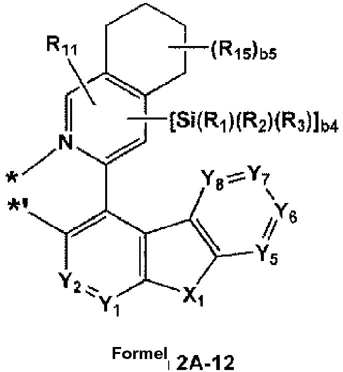 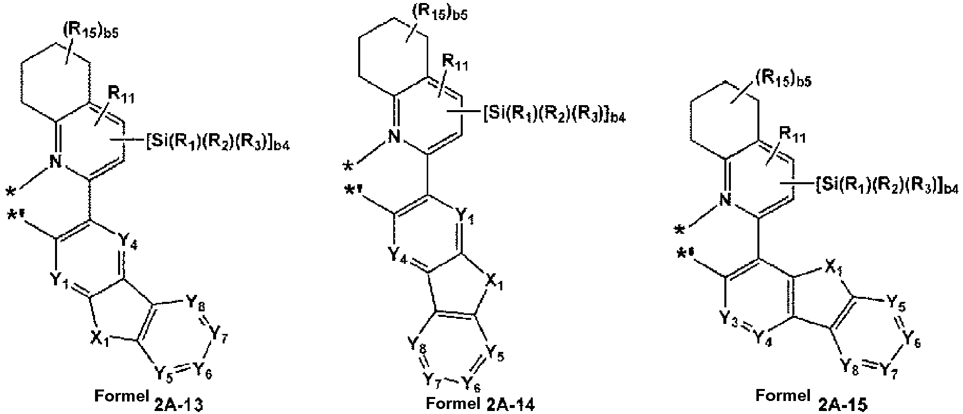 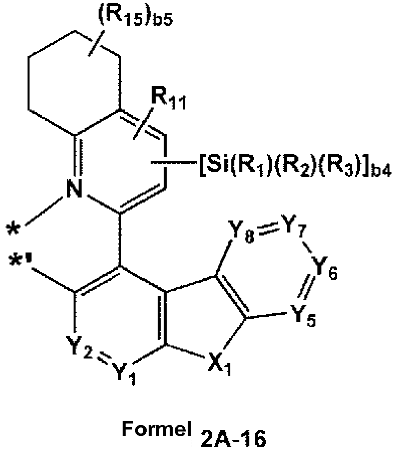
wobei in Formeln 2A-1 bis 2A-16, R₁ bis R₃, X₁, Y₁ bis Y₈, R₁₁, und b1 und b4 die gleichen sind wie in Anspruch 1 definiert, R₁₅ das gleiche ist wie R₁₁, b5 eine aus 0 bis 8 ausgewählte ganze Zahl ist und * und *' Bindungsstellen an M in Formel 1 sind, wobei vorzugsweise:
in Formeln 2A-1 bis 2A-16, Y₁ C(R₄₁) ist, Y₂ C(R₄₂) ist, Y₃ C(R₄₃) ist, Y₄ C(R₄₄) ist, Y₅ C(R₄₅) ist, Y₆ C(R₄₆) ist, Y₇ C(R₄₇) ist und Y₈ C(R₄₈) ist;
in Formeln 2A-1, 2A-2, 2A-4, 2A-5, 2A-6, 2A-8, 2A-9, 2A-10, 2A-12, 2A-13, 2A-14 und 2A-16, Y₁ N ist, Y₄ C(R₄₄) ist, Y₅ C(R₄₅) ist, Y₆ C(R₄₆) ist, Y₇ C(R₄₇) ist und Y₈ C(R₄₈) ist;
in Formeln 2A-1, 2A-2, 2A-4, 2A-5, 2A-6, 2A-8, 2A-9, 2A-10, 2A-12, 2A-13, 2A-14 und 2A-16, Y₁ C(R₄₁) ist, Y₄ C(R₄₄) ist, Y₄ C(R₄₄) ist, Y₅ N ist, Y₆ C(R₄₆) ist, Y₇ C(R₄₇) ist und Y₈ C(R₄₈) ist;
in Formeln 2A-1, 2A-2, 2A-4, 2A-5, 2A-6, 2A-8, 2A-9, 2A-10, 2A-12, 2A-13, 2A-14 und 2A-16, Y₁ C(R₄₁) ist, Y₄ C(R₄₄) ist, Y₅ C(R₄₅) ist, Y₆ N ist, Y₇ C(R₄₇) ist und Y₈ C(R₄₈) ist;
in Formeln 2A-1, 2A-2, 2A-4, 2A-5, 2A-6, 2A-8, 2A-9, 2A-10, 2A-12, 2A-13, 2A-14 und 2A-16, Y₁ N ist, Y₄ C(R₄₄) ist, Y₄ C(R₄₄) ist, Y₅ N ist, Y₆ C(R₄₆) ist, Y₇ C(R₄₇) ist und Y₈ C(R₄₈) ist;
in Formeln 2A-1, 2A-2, 2A-4, 2A-5, 2A-6, 2A-8, 2A-9, 2A-10, 2A-12, 2A-13, 2A-14 und 2A-16, Y₁ N ist, Y₄ C(R₄₄) ist, Y₅ C(R₄₅) ist, Y₆ N ist, Y₇ C(R₄₇) ist und Y₈ C(R₄₈) ist;
in Formeln 2A-3, 2A-7, 2A-11 und 2A-15, Y₃ N ist, Y₄ C(R₄₄) ist, Y₅ C(R₄₅) ist, Y₆ C(R₄₆) ist, Y₇ C(R₄₇) ist und Y₈ C(R₄₈) ist;
in Formeln 2A-3, 2A-7, 2A-11 und 2A-15, 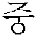 Y₃ C(R₄₃) ist, Y₄ C(R₄₄) ist, Y₅ N ist, Y₆ C(R₄₆) ist, Y₇ C(R₄₇) ist und Y₈ C(R₄₈) ist;
in Formeln 2A-3, 2A-7, 2A-11 und 2A-15, Y₃ C(R₄₃) ist, Y₄ C(R₄₄) ist, Y₅ C(R₄₅) ist, Y₆ N ist, Y₇ C(R₄₇) ist und Y₈ C(R₄₈) ist;
in Formeln 2A-3, 2A-7, 2A-11 und 2A-15, 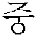 Y₃ N ist, Y₄ C(R₄₄) ist, Y₅ N ist, Y₆ C(R₄₆) ist, Y₇ C(R₄₇) ist und Y₅ C(R₄₈) ist, oder
in Formeln 2A-3, 2A-7, 2A-11 und 2A-15, Y₃ N ist, Y₄ C(R₄₄) ist, Y₅ C(R₄₅) ist, Y₆ N ist, Y₇ C(R₄₇) ist und Y₅ C(R₄₈) ist.

8. Organometallverbindung nach einem der Ansprüche 1 bis 6, wobei:
L₁ in Formel 1 ausgewählt ist aus Gruppen, dargestellt durch die Formeln 2AA-1, 2AA-2, 2AA-3, 2AA-4 und 2AB unten: 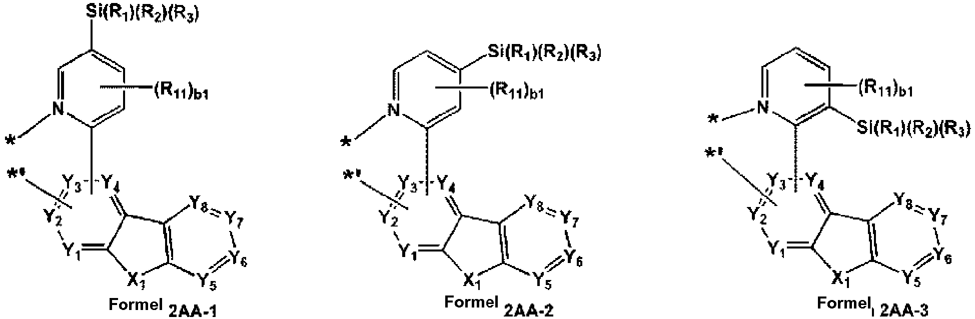 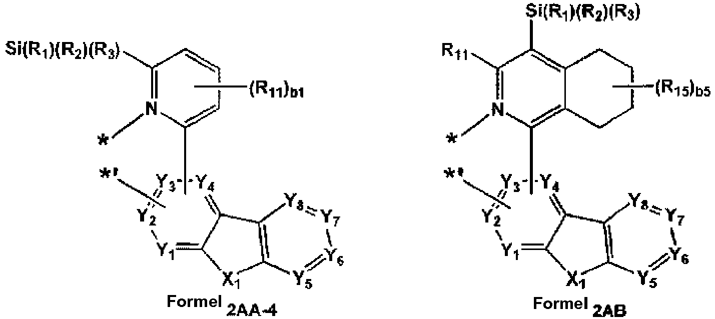
in Formeln 2AA-1, 2AA-2, 2AA-3, 2AA-4 und 2AB,
R₁ bis R₃ jeweils unabhängig voneinander ausgewählt sind aus
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H und -CD₂CDH₂;
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe, einer Naphthylgruppe und -Si(Q₅₁)(Q₅₂)(Q₅₃), und
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, die jeweils mit mindestens einem ausgewählt aus einem Deuterium und einer C₁-C₁₀-Alkylgruppe substituiert sind,
Q₅₁ bis Q₅₃ jeweils unabhängig voneinander ausgewählt sind aus
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H und -CD₂CDH₂;
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, und
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, ein tert-Pentylgruppe, einer Phenylgruppe und einer Naphthylgruppe, die jeweils mit mindestens einem ausgewählt aus einem Deuterium, einer C₁-C₁₀-Alkylgruppe und einer Phenylgruppe substituiert sind,
X₁ ausgewählt ist aus O, S, S(=O)₂, N(R₂₁) und Si(R₂₂)(R₂₃),
Beschreibungen von Y₁ bis Y₃ die gleichen sind wie in Anspruch 1,
R₁₁, R₁₅ und R₂₁ bis R₂₃ jeweils unabhängig voneinander ausgewählt sind aus
einem Wasserstoff, einem Deuterium, -F, einer Cyangruppe, einer Nitrogruppe, -SF 5, einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer n-Hexylgruppe, einer Isohexylgruppe, einer sec-Hexylgruppe, ein tert-Hexylgruppe, einer n-Heptylgruppe, einer Isoheptylgruppe, einer sec-Heptylgruppe, einer tert-Heptylgruppe, einer n-Octylgruppe, einer Isooctylgruppe, einer sec-Octylgruppe, einer tert-Octylgruppe, einer n-Nonylgruppe, einer Isononylgruppe, einer sec-Nonylgruppe, einer tert-Nonylgruppe, einer n-Decylgruppe, einer Isodecylgruppe, einer sec-Decylgruppe, einer tert-Decylgruppe, einer Methoxygruppe, einer Ethoxygruppe, einer Propoxygruppe, einer Butoxygruppe, einer Pentoxygruppe, einer Cyclopentylgruppe, einer Cyclohexylgruppe, einer Cycloheptylgruppe, einer Cyclooctylgruppe, einer Adamantylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe und einer Pyrimidinylgruppe;
einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer n-Hexylgruppe, einer Isohexylgruppe, einer sec-Hexylgruppe, einer tert-Hexylgruppe, einer n-Heptylgruppe, einer Isoheptylgruppe, einer sec-Heptylgruppe, einer tert-Heptylgruppe, einer n-Octylgruppe, einer Isooctylgruppe, einer sec-Octylgruppe, einer tert-Octylgruppe, einer n-Nonylgruppe, einer Isononylgruppe, einer sec-Nonylgruppe, einer tert-Nonylgruppe, einer n-Decylgruppe, einer Isodecylgruppe, einer sec-Decylgruppe, einer tert-Decylgruppe, einer Methoxygruppe, einer Ethoxygruppe, einer Propoxygruppe, einer Butoxygruppe, einer Pentoxygruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe und einer Pyrimidinylgruppe, jeweils substituiert mit mindestens einem ausgewählt aus einem Deuterium, -F, -CD₃, -CD₂H, -CDH₂, -CF₃, -CF₂H, -CFH₂, einer Cyangruppe, einer Nitrogruppe, einer C₁-C₁₀-Alkylgruppe, einer C₁-C₁₀-Alkoxygruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe und einer Pyrimidinylgruppe, und
-B(Q₆)(Q₇) und -P(=O)(Q₈)(Q₉),
wobei Q₆ bis Q₉ einzeln unabhängig voneinander ausgewählt sind aus
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H und -CD₂CDH₂;
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, und
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe und einer Phenylgruppe und einer Naphthylgruppe, die jeweils mit mindestens einem ausgewählt aus einem Deuterium und einer C₁-C₁₀-Alkylgruppe substituiert sind,
b5 eine ganze Zahl ist, die von 0 bis 8 ausgewählt ist, und
* und *' Bindungsstellen zu M in Formel 1 sind.

9. Organometallverbindung nach einem der Ansprüche 1 bis 6, wobei:
L₁ ausgewählt ist aus Liganden der Formeln 2A(1) bis 2A(40): 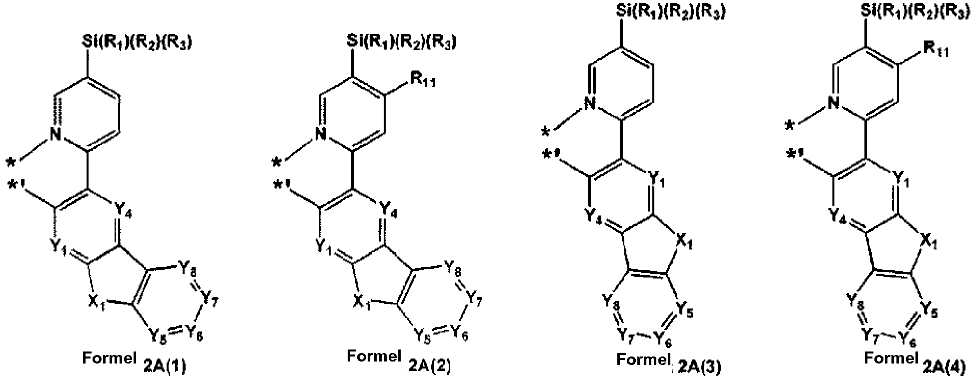 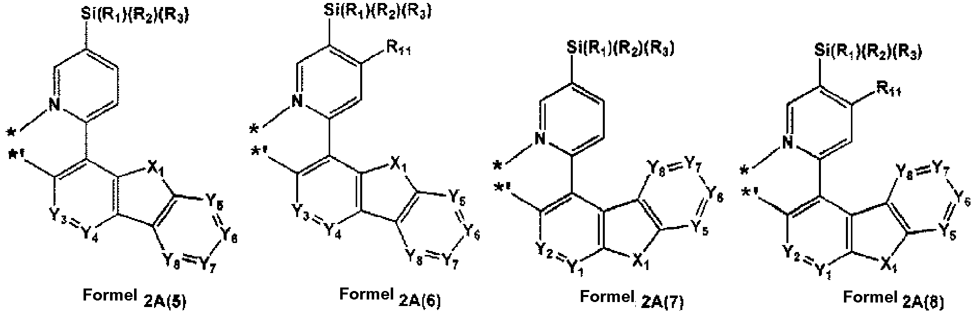 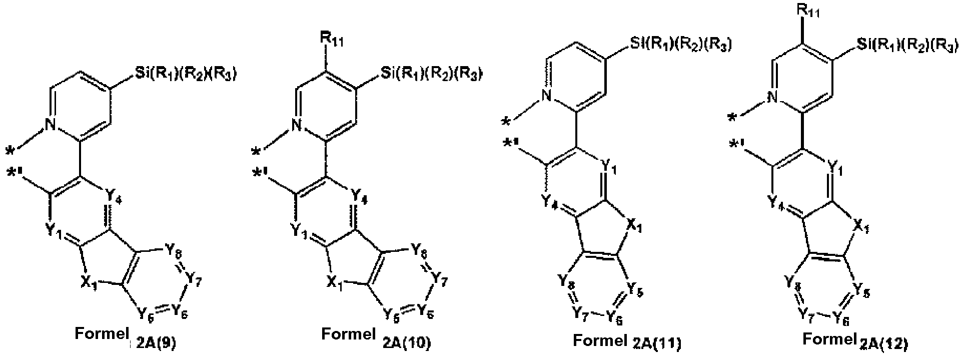 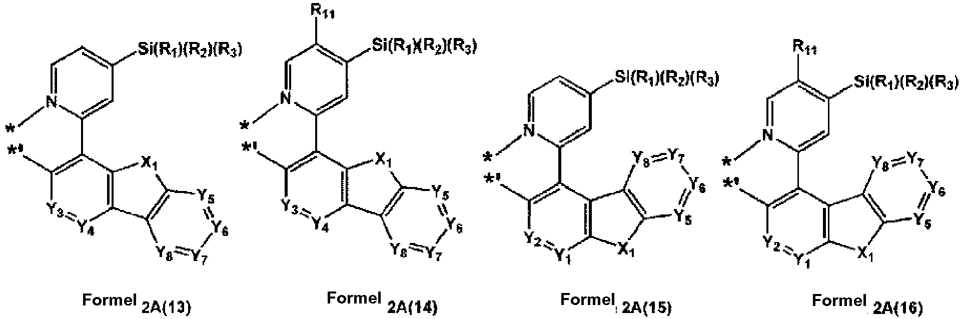 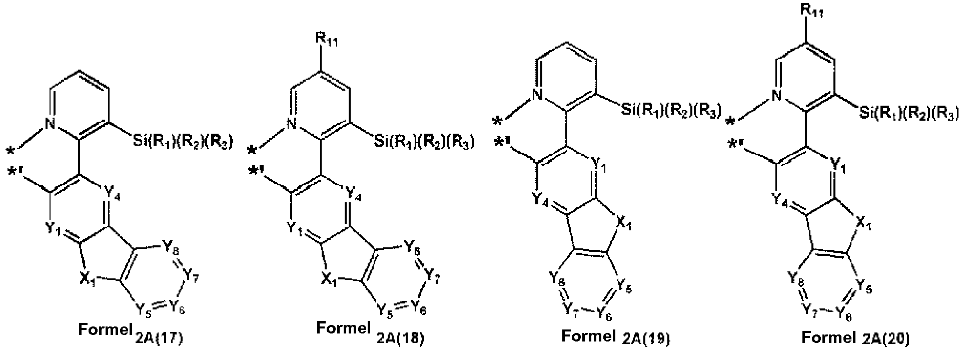 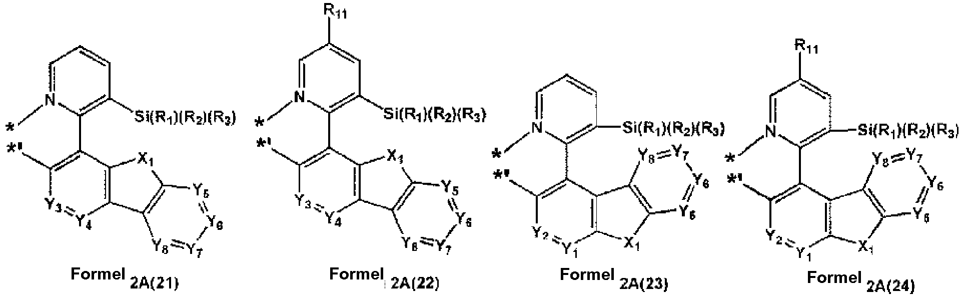 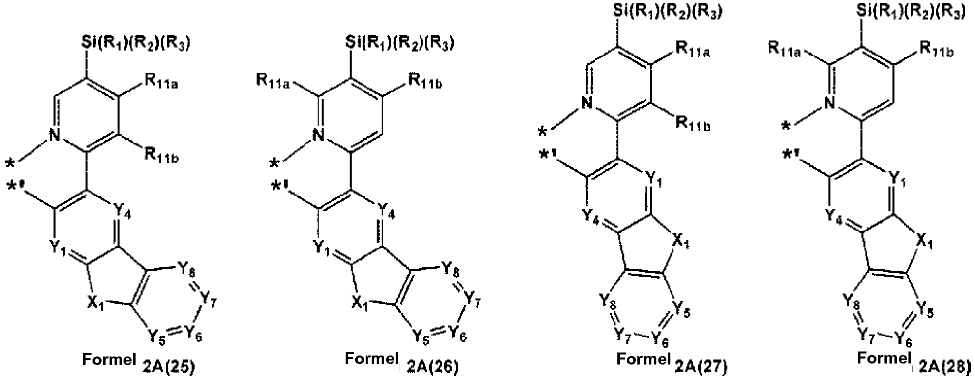 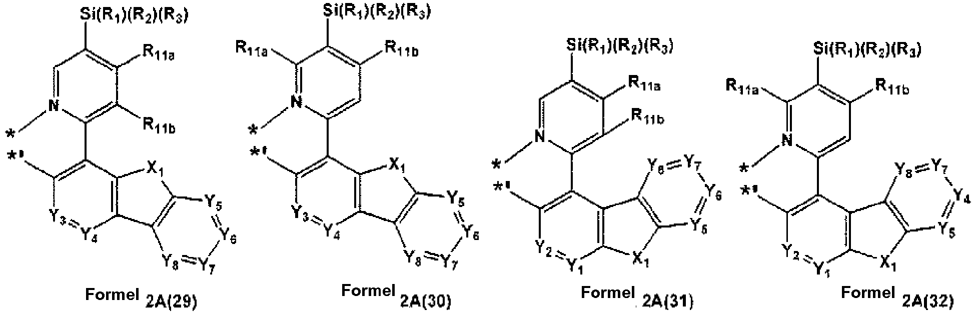 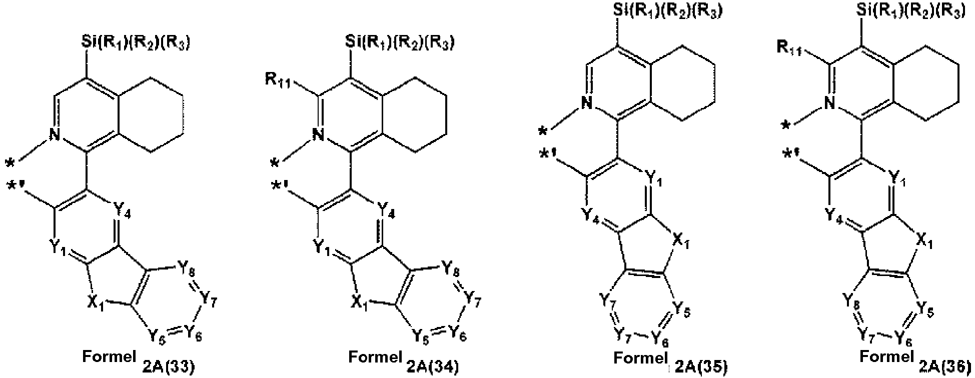 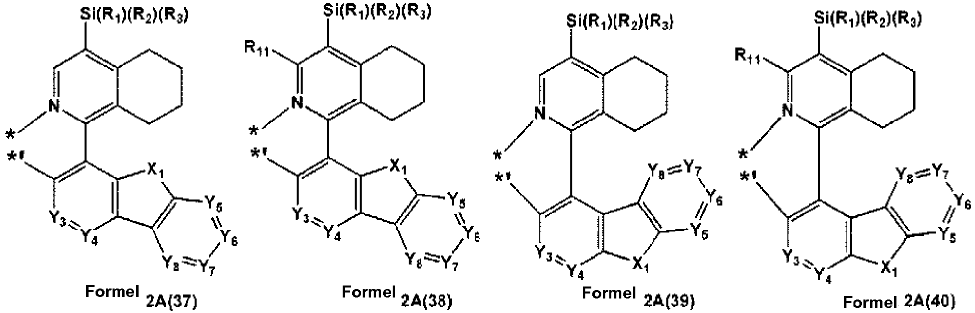
wobei in den Formeln 2A(1) bis 2A(40) die Beschreibungen von R₁ bis R₃, X₁, Y₁ bis Y₈ und R₁₁ die gleichen wie in Anspruch 1 sind, wobei R₁₁ₐ und R_{11b} unter Bezugnahme auf die Beschreibung von R₁₁ verstanden werden, vorausgesetzt, dass R₁₁, R₁₁ₐ und R_{11b} nicht Wasserstoff sind, und jeder von * und *' eine Bindungsstelle zu M in Formel 1 ist.

10. Organometallverbindung nach einem der Ansprüche 1 bis 9, wobei L₂ in Formel 1 ausgewählt ist aus Liganden der Formel 3A bis 3G: 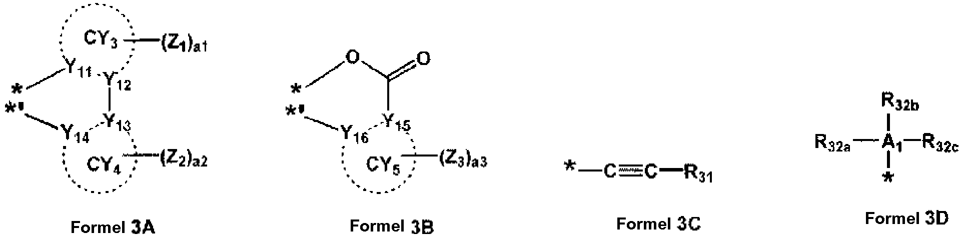 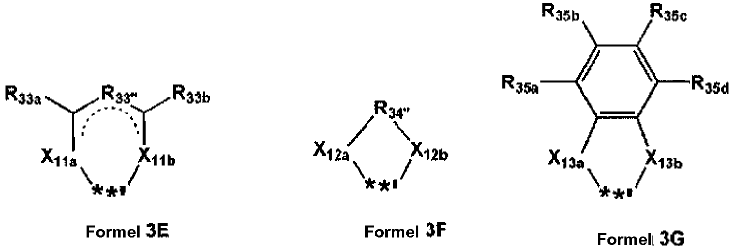
wobei in den Formeln 3A bis 3G,
Y₁₁ bis Y₁₆ jeweils unabhängig voneinander C oder N sind, Y₁₁ und Y₁₂ durch eine Einfachbindung oder eine Doppelbindung miteinander verbunden sind, Y₁₃ und Y₁₄ durch eine Einfachbindung oder eine Doppelbindung miteinander verbunden sind und Y₁₅ und Y₁₆ durch eine Einfachbindung oder eine Doppelbindung miteinander verbunden sind,
CY₃ bis CY₅ jeweils unabhängig voneinander aus einer carbocyclischen C₅-C₆₀-Gruppe und einer heterocyclischen C₂-C₆₀-Gruppe ausgewählt sind
a1 bis a3 jeweils unabhängig voneinander eine ganze Zahl von 1 bis 5 sind;
A₁ P oder As ist;
X₁₁ₐ, X_{11b}, X₁₂ₐ, X_{12b}, X₁₃ₐ und X_{13b} jeweils unabhängig voneinander ausgewählt sind aus N, O, N(R₃₄), P(R₃₅)(R₃₆), und As(R₃₇)(R₃₈), sofern keines von X₁₂ₐ, X_{12b}, X₁₃ₐ und X_{13b} N oder O ist;
R_{33"} und R_{34"} jeweils unabhängig aus einer Einfachbindung, einer Doppelbindung, einer substituierten oder unsubstituierten C₁-C₅-Alkylengruppe, einer substituierten oder unsubstituierten C₂-C₅-Alkenylen-Gruppe und einer substituierten oder unsubstituierten C₆-C₁₀-Arylengruppe ausgewählt sind;
Z₁ bis Z₃, R₃₁, R₃₂ₐ, R_{32b}, R_{32c}, R₃₃ₐ, R_{33b}, R₃₄ bis R₃₈, R₃₅ₐ, R_{35b}, R_{35c} und R_{35d} jeweils unabhängig voneinander ausgewählt sind aus einem Wasserstoff, einem Deuterium, -F, -Cl, -Br, -I, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkynylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nicht-aromatischen kondensierten polycyclischen Gruppe, einer substituierten oder unsubstituierten einwertigen nicht-aromatischen kondensierten heteropolycyclischen Gruppe, -N(Q₁)(Q₂), -Si(Q₃)(Q₄)(Q₅), -B(Q₆)(Q₇) und -P(=O)(Q₈)(Q₉),
* und *' jeweils Bindungsstellen an M in Formel 1 angeben;
mindestens eines der Substituenten der substituierten C₁-C₅-Alkylengruppe, der substituierten C₂-Alkenylengruppe, der substituierten C₆-C₁₀-Arylengruppe, der substituierten C₁-C₆₀-Alkylgruppe, der substituierten C₂-C₆₀-Alkenylgruppe, der substituierten C₂-C₆₀-Alkynylgruppe, der substituierten C₁-C₆₀-Gruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₆-C₆₀-Aryloxygruppe, der substituierten C₆-C₆₀-Arythiogruppe, der substituierten C₁-C₆₀-Heteroarylgruppe, der substituierten einwertigen nicht-aromatischen kondensierten polycyclischen Gruppe und der substituierten einwertigen nicht-aromatischen kondensierten heteropolycyclischen Gruppe ausgewählt ist aus:
einem Deuterium, -F, -Cl, -Br, -I, -CD₃, -CD₂H, -CDH₂, -CF₃, -CF₂H, -CFH₂, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenyl Gruppe, einer C₂-C₆₀-Alkynylgruppe und einer C₁-C₆₀-Alkoxygruppe;
einer C₁-C₆₀-Alkylgruppe, einer C₂-C₆₀-Alkenylgruppe, einer C₂-C₆₀-Alkynylgruppe und einer C₁-C₆₀-Alkoxygruppe, jeweils substituiert mit mindestens einem ausgewählt aus einem Deuterium, -F, -Cl, -Br, -I, -CD₃, -CD₂H, -CDH₂, -CF₃, -CF₂H, -CFH₂, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₃-C₁₀-Cycloalkylgruppe, einer C₁-C₁₀-Heteroycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht-aromatischen kondensierten polycyclischen Gruppe, einer einwertigen nicht-aromatischen kondensierten heteropolycyclischen Gruppe, -N(Q₁₁)(Q₁₂), -Si(Q₁₃)(Q₁₄)(Q₁₅), -B(Q₁₆)(Q₁₇) und -P(=O)(Q₁₈)(Q₁₉);
einer C₃-C₁₀-Cycloalkylgruppe, einer C₁-C₁₀-Heteroycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht-aromatischen kondensierten polycyclischen Gruppe und einer einwertigen nicht-aromatischen kondensierten heteropolycyclischen Gruppe;
einer C₃-C₁₀-Cycloalkylgruppe, einer C₁-C₁₀-Heteroycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht-aromatischen kondensierten polycyclischen Gruppe und einer einwertigen nicht-aromatischen kondensierten heteropolycyclischen Gruppe, jeweils substituiert mit mindestens einem ausgewählt aus einem Deuterium, -F, -Cl, -Br, -I, -CD₃, -CD₂H, -CDH₂, -CF₃, -CF₂H, -CFH₂, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkynylgruppe, einer C₁-C₆₀-Alkoxygruppe, einer C₃-C₁₀-Cycloalkylgruppe, einer C₁-C₁₀-Heteroycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht-aromatischen kondensierten polycyclischen Gruppe, einer einwertigen nicht-aromatischen kondensierten heteropolycyclischen Gruppe, -N(Q₂₁)(Q₂₂), -Si(Q₂₃)(Q₂₄)(Q₂₅), -B(Q₂₆)(Q₂₇) und -P(=O)(Q₂₈)(Q₂₉), und
-N(Q₃₁)(Q₃₂), -Si(Q₃₃)(Q₃₄)(Q₃₅), -B(Q₃₆)(Q₃₇) und -P(=O)(Q₃₈)(Q₃₉), wobei Q₁ bis Q₉, Q₁₁ bis Q₁₉ und Q₂₁ bis Q₂₉ und Q₃₁ bis Q₃₉ jeweils unabhängig voneinander ausgewählt sind aus einem Wasserstoff, einem Deuterium, -F, -Cl, -Br, -I, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkynylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nicht-aromatischen kondensierten polycyclischen Gruppe und einer substituierten oder unsubstituierten einwertigen nicht-aromatischen kondensierten heteropolycyclischen Gruppe.

11. Organometallverbindung nach einem der Ansprüche 1 bis 9, wobei: L₂ in Formel 1 ausgewählt ist aus Liganden, die durch die Formeln 3-1 bis 3-111 dargestellt sind: 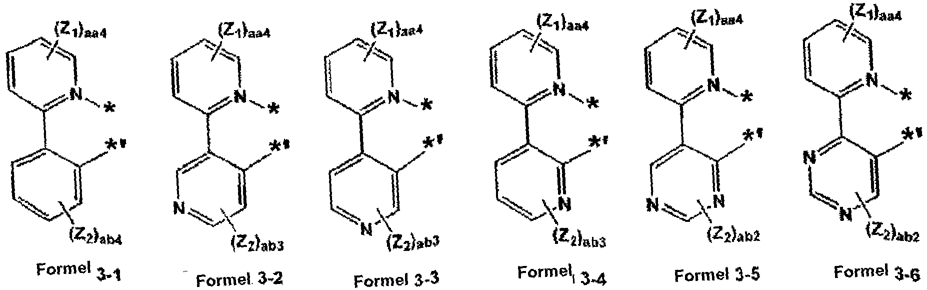 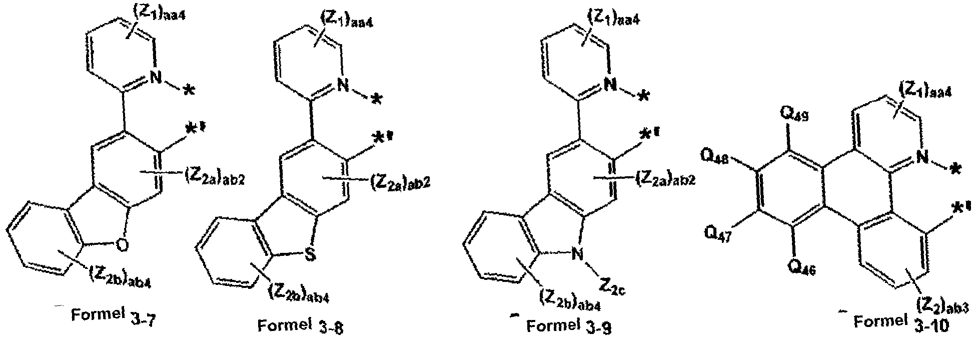 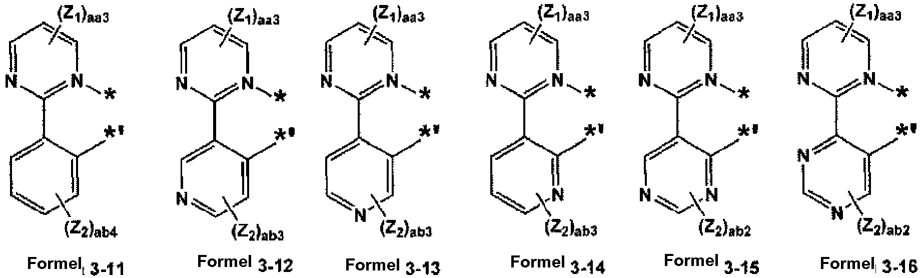 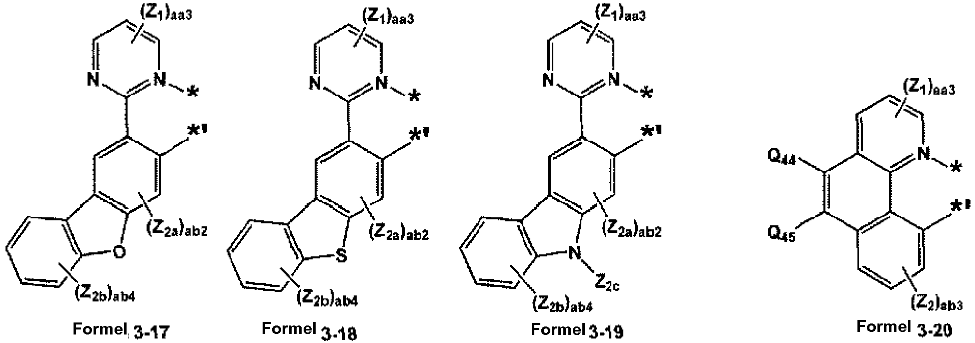 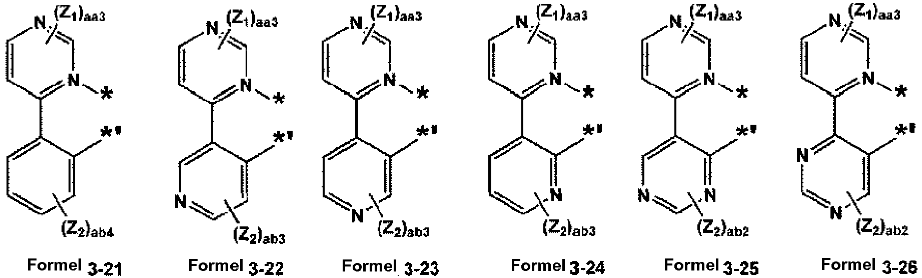 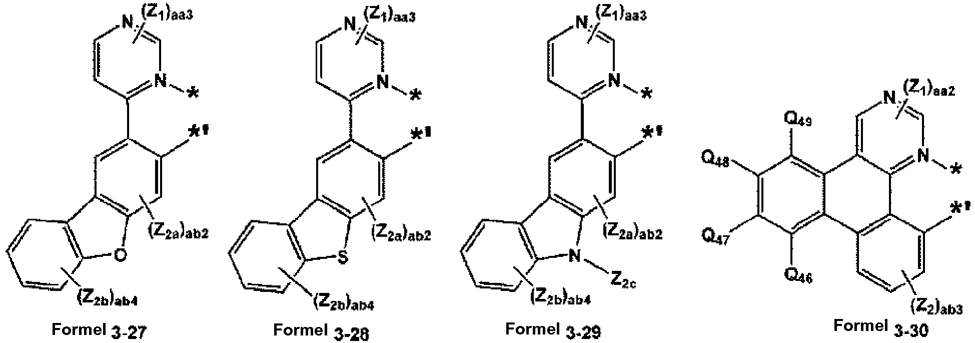 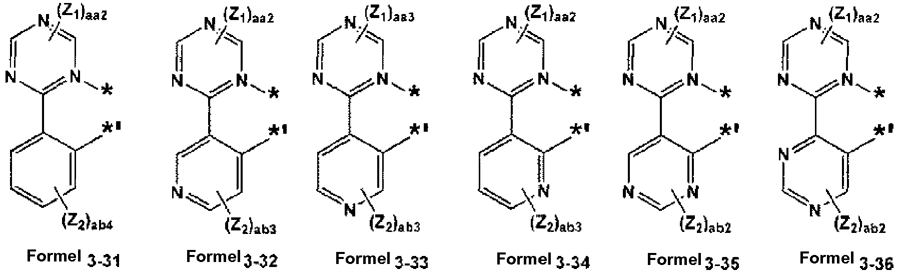 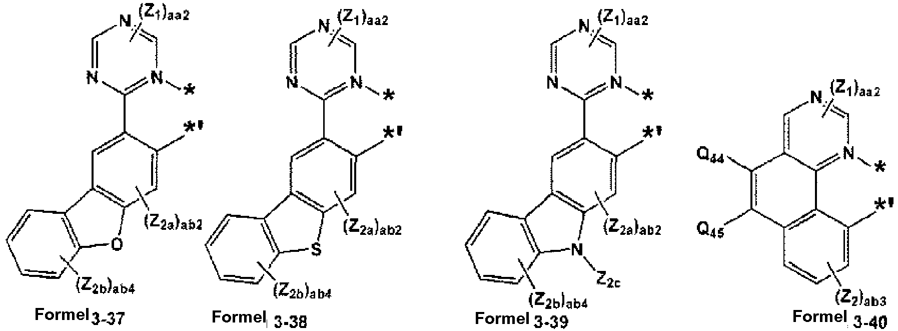 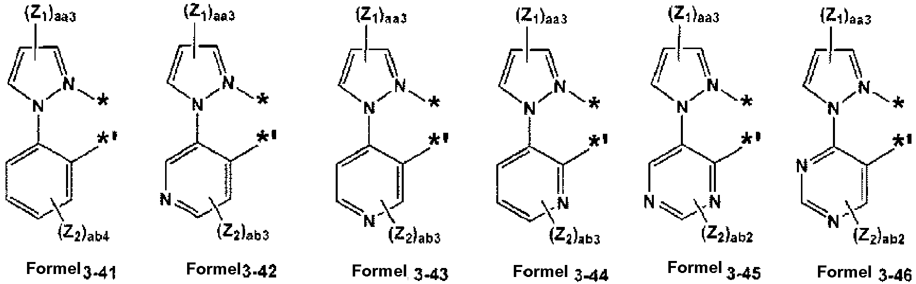 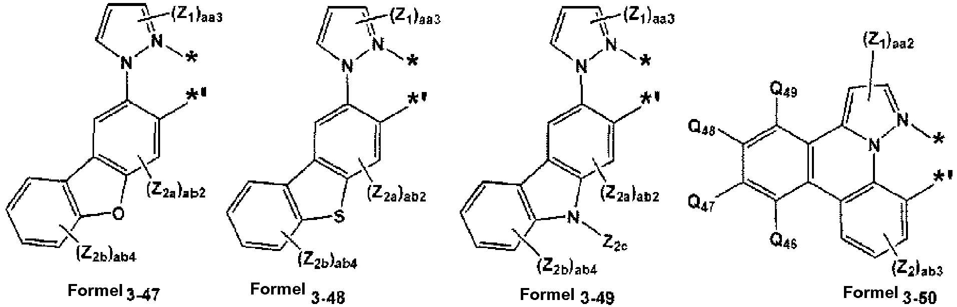 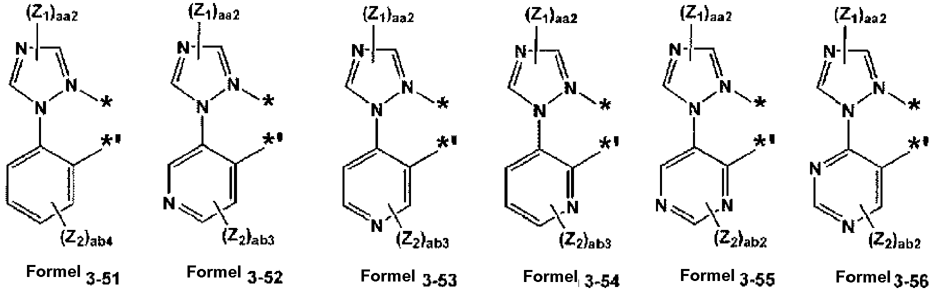 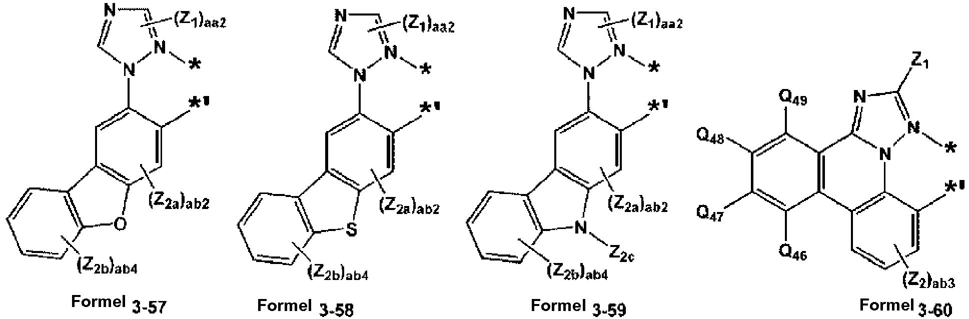 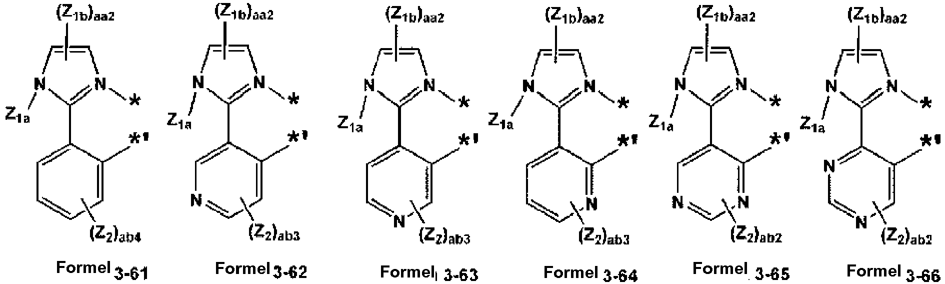 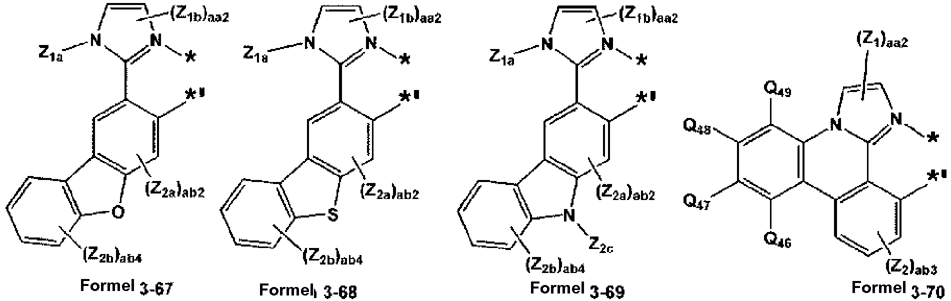 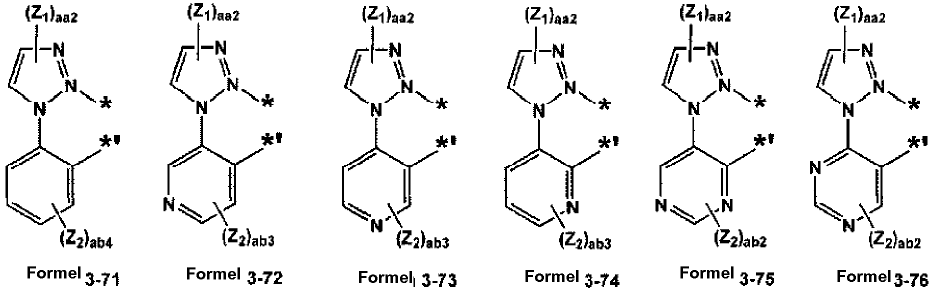 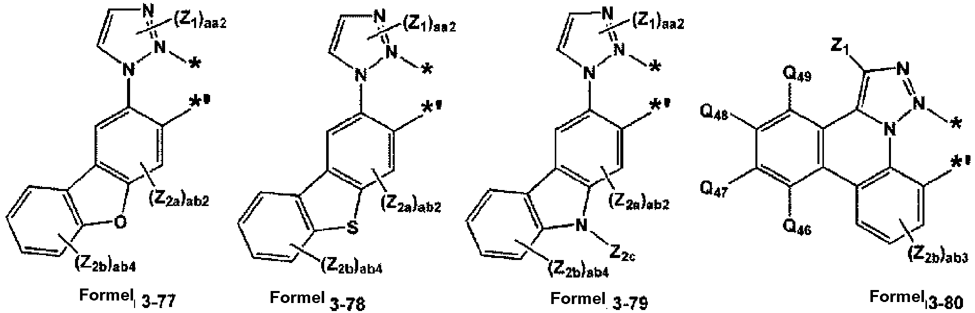 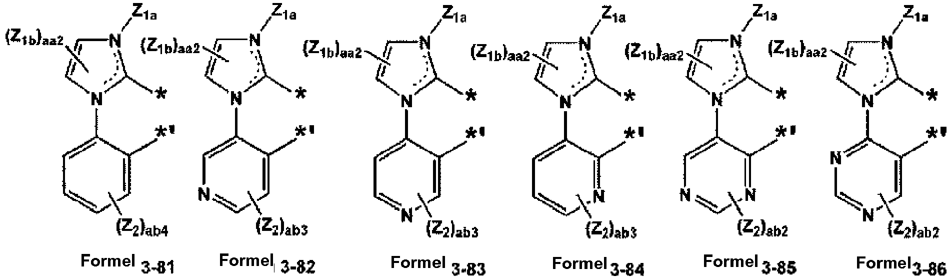 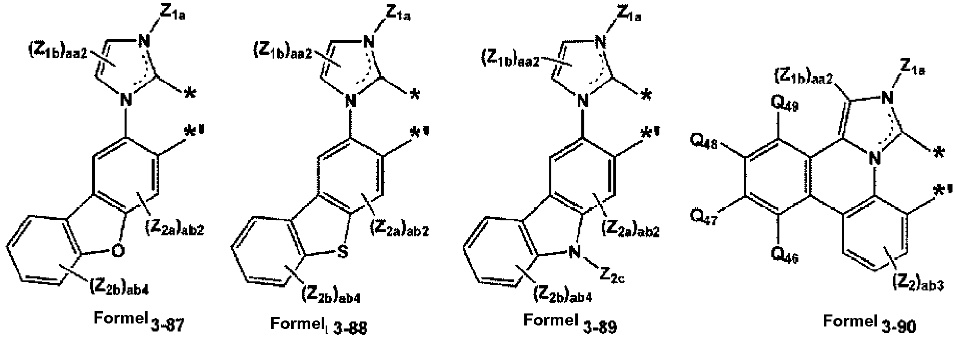 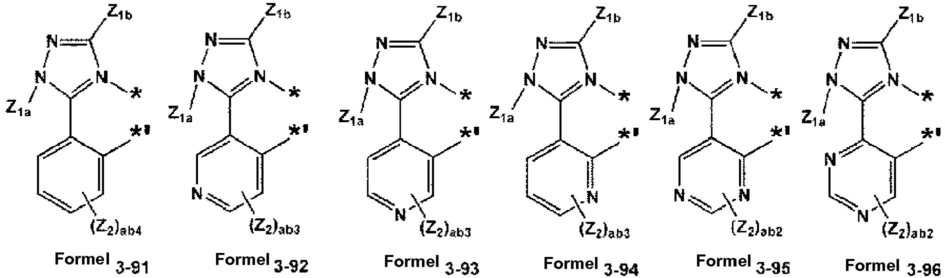 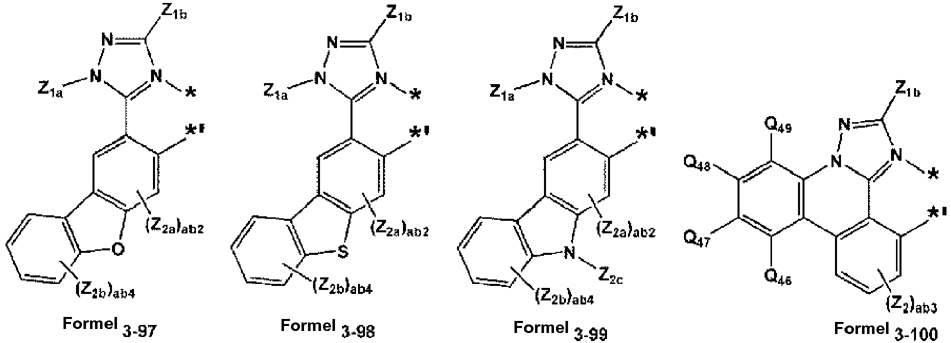 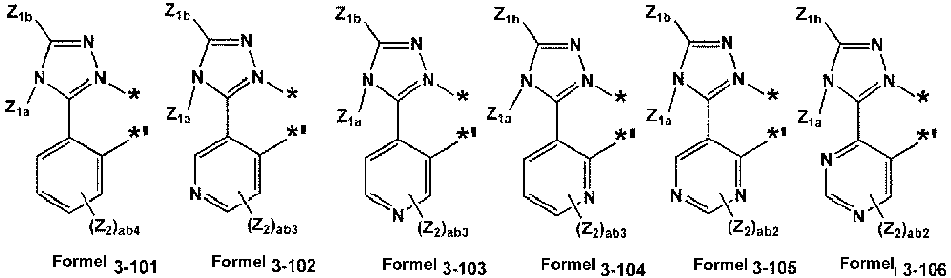 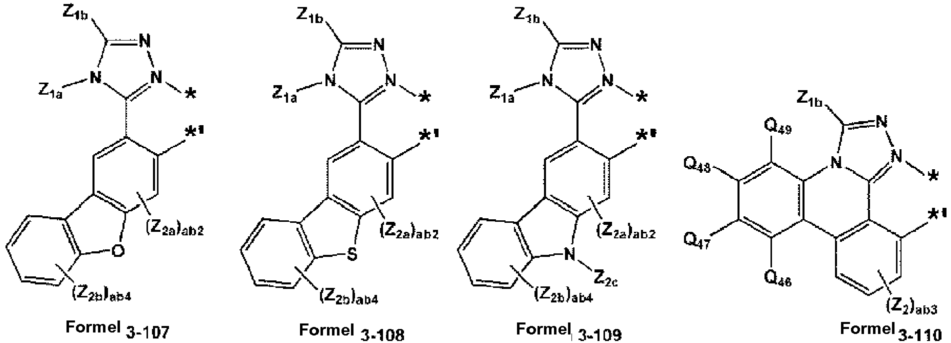 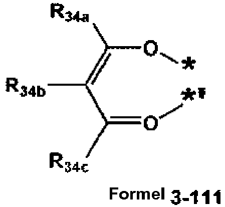
wobei in den Formeln 3-1 bis 3-111,
Z₁, Z₂, Z₁ₐ, Z_{1b}, Z₂ₐ, Z_{2b}, Z_{2c}, R₃₄ₐ, R_{34b} und R_{34c} jeweils unabhängig voneinander ausgewählt sind aus
einem Wasserstoff, einem Deuterium, -F, -Cl, -Br, -I, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, -SF₅, einer C₁-C₂₀-Alkylgruppe und einer C₁-C₂₀-Alkoxygruppe;
einer C₁-C₂₀-Alkylgruppe und einer C₁-C₂₀-Alkoxygruppe, jeweils substituiert mit mindestens einem ausgewählt aus einem Deuterium, -F, -Cl, -Br, -I, -CD₃, -CD₂H, -CDH₂, -CF₃, -CF₂H, -CFH₂, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₁₀-Alkylgruppe, einer Cyclopentylgruppe, einer Cyclohexylgruppe, einer Cycloheptylgruppe, einer Cyclooctylgruppe, einer Adamantylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe und einer Pyrimidinylgruppe;
einer Cyclopentylgruppe, einer Cyclohexylgruppe, einer Cycloheptylgruppe, einer Cyclooctylgruppe, einer Adamantylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzoquinolinylgruppe, einer Chinoxalinylgruppe, einer Chinazolinylgruppe, einer Cinnolinylgruppe, einer Carbazolylgruppe, einer Phenanthrolinylgruppe, einer Benzoimidazolylgruppe, einer Benzofuranylgruppe, einer Benzothiophenylgruppe, einer Isobenzothiazolylgruppe, einer Benzoxazolylgruppe, einer Isoenzoxazolylgruppe, einer Triazolylgruppe, einer Tetrazolylgruppe, einer Oxadiazolylgruppe, einer Triazinylgruppe, einer Dibenzofuranylgruppe, ein Dibenzothiophenylgruppe, einer Benzocarbazolylgruppe, einer Dibenzocarbazolylgruppe, einer Imidazopyridinylgruppe und einer Imidazopyrimidinylgruppe;
einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Quinolinylgruppe, einer Isoquinolinylgruppe, einer Benzoquinolinylgruppe, einer Quinoxalinylgruppe, einer Quinazolinylgruppe, einer Cinnolinylgruppe, einer Carbazolylgruppe, einer Phenanthrolinylgruppe, einer Benzoimidazolylgruppe, einer Benzofuranylgruppe, einer Benzothiophenylgruppe, einer Isobenzothiazolylgruppe, einer Benzoxazolylgruppe, einer Isobenzoxazolylgruppe, einem Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe, jeweils substituiert mit mindestens einem ausgewählt aus einem Deuterium, -F, -Cl, -Br, -I, -CD₃, -CD₂H, -CDH₂, -CF₃, -CF₂H, -CFH₂, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Quinolinylgruppe, einer Isoquinolinylgruppe, einer Benzoquinolinylgruppe, einer Quinoxalinylgruppe, einer Quinazolinylgruppe, einer Cinnolinylgruppe, einer Carbazolylgruppe, einer Phenanthrolinylgruppe, einer Benzoimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe, und
-N(Q₁)(Q₂), -Si(Q₃)(Q₄)(Q₅), -B(Q₆)(Q₇) und -P(=O)(Q₈)(Q₉),
Q₁ bis Q₉ und Q₄₄ bis Q₄₉ jeweils unabhängig voneinander ausgewählt sind aus
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H und -CD₂CDH₂;
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, und
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe und einer Phenylgruppe und einer Naphthylgruppe, die jeweils mit mindestens einem ausgewählt aus einem Deuterium und einer C₁-C₁₀-Alkylgruppe substituiert sind,
aa2 und ab2 jeweils unabhängig voneinander 1 oder 2 sind,
aa3 und ab3 jeweils unabhängig voneinander ausgewählt sind aus 1, 2 und 3,
aa4 und ab4 jeweils unabhängig voneinander ausgewählt sind aus 1, 2, 3 und 4, und
* und *' jeweils Bindungsstellen an M in Formel 1 angeben;
wobei vorzugsweise:
L₂ in Formel 1 ist ausgewählt aus Liganden der Formeln 3-1(1) bis 3-1(59) und 3-111: 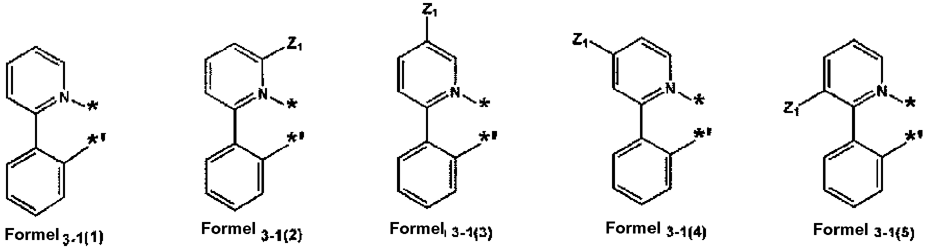 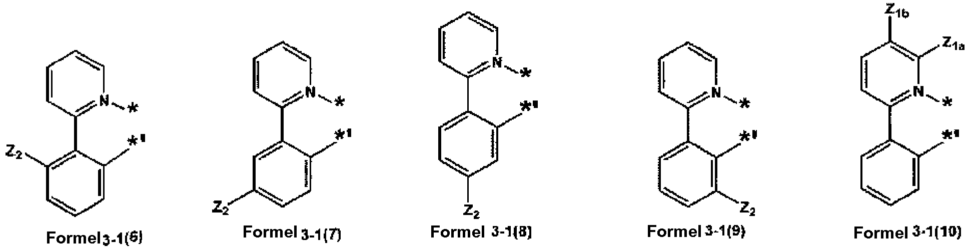 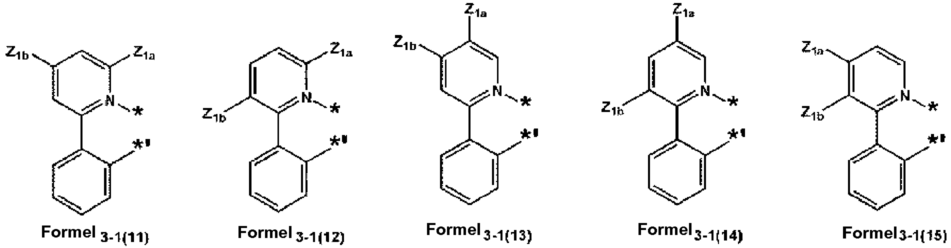 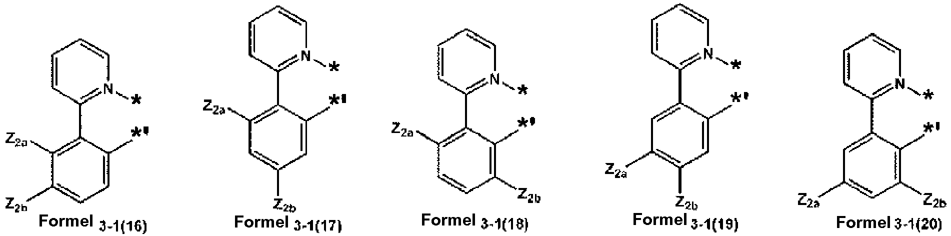 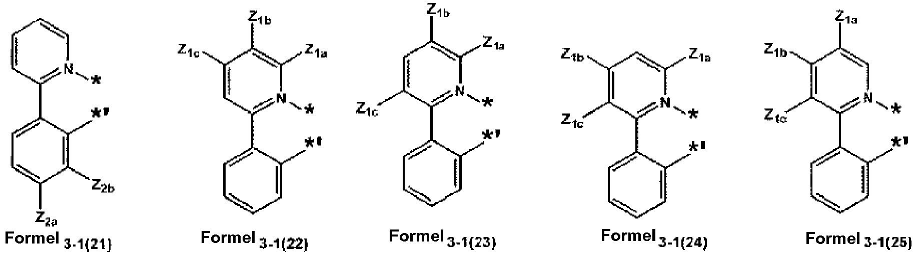 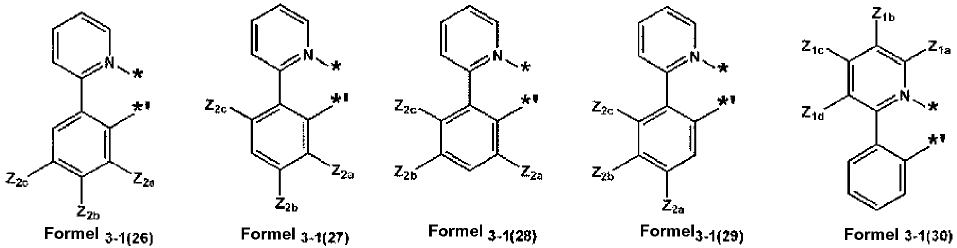 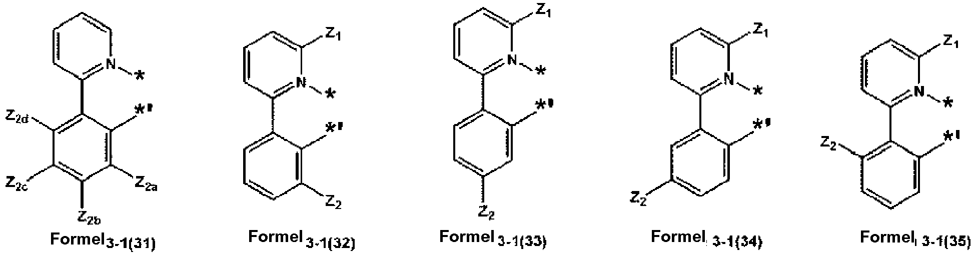 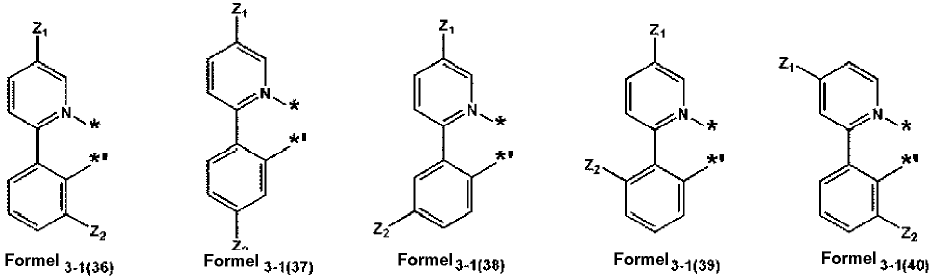 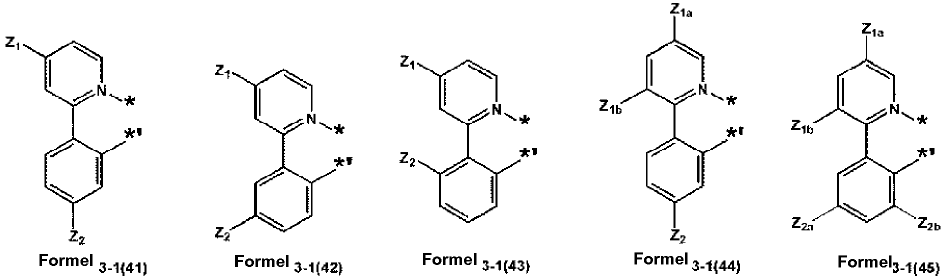 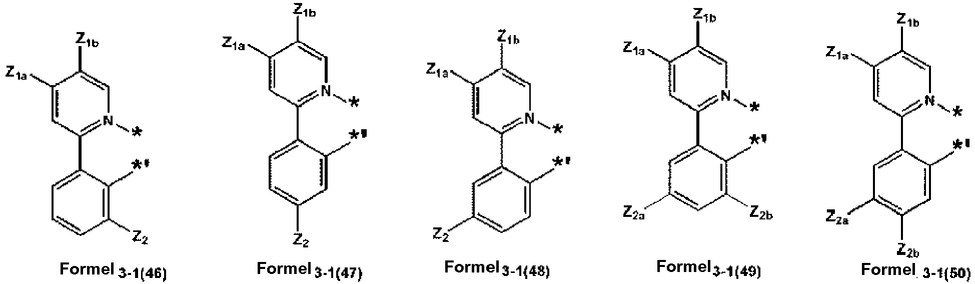 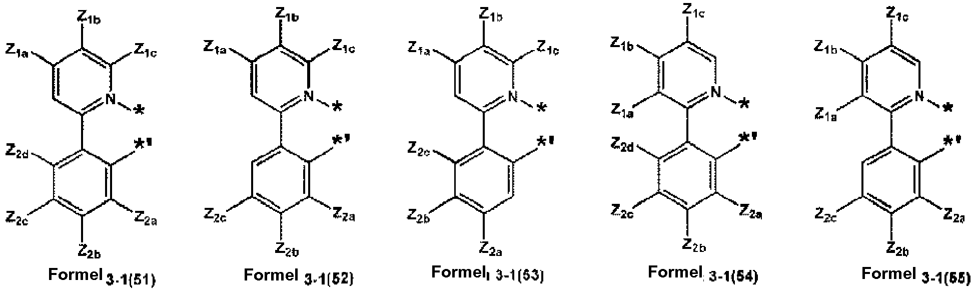 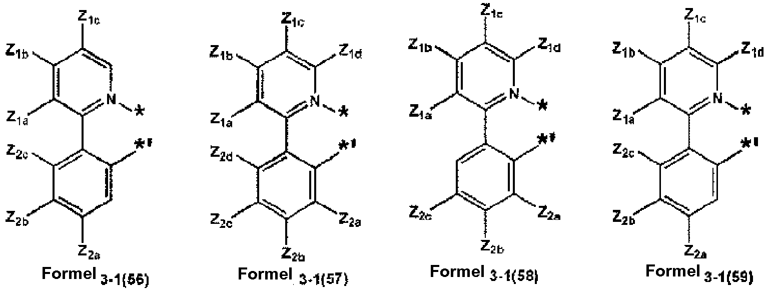 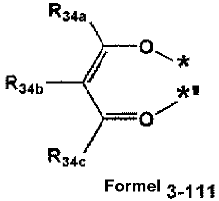
wobei in den Formeln 3-1(1) bis 3-1(59) und in Formel 3-111:
Z₁, Z₂, Z₁ₐ, Z_{1b}, Z_{1c}, Z_{1d}, Z₂ₐ, Z_{2b}, Z_{2c}, Z_{2d}, R₃₄ₐ, R_{34b} und R_{34c} jeweils unabhängig voneinander ausgewählt sind aus einem Deuterium, -F, einer Cyangruppe, einer Nitrogruppe, -SF₅, -CH₃, -CD₃, -CD₂H, -CDH₂, -CF₃, -CF₂H, -CFH₂, -Si(Q₃)(Q₄)(Q₅), aus Gruppen der Formeln 9-1 bis 9-17 und aus Gruppen der Formeln 10-1 bis 10-30,
Q₃ bis Q₅ jeweils unabhängig voneinander ausgewählt sind aus
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H und -CD₂CDH₂;
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, und
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe und einer Phenylgruppe, die jeweils mit mindestens einem ausgewählt aus einem Deuterium und einer C₁-C₁₀-Alkylgruppe substituiert sind, und * und *' Bindungsstellen an M in Formel 1 sind, 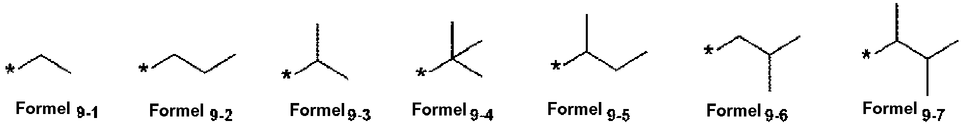 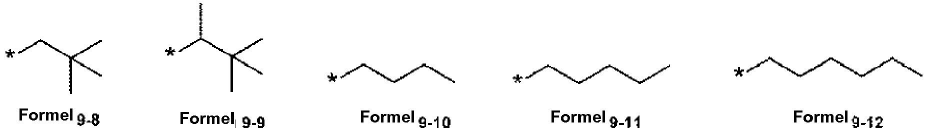 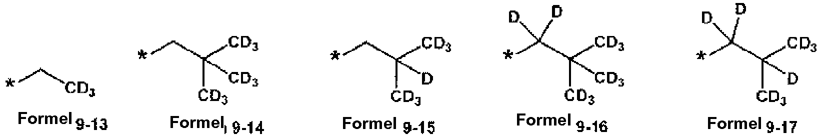 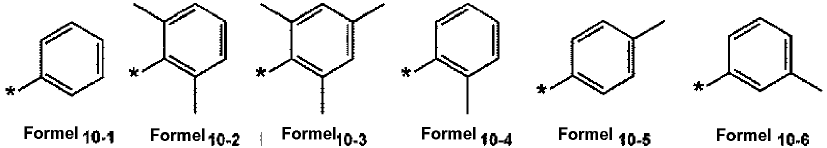 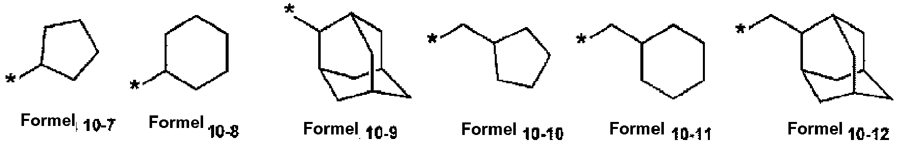 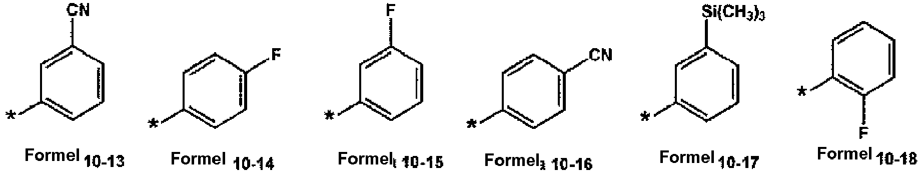 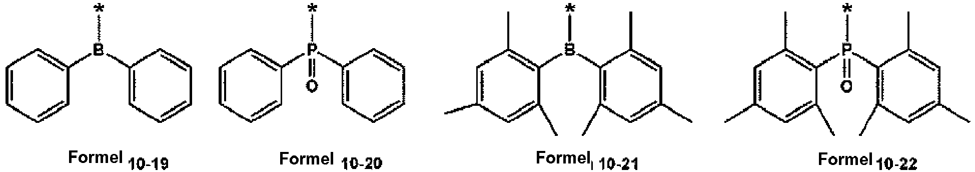 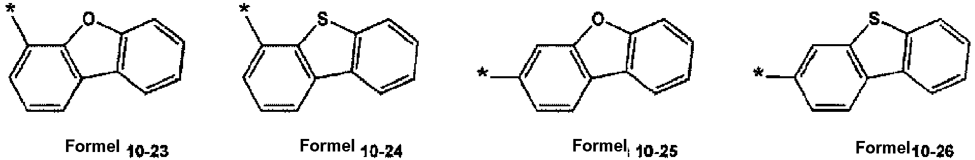 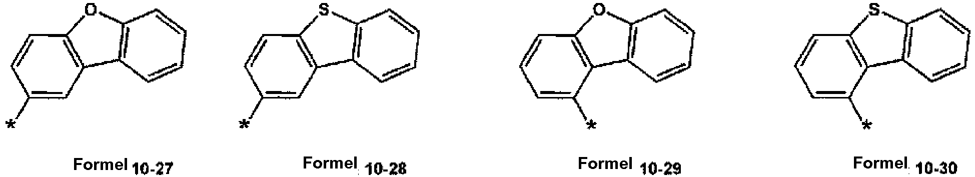
wobei in den Formeln 9-1 bis 9-17 und 10-1 bis 10-30 * eine Bindungsstelle an ein benachbartes Atom ist.

12. Organometallverbindung nach Anspruch 1, wobei die Organometallverbindung eine der Verbindungen 1 bis 481 ist:

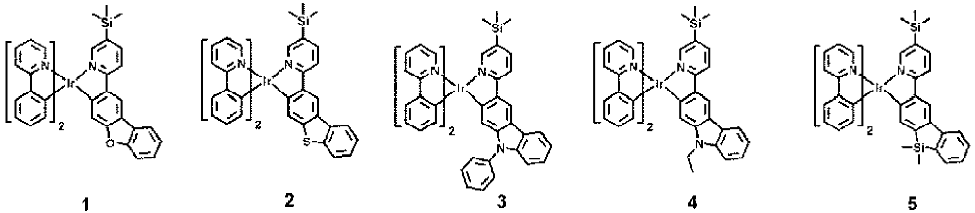

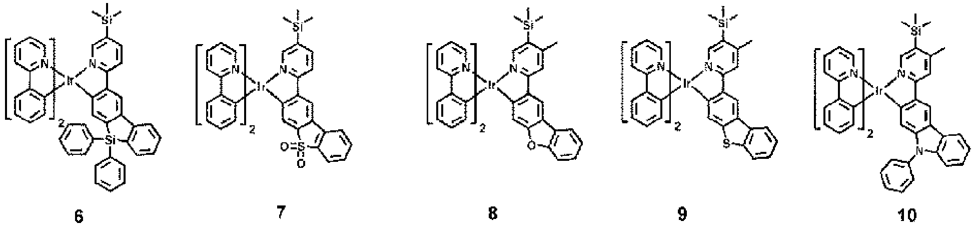

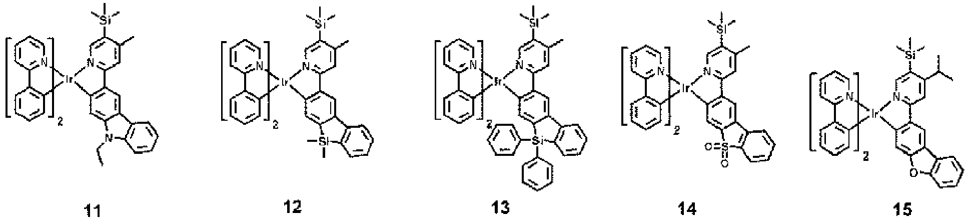

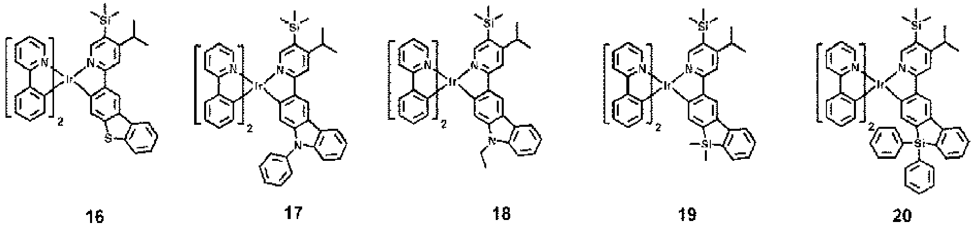

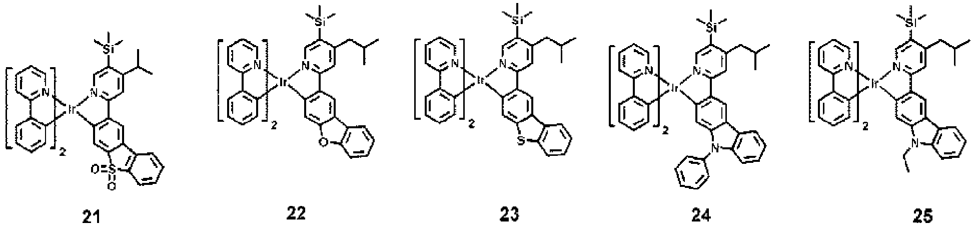

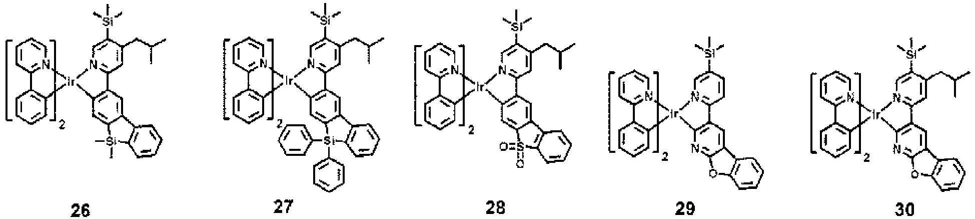

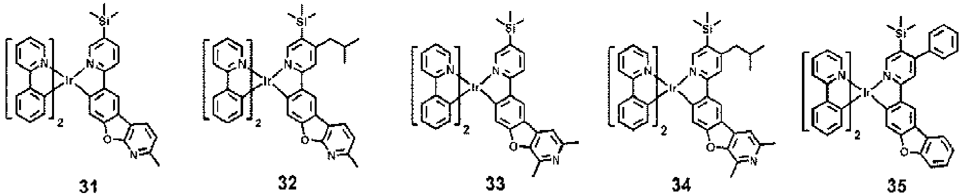

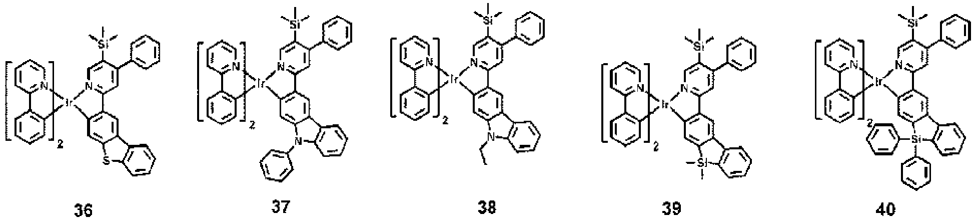

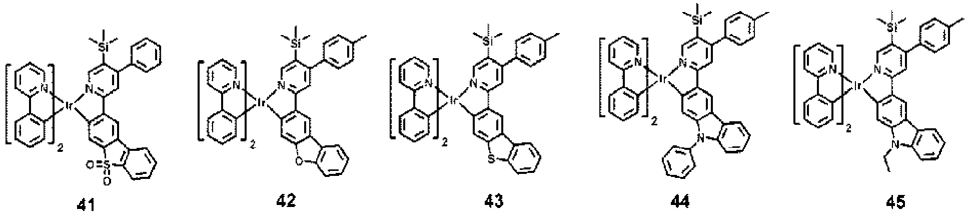

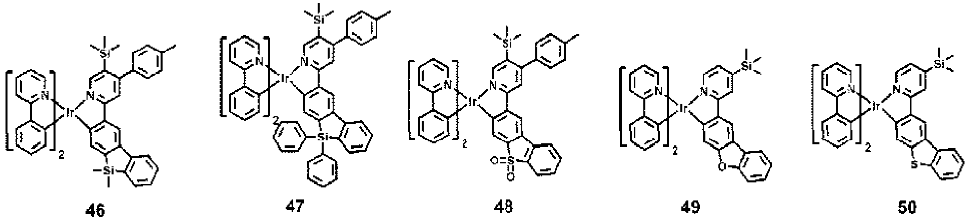

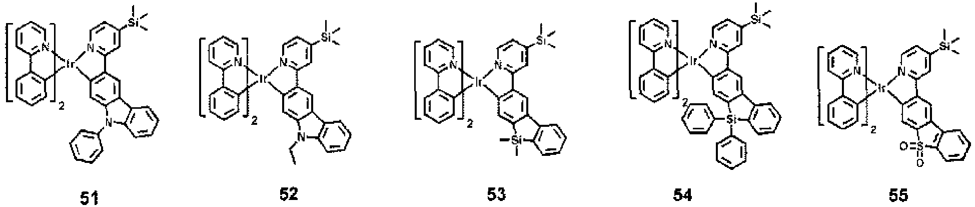

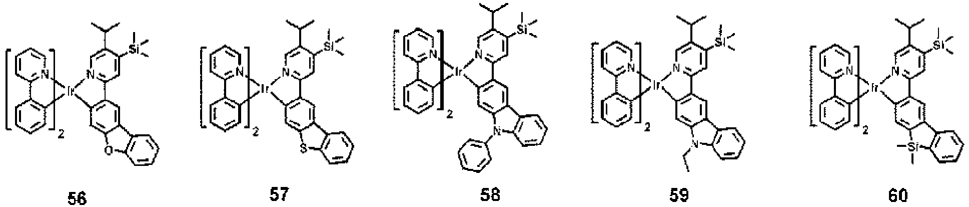

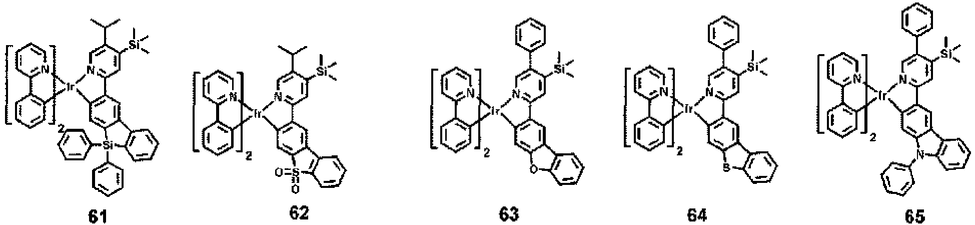

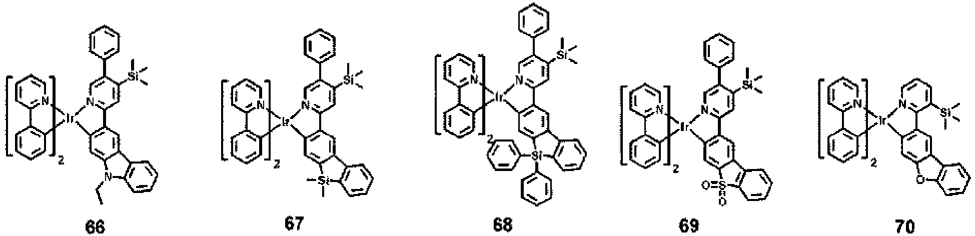

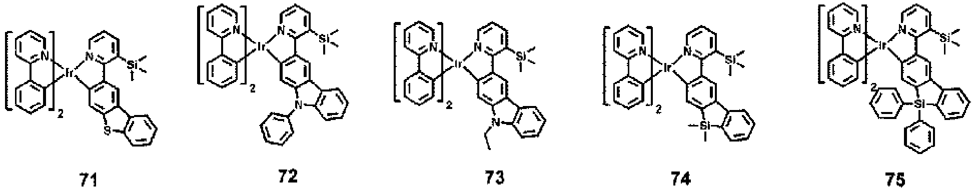

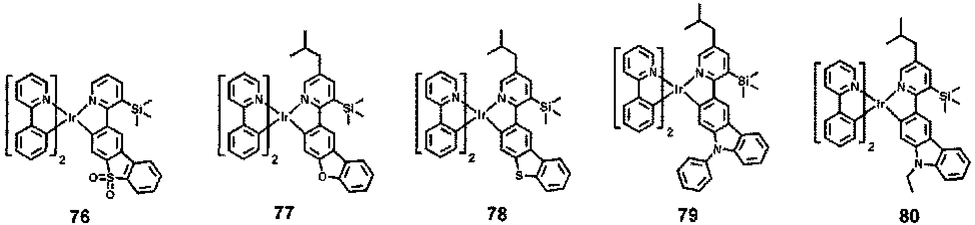

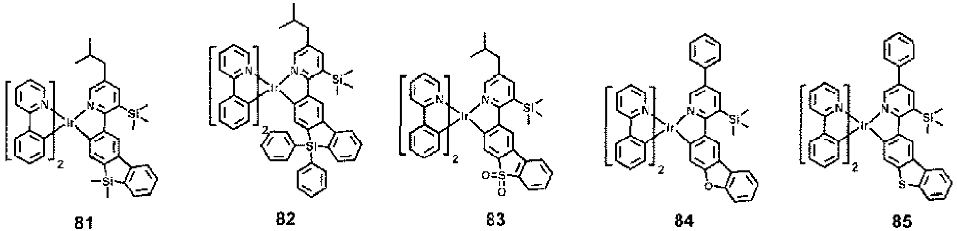

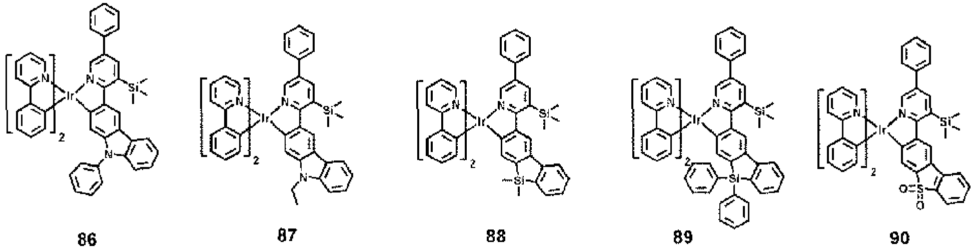

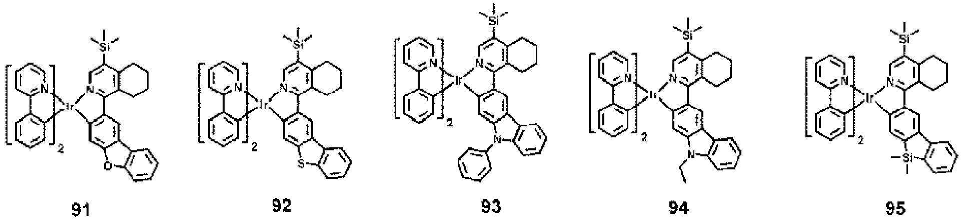

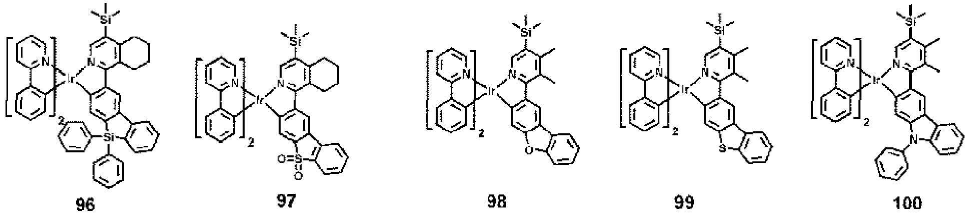

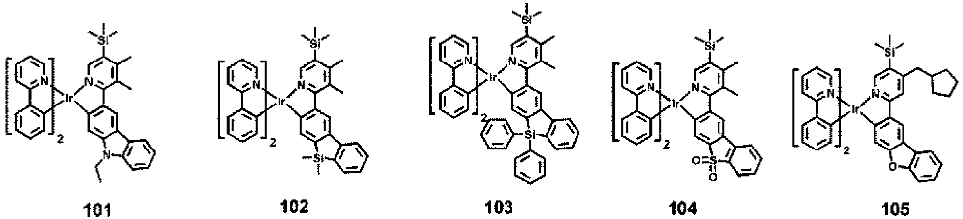

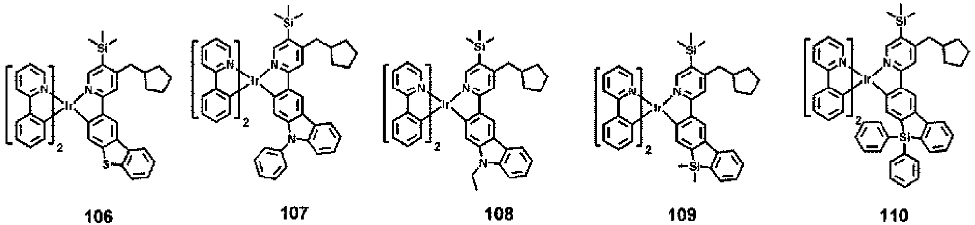

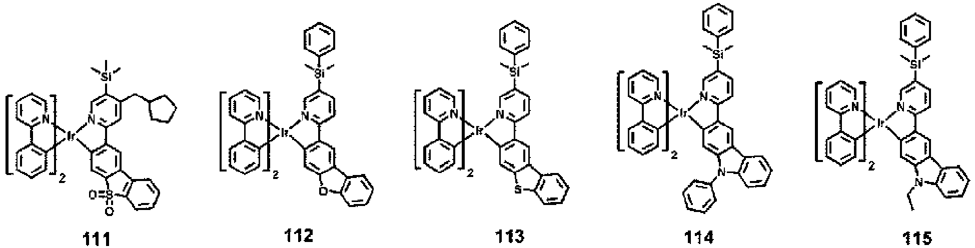

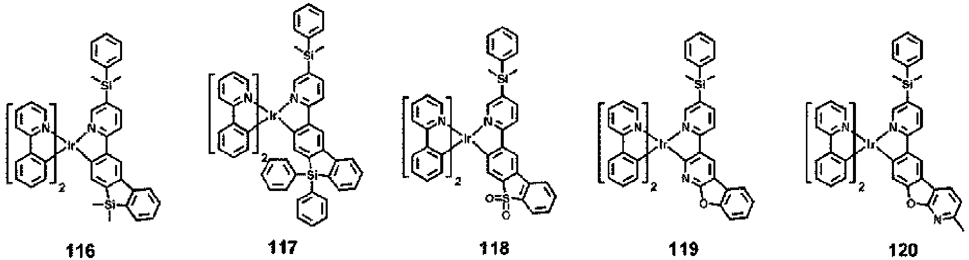

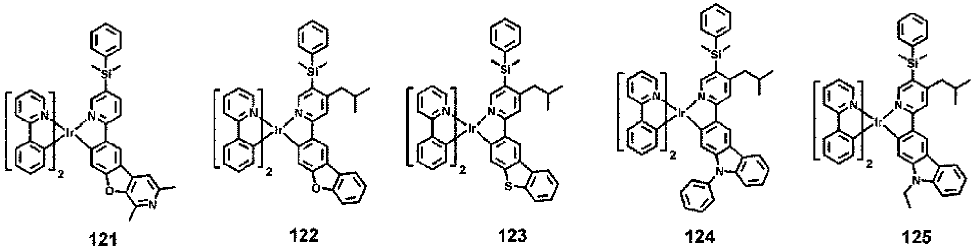

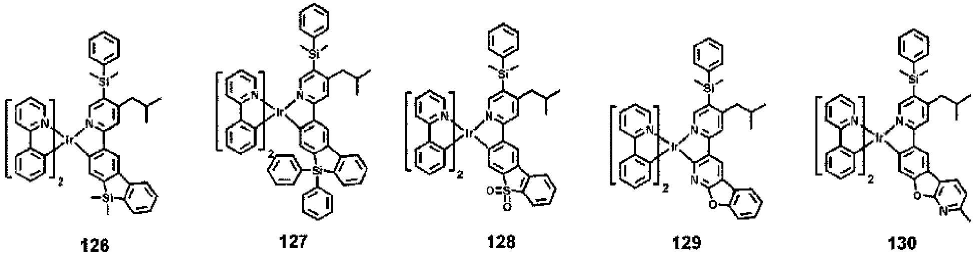

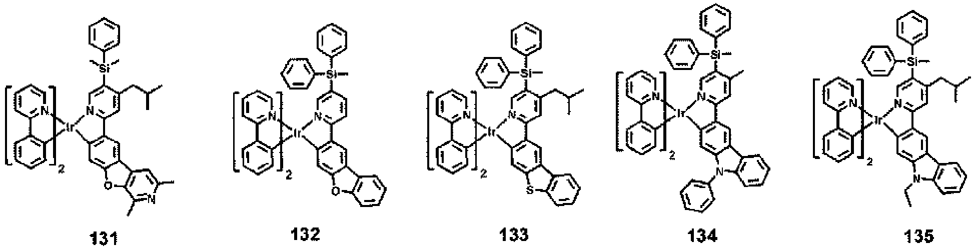

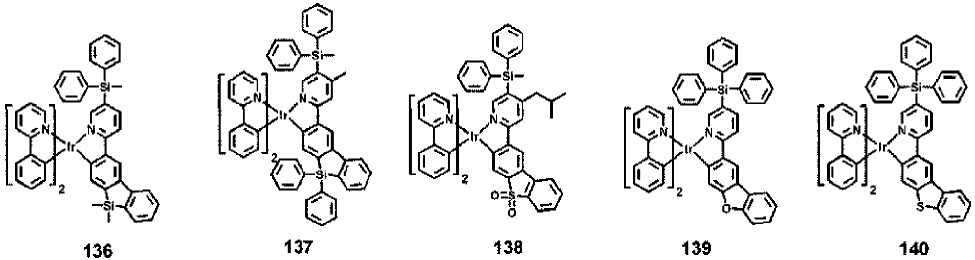

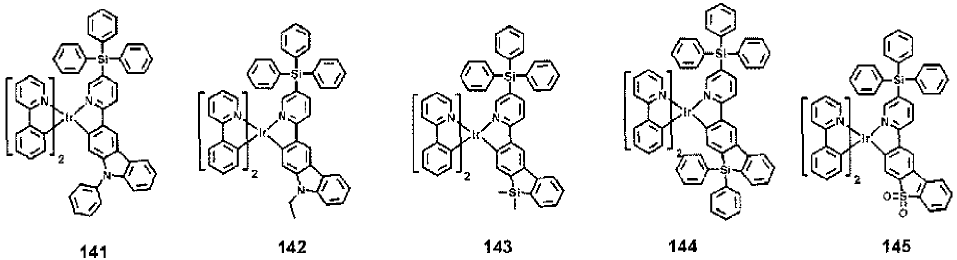

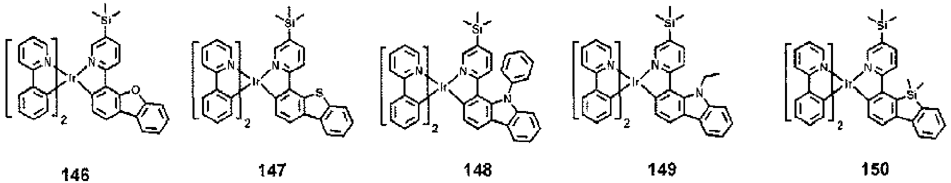

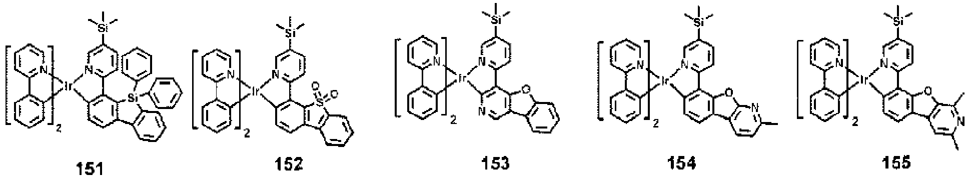

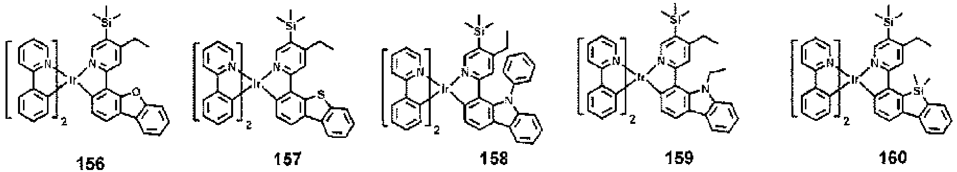

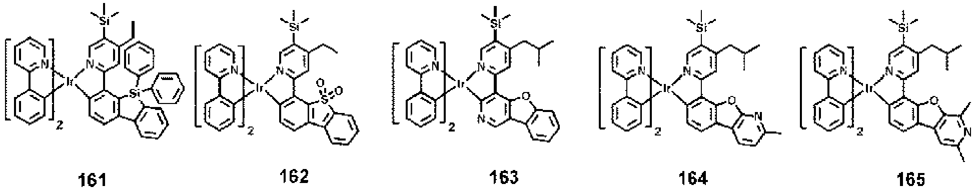

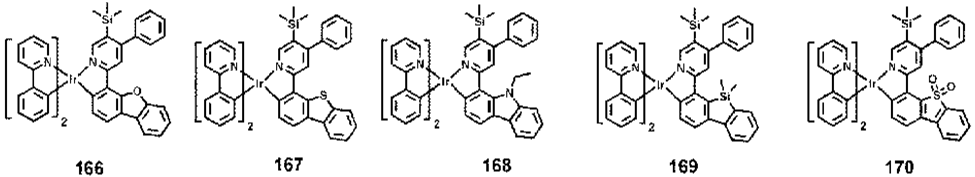

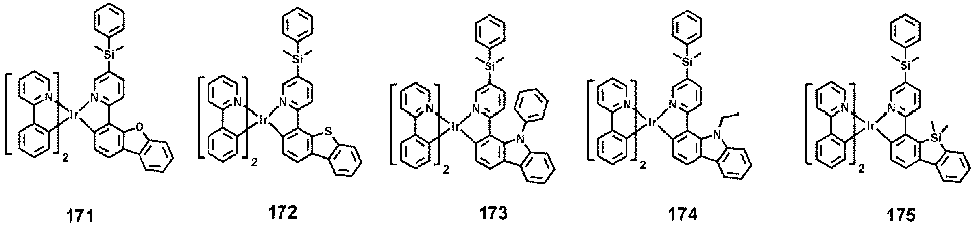

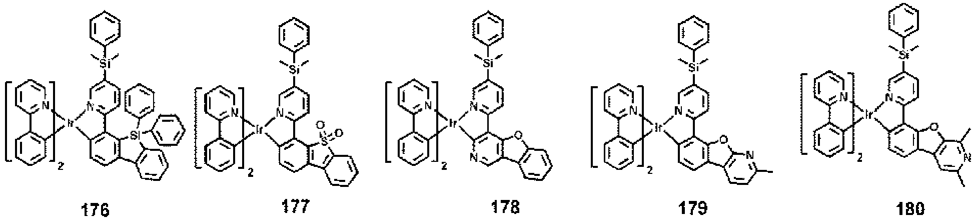

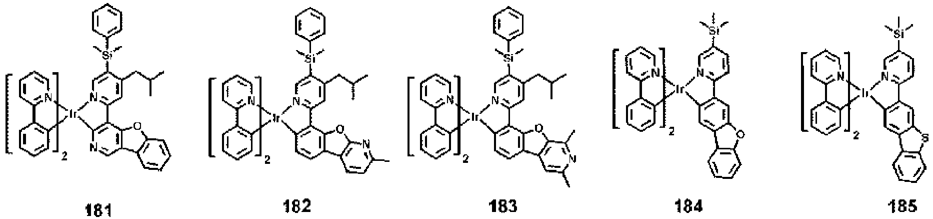

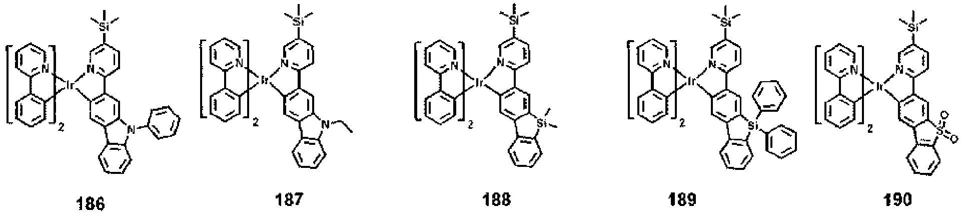

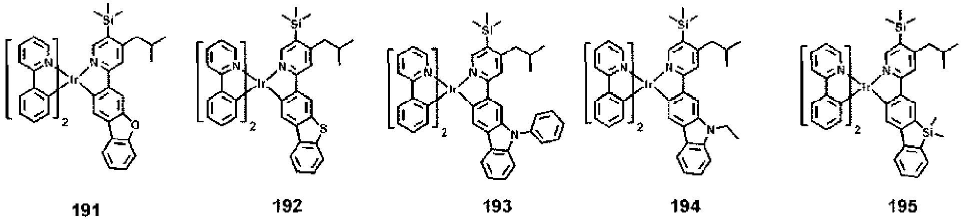

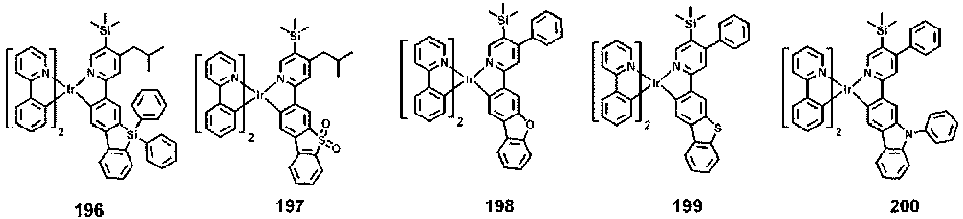

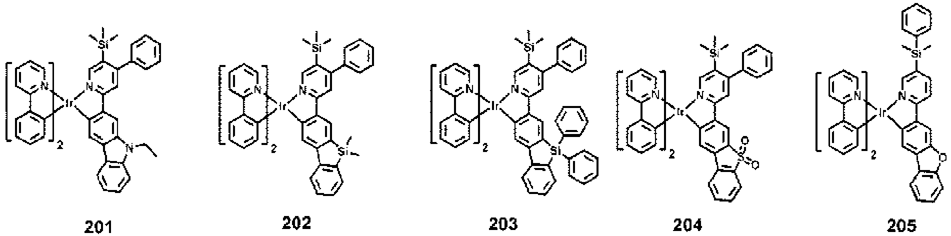

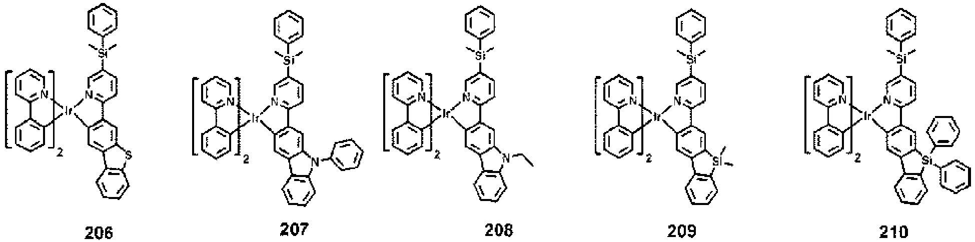

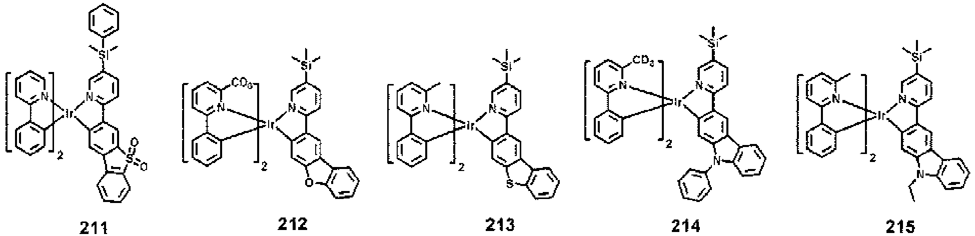

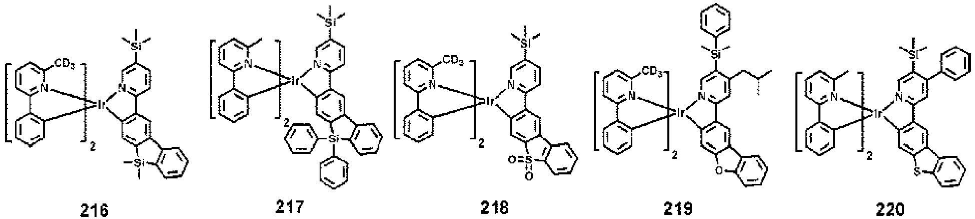

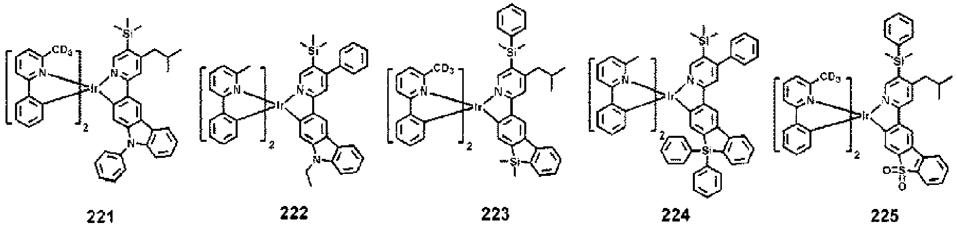

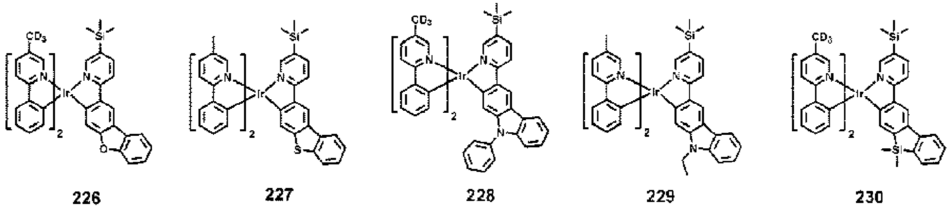

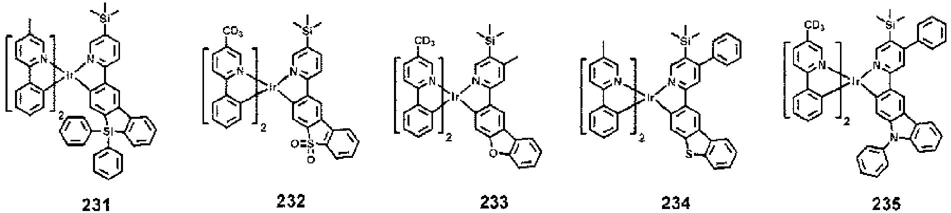

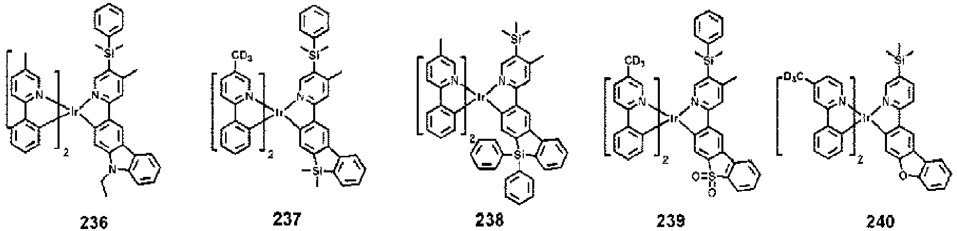

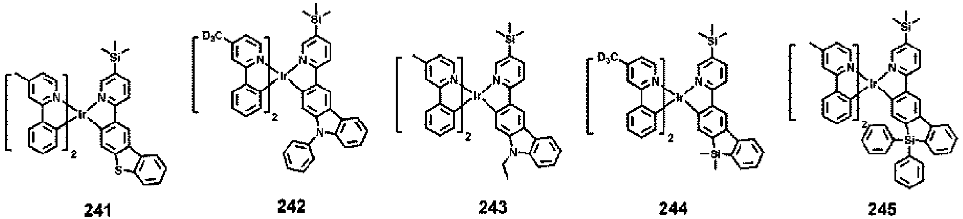

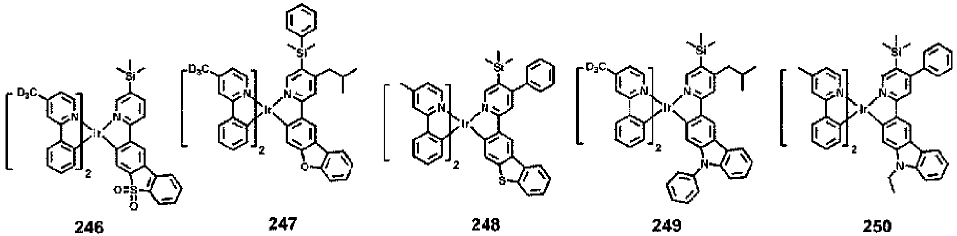

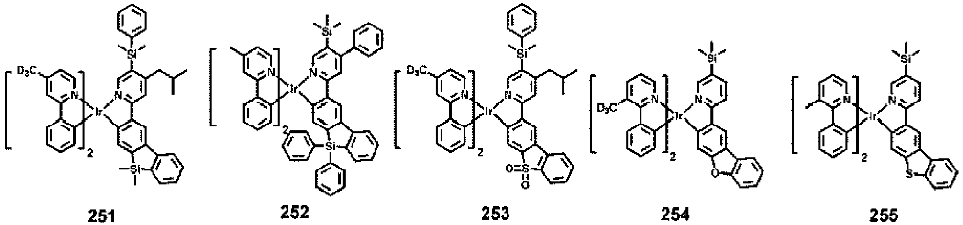

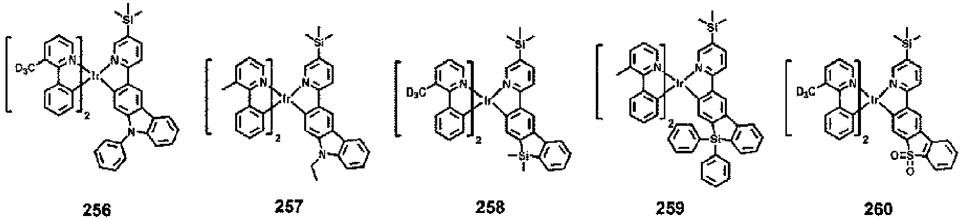

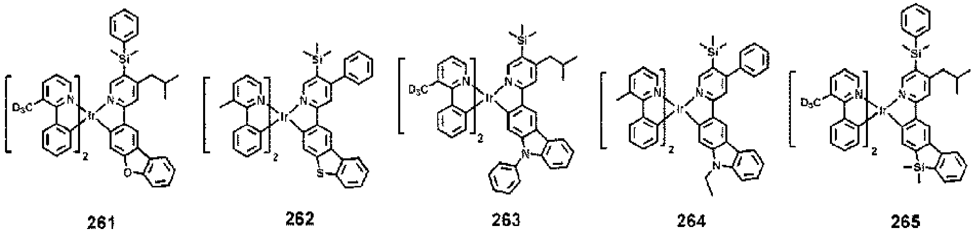

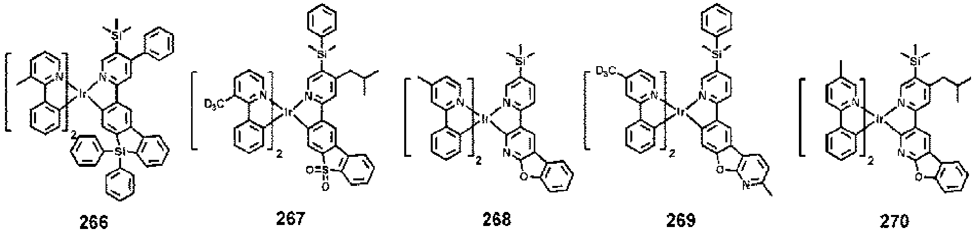

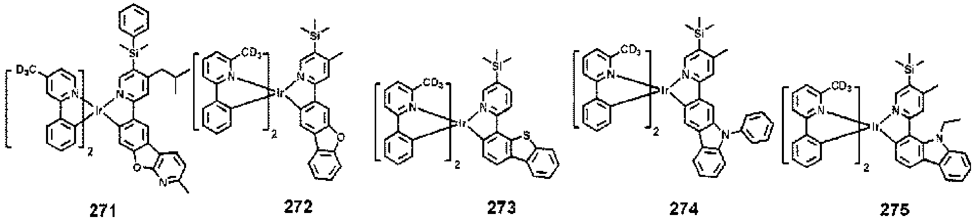

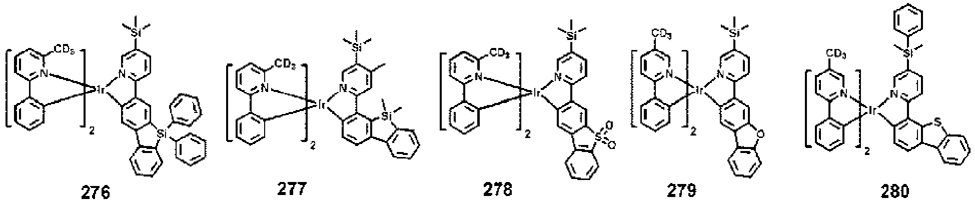

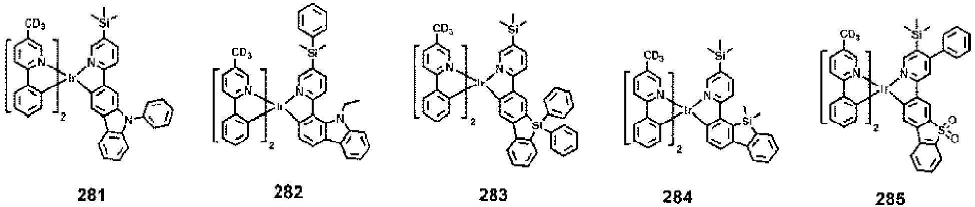

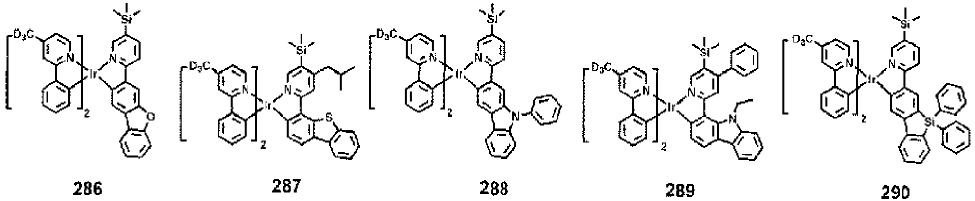

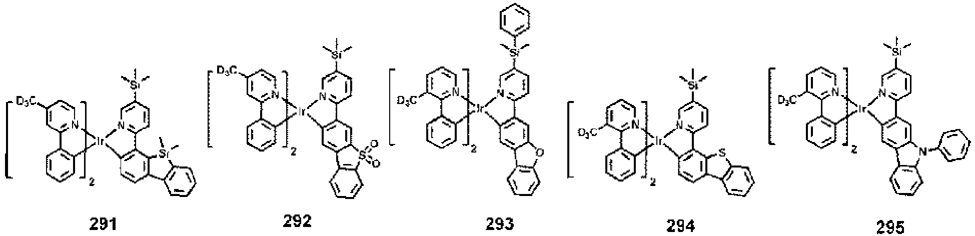

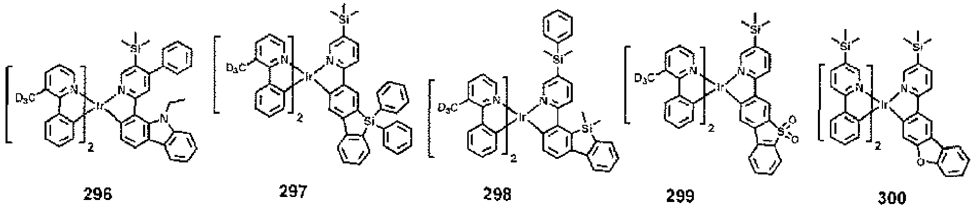

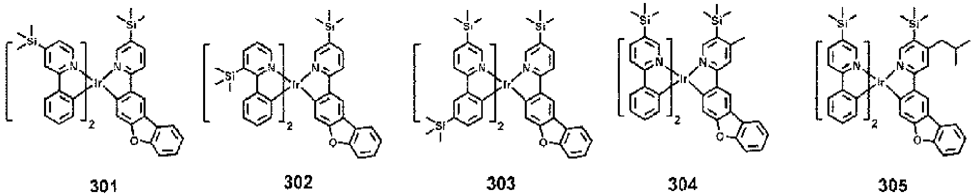

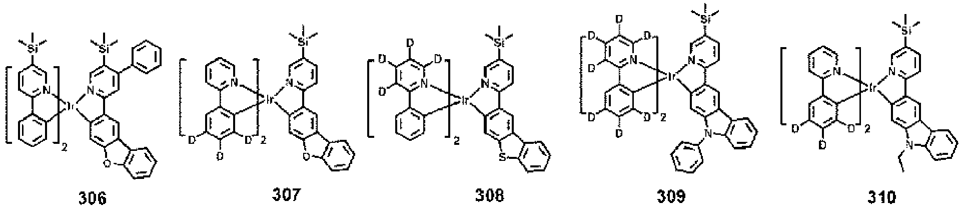

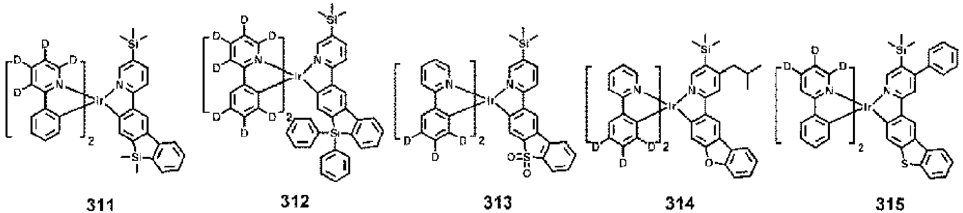

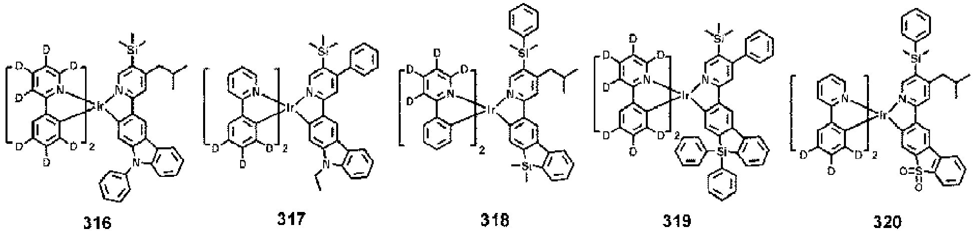

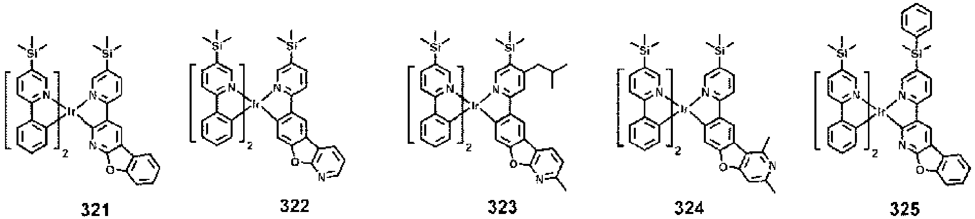

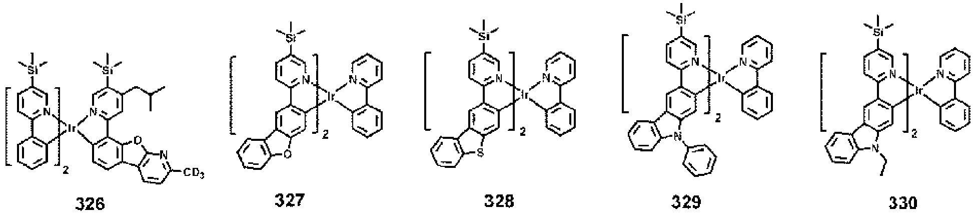

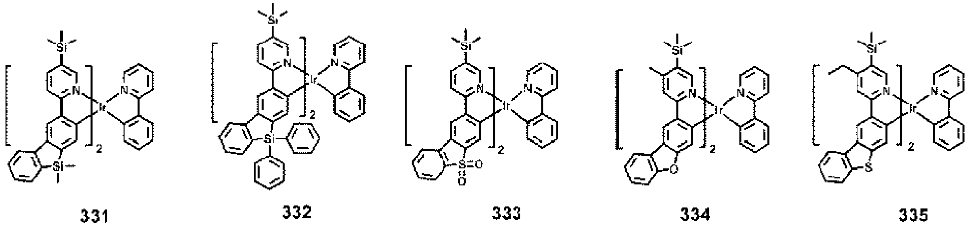

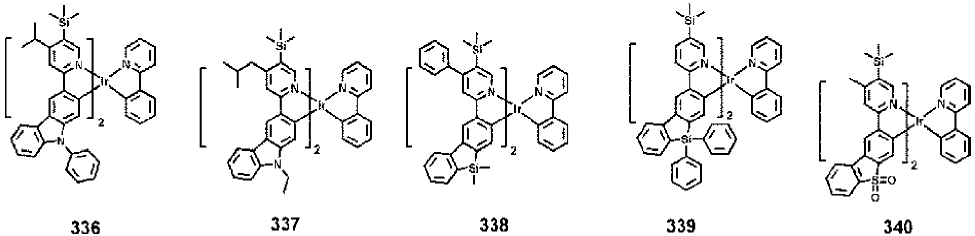

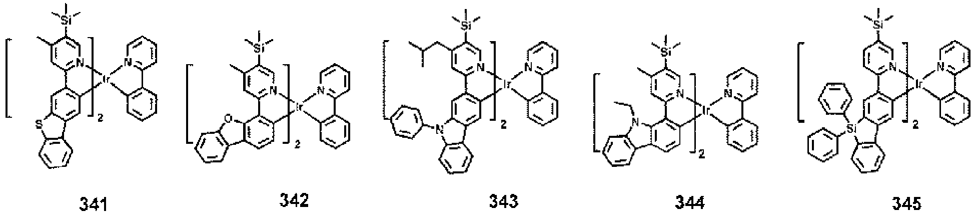

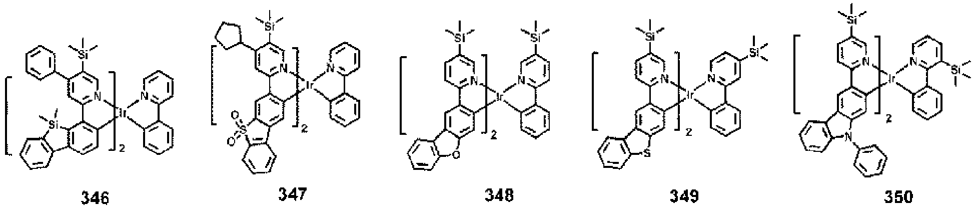

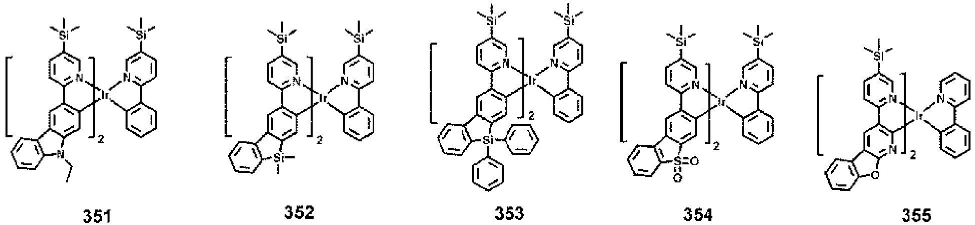

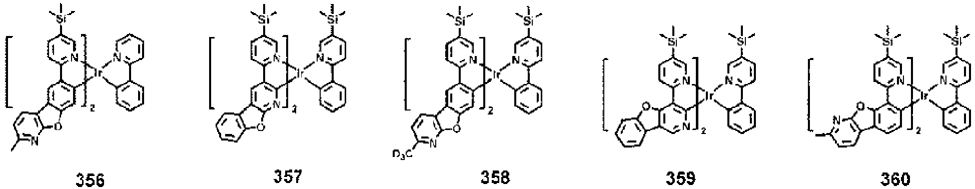

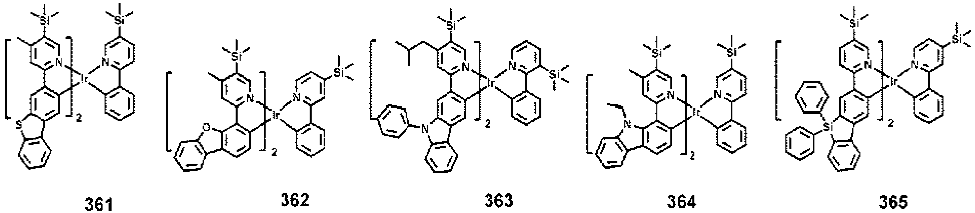

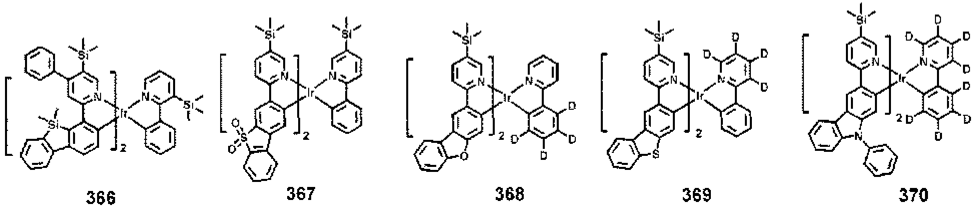

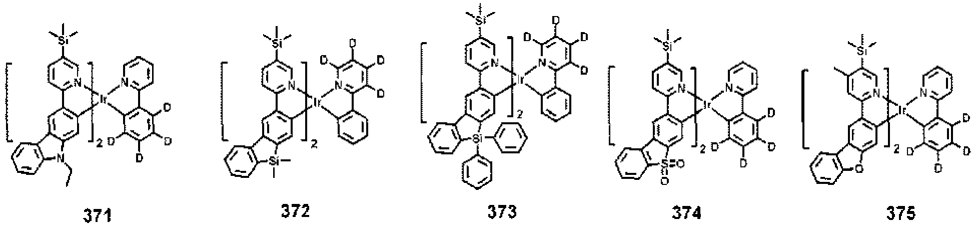

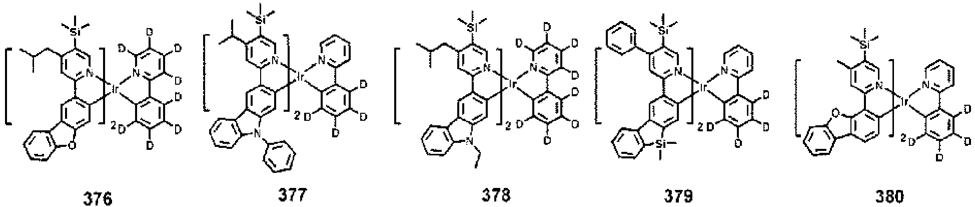

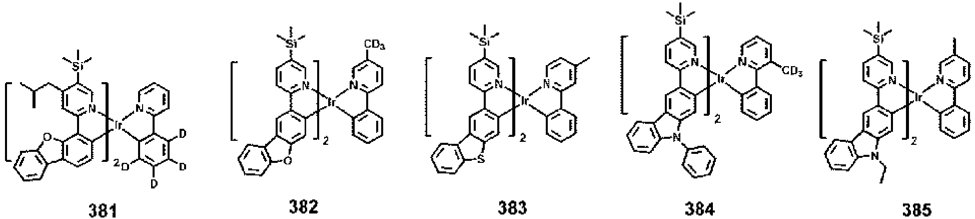

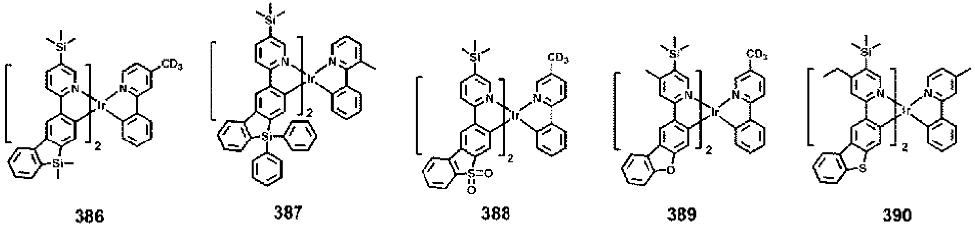

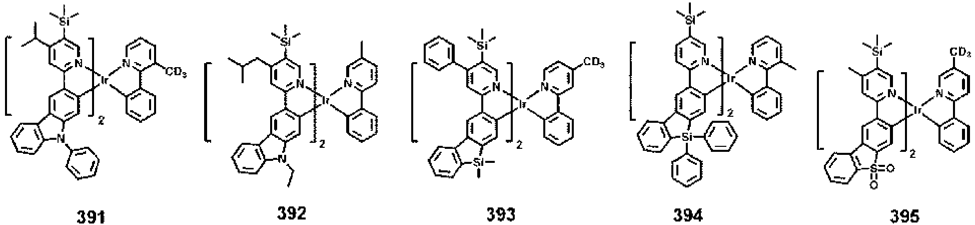

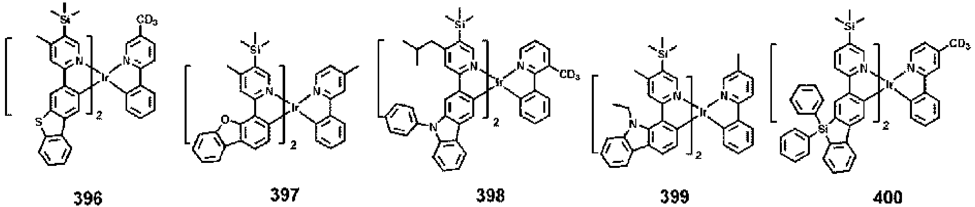

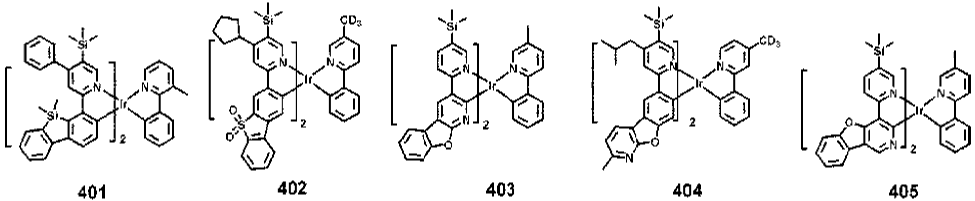

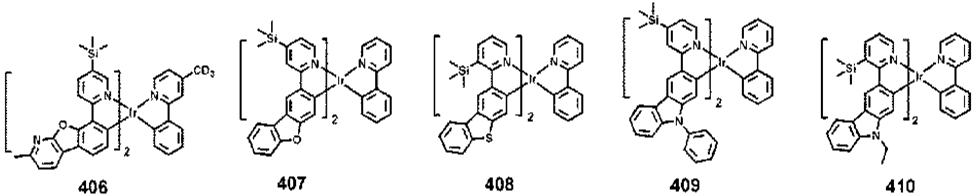

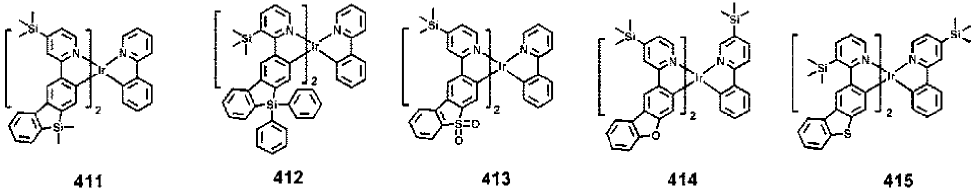

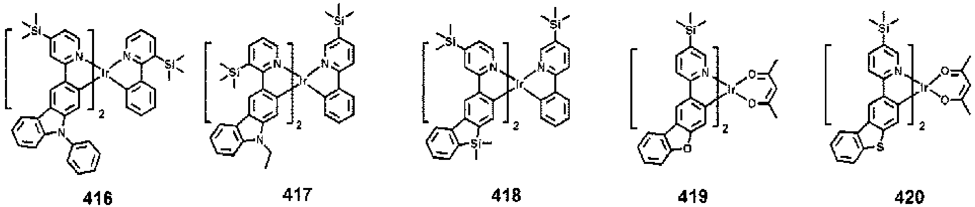

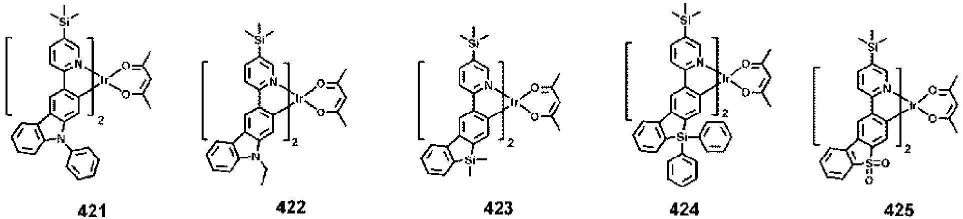

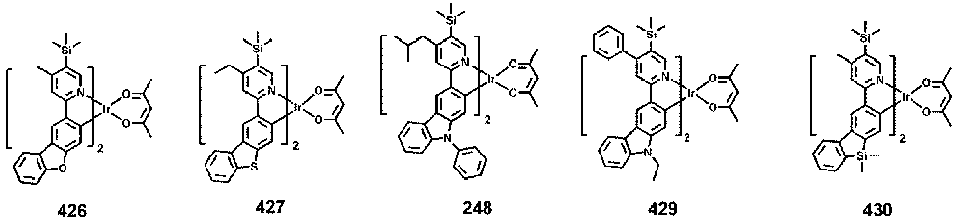

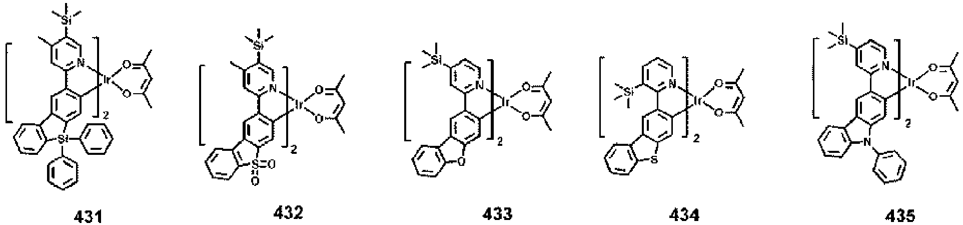

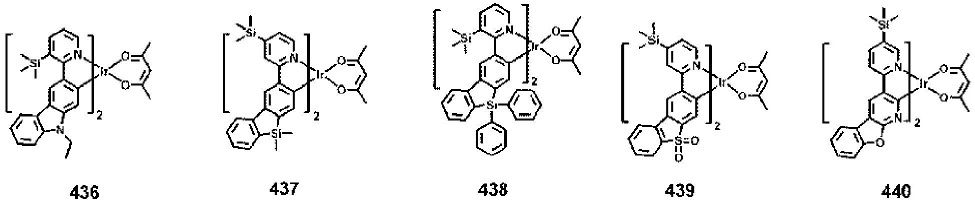

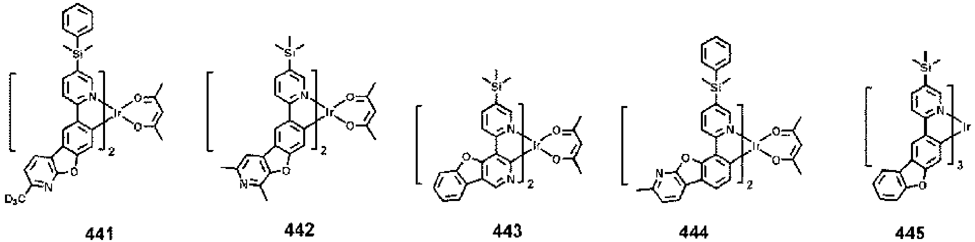

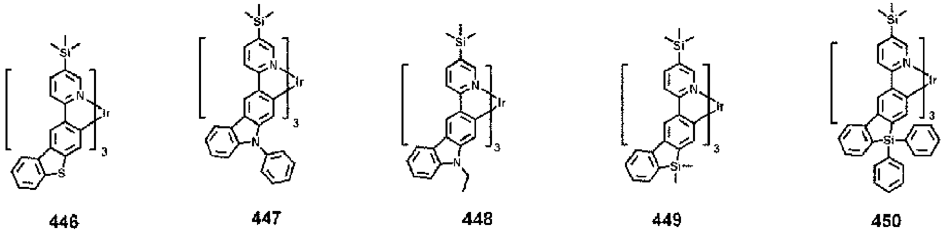

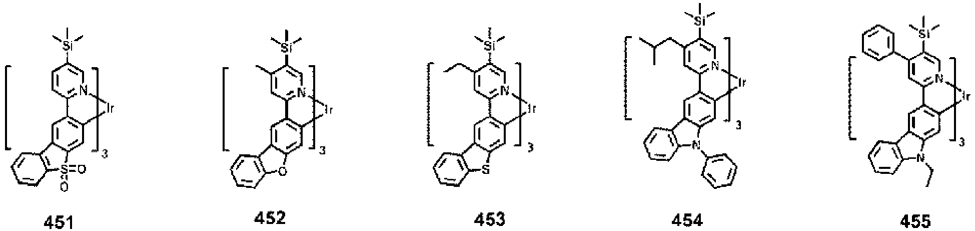

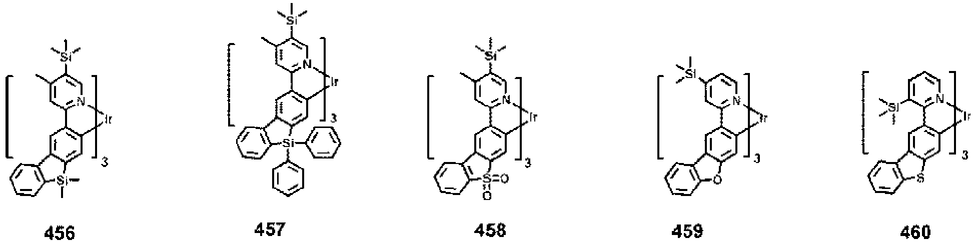

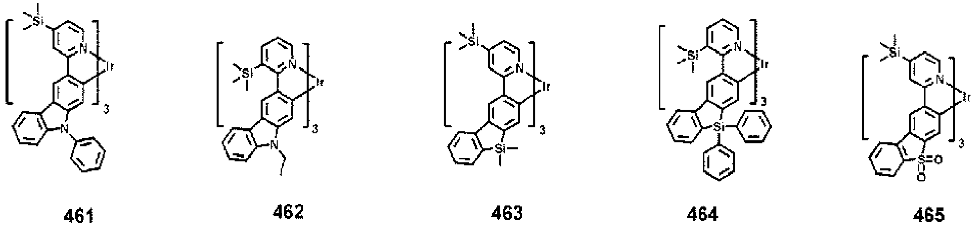

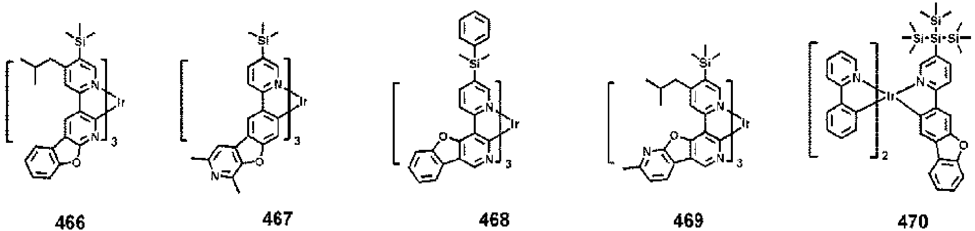

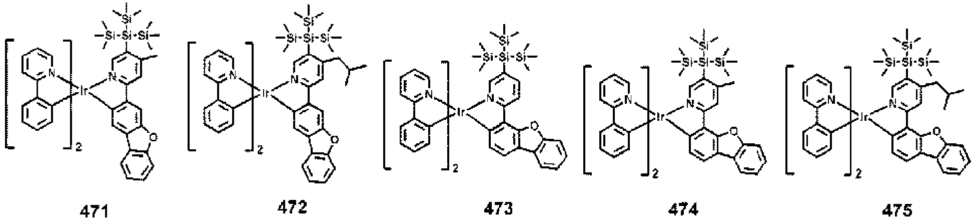

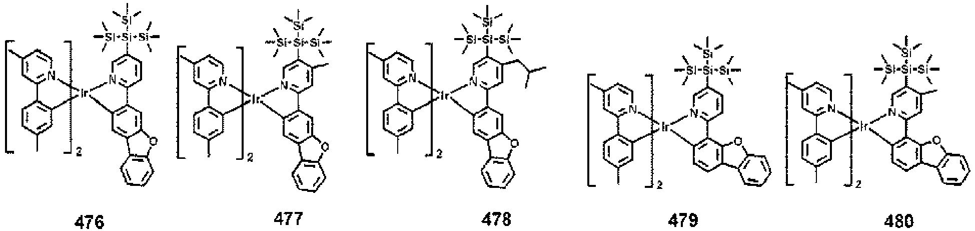

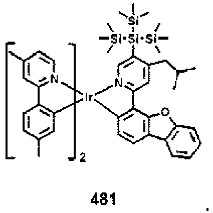

13. Eine organische lichtemittierende Vorrichtung, umfassend:
eine erste Elektrode,
eine zweite Elektrode, und
eine organische Schicht, die zwischen der ersten Elektrode und der zweiten Elektrode angeordnet ist,
wobei die organische Schicht eine Emissionsschicht und mindestens eine Organometallverbindung nach einem der Ansprüche 1 bis 12 umfasst.

14. Organische lichtemittierende Vorrichtung nach Anspruch 13,
wobei die erste Elektrode eine Anode ist,
die zweite Elektrode eine Kathode ist und
die organische Schicht einen Lochtransportbereich zwischen der ersten Elektrode und der Emissionsschicht und einen Elektronentransportbereich zwischen der Emissionsschicht und der zweiten Elektrode umfasst,
wobei der Lochtransportbereich mindestens eine einer Lochinjektionsschicht, einer Lochtransportschicht und einer Elektronenblockierungsschicht umfasst, und
der Elektronentransportbereich mindestens eine aus einer Lochblockierungsschicht, einer Elektronentransportschicht und einer Elektroneninjektionsschicht ausgewählte umfasst.

15. Organische lichtemittierende Vorrichtung nach Anspruch 13 oder 14, wobei die Emissionsschicht mindestens eine Organometallverbindung nach einem der Ansprüche 1 bis 12 umfasst.

## Revendications

1. Composé organométallique représenté par la Formule 1 :
Formule 1 M(L₁)ₙ₁(L₂)n₂ 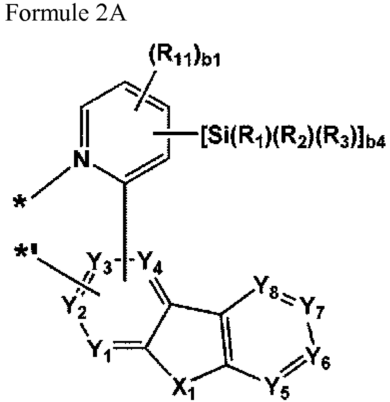
où
M dans la Formule 1 est sélectionné entre Ir, Pt, Os, Ti, Zr, Hf, Eu, Tb, Tm et Rh, dans la Formule 1, L₁ est un ligand représenté par la Formule 2A, n1 est 1, 2 ou 3, et lorsque n1 est 2 ou plus, 2 L₁ ou plus sont identiques ou différents,
dans la Formule 1, L₂ est sélectionné entre un ligand organique monovalent, un ligand organique bivalent, un ligand organique trivalent et un ligand organique tétravalent, n2 est 0, 1, 2, 3, ou 4, et lorsque n2 est 2 ou plus, 2 L₂ ou plus sont identiques ou différents,
L₁ et L₂ dans la Formule 1 sont différents l'un de l'autre,
R₁ à R₃ dans la Formule 2A sont chacun indépendamment sélectionnés entre : un groupe alkyle C₁-C₆₀ substitué ou non substitué, un groupe alkényle C₂-C₆₀ substitué ou non substitué, un groupe alkynyle C₂-C₆₀ substitué ou non substitué, un groupe alkoxy C₁-C₆₀ substitué ou non substitué, un groupe cycloalkyle C₃-C₁₀ substitué ou non substitué, un groupe hétérocycloalkyle C₁-C₁₀ substitué ou non substitué, un groupe cycloalkényle C₃-C₁₀ substitué ou non substitué, un groupe hétérocycloalkényle C₁-C₁₀ substitué ou non substitué, un groupe aryle C₆-C₆₀ substitué ou non substitué, un groupe C₆-C₆₀ substitué ou non substitué, un groupe hétéroaryle C₁-C₆₀ substitué ou non substitué, un groupe polycyclique condensé non aromatique substitué ou monovalent, un groupe hétéropolycyclique condensé non aromatique monovalent substitué ou non substitué, et -Si(Q₅₁)(Q₅₂)(Q₅₃),
X₁ dans la Formule 2A est sélectionné entre O, S, S(=O)₂, N(R₂₁), et Si(R₂₂)(R₂₃),
dans la Formule 2A, Y₁ est N, C(R₄₁), ou un atome de carbone connecté à un noyau de pyridine, Y₂ est N, C(R₄₂), ou un atome de carbone connecté à un noyau de pyridine, Y₃ est N, C(R₄₃), ou un atome de carbone connecté à un noyau de pyridine, Y₄ est N, C(R₄₄), ou un atome de carbone connecté à un noyau de pyridine, Y₅ est N ou C(R₄₅), Y₆ est N ou C(R₄₆), Y₇ est N ou C(R₄₇), Y₈ est N ou C(R₄₈), et l'un de Y₁ à Y₄ est un atome de carbone connecté à un noyau de pyridine,
R₁₁, R₂₁ à R₂₃ et R₄₁ à R₄₈ dans la Formule 2A sont chacun indépendamment sélectionnés entre : hydrogène, un deutérium, -F, -Cl, -Br, -I, -SF₅, un groupe hydroxyle, un groupe cyano, un groupe nitro et un groupe amino, un groupe amidino, un groupe hydrazine, un groupe hydrazone, un groupe carboxylique ou un sel de celui-ci, un groupe acide sulfonique ou un sel de celui-ci, un groupe acide phosphorique ou un sel de celui-ci, un groupe alkyle C₁-C₆₀ substitué ou non substitué, un groupe alkényle substitué ou C₂-C₆₀, un groupe alkynyle C₂-C₆₀ substitué ou non substitué, un groupe alkoxy C₁-C₆₀ substitué ou non substitué, un groupe cycloalkyle C₃-C₁₀ substitué ou non substitué, un groupe hétérocycloalkyle C₁-C₁₀ substitué ou non substitué, un groupe cycloalkényle C₃-C₁₀ substitué ou non substitué, un groupe hétérocycloalkényle C₁-C₁₀ substitué ou non substitué, un groupe aryle C₆-C₆₀ substitué ou non substitué, un groupe C₆-C₆₀ substitué ou non substitué, un groupe arylthio C₆-C₆₀ substitué ou non substitué, un groupe hétéroaryle C₁-C₆₀ substitué ou non substitué, un groupe polycyclique condensé non aromatique monovalent substitué ou non substitué, un groupe hétéropolycyclique condensé non aromatique monovalent substitué ou non substitué, -N(Q₁)(Q₂), -Si(Q₃)(Q₄)(Q₅), -B(Q₆)(Q₇), et --P(=O)(Q₈)(Q₉), et 2 ou plus R₁₁ sont optionnellement liés l'un à l'autre pour former un noyau C₄-C₆₀ saturé non saturé, deux ou plus de R₄₁ à R₄₄ sont optionnellement liés l'un à l'autre à un noyau C₄-C₆₀ saturé ou non saturé, et deux ou plus de R₄₅ à R₄₈ sont optionnellement liés l'un à l'autre pour former un noyau C₄-C₆₀ saturé ou non saturé,
dans la Formule 2A, b1 est un nombre entier sélectionné de 0 à 3, et b4 est un nombre entier sélectionné de 1 à 4,
* et *' dans la Formule 2A sont des sites de fixation à M dans la Formule 1,
au moins l'un des substituants du groupe alkyle C₁-C₆₀ substitué, du groupe alkényle C₂-C₆₀ substitué, du groupe alkynyle C₂-C₆₀ substitué, du groupe alkoxy C₁-C₆₀ substitué, du groupe cycloalkyle C₃-C₁₀ substitué, du groupe hétérocycloalkyle C₁-C₁₀ substitué, du groupe cycloalkényle C₃-C₁₀ substitué, du groupe hétérocycloalkényle C₁-C₁₀ substitué, du groupe aryle C₆-C₆₀ substitué, du groupe aryloxy C₆-C₆₀ substitué, du groupe arylthio C₆-C₆₀ substitué, du groupe hétéroaryle C₁-C₆₀ substitué, du groupe polycyclique condensé non aromatique monovalent substitué, et du groupe hétéropolycyclique condensé non aromatique monovalent substitué est sélectionné entre
un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle C₁-C₆₀, un groupe alkényle C₂-C₆₀, un groupe alkynyle C₂-C₆₀ et un groupe alkoxy C₁-C₆₀ ;
un groupe alkyle C₁-C₆₀, un groupe alkényle C₂-C₆₀, un groupe alkynyle C₂-C₆₀ et un groupe alkoxy C₁-C₆₀, chacun substitué avec au moins un élément sélectionné entre deutérium, -F, -Cl, -Br, -I, - -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle C₃-C₁₀, un groupe hétérocycloalkyle C₁-C₁₀, un groupe cycloalkényle C₃-C₁₀, un groupe hétérocycloalkényle C₁-C₁₀, un groupe aryle C₆-C₆₀, un groupe aryloxy C₆-C₆₀, un groupe arylthio C₆-C₆₀, un groupe hétéroaryle C₁-C₆₀, un groupe polycyclique condensé non aromatique monovalent, un groupe hétéropolycyclique condensé non aromatique monovalent, -N(Q₁₁)(Q₁₂), -Si(Q₁₃)(Q₁₄)(Q₁₅), -B(Q₁₆)(Q₁₇), et -P(=O)(Q₁₈)(Q₁₉) ;
un groupe cycloalkyle C₃-C₁₀, un groupe hétérocycloalkyle C₁-C₁₀, un groupe cycloalkényle C₃-C₁₀, un groupe hétérocycloalkényle C₁-C₁₀, un groupe aryle C₆-C₆₀, un groupe aryloxy C₆-C₆₀, un groupe arylthio C₆-C₆₀, un groupe hétéroaryle C₁-C₆₀, un groupe polycyclique condensé non aromatique monovalent, et un groupe hétéropolycyclique condensé non aromatique monovalent ;
un groupe cycloalkyle C₃-C₁₀, un groupe hétérocycloalkyle C₁-C₁₀, un groupe cycloalkényle C₃-C₁₀, un groupe hétérocycloalkényle C₁-C₁₀, un groupe aryle C₆-C₆₀, un groupe aryloxy C₆-C₆₀, un groupe arylthio C₆-C₆₀, un groupe hétéroaryle C₁-C₆₀, un groupe polycyclique condensé non aromatique monovalent, et un groupe hétéropolycyclique condensé non aromatique monovalent, chacun substitué avec au moins un élément sélectionné entre un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle C₁-C₆₀, un groupe alkényle C₂-C₆₀, un groupe alkynyle C₂-C₆₀, un groupe alkoxy C₁-C₆₀, un groupe cycloalkyle C₃-C₁₀, un groupe hétérocycloalkyle C₁-C₁₀, un groupe cycloalkényle C₃-C₁₀, un groupe hétérocycloalkényle C₁-C₁₀, un groupe aryle C₆-C₆₀, un groupe aryloxy C₆-C₆₀, un groupe arylthio C₆-C₆₀, un groupe hétéroaryle C₁-C₆₀, un groupe polycyclique condensé non aromatique monovalent, un groupe hétéropolycyclique condensé non aromatique monovalent, -N(Q₂₁)(Q₂₂), -Si(Q₂₃)(Q₂₄)(Q₂₅), -B(Q₂₆)(Q₂₇) et -P(=O)(Q₂₈)(Q₂₉) ; et
-N(Q₃₁)(Q₃₂), -Si(Q₃₃)(Q₃₄)(Q₃₅), -B(Q₃₆)(Q₃₇), et -P(=O)(Q₃₈)(Q₃₉) ;
où Q₁ à Q₉, Q₁₁ à Q₁₉, Q₂₁ à Q₂₉, Q₃₁ à Q₃₉ et Q₅₁ à Q₅₃ sont chacun indépendamment sélectionnés entre : un hydrogène, un a deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle C₁-C₆₀ substitué ou non substitué, un groupe alkényle C₂-C₆₀ substitué ou non substitué, un groupe alkynyle C₂-C₆₀ substitué ou non substitué, un groupe alkoxy C₁-C₆₀ substitué ou non substitué, un groupe cycloalkyle C₃-C₁₀ substitué ou non substitué, un groupe hétérocycloalkyle C₁-C₁₀ substitué ou non substitué, un groupe cycloalkényle C₃-C₁₀ substitué ou non substitué, un groupe hétérocycloalkényle C₁-C₁₀ substitué ou non substitué, un groupe aryle C₆-C₆₀ substitué ou non substitué, un groupe aryloxy C₆-C₆₀ substitué ou non substitué, un groupe arylthio C₆-C₆₀ substitué ou non substitué, un groupe hétéroaryle C₁-C₆₀ substitué ou non substitué, un groupe polycyclique condensé non aromatique monovalent substitué ou non substitué, et un groupe hétéropolycyclique condensé non aromatique monovalent substitué ou non substitué.

2. Composé organométallique selon la revendication 1, dans lequel
dans la Formule 1, M est Ir et la somme de n1 et n2 est 3 ; ou M est Pt et la somme de n1 et n2 est 2, et
le composé organométallique ne comprend pas de groupe ionique.

3. Composé organométallique selon la revendication 1 ou 2, dans lequel
R₁ à R₃ dans la Formule 2A sont chacun indépendamment sélectionnés entre
un groupe alkyle C₁-C₂₀, un groupe alkoxy C₁-C₂₀, et -Si(Q₅₁)(Q₅₂)(Q₅₃) ;
un groupe alkyle C₁-C₂₀ et un groupe alkoxy C₁-C₂₀, chacun substitué avec au moins un élément sélectionné entre : un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe sulfonique ou un sel de celui-ci, un groupe acide phosphorique ou un sel de celui-ci, un groupe alkyle C₁-C₁₀, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentyle, un groupe cyclohexényle, un groupe cycloheptényle, un groupe phényle, un groupe naphthyle, un groupe pyridinyle et un groupe pyrimidinyle ;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzoïmidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle et un groupe imidazopyrimidinyle ; et
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzoïmidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un troupe triazinyle, un groupe dibenzofuranyle, un groupe dibenzothiophényle, un groupe benzocarbazolyle, un groupe dibenzocarbazolyle, un groupe imidazopyridinyle, et un groupe imidazopyrimidinyle, chacun substitué avec au moins un élément sélectionné entre un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe sulfonique ou un sel de celui-ci, un groupe acide phosphorique ou un sel de celui-ci, un groupe alkyle C₁-C₂₀, un groupe alkoxy C₁-C₂₀, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzoïmidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe, un groupe dibenzofuranyle, un groupe dibenzothiophényle, un groupe benzocarbazolyle, un groupe dibenzocarbazolyle, un groupe imidazopyridinyle et un groupe imidazopyrimidinyle ; et
Q₅₁ à Q₅₃ sont chacun indépendamment sélectionnés entre
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H et -CD₂CDH₂ ;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle et un groupe naphthyle ; et
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle et un groupe naphthyle, chacun substitué avec au moins un élément sélectionné entre un deutérium, un groupe alkyle C₁-C₁₀ et un groupe phényle ;
où, de préférence :
R₁ à R₃ dans la Formule 2A sont chacun indépendamment sélectionnés entre -CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, et -CD₂CDH₂ ;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, un groupe naphthyle et -Si(Q₅₁)(Q₅₂)(Q₅₃) ; et
un groupe n-propyle, un groupe isopropyle, un groupe n-butyle, un groupe isobutyle, un groupe sec-sec-butyle, un groupe tert-butyle, un groupe n-pentyle, un groupe isopentyle, un groupe sec-pentyle, un groupe tert-pentyle, un groupe phényle et un groupe naphthyle, chacun substitué avec au moins un élément sélectionné entre : un deutérium, un groupe alkyle C₁-C₁₀ et un groupe phényle ; et
Q₅₁ à Q₅₃ sont chacun indépendamment sélectionnés entre
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H et -CD₂CDH₂ ;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle et un groupe naphthyle ; et
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle et un groupe naphthyle, chacun substitué avec au moins un élément sélectionné entre un deutérium, un groupe alkyle C₁-C₁₀ et un groupe phényle.

4. Composé organométallique selon l'une quelconque des revendications 1-3, où
R₁₁, R₂₁ à R₂₃ et R₄₁ à R₄₈ dans la Formule 2A sont chacun indépendamment sélectionnés entre
un hydrogène, un deutérium, -F, -Cl, -Br, -I, -SF₅, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle C₁-C₂₀, et un groupe alkoxy C₁-C₂₀ ;
un groupe alkyle C₁-C₂₀ et un groupe alkoxy C₁-C₂₀, chacun substitué avec au moins un élément sélectionné entre : un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe sulfonique ou un sel de celui-ci, un groupe acide phosphorique ou un sel de celui-ci, un groupe alkyle C₁-C₁₀, un groupe alkoxy C₁-C₁₀, un groupe cycloalkyle C₃-C₁₀, un groupe hétérocycloalkyle C₁-C₁₀, un groupe cycloalkényle C₃-C₁₀, un groupe hétérocycloalkényle C₁-C₁₀, un groupe aryle C₆-C₁₄, un groupe hétéroaryle C₁-C₁₄, un groupe polycyclique condensé non aromatique monovalent et un groupe hétéropolycyclique condensé non aromatique monovalent ;
un groupe cycloalkyle C₃-C₁₀, un groupe hétérocycloalkyle C₁-C₁₀, un groupe cycloalkényle C₃-C₁₀, un groupe hétérocycloalkényle C₁-C₁₀, un groupe aryle C₆-C₁₄, un groupe hétéroaryle C₁-C₁₄, un groupe polycyclique condensé non aromatique monovalent et un groupe hétéropolycyclique condensé non aromatique monovalent ;
un groupe cycloalkyle C₃-C₁₀, un groupe hétérocycloalkyle C₁-C₁₀, un groupe cycloalkényle C₃-C₁₀, un groupe hétérocycloalkényle C₁-C₁₀, un groupe aryle C₆-C₁₄, un groupe hétéroaryle C₁-C₁₄, un groupe polycyclique condensé non aromatique monovalent et un groupe hétéropolycyclique condensé non aromatique monovalent, chacun substitué avec au moins un élément sélectionné entre : un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle C₁-C₂₀, un groupe alkoxy C₁-C₂₀, un groupe cycloalkyle C₃-C₁₀, un groupe hétérocycloalkyle C₁-C₁₀, un groupe cycloalkényle C₃-C₁₀, un groupe hétérocycloalkényle C₁-C₁₀, un groupe aryle C₆-C₁₄, un groupe hétéroaryle C₁-C₁₄, un groupe polycyclique condensé non aromatique monovalent et un groupe hétéropolycyclique condensé non aromatique monovalent ; et
-N(Q₁)(Q₂), -Si(Q₃)(Q₄)(Q₅), -B(Q₆)(Q₇) et -P(=O)(Q₈)(Q₉) ;
où Q₁ à Q₉ sont chacun indépendamment sélectionnés entre un groupe alkyle substitué ou C₁-C₂₀, un groupe alkoxy C₁-C₂₀ substitué ou non substitué, un groupe cycloalkyle C₃-C₁₀ substitué ou non substitué, un groupe hétérocycloalkyle C₁-C₁₀ substitué ou non substitué, un groupe cycloalkényle C₃-C₁₀ substitué ou non substitué, un groupe hétérocycloalkényle C₁-C₁₀ substitué ou non substitué, un groupe aryle substitué ou C₆-C₁₄, un groupe hétéroaryle C₁-C₁₄ substitué ou non substitué, un groupe polycyclique condensé non aromatique monovalent substitué ou non substitué et un groupe hétéropolycyclique condensé non aromatique monovalent substitué ou non substitué ;
où, de préférence :
R₁₁, R₂₁ à R₂₃ et R₄₁ à R₄₈ dans la Formule 2A sont chacun indépendamment sélectionnés entre
un hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, -SF₅, un groupe alkyle C₁-C₂₀ et un groupe alkoxy C₁-C₂₀ ;
un groupe alkyle C₁-C₂₀ et un groupe alkoxy C₁-C₂₀, chacun substitué avec au moins un élément sélectionné entre : un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle C₁-C₁₀, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe pyridinyle et un groupe pyrimidinyle ;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzoïmidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle et un groupe imidazopyrimidinyle ;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzoïmidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle et un groupe imidazopyrimidinyle, chacun substitué avec au moins un élément sélectionné entre : un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe sulfonique ou un sel de celui-ci, un groupe acide phosphorique ou un sel de celui-ci, un groupe alkyle C₁-C₂₀, un groupe alkoxy C₁-C₂₀, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzoïmidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe, un groupe dibenzofuranyle, un groupe dibenzothiophényle, un groupe benzocarbazolyle, un groupe dibenzocarbazolyle, un groupe imidazopyridinyle et un groupe imidazopyrimidinyle ; et
-B(Q₆)(Q₇) et -P(=O)(Q₈)(Q₉),
où Q₆ à Q₉ sont chacun indépendamment sélectionnés entre
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H et -CD₂CDH₂ ;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle et un groupe naphthyle ; et
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle et un groupe naphthyle, chacun substitué avec au moins un élément sélectionné entre un deutérium, un groupe alkyle C₁-C₁₀ et un groupe phényle ;
où, de préférence :
R₁₁, R₂₁ à R₂₃ et R₄₁ à R₄₈ dans la Formule 2A sont chacun indépendamment sélectionnés entre : un hydrogène, un deutérium, -F, un groupe cyano, un groupe nitro, -SF₅, un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe n-hexyle, un groupe isohexyle, un groupe sec-hexyle, un groupe tert-hexyle, un groupe n-heptyle, un groupe isoheptyle, un groupe sec-heptyle, un groupe tert-heptyle, un groupe n-octyle, un groupe isooctyle, un groupe sec-octyle, un groupe tert-octyle, un groupe n-nonyle, un groupe isononyle, un groupe sec-nonyle, un groupe tert-nonyle, un groupe n-décyle, un groupe isodécyle, un groupe sec-décyle, un groupe tert-décyle, un groupe méthoxy, un groupe éthoxy, un groupe propoxy, un groupe butoxy, un groupe pentoxy, un groupe cyclopentyle, un groupe cyclohexyle, un groupe cycloheptyle, un groupe cyclooctyle, un adamantanyle, un groupe norbornanyle, un norbornényle, un groupe cyclopentényle, un groupe cyclohexényle, un groupe cycloheptényle, un groupe phényle, un groupe naphthyle, un groupe pyridinyle et un groupe pyrimidinyle ;
un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe n-hexyle, un groupe isohexyle, un groupe sec-hexyle, un groupe tert-hexyle, un groupe n-heptyle, un groupe isoheptyle, un groupe sec-heptyle, un groupe tert-heptyle, un groupe n-octyle, un groupe isooctyle, un groupe sec-octyle, un groupe tert-, un groupe n-nonyle, un groupe isononyle, un groupe sec-nonyle, un groupe tert-nonyle, un groupe n-n-décyle, un groupe isodécyle, un groupe sec-décyle, un groupe tert-décyle, un groupe méthoxy, un groupe éthoxy, un groupe propoxy, un groupe butoxy, un groupe pentoxy, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe pyridinyle et un groupe pyrimidinyle, chacun substitué avec au moins un élément sélectionné entre : un deutérium, -F, -CD₃, -CD₂H, - -CF₃, -CF₂H, -CFH₂, un groupe cyano, un groupe nitro, un groupe C₁-C₁₀ alkyle, un groupe alkoxy C₁-C₁₀, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe pyridinyle et un groupe pyrimidinyle ; et
-B(Q₆)(Q₇) et -P(=O)(Q₈)(Q₉),
où Q₆ à Q₉ sont chacun indépendamment sélectionnés entre
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H et -CD₂CDH₂ ;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle et un groupe naphthyle ; et
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle et un groupe naphthyle, chacun substitué avec au moins un élément sélectionné entre : un deutérium, un groupe alkyle C₁-C₁₀, et un groupe phényle.

5. Composé organométallique selon l'une quelconque des revendications 1-4, dans lequel :
R₁₁, R₂₁ à R₂₃ et R₄₁ à R₄₈ dans la Formule 2A sont chacun indépendamment sélectionnés entre un hydrogène, un deutérium, -F, un groupe cyano, un groupe nitro, -SF₅, -CH₃, -CD₃, -CD₂H, -CDH₂, -CF₃, -CF₂H, -CFH₂, les groupes représentés par les Formules 9-1 à 9-17, et les groupes représentés par les formules 10-1 à 10-30 : 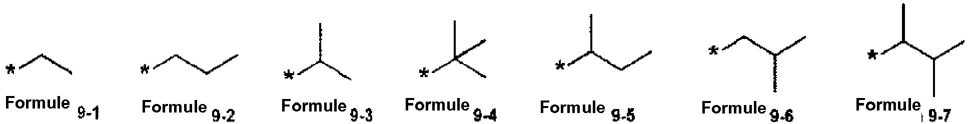 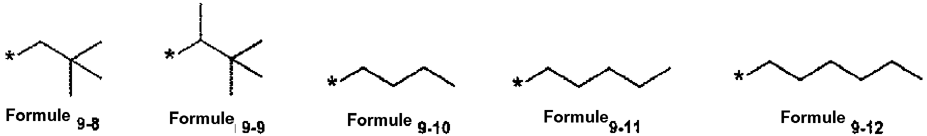 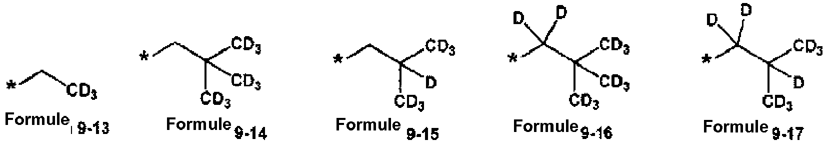 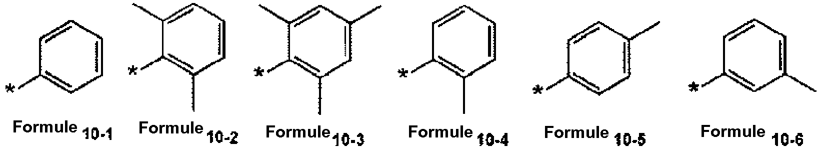 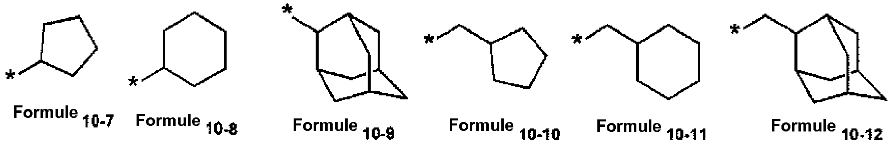 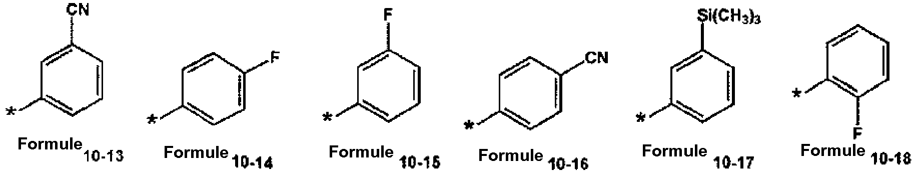 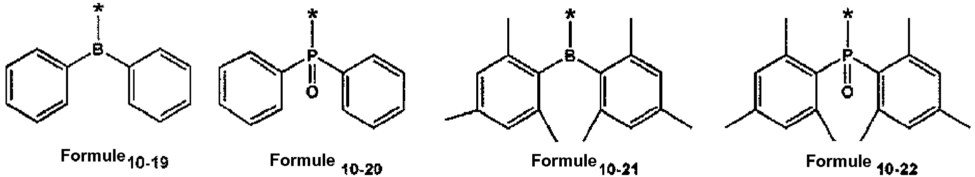 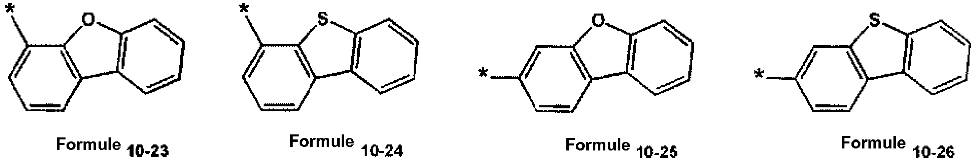 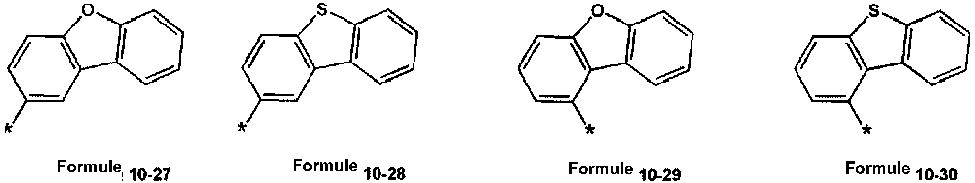
où, dans les Formules 9-1 à 9-17 et 10-1 à 10-30, * est un site de liaison à un atome voisin.

6. Composé organométallique selon l'une quelconque des revendications 1-5, où deux groupes R₁₁ dans la Formule 2A sont liés l'un à l'autre pour former un cyclohexane substitué ou non substitué ou un benzène substitué ou non substitué.

7. Composé organométallique selon l'une quelconque des revendications 1-6, dans lequel L₁ est sélectionné entre des ligands représentés par les Formules 2A-1 à 2A-16 : 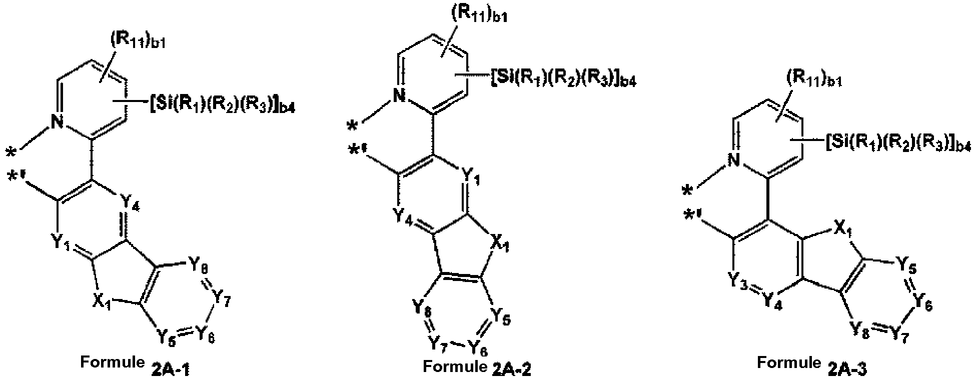 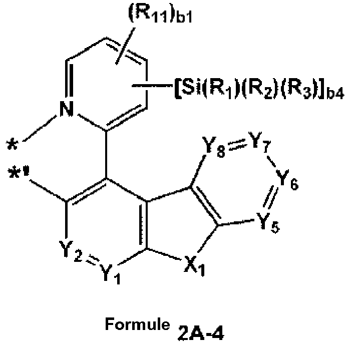 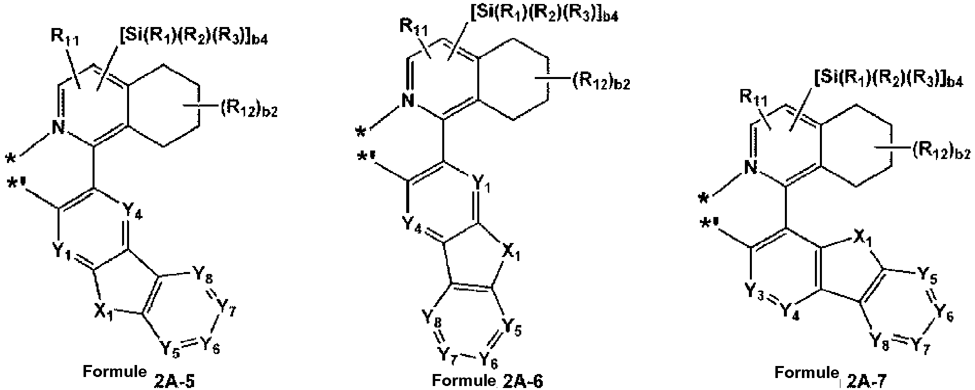 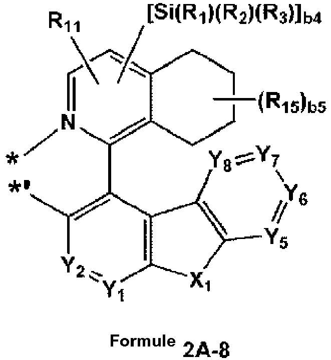 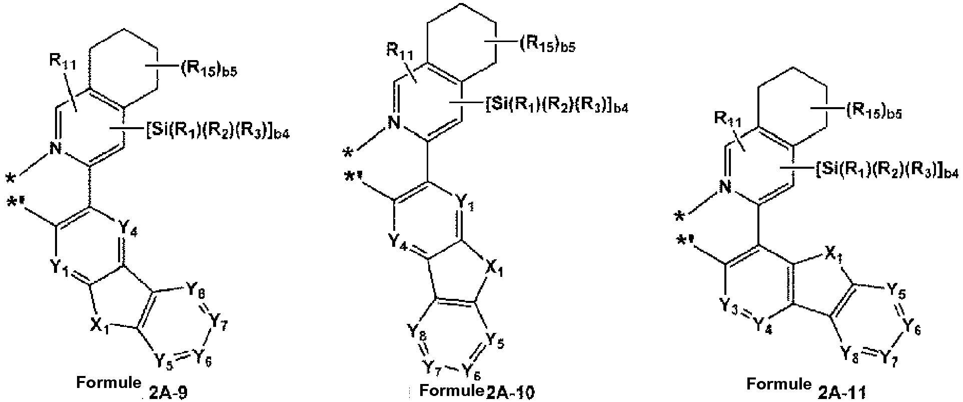 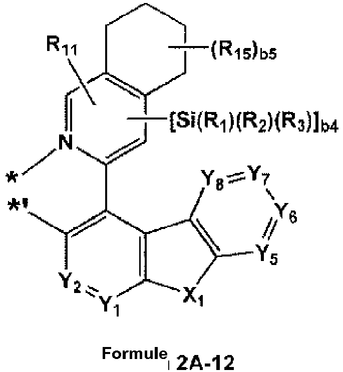 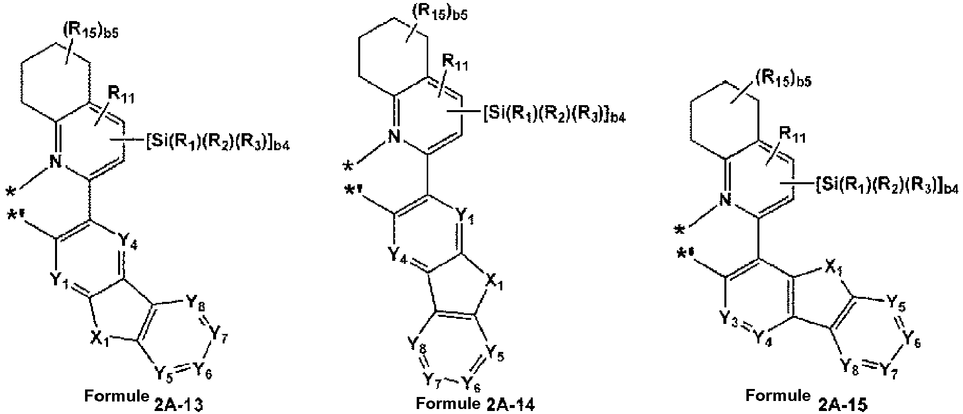 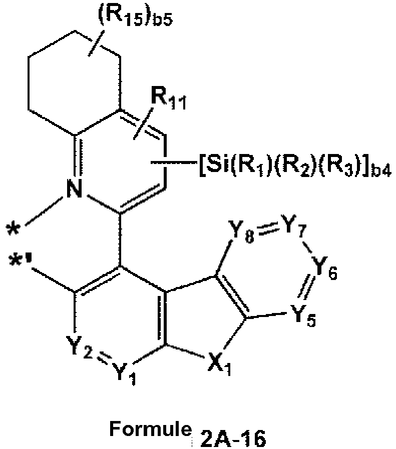
où, dans les Formules 2A-1 à 2A-16, R₁ à R3, X₁, Y₁ à Y₈, R₁₁, et b1 et b4 sont identiques à la définition de la revendication 1, R₁₅ est identique à R₁₁, b5 est un nombre entier sélectionné de 0 à 8 et * et *' sont des sites de liaison à M dans la Formule 1, de préférence où :
dans les Formules 2A-1 à 2A-16, Y₁ est C(R₄₁), Y₂ est C(R₄₂), Y₃ est C(R₄₃), Y₄ est C(R₄₄), Y₅ est C(R₄₅), Y₆ est C(R₄₆), Y₇ est C(R₄₇), et Y₈ est C(R₄₈);
dans les Formules 2A-1, 2A-2, 2A-4, 2A-5, 2A-6, 2A-8, 2A-9, 2A-10, 2A-12, 2A-13, 2A-14 et 2A-16, Y₁ est N, Y₄ est C(R₄₄), Y₅ est C(R₄₅), Y₆ est C(R₄₆), Y₇ est C(R₄₇), et Y₈ est C(R₄₈);
dans les Formules 2A-1, 2A-2, 2A-4, 2A-5, 2A-6, 2A-8, 2A-9, 2A-10, 2A-12, 2A-13, 2A-14 et 2A-16, Y₁ est C(R₄₁), Y₄ est C(R₄₄), Y₅ est N, Y₆ est C(R₄₆), Y₇ est C(R₄₇), et Y₈ est C(R₄₈);
dans les Formules 2A-1, 2A-2, 2A-4, 2A-5, 2A-6, 2A-8, 2A-9, 2A-10, 2A-12, 2A-13, 2A-14 et 2A-16, Y₁ est C(R₄₁), Y₄ est C(R₄₄), Y₅ est C(R₄₅), Y₆ est N, Y₇ est C(R₄₇), et Y₈ est C(R₄₈);
dans les Formules 2A-1, 2A-2, 2A-4, 2A-5, 2A-6, 2A-8, 2A-9, 2A-10, 2A-12, 2A-13, 2A-14 et 2A-16, Y₁ est N, Y₄ est C(R₄₄), Y₅ est N, Y₆ est C(R₄₆), Y₇ est C(R₄₇), et Y₈ est C(R₄₈) ;
dans les Formules 2A-1, 2A-2, 2A-4, 2A-5, 2A-6, 2A-8, 2A-9, 2A-10, 2A-12, 2A-13, 2A-14 et 2A-16, Y₁ est N, Y₄ est C(R₄₄), Y₅ est C(R₄₅), Y₆ est N, Y₇ est C(R₄₇), et Y₈ est C(R₄₈) ;
dans les Formules 2A-3, 2A-7, 2A-11 et 2A-15, Y₃ est N, Y₄ est C(R₄₄), Y₅ est C(R₄₅), Y₆ est C(R₄₆), Y₇ est C(R₄₇), et Y₈ est C(R₄₈);
dans les Formules 2A-3, 2A-7, 2A-11, et 2A-15, 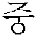 Y₃ est C(R₄₃), Y₄ est C(R₄₄), Y₅ est N, Y₆ est C(R₄₆), Y₇ est C(R₄₇), et Y₈ est C(R₄₈);
dans les Formules 2A-3, 2A-7, 2A-11 et 2A-15, Y₃ est C(R₄₃), Y₄ est C(R₄₄), Y₅ est C(R₄₅), Y₆ est N, Y₇ est C(R₄₇), et Y₈ est C(R₄₈);
dans les Formules 2A-3, 2A-7, 2A-11 et 2A-15, 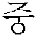 Y₃ est N, Y₄ est C(R₄₄), Y₅ est N, Y₆ est C(R₄₆), Y₇ est C(R₄₇), et Y₈ est C(R₄₈); ou
dans les Formules 2A-3, 2A-7, 2A-11 et 2A-15, Y₃ est N, Y₄ est C(R₄₄), Y₅ est C(R₄₅), Y₆ est N, Y₇ est C(R₄₇), et Y₈ est C(R₄₈)

8. Composé organométallique selon l'une quelconque des revendications 1-6, dans lequel :
L₁ dans la Formula 1 est sélectionné entre les groupes représentés par les Formules 2AA-1, 2AA-2, 2AA-3, 2AA-4 et 2AB ci-dessous : 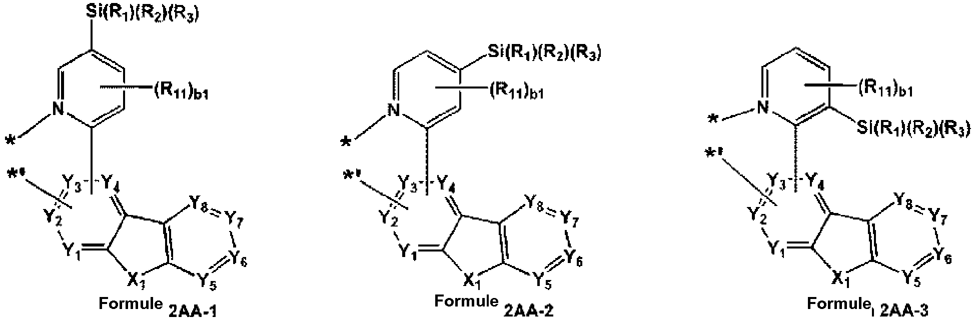 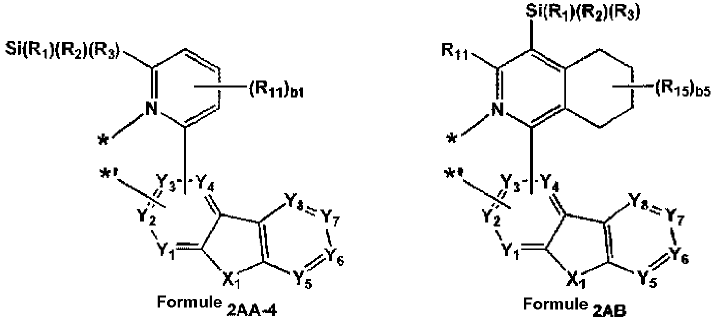
dans les Formules 2AA-1, 2AA-2, 2AA-3, 2AA-4 et 2AB,
R₁ à R₃ sont chacun indépendamment sélectionnés entre
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H et -CD₂CDH₂ ;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, un groupe naphthyle et -Si(Q₅₁)(Q₅₂)(Q₅₃) ; et
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle et un groupe naphthyle, chacun substitué avec au moins un élément sélectionné entre un deutérium et un groupe alkyle C₁-C₁₀,
Q₅₁ à Q₅₃ sont chacun indépendamment sélectionnés entre
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H et -CD₂CDH₂ ;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle et un groupe naphthyle ; et
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle et un groupe naphthyle, chacun substitué avec au moins un élément sélectionné entre un deutérium, un groupe alkyle C₁-C₁₀ et un groupe phényle,
X₁ est sélectionné entre O, S, S(=O)₂, N(R₂₁) et Si(R₂₂)(R₂₃),
les descriptions de Y₁ à Y₈ sont les mêmes que dans la revendication 1,
R₁₁, R₁₅, et R₂₁ à R₂₃ sont chacun indépendamment sélectionnés entre
un hydrogène, un deutérium, -F, un groupe cyano, un groupe nitro, -SF₅, un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe n-hexyle, un groupe isohexyle, un groupe sec-hexyle, un groupe tert-hexyle, un groupe n-heptyle, un groupe isoheptyle, un groupe sec-heptyle, un groupe tert-heptyle, un groupe n-octyle, un groupe isooctyle, un groupe sec-octyle, un groupe tert-octyle, un groupe n-nonyle, un groupe isononyle, un groupe sec-nonyle, un groupe tert-nonyle, un groupe n-décyle, un groupe isodécyle, un groupe sec-décyle, un groupe tert-décyle, un groupe méthoxy, un groupe éthoxy, un groupe propoxy, un groupe butoxy, un groupe pentoxy, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe pyridinyle et un groupe pyrimidinyle ;
un groupe méthyle, un groupe éthyle, un groupe n-propyle, un groupe isopropyle, un groupe n-butyle, un groupe isobutyle, a un groupe sec-butyle, un groupe tert-butyle, un groupe n-pentyle, un groupe isopentyle, un groupe sec-pentyle, un groupe tert-pentyle, un groupe n-hexyle, un groupe isohexyle, un groupe sec-hexyle, un groupe tert-hexyle, un groupe n-heptyle, un groupe isoheptyle, un groupe sec-heptyle, un groupe tert-heptyle, un groupe n-octyle, un groupe isooctyle, un groupe sec-octyle, un groupe tert-octyle, un groupe n-nonyle, un groupe isononyle, un groupe sec-nonyle, un groupe tert-nonyle, un groupe n-décyle, un groupe isodécyle, un groupe sec-décyle, un groupe tert-décyle, un groupe méthoxy, un groupe éthoxy, un groupe propoxy, un groupe butoxy, un groupe pentoxy, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe pyridinyle et un groupe pyrimidinyle, chacun substitué avec au moins un élément sélectionné entre : un deutérium, -F, -CD₃, -CD₂H, -CDH₂, -CF₃, -CF₂H, -CFH₂, un groupe cyano, un groupe nitro, un groupe alkyle C₁-C₁₀, un groupe alkoxy C₁-C₁₀, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe pyridinyle et un groupe pyrimidinyle ; et
-B(Q₆)(Q₇) et -P(=O)(Q₈)(Q₉),
où Q₆ à Q₉ sont chacun indépendamment sélectionnés entre
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H et -CD₂CDH₂ ;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle et un groupe naphthyle ; et
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle et un groupe phényle, et un groupe naphthyle, chacun substitué avec au moins un élément sélectionné entre un deutérium et un groupe alkyle C₁-C₁₀,
b5 est un nombre entier sélectionné de 0 à 8, et
* et *' sont des sites de liaison à M dans la Formule 1.

9. Composé organométallique selon l'une quelconque des revendications 1 -6, dans lequel :
L₁ est sélectionné entre des ligands représentés par les Formules 2A(1) à 2A(40) : 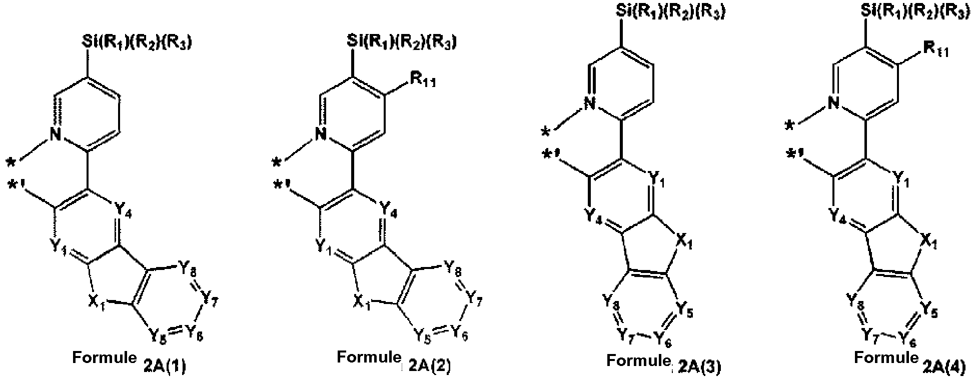 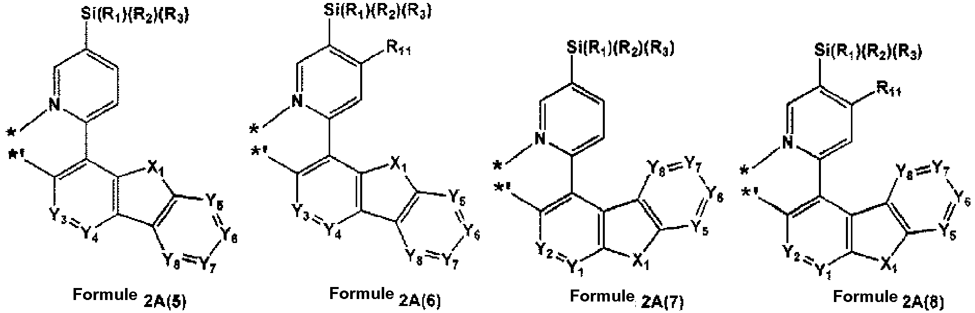 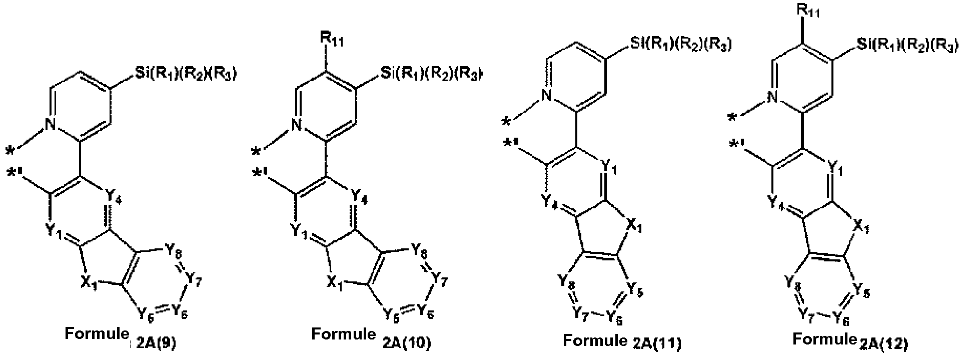 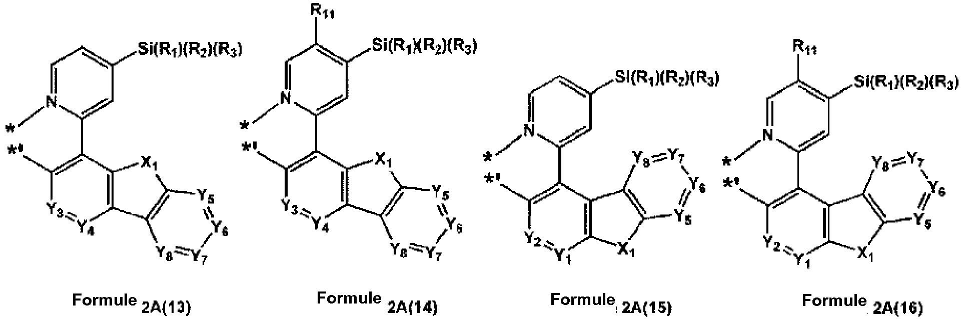 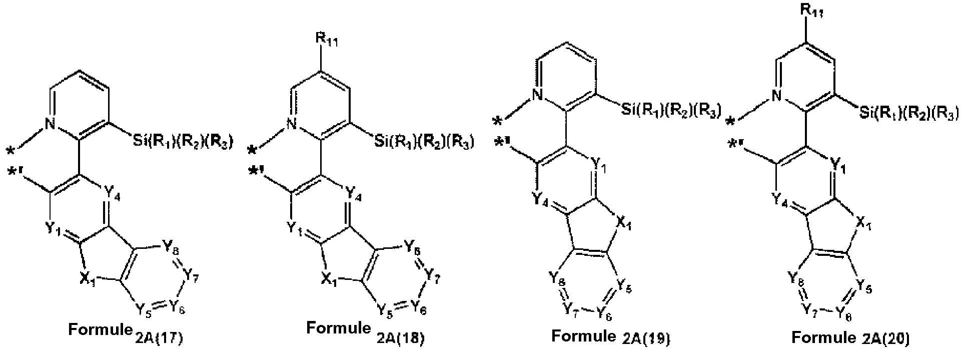 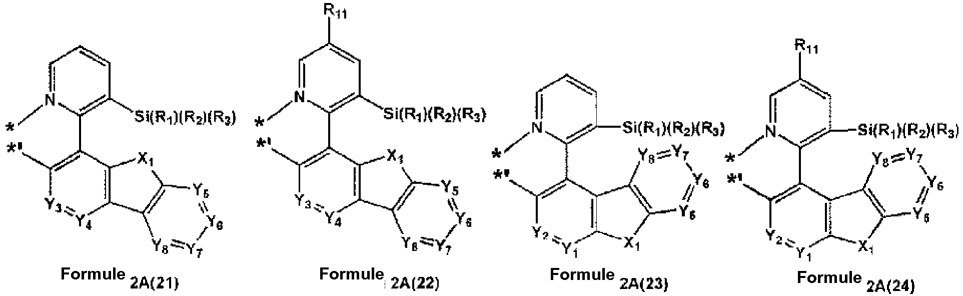 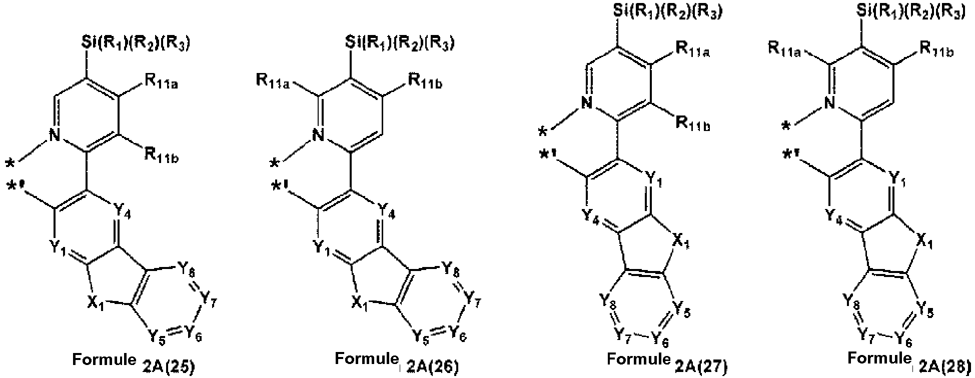 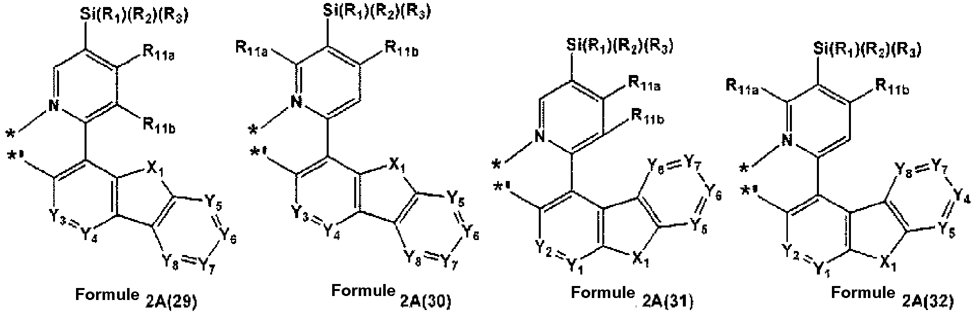 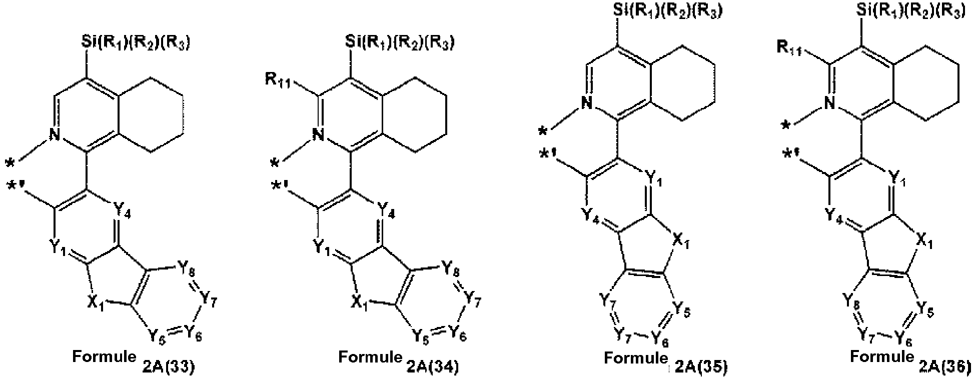 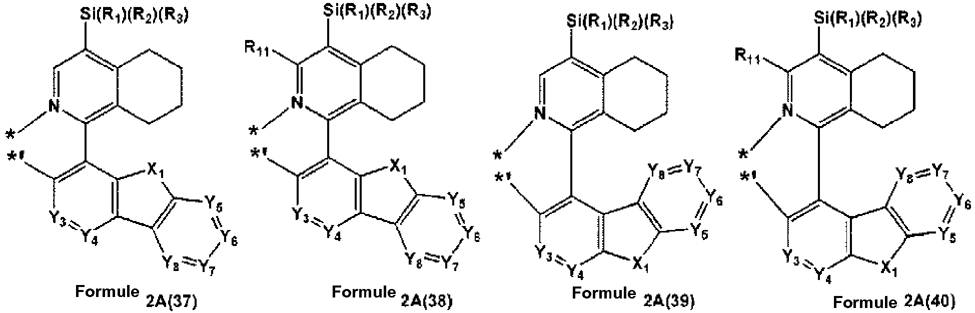
où, dans les Formules 2A(1) à 2A(40), les descriptions de R₁ à R₃, X₁, Y₁ à Y₈, et R₁₁ sont les mêmes que dans la revendication 1, R₁₁ₐ et R_{11b} sont compris par référence à la description de R₁₁, étant entendu que R₁₁, R₁₁ₐ et R_{11b} ne sont pas l'hydrogène, et que chacun de *et*' est un site de liaison à M dans la Formule 1.

10. Composé organométallique selon l'une quelconque des revendications 1-9, dans lequel L₂ dans la Formule 1 est sélectionné entre des ligands représentés par les formules 3A à 3G : 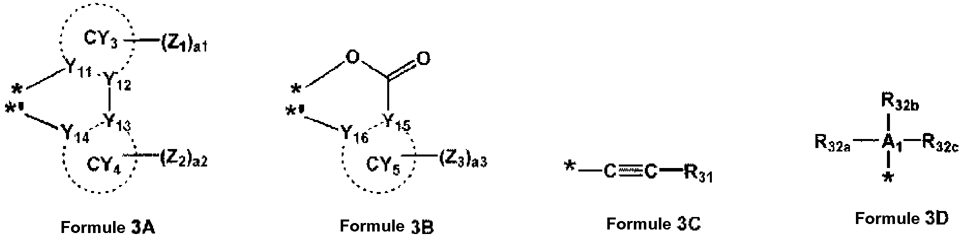 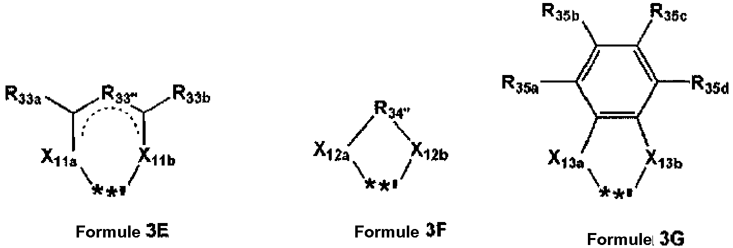
où, dans les Formules 3A à 3G,
Y₁₁ à Y₁₆ sont chacun indépendamment C ou N, Y₁₁ et Y₁₂ sont liés l'un à l'autre par une liaison simple ou une liaison double, Y₁₃ et Y₁₄ sont liés l'un à l'autre par une liaison simple ou une liaison double, et Y₁₅ et Y₁₆ sont liés l'un à l'autre par une liaison simple ou une liaison double,
CY₃ à CY₅ sont chacun indépendamment sélectionnés entre un groupe carbocyclique C₅-C₆₀ et un groupe hétérocyclique C₂-C₆₀.
a1 à a3 sont chacun indépendamment un nombre entier sélectionné de 1 à 5 ;
A₁ est P ou As ;
X₁₁ₐ, X_{11b}, X₁₂ₐ, X_{12b}, X₁₃ₐ, et X_{13b} sont chacun indépendamment sélectionnés entre N, O, N(R₃₄), P(R₃₅)(R₃₆) et As(R₃₇)(R₃₈), étant entendu qu'aucun de X₁₂ₐ, X_{12b}, X₁₃ₐ et X_{13b} n'est N ou O;
R_{33"} et R_{34"} sont chacun indépendamment sélectionnés entre une liaison simple, une liaison double, un groupe alkylène C₁-C₅ substitué ou non substitué, un groupe alkénylène C₂-C₅ substitué ou non substitué et un groupe arylène C₆-C₁₀ substitué ou non substitué ;
Z₁ à Z₃, R₃₁, R₃₂ₐ, R_{32b}, R_{32c}, R₃₃ₐ, R_{33b}, R₃₄ to R₃₈, R₃₅ₐ, R_{35b}, R_{35c}, et R_{35d} sont chacun indépendamment sélectionnés entre un hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle C₁-C₆₀ substitué ou non substitué, un groupe alkényle C₂-C₆₀ substitué ou non substitué, un groupe alkynyle C₂-C₆₀ substitué ou non substitué, un groupe alkoxy C₁-C₆₀ substitué ou non substitué, un groupe cycloalkyle C₃-C₁₀ substitué ou non substitué, un groupe hétérocycloalkyle C₁-C₁₀ substitué ou non substitué, un groupe cycloalkényle C₃-C₁₀ substitué ou non substitué, un groupe hétérocycloalkényle C₁-C₁₀ substitué ou non substitué, un groupe aryle C₆-C₆₀ substitué ou non substitué, un groupe aryloxy C₆-C₆₀ substitué ou non substitué, un groupe arylthio C₆-C₆₀ substitué ou non substitué, un groupe hétéroaryle C₁-C₆₀ substitué ou non substitué, un groupe polycyclique condensé non aromatique monovalent substitué ou non substitué, un groupe hétéropolycyclique condensé non aromatique monovalent substitué ou non substitué, -N(Q₁)(Q₂), -Si(Q₃)(Q₄)(Q₅), -B(Q₆)(Q₇) et -P(=O)(Q₈)(Q₉),
* et *' indiquent chacun des sites de liaison à M dans la Formule 1 ;
au moins l'un des substituants du groupe alkylène C₁-C₅ substitué, du groupe alkénylène C2- substitué, du groupe arylène C₆-C₁₀ substitué, du groupe alkyle C₁-C₆₀ substitué, du groupe alkényle C₂-C₆₀ substitué, du groupe alkynyle C₂-C₆₀ substitué, du groupe C₁-C₆₀ substitué, du groupe cycloalkyle C₃-C₁₀ substitué, du groupe hétérocycloalkyle C₁-C₁₀ substitué, du groupe cycloalkényle C₃-C₁₀ substitué, du groupe hétérocycloalkényle C₁-C₁₀ substitué, du groupe aryle C₆-C₆₀ substitué, du groupe aryloxy C₆-C₆₀ substitué, du groupe arylthio C₆-C₆₀ substitué, du groupe hétéroaryle C₁-C₆₀ substitué, du groupe polycyclique condensé non aromatique monovalent substitué et du groupe hétéropolycyclique condensé non aromatique monovalent substitué est sélectionné entre
un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle C₁-C₆₀, un groupe alkényle C₂-C₆₀, un groupe alkynyle C₂-C₆₀ et un groupe alkoxy C₁-C₆₀;
un groupe alkyle C₁-C₆₀, un groupe alkényle C₂-C₆₀, un groupe alkynyle C₂-C₆₀, et un groupe alkoxy C₁-C₆₀, chacun substitué avec au moins un élément sélectionné entre : un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle C₃-C₁₀, un groupe hétérocycloalkyle C₁-C₁₀, un groupe cycloalkényle C₃-C₁₀, un groupe hétérocycloalkényle C₁-C₁₀, un groupe aryle C₆-C₆₀, un groupe aryloxy C₆-C₆₀, un groupe arylthio C₆-C₆₀, un groupe hétéroaryle C₁-C₆₀, un groupe polycyclique condensé non aromatique monovalent, un groupe hétéropolycyclique condensé non aromatique monovalent, -N(Q₁₁)(Q₁₂), -Si(Q₁₃)(Q₁₄)(Q₁₅), -B(Q₁₆)(Q₁₇) et -P(=O)(Q₁₈)(Q₁₉) ;
un groupe cycloalkyle C₃-C₁₀, un groupe hétérocycloalkyle C₁-C₁₀, un groupe cycloalkényle C₃-C₁₀, un groupe hétérocycloalkényle C₁-C₁₀, un groupe aryle C₆-C₆₀, un groupe aryloxy C₆-C₆₀, un groupe arylthio C₆-C₆₀, un groupe hétéroaryle C₁-C₆₀, un groupe polycyclique condensé non aromatique monovalent et un groupe hétéropolycyclique condensé non aromatique monovalent ;
un groupe cycloalkyle C₃-C₁₀, un groupe hétérocycloalkyle C₁-C₁₀, un groupe cycloalkényle C₃-C₁₀, un groupe hétérocycloalkényle C₁-C₁₀, un groupe aryle C₆-C₆₀, un groupe aryloxy C₆-C₆₀, un groupe arylthio C₆-C₆₀, un groupe hétéroaryle C₁-C₆₀, un groupe polycyclique condensé non aromatique monovalent et un groupe hétéropolycyclique condensé non aromatique monovalent, chacun substitué avec au moins un élément sélectionné entre : un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel ce celui-ci, un groupe alkyle C₁-C₆₀, un groupe alkényle C₂-C₆₀, un groupe alkynyle C₂-C₆₀, un groupe alkoxy C₁-C₆₀, un groupe cycloalkyle C₃-C₁₀, un groupe hétérocycloalkyle C₁-C₁₀, un groupe cycloalkényle C₃-C₁₀, un groupe hétérocycloalkényle C₁-C₁₀, un groupe aryle C₆-C₆₀, un groupe aryloxy C₆-C₆₀, un groupe arylthio C₆-C₆₀, un groupe hétéroaryle C₁-C₆₀, un groupe polycyclique condensé non aromatique monovalent, un groupe hétéropolycyclique condensé non aromatique monovalent, -N(Q₂₁)(Q₂₂), -Si(Q₂₃)(Q₂₄)(Q₂₅), -B(Q₂₆)(Q₂₇) et -P(=O)(Q₂₈)(Q₂₉), et
-N(Q₃₁)(Q₃₂), -Si(Q₃₃)(Q₃₄)(Q₃₅), -B(Q₃₆)(Q₃₇), et -P(=O)(Q₃₈)(Q₃₉) ;
où Q₁ à Q₉, Q₁₁ à Q₁₉, Q₂₁ à Q₂₉, et Q₃₁ à Q₃₉ sont chacun indépendamment sélectionnés entre : un hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle C₁-C₆₀ substitué ou non substitué, un groupe alkényle C₂-C₆₀ substitué ou non substitué, un groupe alkynyle C₂-C₆₀ substitué ou non substitué, un groupe alkoxy C₁-C₆₀ substitué ou non substitué, un groupe cycloalkyle C₃-C₁₀ substitué ou non substitué, un groupe hétérocycloalkyle C₁-C₁₀ substitué ou non substitué, un groupe cycloalkényle C₃-C₁₀ substitué ou non substitué, un groupe hétérocycloalkényle C₁-C₁₀ substitué ou non substitué, un groupe aryle C₆-C₆₀ substitué ou non substitué, un groupe aryloxy C₆-C₆₀ substitué ou non substitué, un groupe arylthio C₆-C₆₀ substitué ou non substitué, un groupe hétéroaryle C₁-C₆₀ substitué ou non substitué, un groupe polycyclique condensé non aromatique monovalent substitué ou non substitué, et un groupe hétéropolycyclique condensé non aromatique monovalent substitué ou non substitué.

11. Composé organométallique selon l'une quelconque des revendications 1-9, dans lequel : L₂ dans la Formule 1 est sélectionné entre des ligands représentés par les Formules 3-1 à 3-111 : 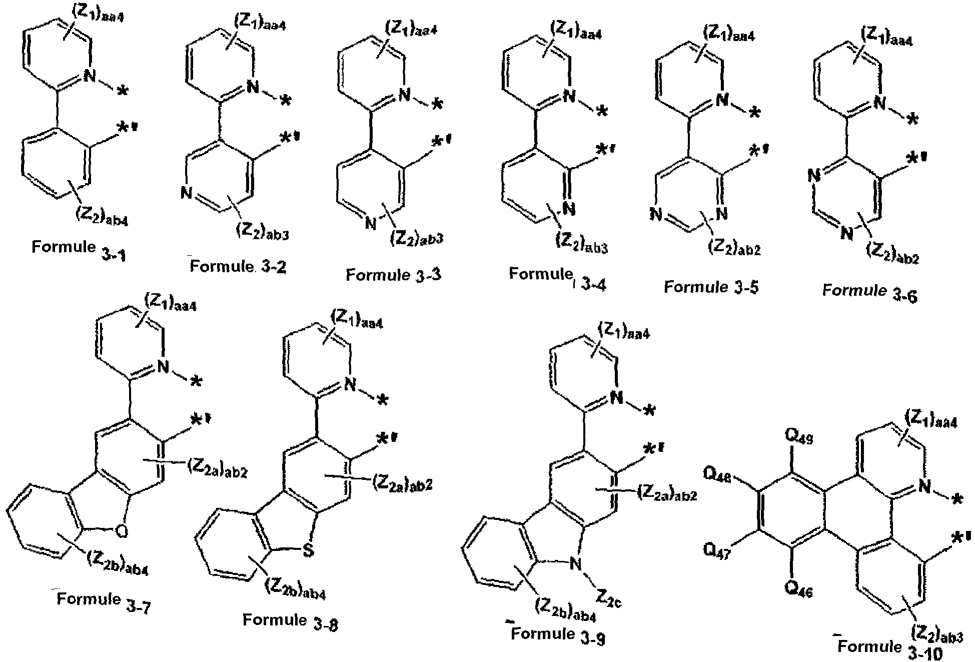 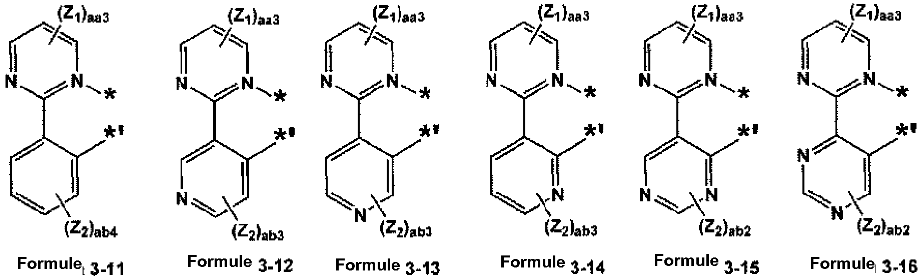 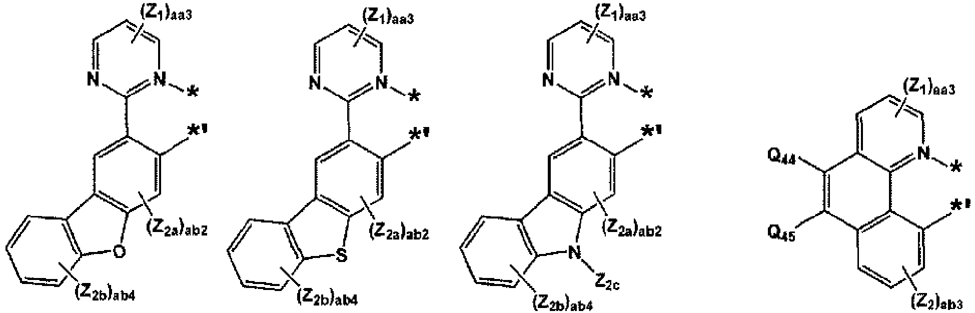 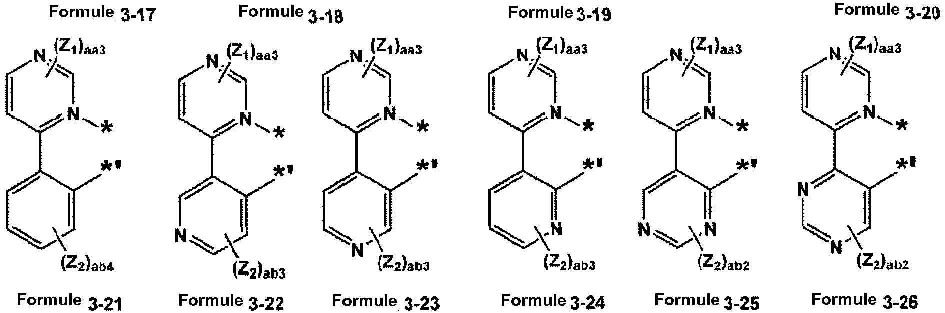 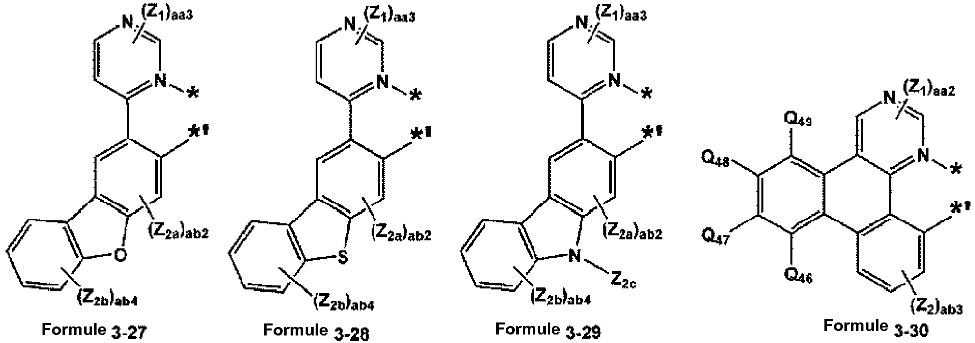 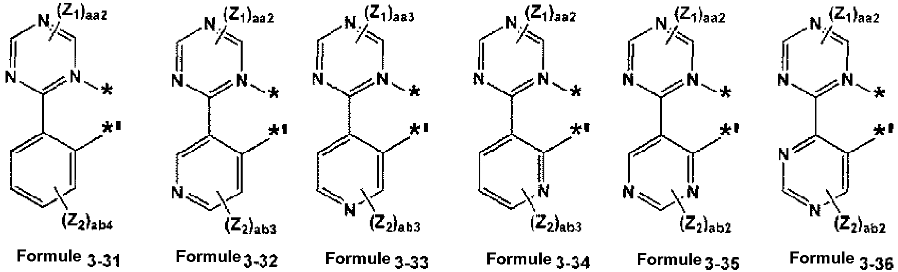 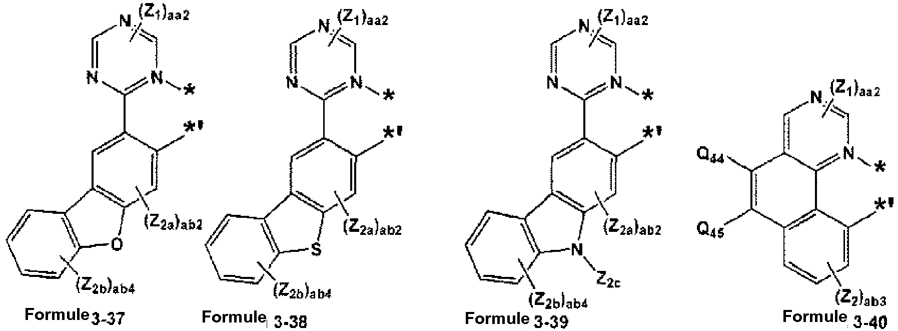 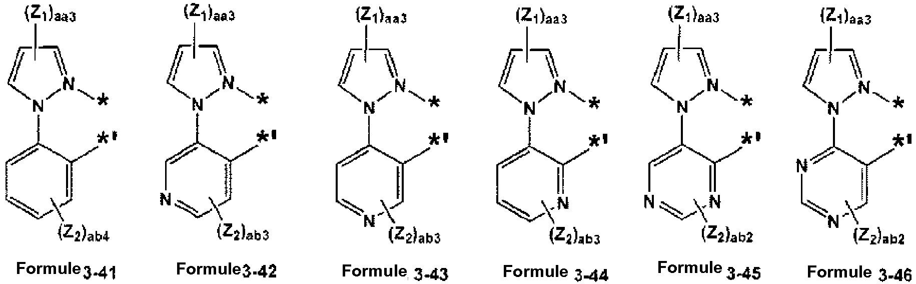 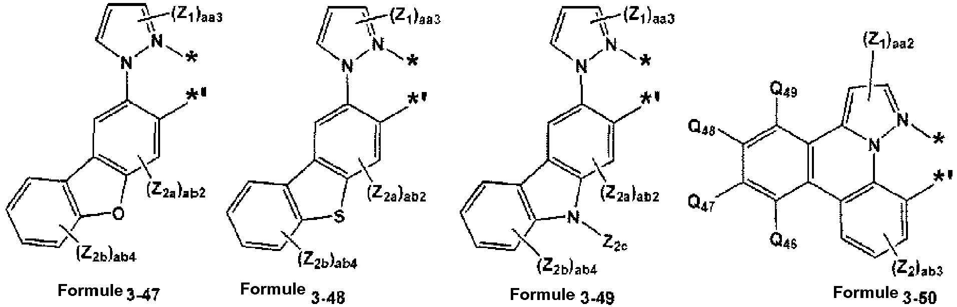 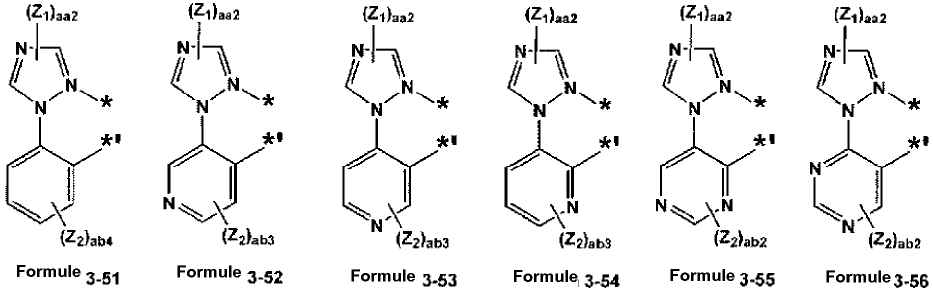 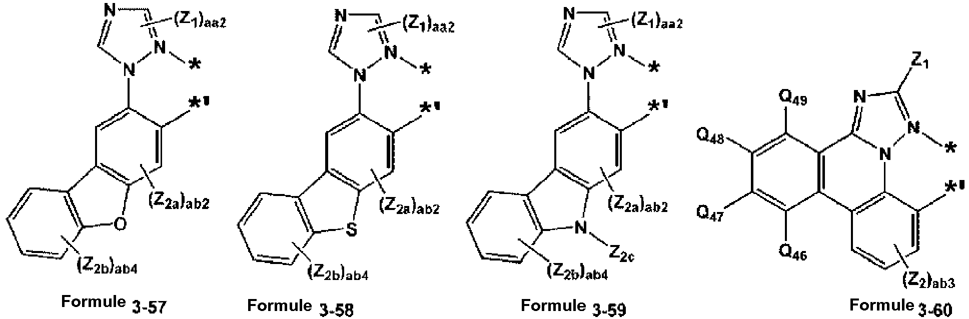 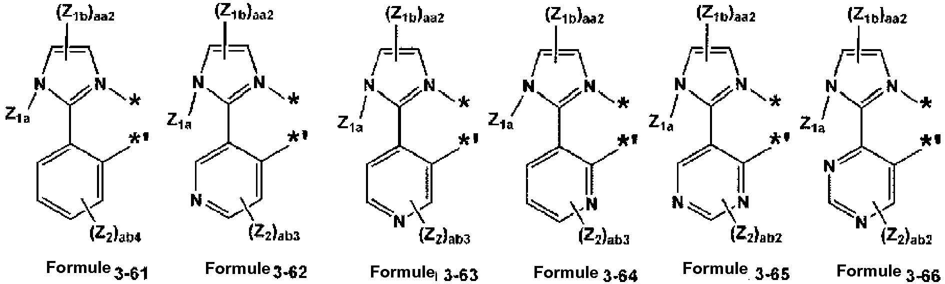 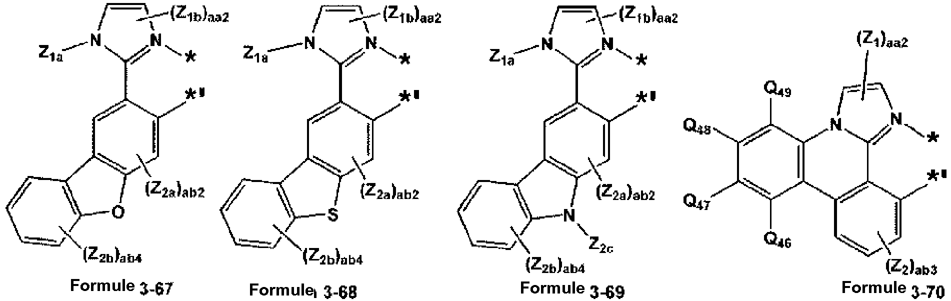 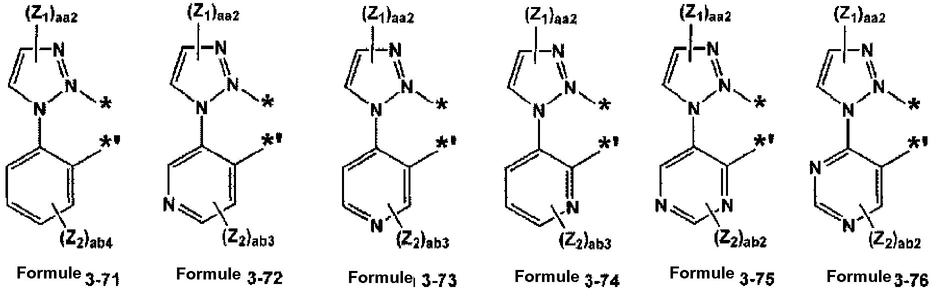 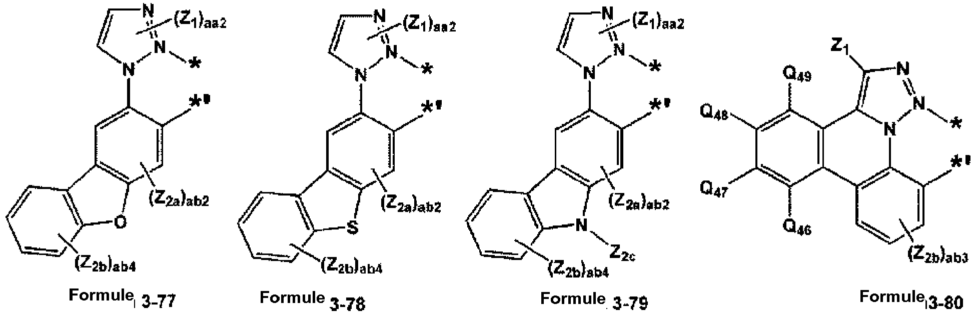 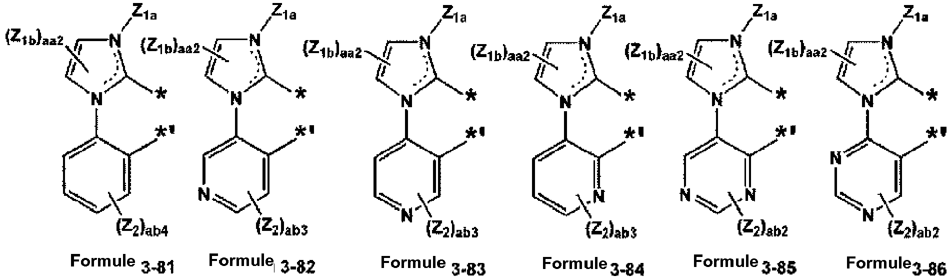 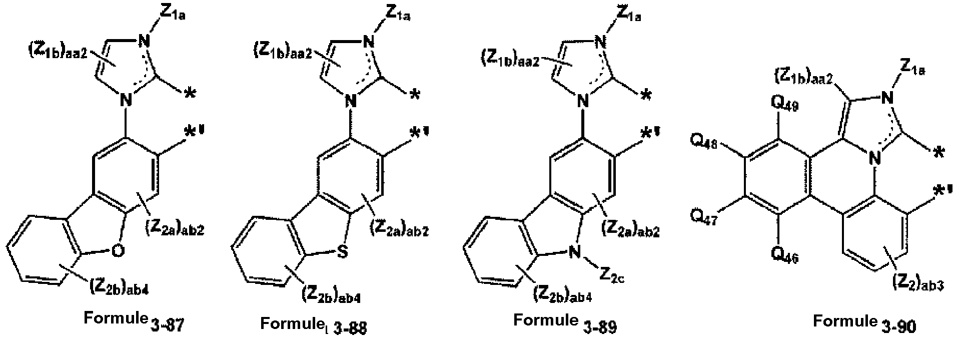 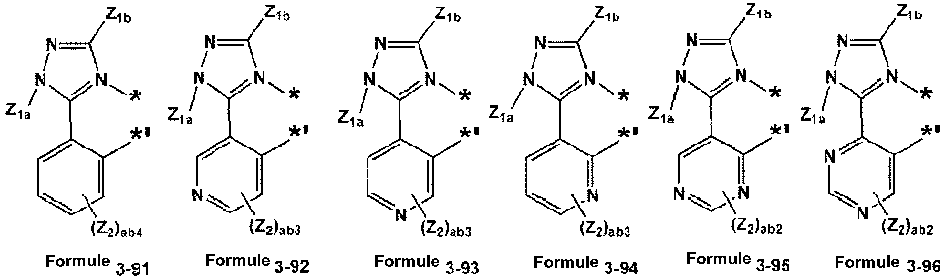 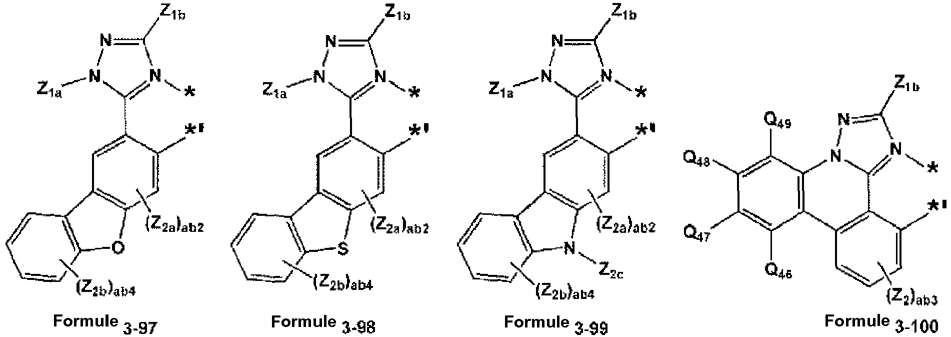 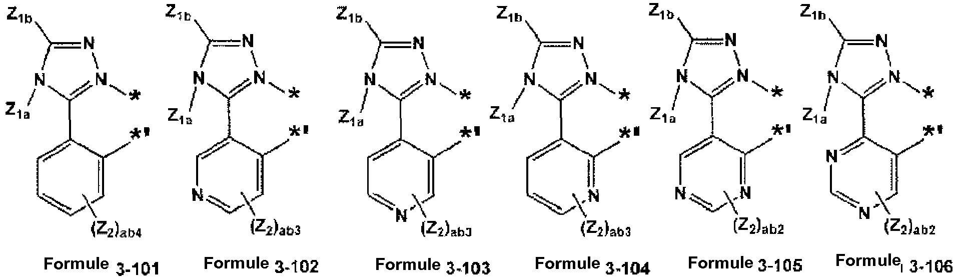 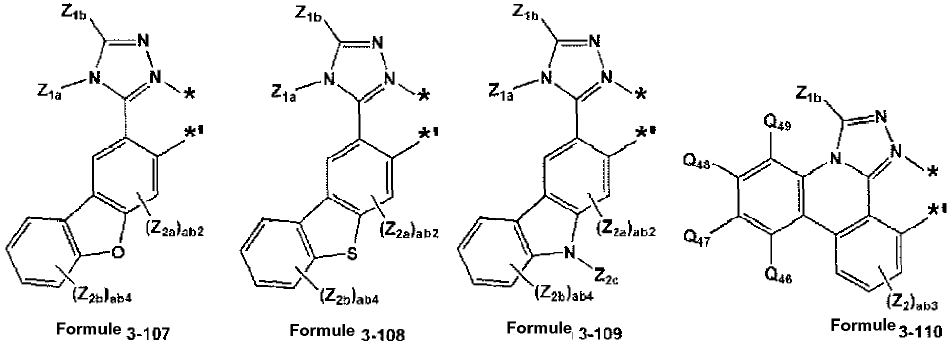 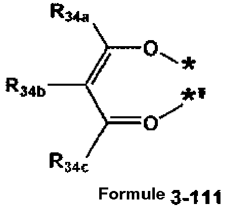
où, dans les Formules 3-1 à 3-111,
Z₁, Z₂, Z₁ₐ, Z_{1b}, Z₂ₐ, Z_{2b}, Z_{2c}, R₃₄ₐ, R_{34b}, et R_{34c} sont chacun indépendamment sélectionnés entre
un hydrogène, un, deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, -SF₅, un groupe alkyle C₁-C₂₀, et un groupe alkoxy C₁-C₂₀;
un groupe alkyle C₁-C₂₀ et un groupe alkoxy C₁-C₂₀, chacun substitué avec au moins un élément sélectionné entre : un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle C₁-C₁₀, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe pyridinyle et un groupe pyrimidinyle ;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzoïmidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle et un groupe imidazopyrimidinyle ;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzoïmidazolyle, un groupe benzofuranyle, un groupe benzothiophényle, un groupe isobenzothiazolyle, un groupe benzoxazolyle, un groupe isobenzoxazolyle, un groupe triazolyle, un groupe a tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle et un groupe imidazopyrimidinyle, chacun substitué avec au moins un élément sélectionné entre : un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe sulfonique ou un sel de celui-ci, un groupe acide phosphorique ou un sel de celui-ci, un groupe alkyle C₁-C₂₀, un groupe alkoxy C₁-C₂₀, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzoïmidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe, un groupe dibenzofuranyle, un groupe dibenzothiophényle, un groupe benzocarbazolyle, un groupe dibenzocarbazolyle, un groupe imidazopyridinyle et un groupe imidazopyrimidinyle ; et
-N(Q₁)(Q₂), -Si(Q₃)(Q₄)(Q₅), -B(Q₆)(Q₇) et -P(=O)(Q₈)(Q₉) ;
Q₁ à Q₉ et Q₄₄ à Q₄₉ sont chacun indépendamment sélectionnés entre
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H et -CD₂CDH₂ ;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle et un groupe naphthyle ; et
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle et un groupe phényle, et un groupe naphthyle, chacun substitué avec un élément sélectionné entre un deutérium et un groupe alkyle C₁-C₁₀,
aa2 et ab2 sont chacun indépendamment 1 ou 2,
aa3 et ab3 sont chacun indépendamment sélectionnés entre 1, 2 et 3,
aa4 et ab4 sont chacun indépendamment sélectionnés entre 1, 2, 3 et 4, et
* et *' indiquent chacun des sites de liaison à M dans la Formule 1 ;
où, de préférence :
L₂ dans la Formule 1 est sélectionné entre des ligands représentés par les Formules 3-1(1) à 3-1(59), et 3- 111 : 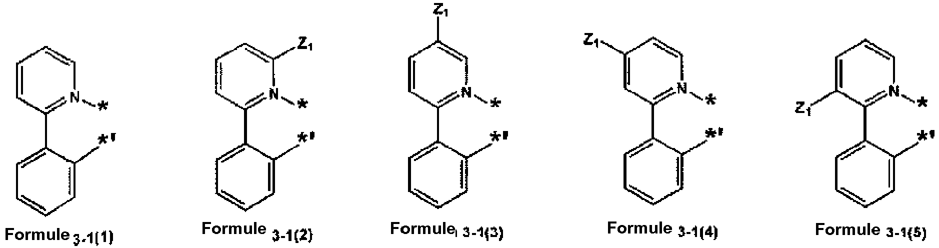 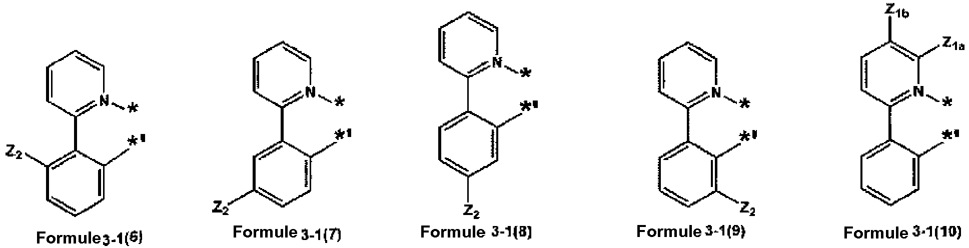 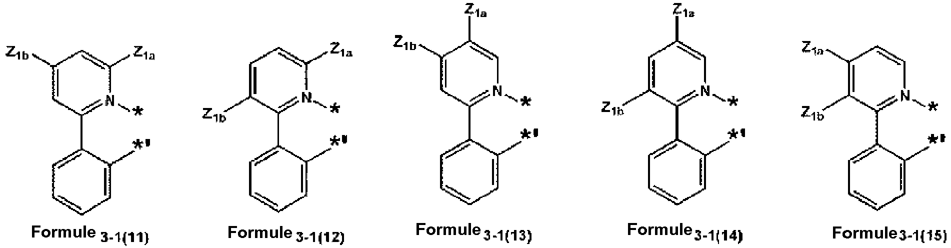 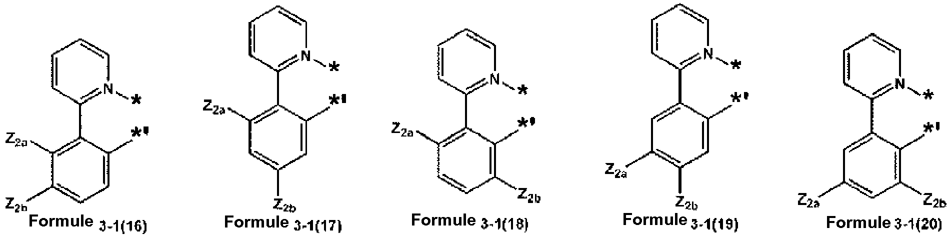 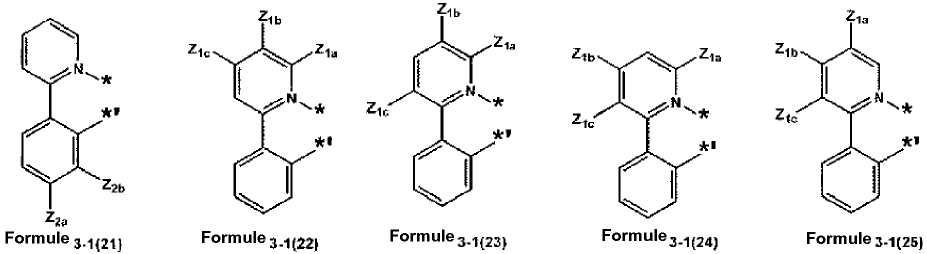 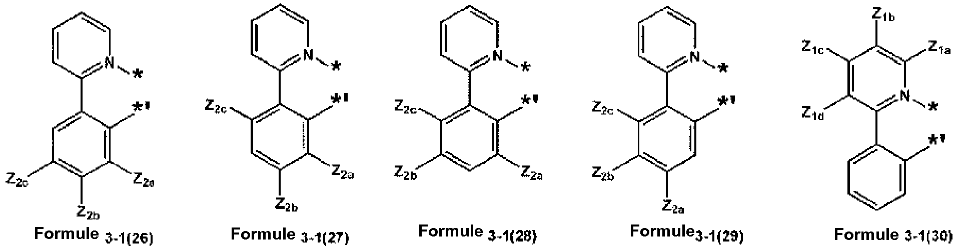 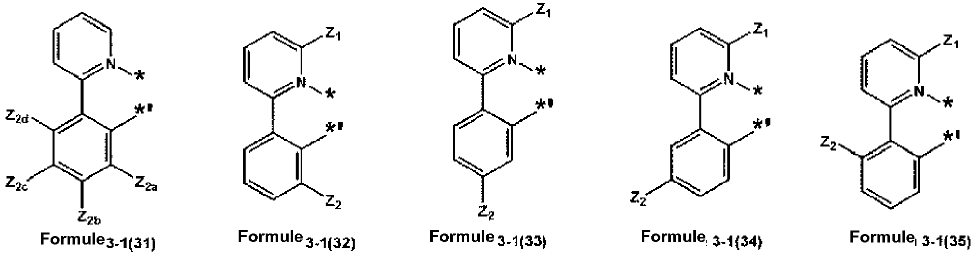 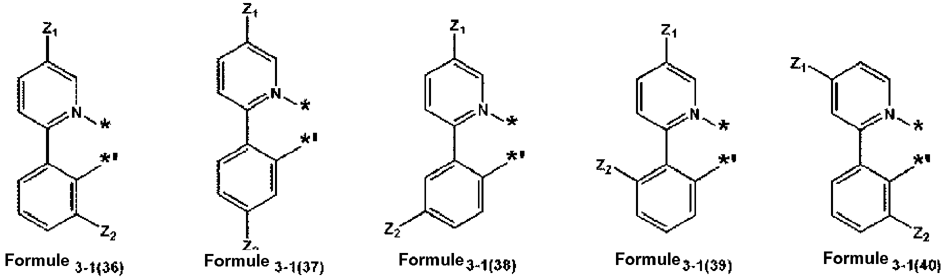 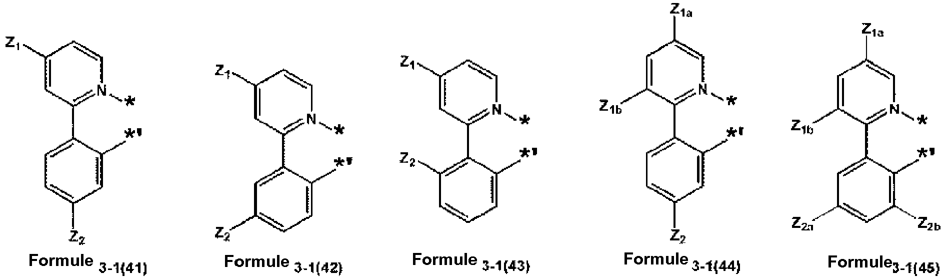 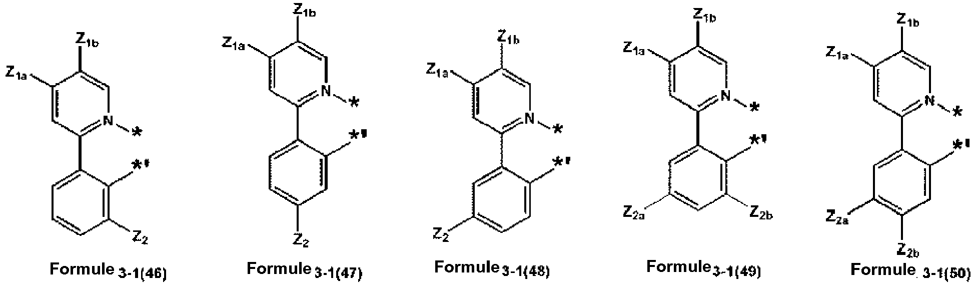 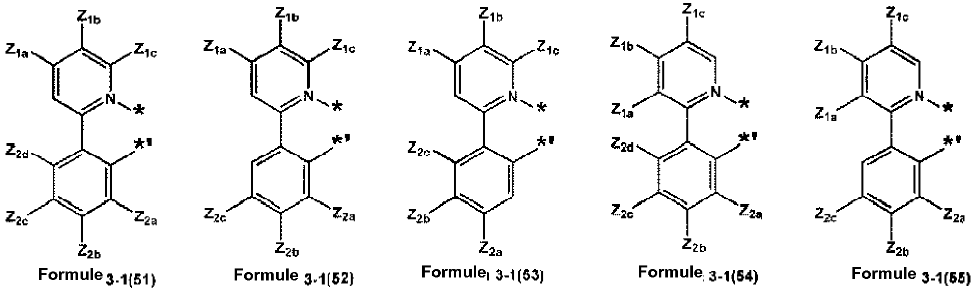 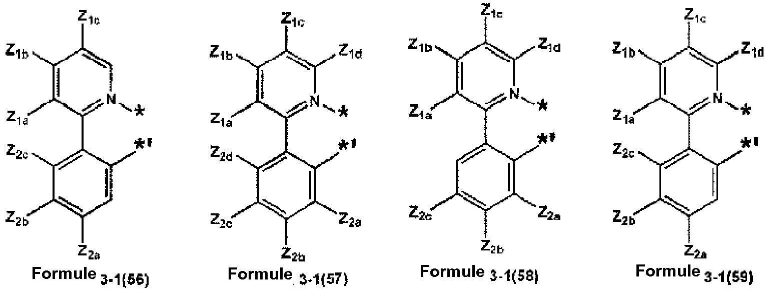 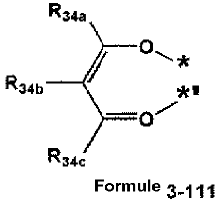
où, dans les Formules 3-1 (1) à 3-1 (59) et la Formule 3-111 :
Z₁, Z₂, Z₁ₐ, Z_{1b}, Z_{1c}, Z_{1d}, Z₂ₐ, Z_{2b}, Z_{2c}, Z_{2d}, R₃₄ₐ, R_{34b}, et R_{34c} sont chacun indépendamment sélectionnés entre : un deutérium, -F, un groupe cyano, un groupe nitro, -SF₅, -CH₃, - CD₃, -CD₂H, -CDH₂, -CF₃, -CF₂H, -CFH₂, -Si(Q₃)(Q₄)(Q₅), les groupes représentés par les Formules 9-1 à 9-17 et les groupes représentés par les Formules 10-1 à 10-30,
Q₃ à Q₅ sont chacun indépendamment sélectionnés entre
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H et-CD₂CDH₂ ;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle et un groupe naphthyle ; et
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle et un groupe phényle, chacun substitué avec au moins un élément sélectionné entre un deutérium et un groupe alkyle C₁-C₁₀, et
* et *' sont des sites de liaison à M dans la Formule 1, 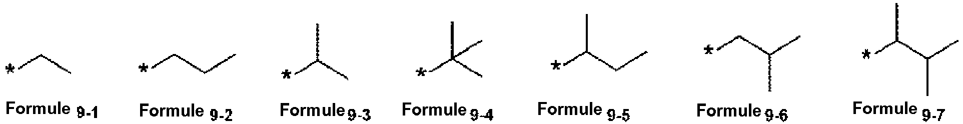 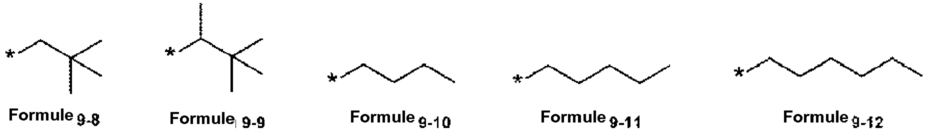 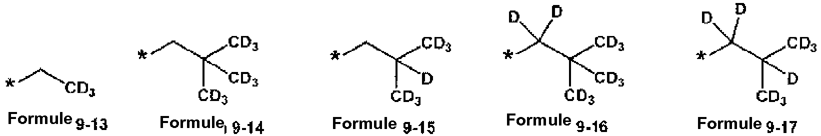 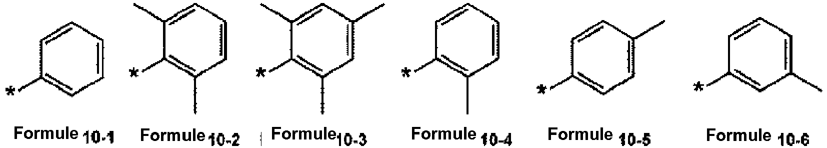 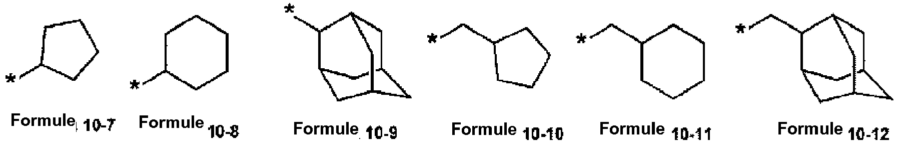 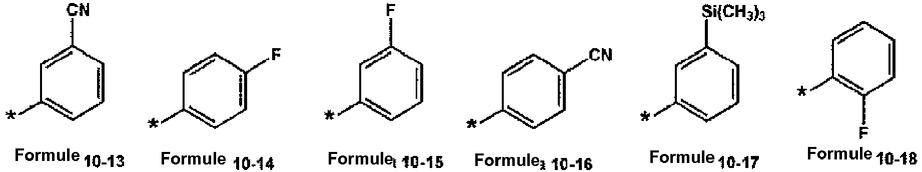 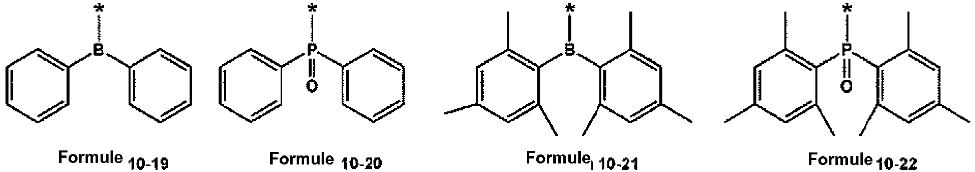 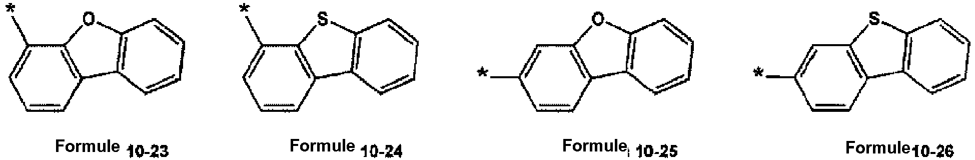 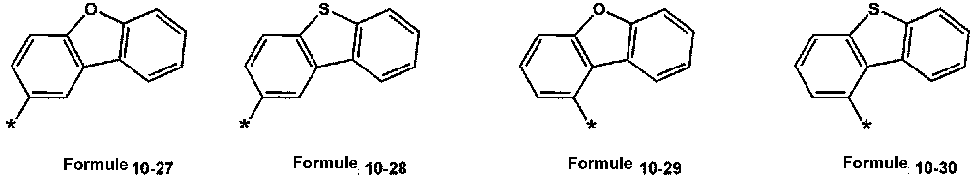
où, dans les Formules 9-1 à 9-17 et 10-1 à 10-30, * est un site de liaison à un atome voisin.

12. Composé organométallique selon la revendication 1, le composé organométallique étant l'un des composés 1 à 481 :

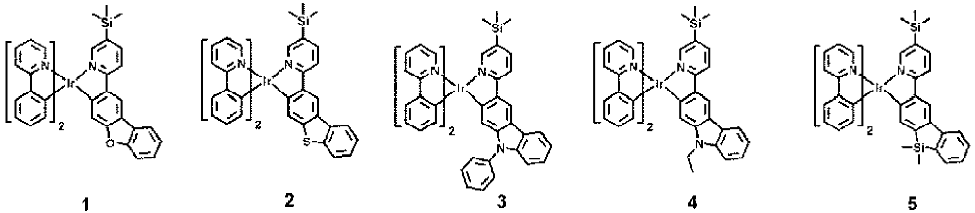

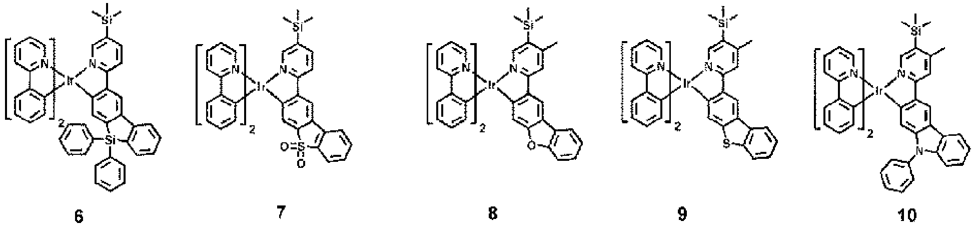

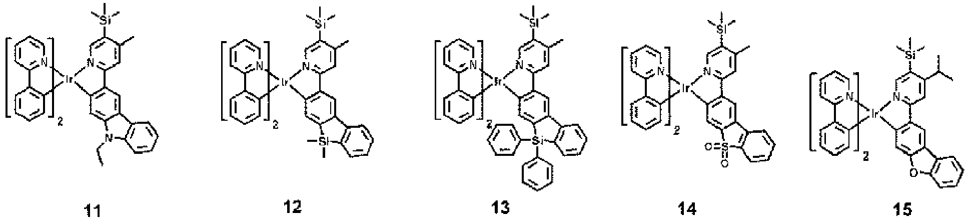

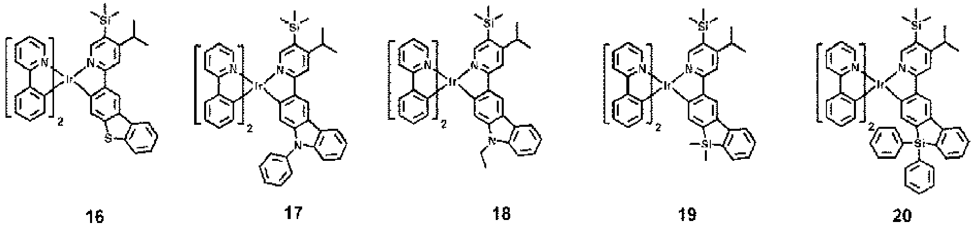

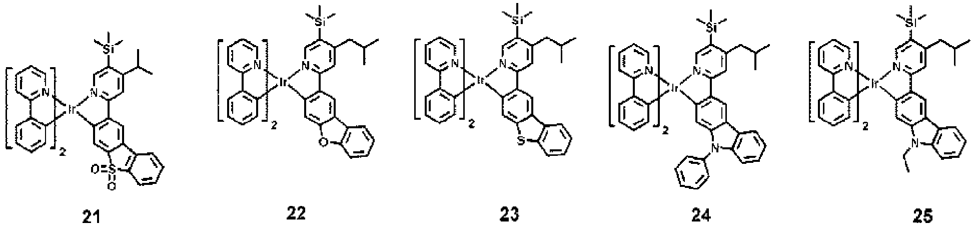

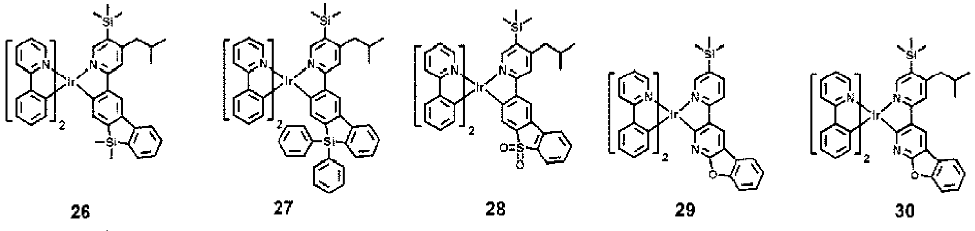

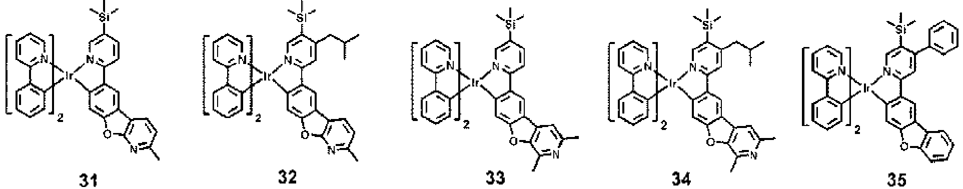

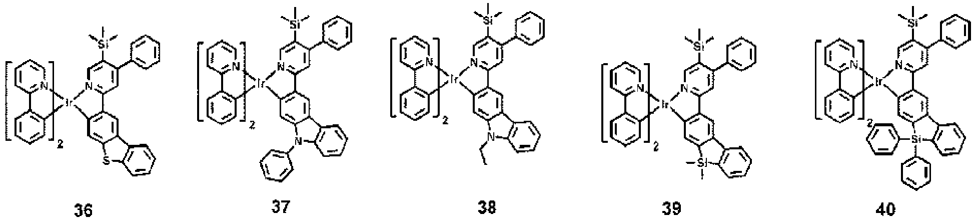

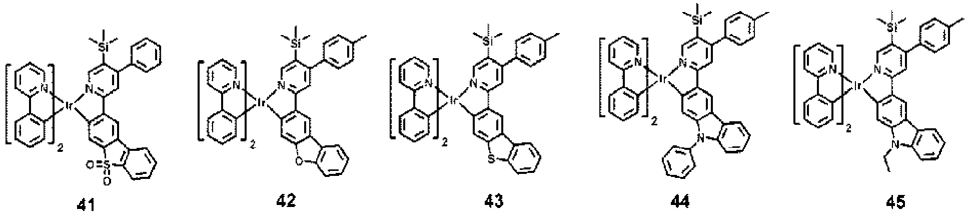

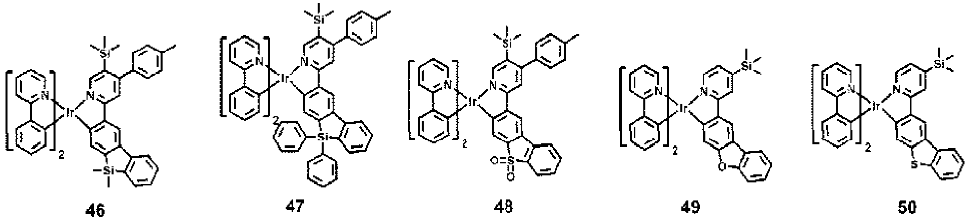

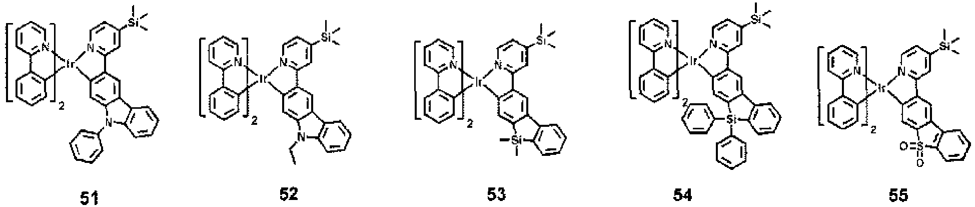

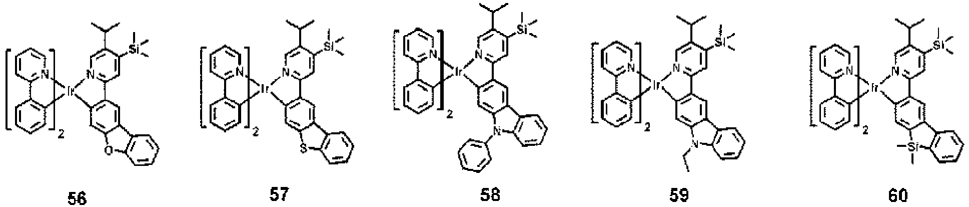

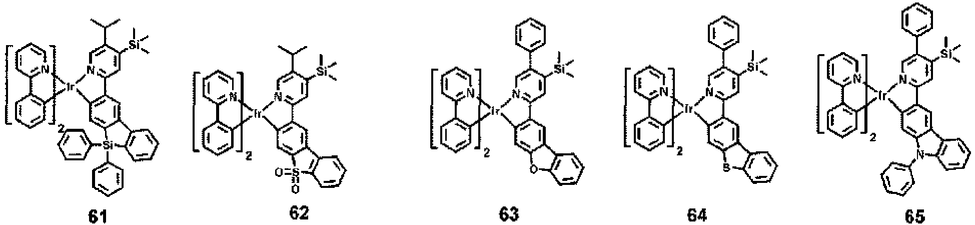

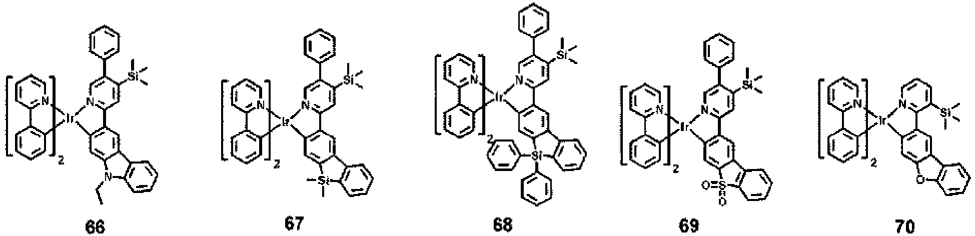

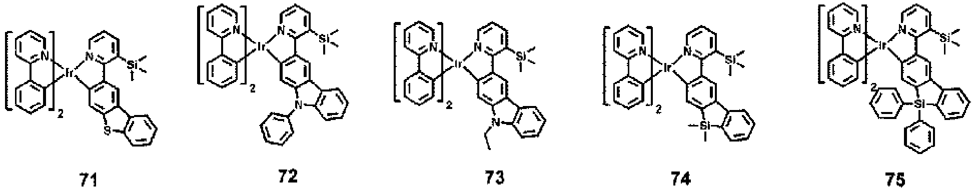

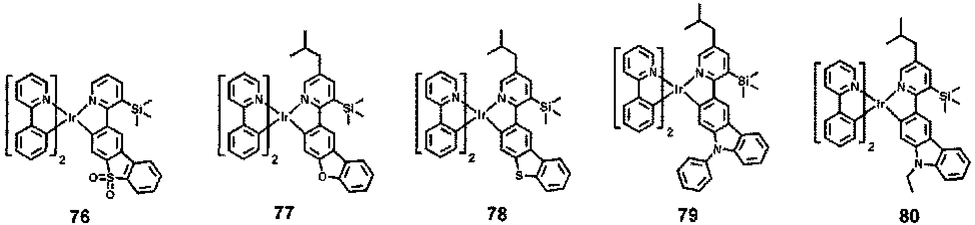

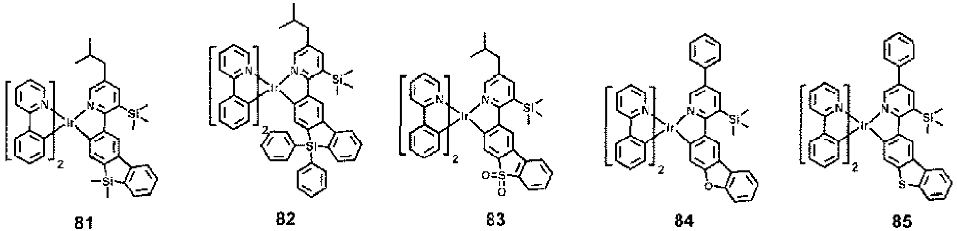

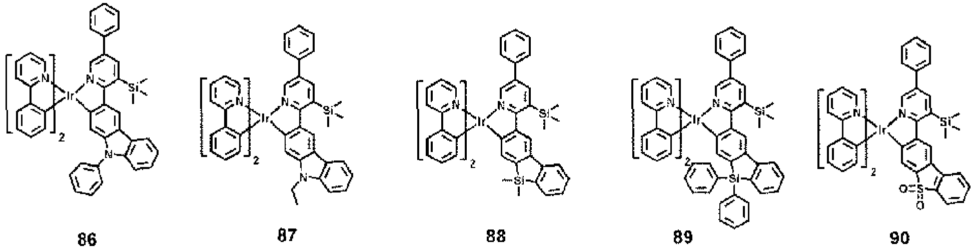

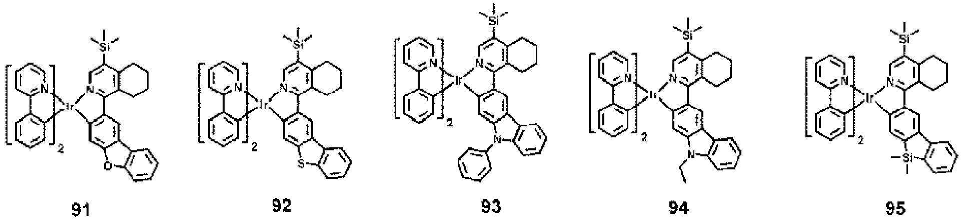

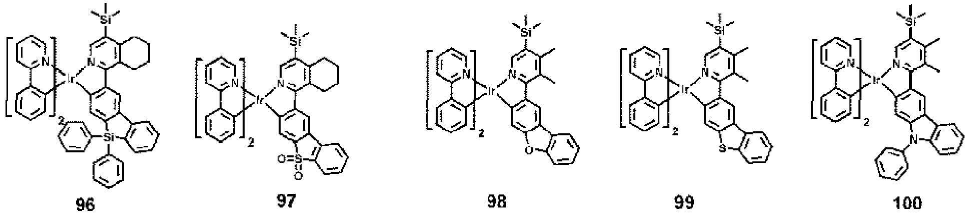

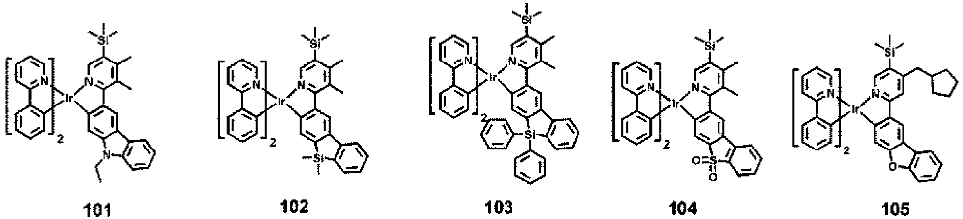

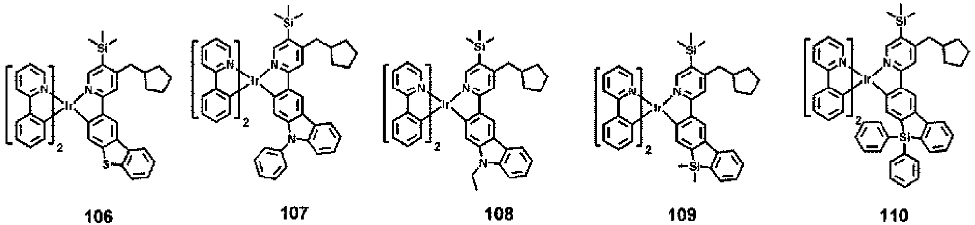

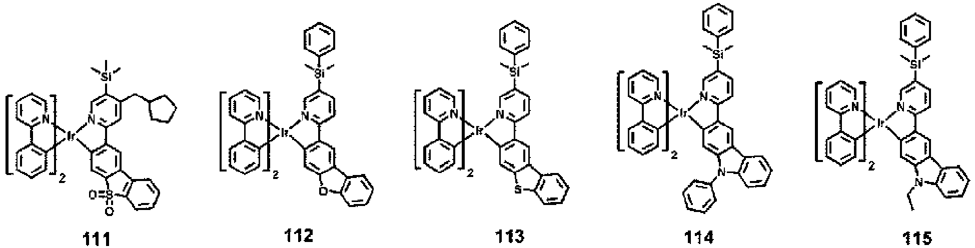

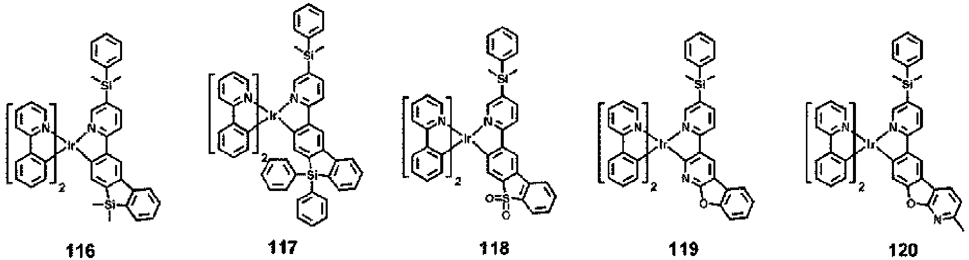

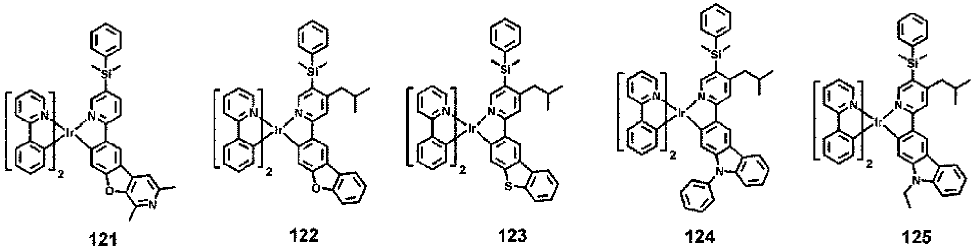

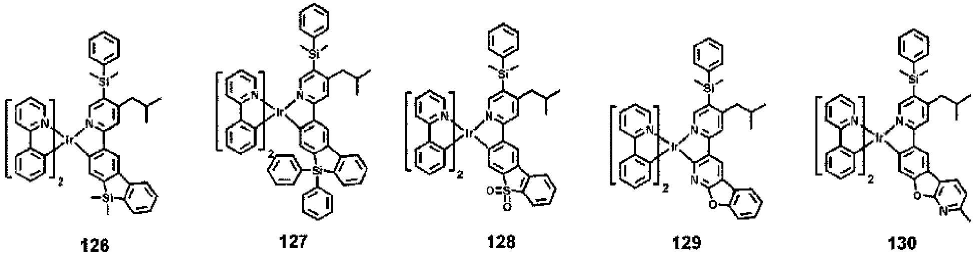

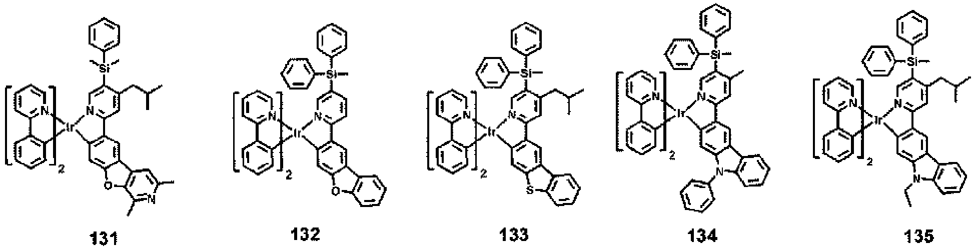

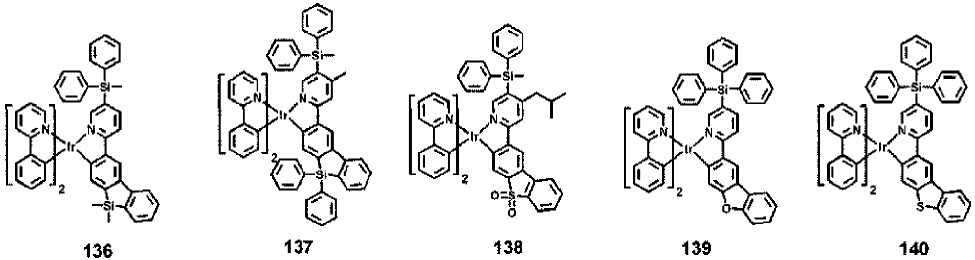

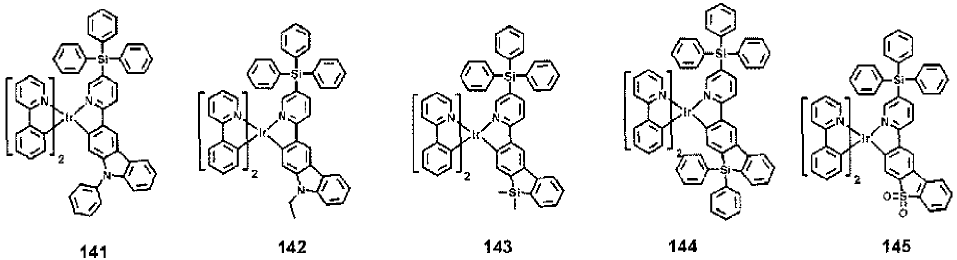

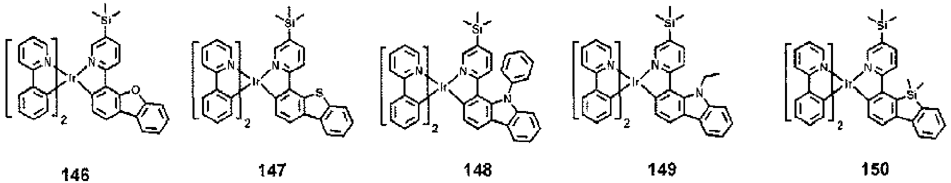

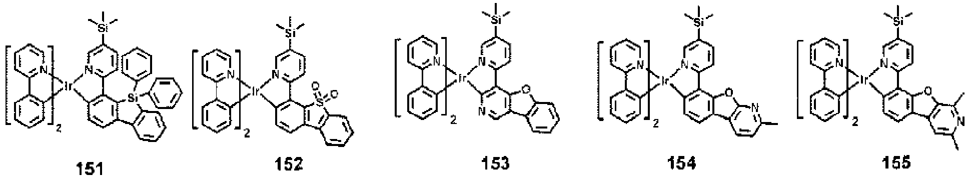

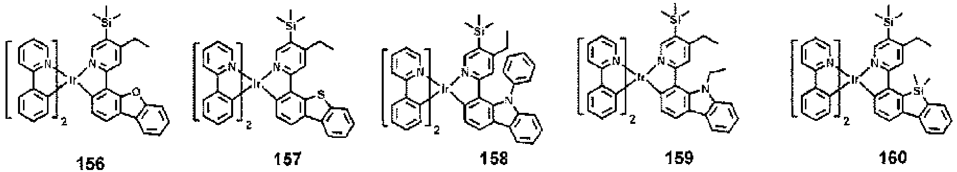

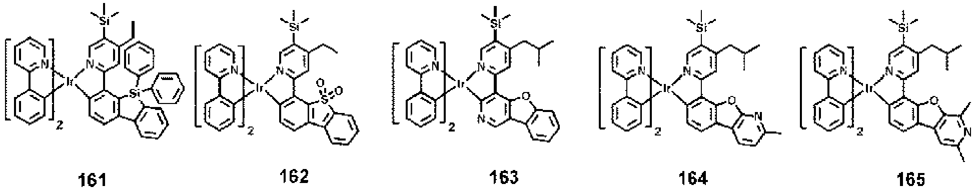

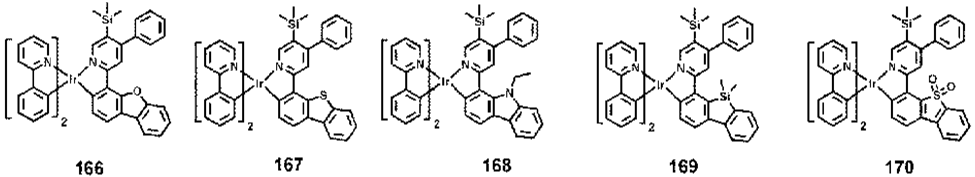

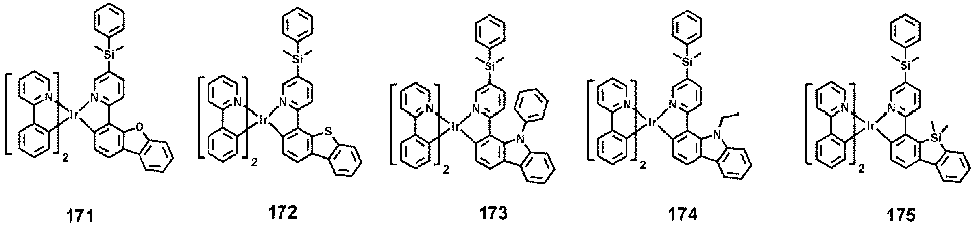

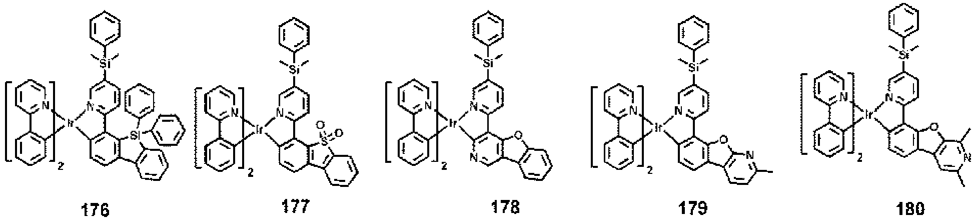

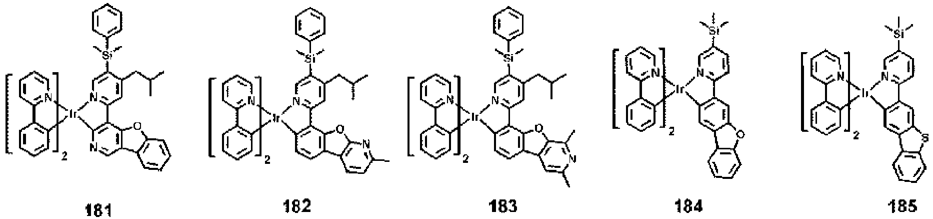

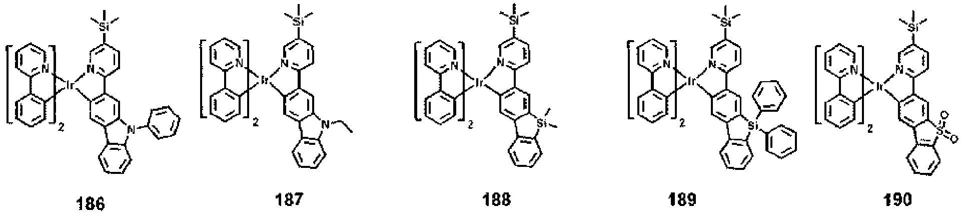

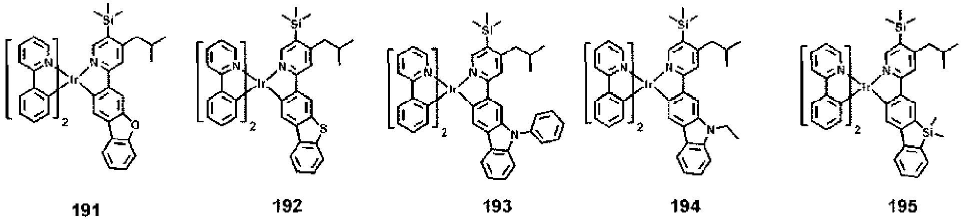

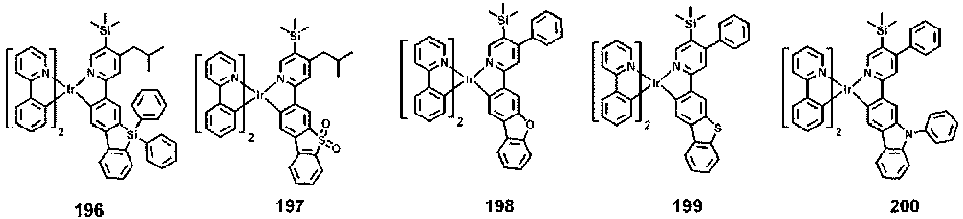

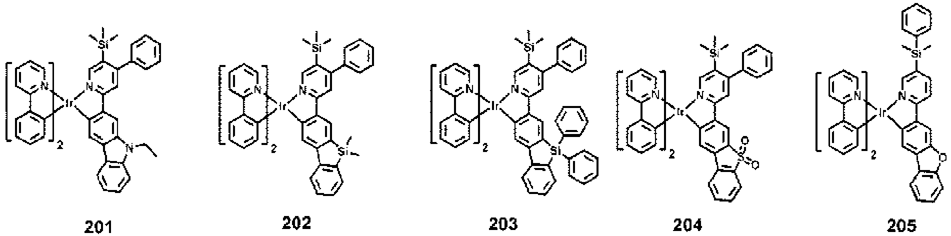

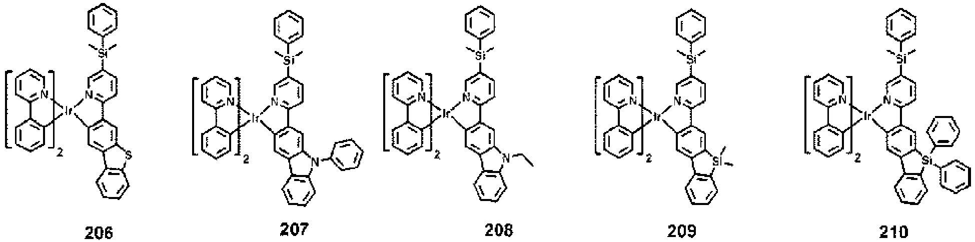

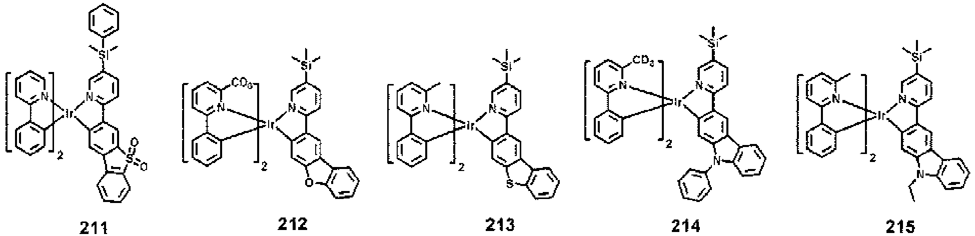

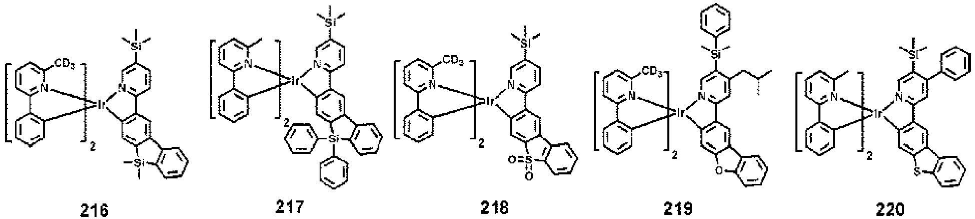

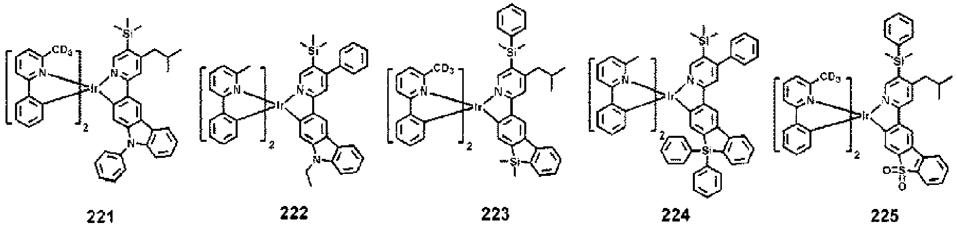

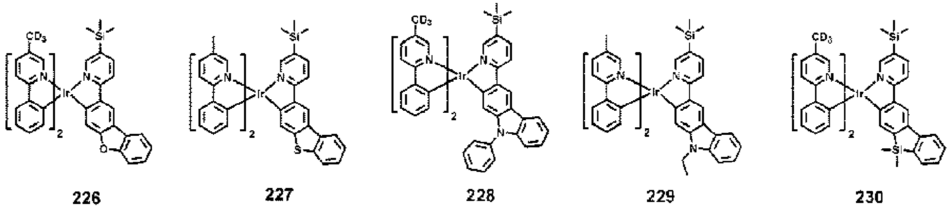

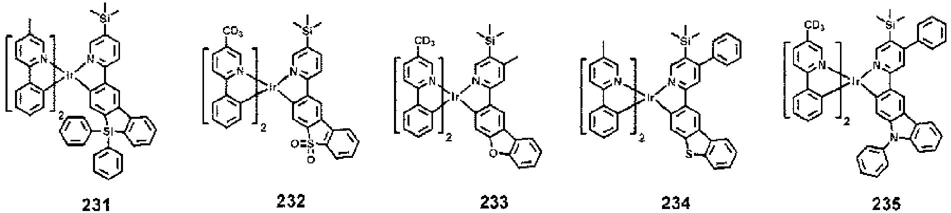

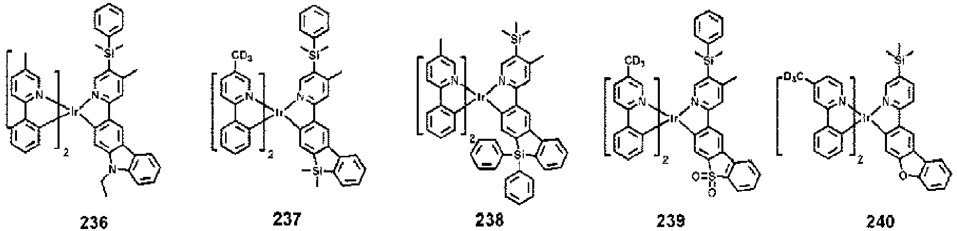

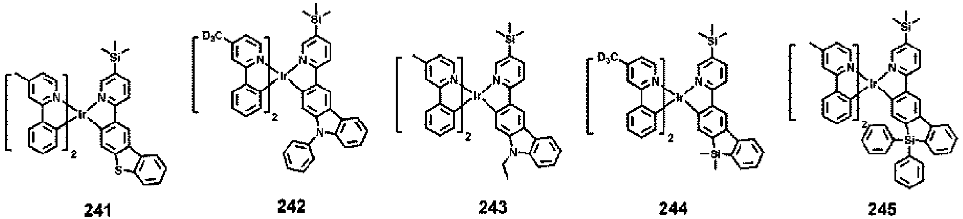

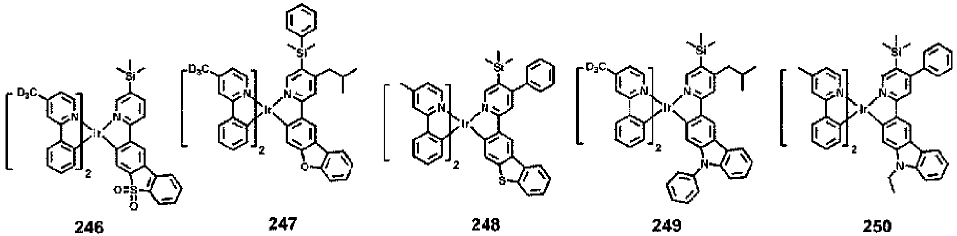

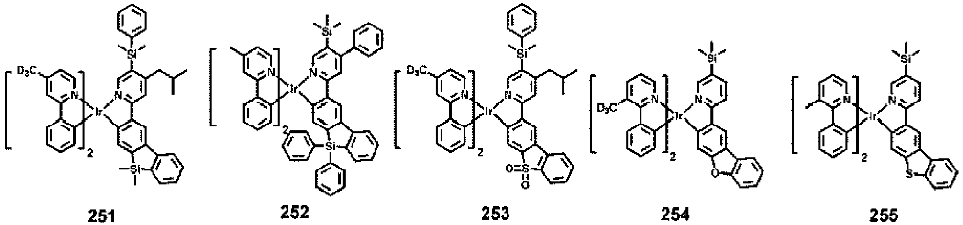

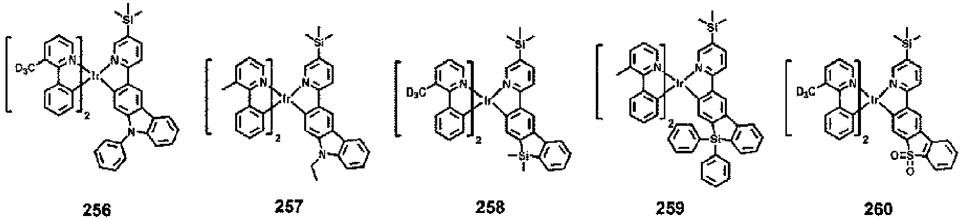

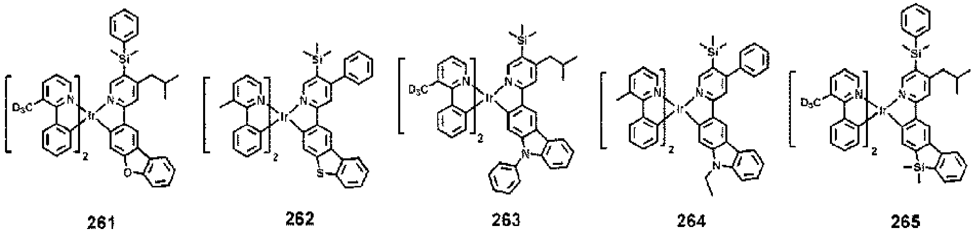

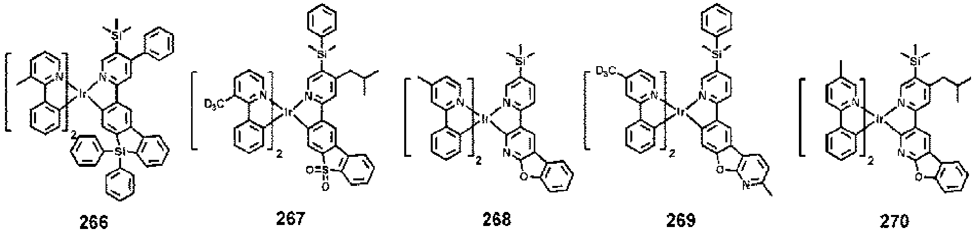

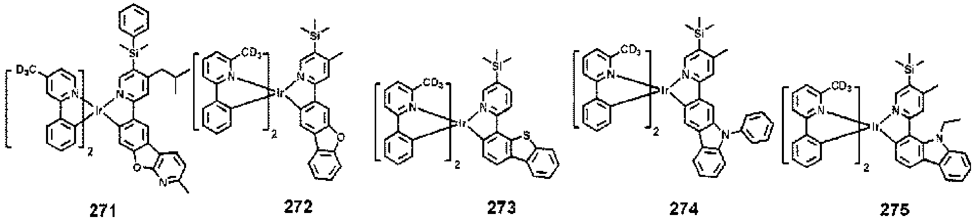

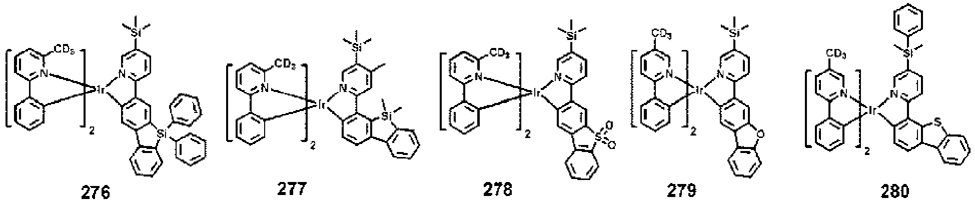

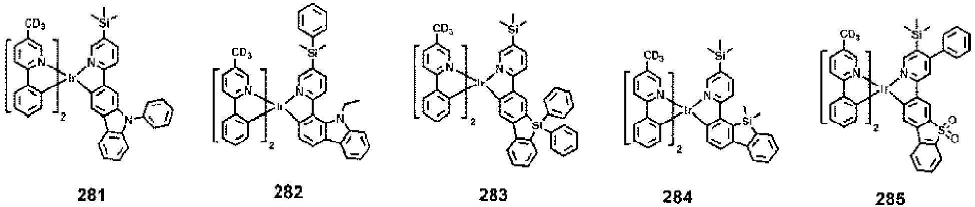

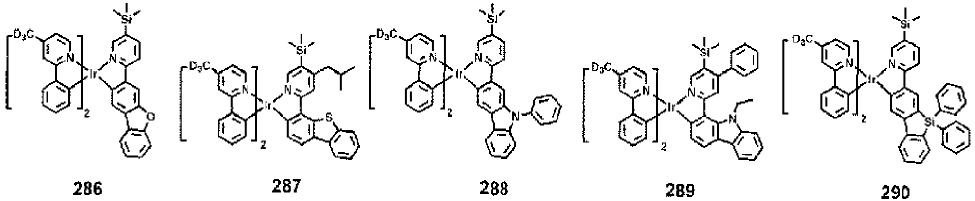

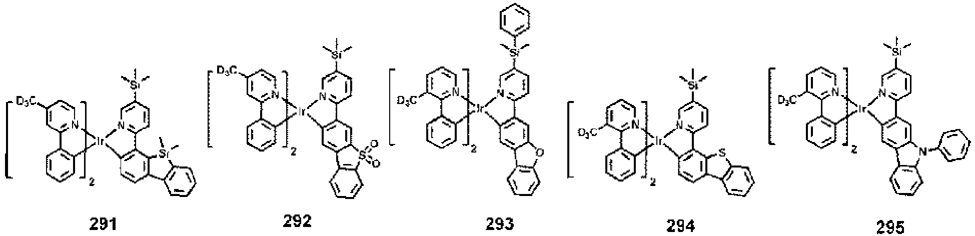

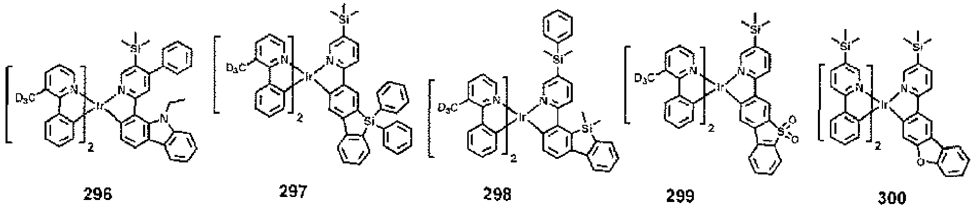

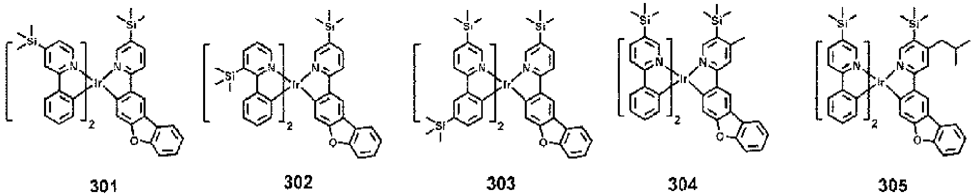

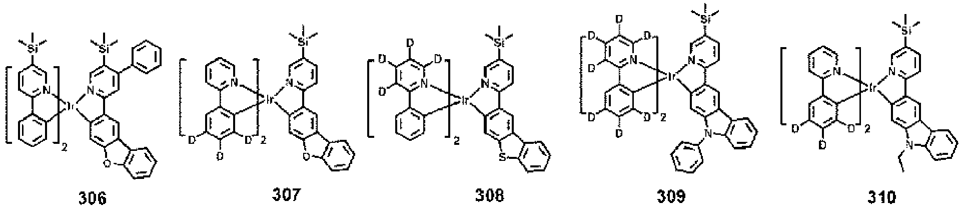

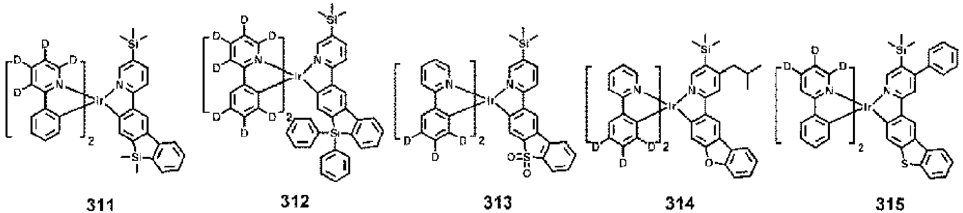

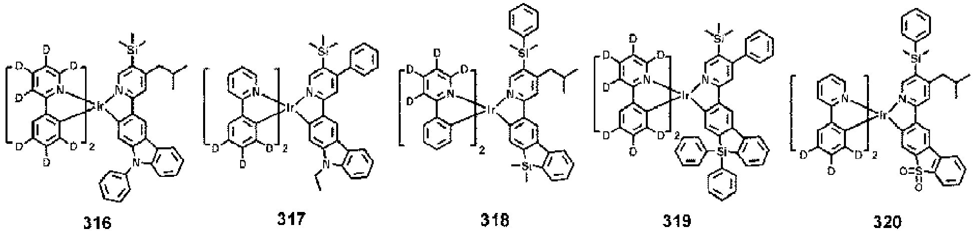

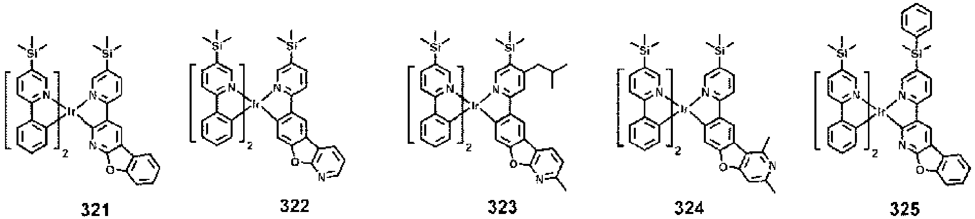

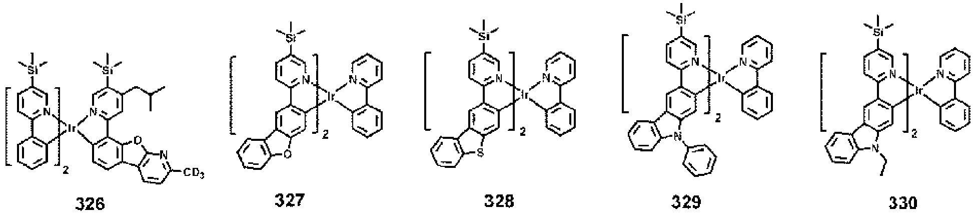

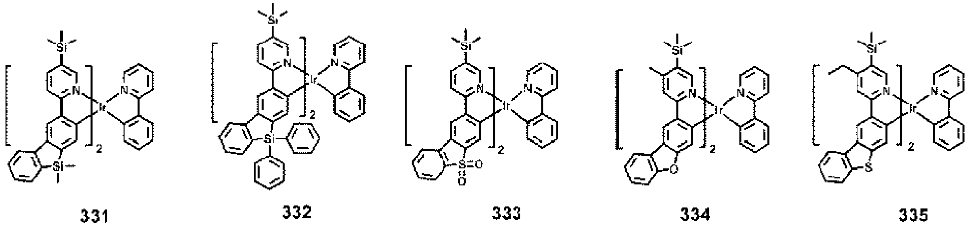

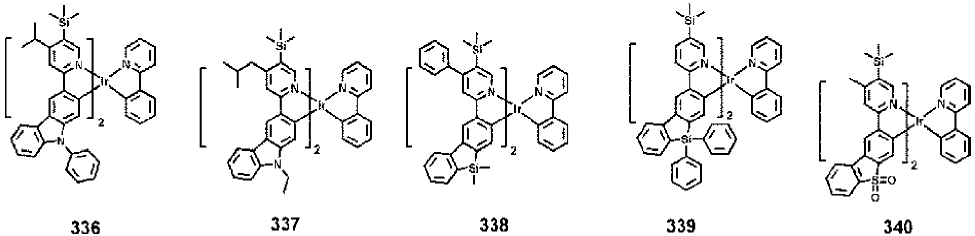

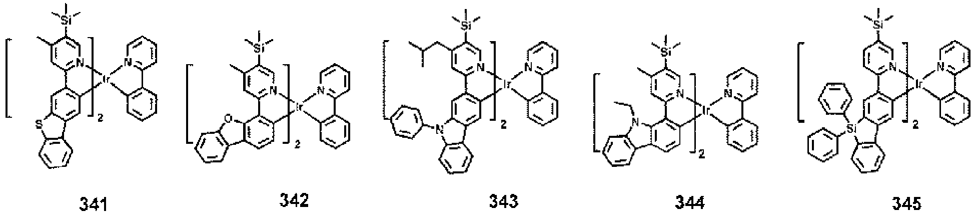

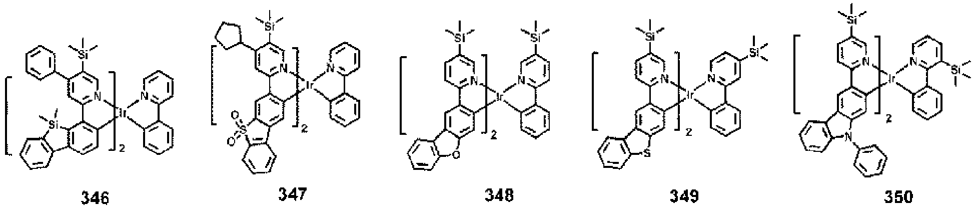

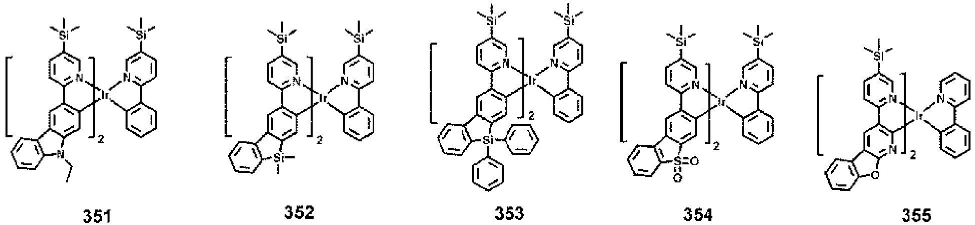

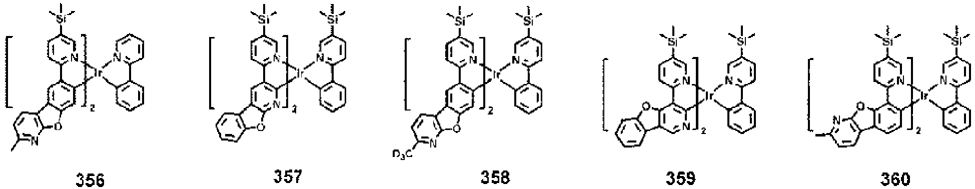

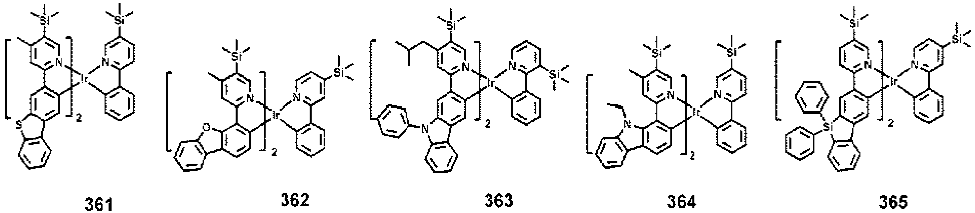

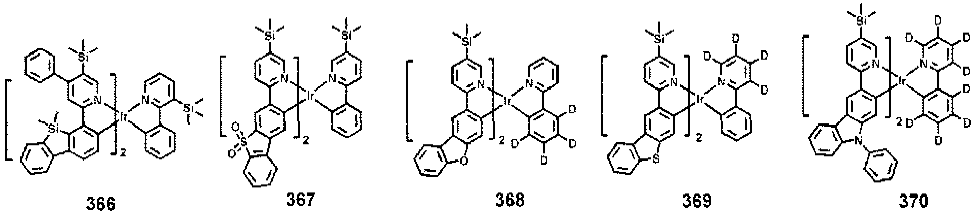

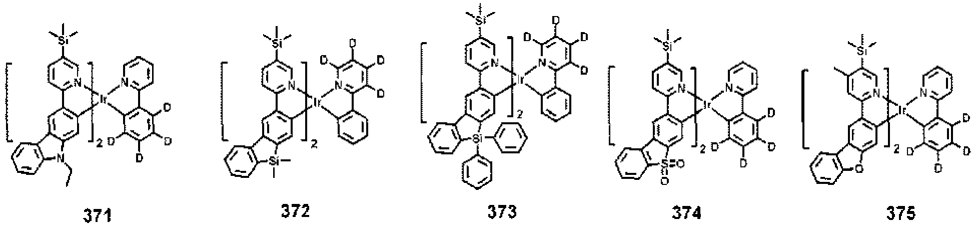

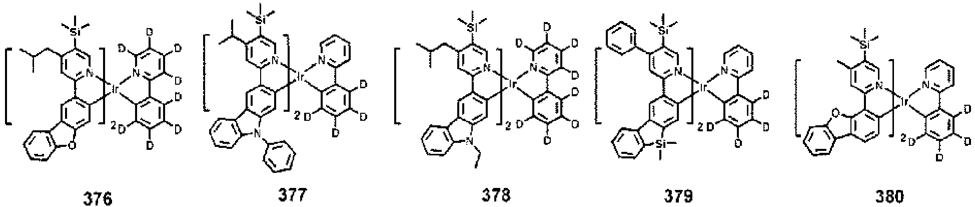

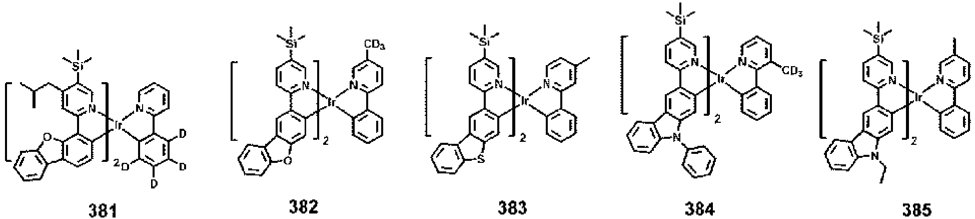

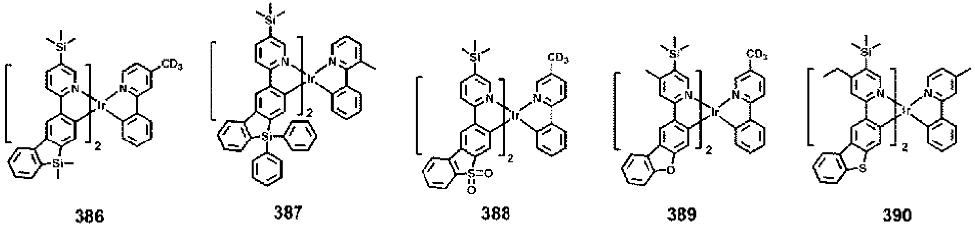

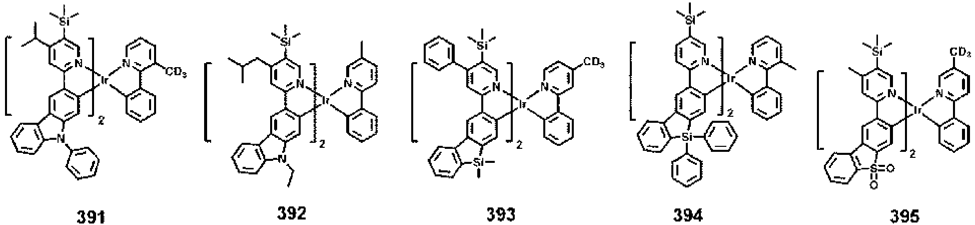

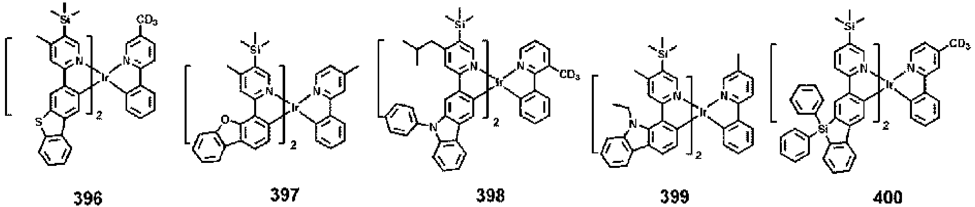

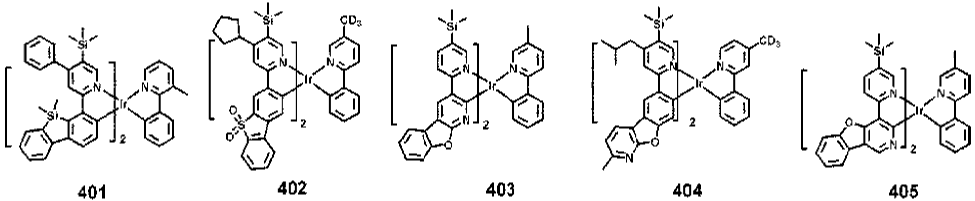

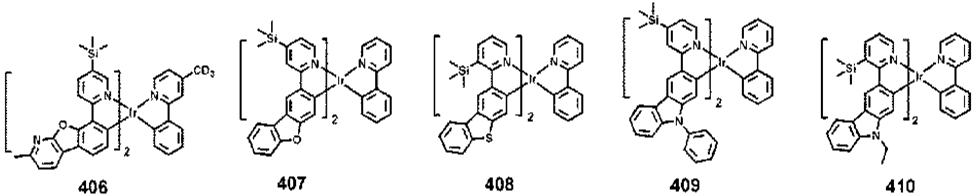

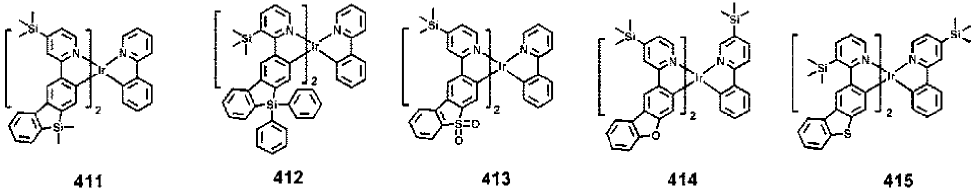

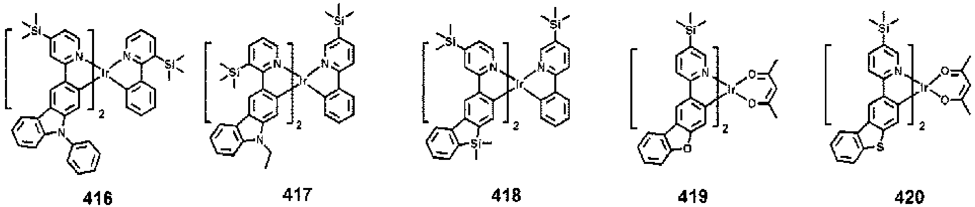

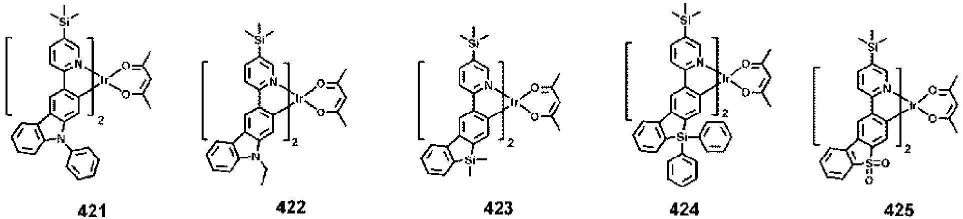

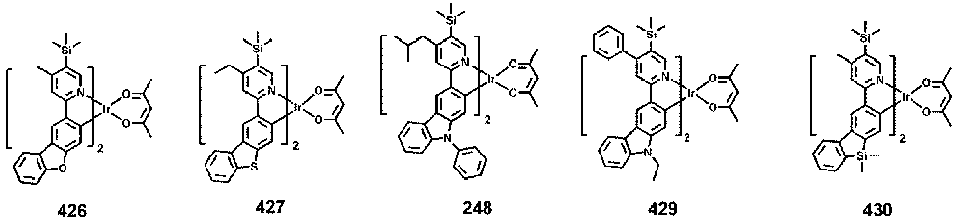

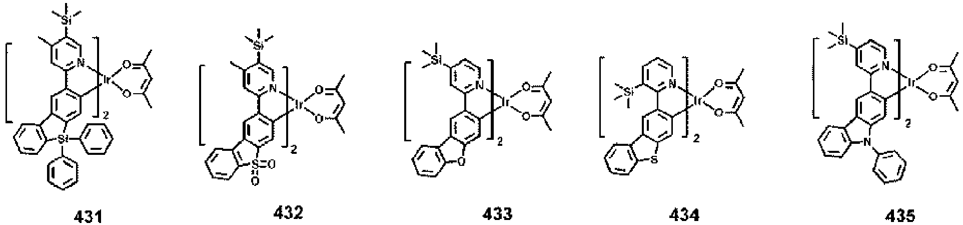

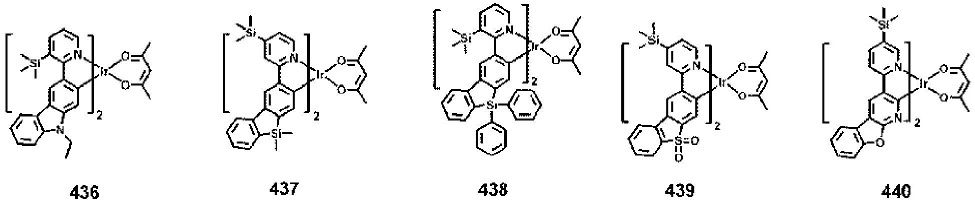

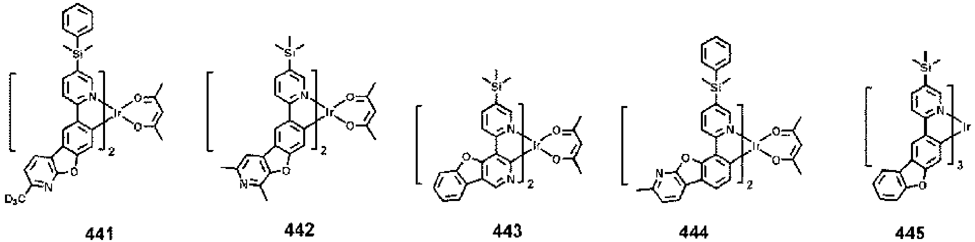

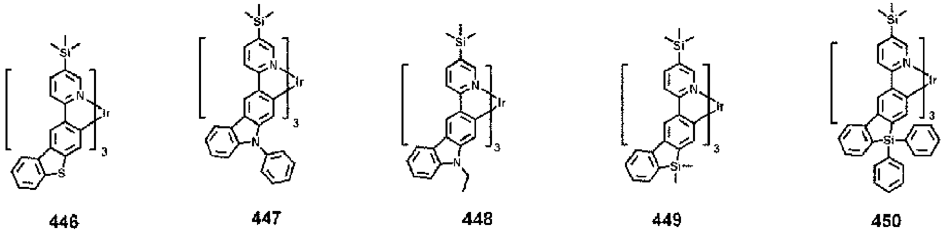

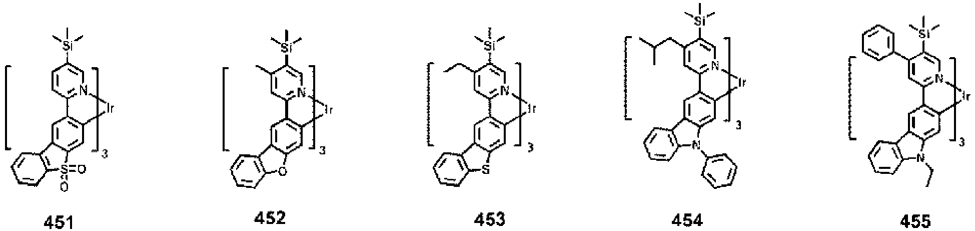

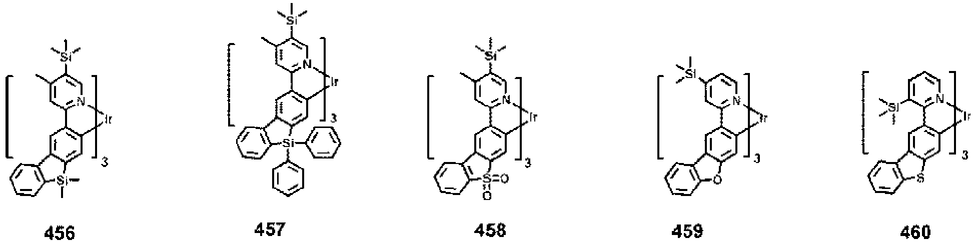

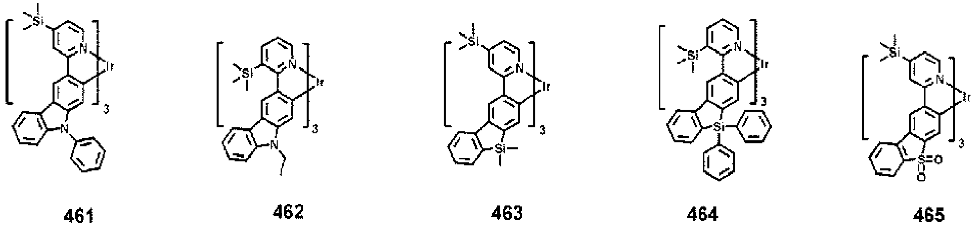

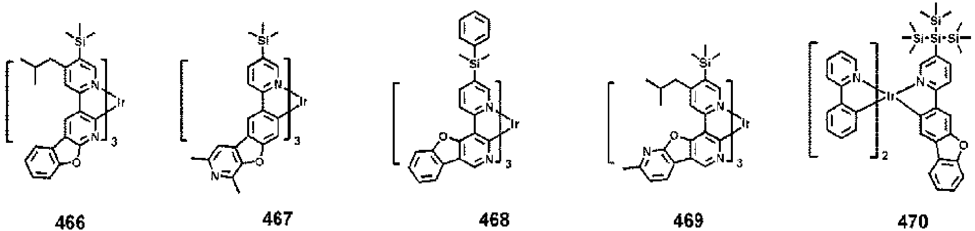

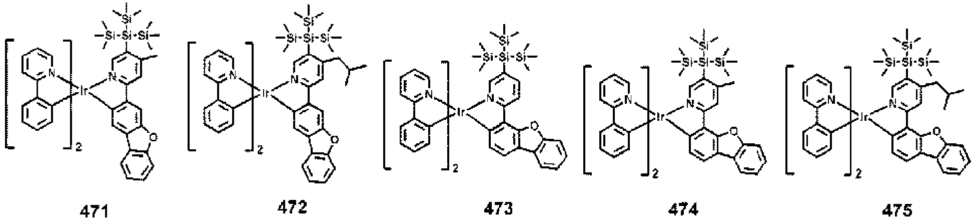

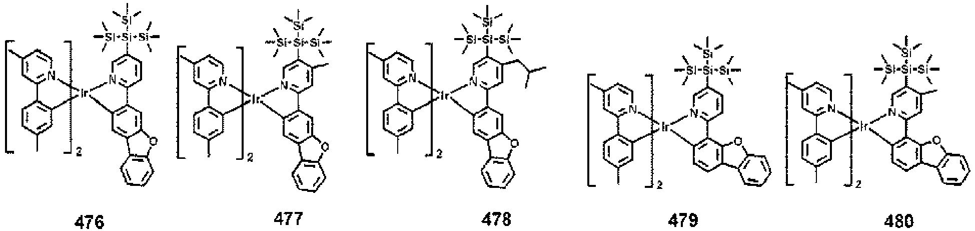

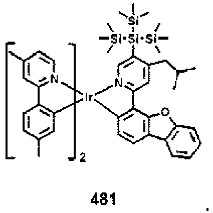

13. Dispositif émetteur de lumière organique comprenant :
une première électrode ;
une deuxième électrode ; et
une couche organique disposée entre la première électrode et la deuxième électrode,
dans lequel la couche organique comprend au moins une couche d'émission et au moins un composé organométallique selon l'une quelconque des revendications 1-12.

14. Dispositif émetteur de lumière organique selon la revendication 13,
dans lequel la première électrode est une anode,
la deuxième électrode est une cathode, et
la couche organique comprend une zone de transport d'électrons-trous entre la première électrode et la couche d'émission, et une zone de transport d'électrons entre la couche d'émission et la deuxième électrode,
dans lequel la zone de transport d'électrons-trous comprend au moins l'une de : une couche d'injection d'électrons-trous, une couche de transport d'électrons-trous et une couche de blocage d'électrons et
la zone de transport d'électrons comprend au moins une couche sélectionnée entre une couche de blocage d'électrons-trous, une couche de transport d'électrons et une couche d'injection d'électrons.

15. Dispositif émetteur de lumière organique selon la revendication 13 ou 14, dans lequel la couche d'émission comprend au moins un composé organométallique selon l'une quelconque des revendications 1-12.
